(19) Europäisches Patentamt
European Patent Office
Office européen des brevets

(11) EP 3 369 737 B1

(12) EUROPEAN PATENT SPECIFICATION

(45) Date of publication and mention of the grant of the patent:
**26.02.2020 Bulletin 2020/09**

(51) Int Cl.:
***C07F 15/00*** *(2006.01)* ***C09K 11/06*** *(2006.01)*
***H01L 51/00*** *(2006.01)*

(21) Application number: **18159703.0**

(22) Date of filing: **02.03.2018**

# (54) ORGANOMETALLIC COMPOUND, ORGANIC LIGHT-EMITTING DEVICE INCLUDING THE ORGANOMETALLIC COMPOUND, AND DIAGNOSTIC COMPOSITION INCLUDING THE ORGANOMETALLIC COMPOUND

ORGANOMETALLISCHE VERBINDUNG, ORGANISCHE LICHTEMITTIERENDE VORRICHTUNG MIT DER ORGANOMETALLISCHEN VERBINDUNG UND DIAGNOSTISCHE ZUSAMMENSETZUNG MIT DER ORGANOMETALLISCHEN VERBINDUNG

COMPOSÉ ORGANOMÉTALLIQUE, DISPOSITIF ÉLECTROLUMINESCENT ORGANIQUE LE COMPRENANT ET COMPOSITION DE DIAGNOSTIC COMPRENANT LE COMPOSÉ ORGANOMÉTALLIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.03.2017 KR 20170027772**

(43) Date of publication of application:
**05.09.2018 Bulletin 2018/36**

(73) Proprietors:
- **Samsung Electronics Co., Ltd.**
  **Suwon-si, Gyeonggi-do 16677 (KR)**
- **Samsung SDI Co., Ltd.**
  **Gyeonggi-do (KR)**

(72) Inventors:
- **BAE, Hyejin**
  **16678 Gyeonggi-do, (KR)**
- **JEON, Soonok**
  **16678 Gyeonggi-do, (KR)**
- **SOTOYAMA, Wataru**
  **Kanagawa,, 230-0027 (JP)**
- **CHWAE, Jun**
  **16678 Gyeonggi-do, (KR)**
- **KIM, Jongsoo**
  **16678 Gyeonggi-do, (KR)**
- **KIM, Joonghyuk**
  **16678 Gyeonggi-do, (KR)**
- **KIM, Wook**
  **Gyeonggi-do (KR)**
- **PARK, Sangho**
  **16678 Gyeonggi-do, (KR)**
- **LEE, Hasup**
  **16678 Gyeonggi-do, (KR)**

(74) Representative: **Elkington and Fife LLP**
**Prospect House**
**8 Pembroke Road**
**Sevenoaks, Kent TN13 1XR (GB)**

(56) References cited:
**US-A1- 2017 040 555**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 369 737 B1

**Description**

FIELD OF THE INVENTION

One or more embodiments relate to an organometallic compound, an organic light-emitting device including the organometallic compound, and a diagnostic composition including the organometallic compound.

BACKGROUND OF THE INVENTION

Organic light-emitting devices (OLEDs) are self-emission devices, which have superior characteristics in terms of a viewing angle, a response time, a brightness, a driving voltage, and a response speed, and which produce full-color images.

A typical organic light-emitting device includes an anode, a cathode, and an organic layer disposed between the anode and the cathode, wherein the organic layer includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state, thereby generating light.

Meanwhile, luminescent compounds may be used to monitor, sense, or detect a variety of biological materials including cells and proteins. An example of the luminescent compounds includes a phosphorescent luminescent compound.

Various types of organic light emitting devices are known. However, there still remains a need in OLEDs having low driving voltage, high efficiency, high brightness, and long lifespan.

US 2017/040555 discloses cyclometalated metal complexes useful for full color displays and lighting applications.

SUMMARY OF THE INVENTION

One or more embodiments include an organometallic compound, an organic light-emitting device including the organometallic compound, and a diagnostic composition including the organometallic compound.

Additional aspects will be set forth in part in the description which follows and, in part, will be apparent from the description, or may be learned by practice of the presented embodiments.

According to one or more embodiments, an organometallic compound is represented by Formula 1:

Formula 1

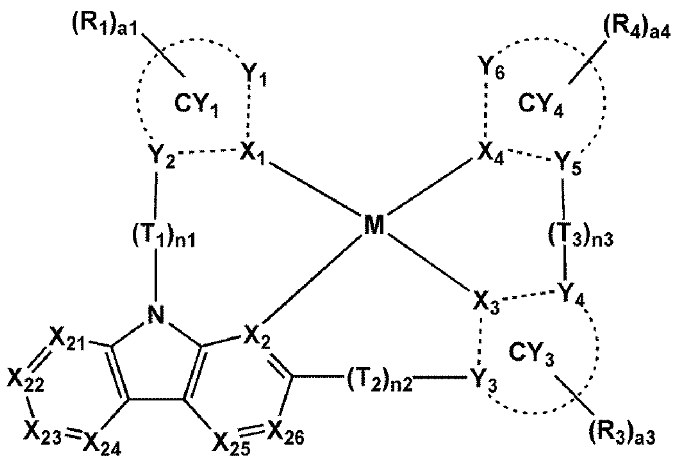

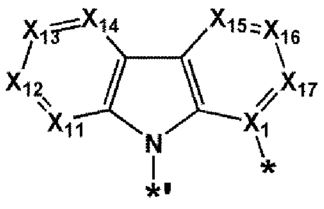

Formula CZ1

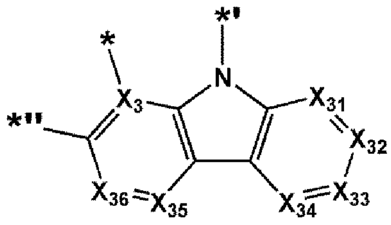

Formula CZ3

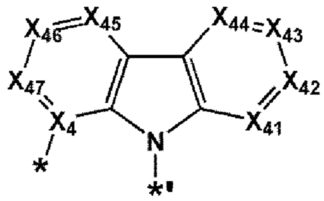

Formula CZ4

.

In Formulae 1, CZ1, CZ3, and CZ4,

M may be selected from a first-row transition metal of the Periodic Table of Elements, a second-row transition metal of the Periodic Table of Elements, and a third-row transition metal of the Periodic Table of Elements,
$X_1$ to $X_4$ may each independently be C or N,
two bonds selected from a bond between $X_1$ and M, a bond between $X_2$ and M, a bond between $X_3$ and M, and a bond between $X_4$ and M may each be a coordinate bond, and the others thereof may each be a covalent bond,
$Y_2$ to $Y_5$ may each independently be C or N,
$Y_1$ and $Y_6$ may each independently be C, N, O, Si, or S,
a bond between $X_1$ and $Y_1$, a bond between $X_1$ and $Y_2$, a bond between $X_3$ and $Y_3$, a bond between $X_3$ and $Y_4$, a bond between $X_4$ and $Y_5$, and a bond between $X_4$ and $Y_6$ may each be a chemical bond that links the corresponding atoms,
$CY_1$ may be selected from a $C_5$-$C_{30}$ carbocyclic group, a $C_1$-$C_{30}$ heterocyclic group, and a group represented by Formula CZ1,
$CY_3$ may be selected from a $C_5$-$C_{30}$ carbocyclic group, a $C_1$-$C_{30}$ heterocyclic group, and a group represented by Formula CZ3,
$CY_4$ may be selected from a $C_5$-$C_{30}$ carbocyclic group, a $C_1$-$C_{30}$ heterocyclic group, and a group represented by Formula CZ4,
$T_1$ to $T_3$ may each independently be selected from *-N[$(L_5)_{b5}$-$(R_5)$]-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-$S(=O)_2$-*', *-C($R_5$)=*', *=C($R_5$)-*', *-C($R_5$)=C($R_6$)-*', *-C(=S)-*', and *-C=C-*',
$L_5$ may be selected from a single bond, a substituted or unsubstituted $C_5$-$C_{30}$ carbocyclic group, and a substituted or unsubstituted $C_1$-$C_{30}$ heterocyclic group,
b5 may be selected from 1 to 3, wherein, when b5 is two or more, two or more groups $L_5$ may be identical to or different from each other,
$R_5$ and $R_6$ may optionally be linked via a first linking group to form a substituted or unsubstituted $C_5$-$C_{30}$ carbocyclic group or a substituted or unsubstituted $C_1$-$C_{30}$ heterocyclic group,
n1 to n3 may each independently be 0, 1, 2, or 3, wherein, when n1 is zero, *-$(T_1)_{n1}$-*' may be a single bond, when n2 is zero, *-$(T_2)_{n2}$-*' may be a single bond, and when n3 is zero, *-$(T_3)_{n3}$-*' may be a single bond,
$X_{11}$ may be N or C($R_{11}$), $X_{12}$ may be N or C($R_{12}$), $X_{13}$ may be N or C($R_{13}$), $X_{14}$ may be N or C($R_{14}$), $X_{15}$ may be N or C($R_{15}$), $X_{16}$ may be N or C($R_{16}$), $X_{17}$ may be N or C($R_{17}$), $X_{21}$ may be N or C($R_{21}$), $X_{22}$ may be N or C($R_{22}$), $X_{23}$ may be N or C($R_{23}$), $X_{24}$ may be N or C($R_{24}$), $X_{25}$ may be N or C($R_{25}$), $X_{26}$ may be N or C($R_{26}$), $X_{31}$ may be N or C($R_{31}$), $X_{32}$ may be N or C($R_{32}$), $X_{33}$ may be N or C($R_{33}$), $X_{34}$ may be N or C($R_{34}$), $X_{35}$ may be N or C($R_{35}$), $X_{36}$ may be N or C($R_{36}$), $X_{41}$ may be N or C($R_{41}$), $X_{42}$ may be N or C($R_{42}$), $X_{43}$ may be N or C($R_{43}$), $X_{44}$ may be N or C($R_{44}$), $X_{45}$ may be N or C($R_{45}$), $X_{46}$ may be N or C($R_{46}$), and $X_{47}$ may be N or C($R_{47}$),
$R_1$, $R_3$ to $R_6$, $R_{11}$ to $R_{17}$, $R_{21}$ to $R_{26}$, $R_{31}$ to $R_{36}$, and $R_{41}$ to $R_{47}$ may each independently be selected from hydrogen, deuterium, -F, -Cl, -Br, -I, - $SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $- Si(Q_3)(Q_4)(Q_5)$, $-B(Q_6)(Q_7)$, and $-P(=O)(Q_8)(Q_9)$,

a1, a3, and a4 may each independently be 0, 1, 2, 3, 4, or 5,

two of groups $R_1$ in the number of a1 may optionally be linked to form a substituted or unsubstituted $C_5$-$C_{30}$ carbocyclic group or a substituted or unsubstituted $C_1$-$C_{30}$ heterocyclic group,

two of groups $R_3$ in the number of a3 may optionally be linked to form a substituted or unsubstituted $C_5$-$C_{30}$ carbocyclic group or a substituted or unsubstituted $C_1$-$C_{30}$ heterocyclic group,

two of groups $R_4$ in the number of a4 may optionally be linked to form a substituted or unsubstituted $C_5$-$C_{30}$ carbocyclic group or a substituted or unsubstituted $C_1$-$C_{30}$ heterocyclic group,

two of $R_{11}$ to $R_{17}$ may optionally be linked to form a substituted or unsubstituted $C_5$-$C_{30}$ carbocyclic group or a substituted or unsubstituted $C_1$-$C_{30}$ heterocyclic group,

two of $R_{21}$ to $R_{26}$ may optionally be linked to form a substituted or unsubstituted $C_5$-$C_{30}$ carbocyclic group or a substituted or unsubstituted C1-$C_{30}$ heterocyclic group,

two of $R_{31}$ to $R_{36}$ may optionally be linked to form a substituted or unsubstituted $C_5$-$C_{30}$ carbocyclic group or a substituted or unsubstituted $C_1$-$C_{30}$ heterocyclic group,

two of $R_{41}$ to $R_{47}$ may optionally be linked to form a substituted or unsubstituted $C_5$-$C_{30}$ carbocyclic group or a substituted or unsubstituted $C_1$-$C_{30}$ heterocyclic group,

*, *', and *" each indicate a binding site to a neighboring atom, wherein the substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted C1-C60 heteroarylthio group, the substituted $C_2$-$C_{60}$ heteroarylalkyl group, the substituted monovalent non-aromatic condensed polycyclic group, and the substituted monovalent non-aromatic condensed heteropolycyclic group are selected from:

deuterium, -F, Cl, -Br, -I, $-CD_3$, $-CD_2H$, $-CDH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-C60 alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$,

Q1 to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C1-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a C1-C60 alkyl group and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, and
Formula 1 satisfies at least one of Condition 1 to Condition 4:

Condition 1
$CY_1$ in Formula 1 is a group represented by Formula CZ1, provided that at least one of $X_{11}$ to $X_{17}$ in Formula CZ1 is each independently N or C(CN),
Condition 2
at least one of $X_{21}$ to $X_{26}$ in Formula 1 is each independently N or C(CN),
Condition 3
$CY_3$ in Formula 1 is a group represented by Formula CZ3, provided that at least one of $X_{31}$ to $X_{36}$ in Formula CZ3 is each independently N or C(CN), and
Condition 4
$CY_4$ in Formula 1 is a group represented by Formula CZ4, provided that at least one of $X_{41}$ to $X_{47}$ in Formula CZ4 is each independently N or C(CN).

According to one or more embodiments, an organic light-emitting device includes: a first electrode; a second electrode; and an organic layer that is disposed between the first electrode and the second electrode and includes an emission layer and at least one organometallic compound.
The organometallic compound may act as a dopant in the organic layer.
According to one or more embodiments, a diagnostic composition includes at least one organometallic compound represented by Formula 1.

BRIEF DESCRIPTION OF THE DRAWINGS

These and/or other aspects will become apparent and more readily appreciated from the following description of the embodiments, taken in conjunction with the accompanying drawings in which:

FIG. 1 is a schematic view of an organic light-emitting device according to an embodiment; and
FIG. 2 is a graph of photoluminescence (PL) intensity (arbitrary units, a.u.) versus wavelength (nanometers, nm) showing photoluminescence spectra of Compounds 1, 2, A, 7, 24, and B.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.
It will be understood that when an element is referred to as being "on" another element, it can be directly in contact with the other element or intervening elements may be present therebetween. In contrast, when an element is referred to as being "directly on" another element, there are no intervening elements present.
It will be understood that, although the terms first, second, third etc. may be used herein to describe various elements, components, regions, layers, and/or sections, these elements, components, regions, layers, and/or sections

should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

In an embodiment, an organometallic compound is provided. The organometallic compound according to an embodiment may be represented by Formula 1:

Formula 1

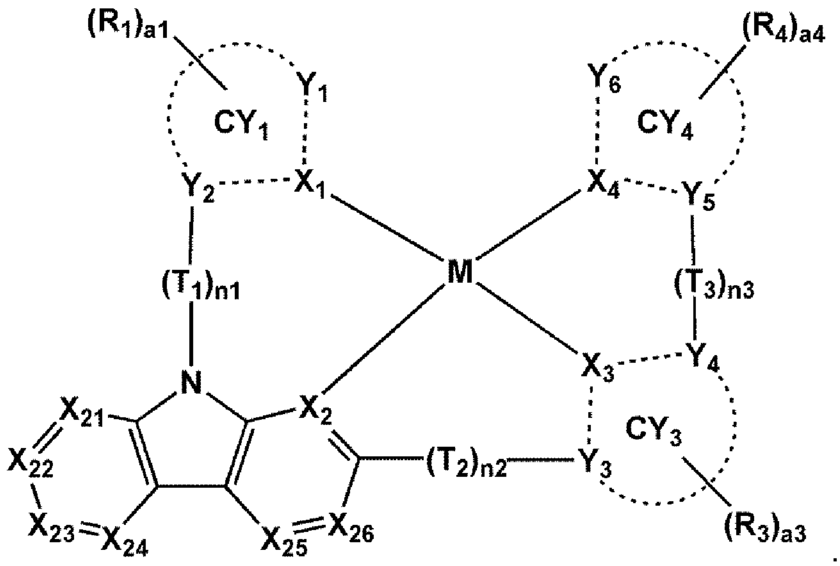

M in Formula 1 may be selected from a first-row transition metal of the Periodic Table of Elements, a second-row transition metal of the Periodic Table of Elements, and a third-row transition metal of the Periodic Table of Elements.

For example, M in Formula 1 may be platinum (Pt) or palladium (Pd), but embodiments of the present disclosure are not limited thereto.

The organometallic compound represented by Formula 1 may be a neutral compound that does not consist of an ion pair of an anion and a cation.

$X_1$ to $X_4$ in Formula 1 may each independently be C or N.

In Formula 1, two bonds selected from a bond between $X_1$ and M, a bond between $X_2$ and M, a bond between $X_3$ and M, and a bond between $X_4$ and M may each be a coordinate bond, and the others thereof may each be a covalent bond.

In one or more embodiments, in Formula 1,

i) $X_1$ and $X_4$ may each be N, $X_2$ and $X_3$ may each be C, a bond between $X_1$ and M and a bond between $X_4$ and M may each be a coordinate bond, and a bond between $X_2$ and M and a bond between $X_3$ and M may each be a covalent bond;
ii) $X_1$ and $X_3$ may each be N, $X_2$ and $X_4$ may each be C, a bond between $X_1$ and M and a bond between $X_3$ and M may each be a coordinate bond, and a bond between $X_2$ and M and a bond between $X_4$ and M may each be a covalent bond; or
iii) $X_3$ and $X_4$ may each be N, $X_1$ and $X_2$ may each be C, a bond between $X_3$ and M and a bond between $X_4$ and M may each be a coordinate bond, and a bond between $X_1$ and M and a bond between $X_2$ and M may each be a covalent bond.

In Formula 1, $Y_2$ to $Y_5$ may each independently be C or N, and $Y_1$ and $Y_6$ may each independently be C, N, O, Si, or S.

In Formula 1, a bond between $X_1$ and $Y_1$, a bond between $X_1$ and $Y_2$, a bond between $X_3$ and $Y_3$, a bond between $X_3$ and $Y_4$, a bond between $X_4$ and $Y_5$, and a bond between $X_4$ and $Y_6$ may each be a chemical bond that links the corresponding atoms.

In Formula 1, $CY_1$ may be selected from a $C_5$-$C_{30}$ carbocyclic group, a $C_1$-$C_{30}$ heterocyclic group, and a group represented by Formula CZ1, $CY_3$ may be selected from a $C_5$-$C_{30}$ carbocyclic group, a $C_1$-$C_{30}$ heterocyclic group, and a group represented by Formula CZ3, and $CY_4$ may be selected from a $C_5$-$C_{30}$ carbocyclic group, a $C_1$-$C_{30}$ heterocyclic group, and a group represented by Formula CZ4:

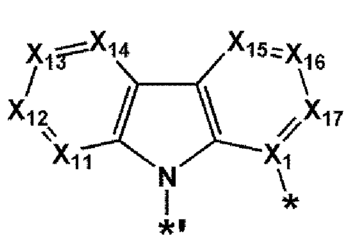

Formula CZ1

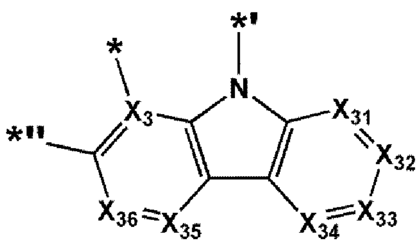

Formula CZ3

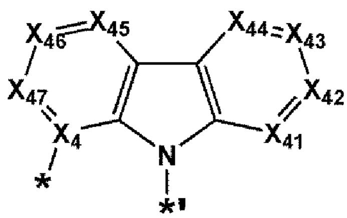

Formula CZ4

.

Formulae CZ1, CZ3, and CZ4 are each independently the same as described below.

In an embodiment, in Formula 1, $CY_1$, $CY_3$, and $CY_4$ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a pyrrole group, a thiophene group, a furan group, an indole group, an iso-indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-on group, a dibenzothiophene 5,5-dioxide group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-on group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group; $CY_1$ may be a group represented by Formula CZ1; $CY_3$ may be a group represented by Formula CZ3; or

$CY_4$ may be a group represented by Formula CZ4.

For example, in Formula 1, $CY_1$, $CY_3$, and $CY_4$ may each independently be selected from a benzene group, a naphthalene group, a pyrrole group, a thiophene group, a furan group, an indole group, an iso-indole group, a pyridine group, a pyrimidine group, a pyrazine group, a pyridazine group, a quinoline group, an isoquinoline group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group; $CY_1$ may be a group represented by Formula CZ1; $CY_3$ may be a group represented by Formula CZ3; or $CY_4$ may be a group represented by Formula CZ4, but embodiments of the present disclosure are not limited thereto.

"An azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-on group, and an azadibenzothiophene 5,5-dioxide group" as used herein mean hetero-rings that respectively have the same backbones as "a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-on group, and a dibenzothiophene 5,5-dioxide group", provided that at least one of carbons forming rings thereof is substituted with nitrogen.

In one or more embodiments, $CY_1$ and $CY_4$ in Formula 1 may be identical to each other.

In one or more embodiments, in Formula 1, a moiety represented by

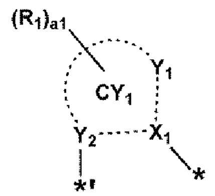

and a moiety represented by

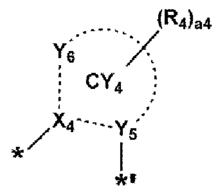

may be identical to each other; a moiety represented by

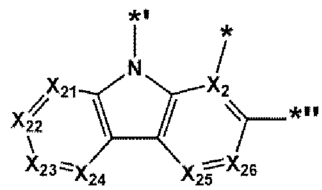

and a moiety represented by

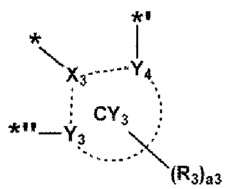

may be identical to each other; a moiety represented by

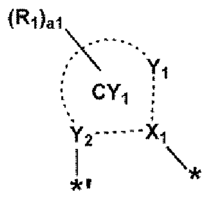

and a moiety represented by

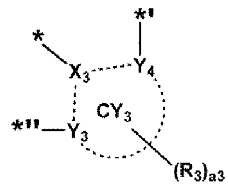

may be identical to each other; a moiety represented by

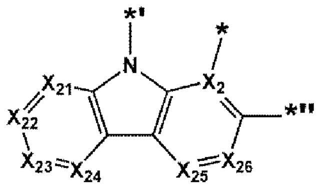

and

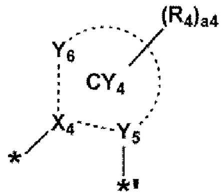

may be identical to each other; or a moiety represented by

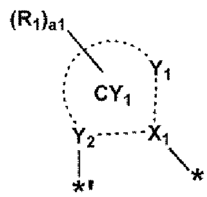

,

a moiety represented by

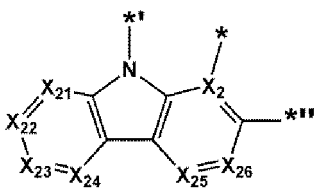

,

a moiety represented by

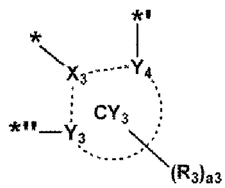

,

and a moiety represented by

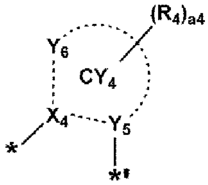

may be different from one another.

In one or more embodiments, the organometallic compound may have a symmetrical structure with respect to an axis connecting M and $T_2$ in Formula 1.

$T_1$ to $T_3$ in Formula 1 may each independently be selected from *-N[$(L_5)_{b5}$-($R_5$)]-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)2-*', *-C($R_5$)=*', *=C($R_5$)-*', *-C($R_5$)=C($R_6$)-*', *-C(=S)-*', and *-C≡C-*'. $R_5$ and $R_6$ are each independently the same as described below.

$L_5$ may be selected from a single bond, a substituted or unsubstituted $C_5$-$C_{30}$ carbocyclic group, and a substituted or unsubstituted $C_1$-$C_{30}$ heterocyclic group, and b5 may be selected from 1 to 3 (for example, b5 may be 1), wherein, when b5 is two or more, two or more groups $L_5$ may be identical to or different from each other.

In an embodiment, $L_5$ may be selected from:

a single bond, a phenylene group, a naphthylene group, a fluorenylene group, a pyridinylene group, a pyrimidinylene group, and a carbazolylene group; and
a phenylene group, a naphthylene group, a fluorenylene group, a pyridinylene group, a pyrimidinylene group, and a carbazolylene group, each substituted with at least one selected from deuterium, -F, -Cl, -Br, -I, $-CD_3$, - $CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a biphenyl group, and a terphenyl group,
but embodiments of the present disclosure are not limited thereto.

$R_5$ and $R_6$ may optionally be linked via a first linking group to form a substituted or unsubstituted $C_5$-$C_{30}$ carbocyclic group or a substituted or unsubstituted $C_1$-$C_{30}$ heterocyclic group (for example, a $C_5$-$C_6$ 5-membered to 7-membered cyclic group; or a $C_5$-$C_6$ 5-membered to 7-membered cyclic group substituted with at least one deuterium, a cyano group, -F, a $C_1$-$C_{10}$ alkyl group, and a $C_6$-$C_{14}$ aryl group).

In an embodiment, $T_1$ to $T_3$ in Formula 1 may each independently be selected from *-N[$(L_5)_{b5}$-($R_5$)]-*', *-B($R_5$)-*', *-C($R_5$)($R_6$)-*', *-Si($R_5$)($R_6$)-*', *-S-*', or *-O-*', but embodiments of the present disclosure are not limited thereto.

In one or more embodiments, $T_1$ to $T_3$ in Formula 1 may each independently be selected from *-C($R_5$)($R_6$)-*', *-Si($R_5$)($R_6$)-*', and *-Ge($R_5$)($R_6$)-*',
$R_5$ and $R_6$ may be linked via a first linking group.
The first linking group may be selected from a single bond, *-N[$(L_9)_{b9}$-($R_9$)]-*', *-B($R_9$)-*' *-P($R_9$)-*', *-C($R_9$)($R_{10}$)-*', *-Si($R_9$)($R_{10}$)-*', *-Ge($R_9$)($R_{10}$)-*', *-S-*', *-Se-*', *-O-*', *-C(=O)-*', *-S(=O)-*', *-S(=O)$_2$-*', *-C($R_9$)=C($R_{10}$)-*', *-C(=S)-*', and *-C≡C-*',
$L_9$ and b9 are each independently the same as described in connection with $L_5$ and b5,
$R_9$ and $R_{10}$ are each independently the same as described in connection with $R_5$, and
* and *' each indicate a binding site to a neighboring atom, but embodiments of the present disclosure are not limited thereto.

n1, n2, and n3 in Formula 1 respectively indicate the number of groups $T_1$, the number of groups $T_2$, and the number of groups $T_3$, and may each independently be 0, 1, 2, or 3, wherein, when n1 is zero, *-$(T_1)_{n1}$-*' may be a single bond, when n2 is zero, *-$(T_2)_{n2}$-*' may be a single bond, and when n3 is zero, *-$(T_3)_{n3}$-*' may be a single bond. When n1 is two or more, two or more groups $T_1$ may be identical to or different from each other, when n2 is two or more, two or more groups $T_2$ may be identical to or different from each other, and when n3 is two or more, two or more groups $T_3$ may be identical to or different from each other.

In an embodiment, n1 to n3 in Formula 1 may each independently 0 or 1.

In one or more embodiments, the sum of n1, n2, and n3 may be 1 or 2.

In one or more embodiments, in Formula 1, i) n1 and n3 may each be 0 and n2 may be 1; or ii) n1 may be 0 and n2 and n3 may each be 1, but embodiments of the present disclosure are not limited thereto.

In Formulae CZ1, CZ3, and CZ4, $X_{11}$ may be N or C($R_{11}$), $X_{12}$ may be N or C($R_{12}$), $X_{13}$ may be N or C($R_{13}$), $X_{14}$ may be N or C($R_{14}$), $X_{15}$ may be N or C($R_{15}$), $X_{16}$ may be N or C($R_{16}$), $X_{17}$ may be N or C($R_{17}$), $X_{21}$ may be N or C($R_{21}$), $X_{22}$ may be N or C($R_{22}$), $X_{23}$ may be N or C($R_{23}$), $X_{24}$ may be N or C($R_{24}$), $X_{25}$ may be N or C($R_{25}$), $X_{26}$ may be N or C($R_{26}$), $X_{31}$ may be N or C($R_{31}$), $X_{32}$ may be N or C($R_{32}$), $X_{33}$ may be N or C($R_{33}$), $X_{34}$ may be N or C($R_{34}$), $X_{35}$

may be N or C($R_{35}$), $X_{36}$ may be N or C($R_{36}$), $X_{41}$ may be N or C($R_{41}$), $X_{42}$ may be N or C($R_{42}$), $X_{43}$ may be N or C($R_{43}$), $X_{44}$ may be N or C($R_{44}$), $X_{45}$ may be N or C($R_{45}$), $X_{46}$ may be N or C($R_{46}$), and $X_{47}$ may be N or C($R_{47}$).

Formula 1 may satisfy at least one of Condition 1 to Condition 4:

Condition 1
$CY_1$ in Formula 1 is a group represented by Formula CZ1, provided that at least one of $X_{11}$ to $X_{17}$ in Formula CZ1 is each independently N or C(CN),
Condition 2
at least one of $X_{21}$ to $X_{26}$ in Formula 1 is each independently N or C(CN),
Condition 3
$CY_3$ in Formula 1 is a group represented by Formula CZ3, provided that at least one of $X_{31}$ to $X_{36}$ in Formula CZ3 is each independently N or C(CN), and
Condition 4
$CY_4$ in Formula 1 is a group represented by Formula CZ4, provided that at least one of $X_{41}$ to $X_{47}$ in Formula CZ4 is each independently N or C(CN).

For example, in Formula 1,

i) when $CY_1$ is not a group represented by Formula CZ1, $CY_3$ is not a group represented by Formula CZ3, and $CY_4$ is not a group represented by Formula CZ4, at least one of $X_{21}$ to $X_{26}$ (for example, one or two of $X_{21}$ to $X_{26}$) may each independently be N or C(CN),
ii) when $CY_1$ is a group represented by Formula CZ1, at least one of $X_{11}$ to $X_{17}$ and $X_{21}$ to $X_{26}$ (for example, one or two of $X_{11}$ to $X_{17}$ and $X_{21}$ to $X_{26}$) may each independently be N or C(CN),
iii) when $CY_3$ is a group represented by Formula CZ3, at least one of $X_{21}$ to $X_{26}$ and $X_{31}$ to $X_{36}$ (for example, one or two of $X_{21}$ to $X_{26}$ and $X_{31}$ to $X_{36}$) may each independently be N or C(CN), and
iv) when $CY_4$ is a group represented by Formula CZ4, at least one of $X_{21}$ to $X_{26}$ and $X_{41}$ to $X_{47}$ (for example, one or two of $X_{21}$ to $X_{26}$ and $X_{41}$ to $X_{47}$) may each independently be N or C(CN).

$R_1$, $R_3$ to $R_6$, $R_{11}$ to $R_{17}$, $R_{21}$ to $R_{26}$, $R_{31}$ to $R_{36}$, and $R_{41}$ to $R_{47}$ may each independently be selected from hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, and $-P(=O)(Q_8)(Q_9)$. $Q_1$ to $Q_9$ are each independently the same as described herein.

For example, $R_1$, $R_3$ to $R_6$, $R_{11}$ to $R_{17}$, $R_{21}$ to $R_{26}$, $R_{31}$ to $R_{36}$, and $R_{41}$ to $R_{47}$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and

$-N(Q_1)(Q_2)$, $-Si(Q_3)(Q_4)(Q_5)$, $-B(Q_6)(Q_7)$, and $-P(=O)(Q_8)(Q_9)$, and

$Q_1$ to $Q_9$ may each independently be selected from:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, and $-CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{10}$ alkyl group, and a phenyl group.

In an embodiment, $R_1$, $R_3$ to $R_6$, $R_{11}$ to $R_{17}$, $R_{21}$ to $R_{26}$, $R_{31}$ to $R_{36}$, and $R_{41}$ to $R_{47}$ may each independently be selected from:

hydrogen, deuterium, -F, a cyano group, a nitro group, $-SF_5$, a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group,

an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a carbazolyl group, a dibenzofuranyl group, and a dibenzothiophenyl group;

a methyl group, an ethyl group, an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a carbazolyl group, a dibenzofuranyl group, and a dibenzothiophenyl group, each substituted with at least one selected from deuterium, -F, $-CD_3$, $-CD_2H$, $-CDH_2$, $-CF_3$, $-CF_2H$, $-CFH_2$, a cyano group, a nitro group, a $C_1$-$C_{10}$ alkyl group, a $C_1$-$C_{10}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a carbazolyl group, a dibenzofuranyl group, and a dibenzothiophenyl group; and

$-N(Q_1)(Q_2)$, $-Si(Q_3)(Q_4)(Q_5)$, $-B(Q_6)(Q_7)$, and $-P(=O)(Q_8)(Q_9)$, and

$Q_1$ to $Q_9$ are each independently the same as described above.

In one or more embodiments, $R_1$, $R_3$ to $R_6$, $R_{11}$ to $R_{17}$, $R_{21}$ to $R_{26}$, $R_{31}$ to $R_{36}$, and $R_{41}$ to $R_{47}$ may each independently be selected from hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, groups represented by Formulae 9-1 to 9-19, groups represented by Formulae 10-1 to 10-139, and $-Si(Q_3)(Q_4)(Q_5)$ (wherein $Q_3$ to $Q_5$ are each independently the same as described herein), but embodiments of the present disclosure are not limited thereto:

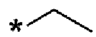
Formula 9-1

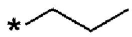
Formula 9-2

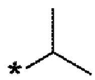
Formula 9-3

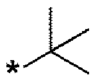
Formula 9-4

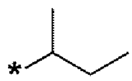
Formula 9-5

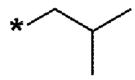
Formula 9-6

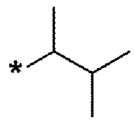
Formula 9-7

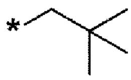
Formula 9-8

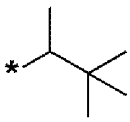
Formula 9-9

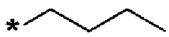
Formula 9-10

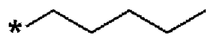
Formula 9-11

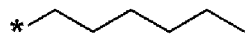
Formula 9-12

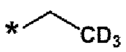
Formula 9-13

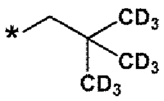
Formula 9-14

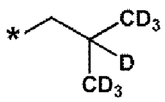
Formula 9-15

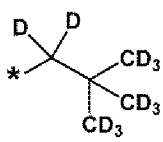
Formula 9-16

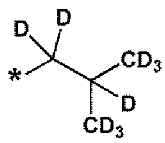
Formula 9-17

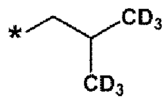
Formula 9-18

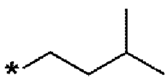
Formula 9-19

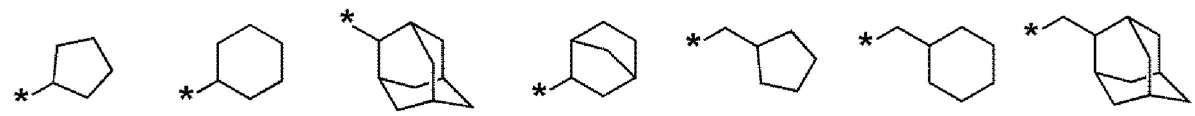

Formula 10-1 Formula 10-2 Formula 10-3 Formula 10-4 Formula 10-5 Formula 10-6 Formula 10-7

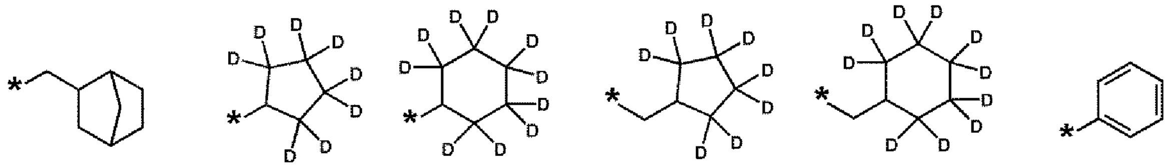

Formula 10-8 Formula 10-9 Formula 10-10 Formula 10-11 Formula 10-12 Formula 10-13

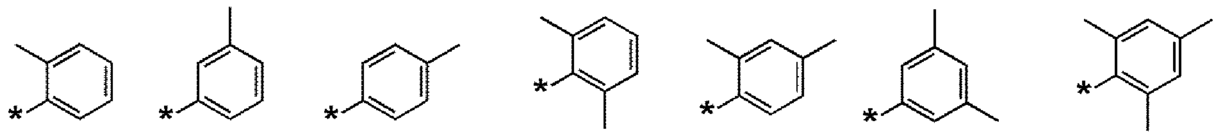

Formula 10-14 Formula 10-15 Formula 10-16 Formula 10-17 Formula 10-18 Formula 10-19 Formula 10-20

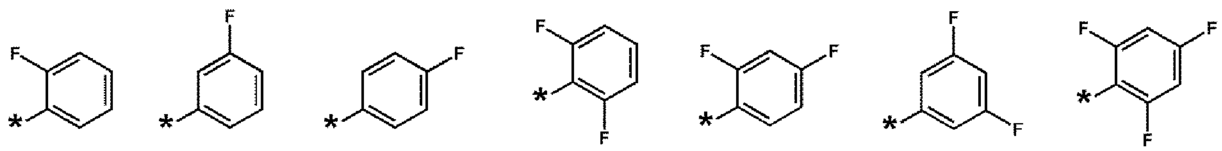

Formula 10-21 Formula 10-22 Formula 10-23 Formula 10-24 Formula 10-25 Formula 10-26 Formula 10-27

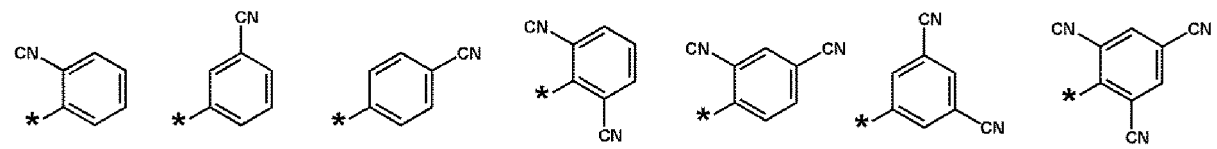

Formula 10-28 Formula 10-29 Formula 10-30 Formula 10-31 Formula 10-32 Formula 10-33 Formula 10-34

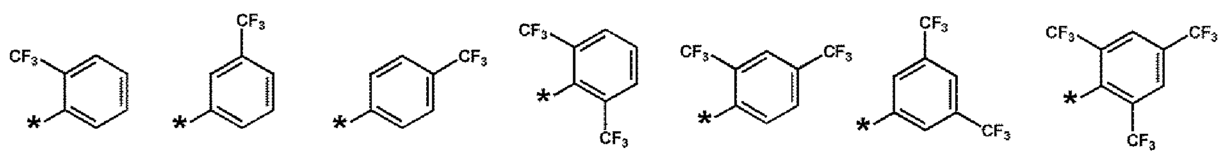

Formula 10-35 Formula 10-36 Formula 10-37 Formula 10-38 Formula 10-39 Formula 10-40 Formula 10-41

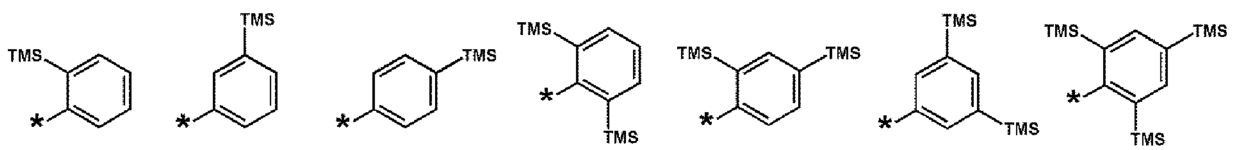

Formula 10-42 Formula 10-43 Formula 10-44 Formula 10-45 Formula 10-46 Formula 10-47 Formula 10-48

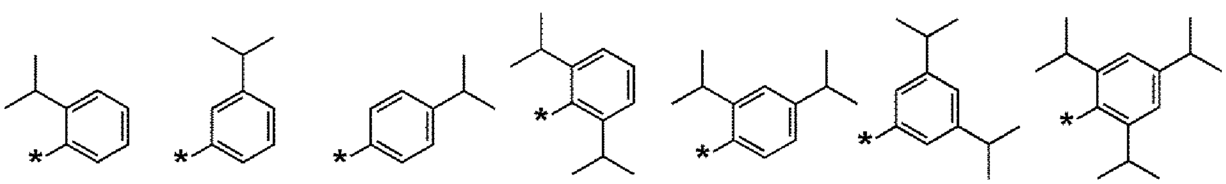

Formula 10-49 Formula 10-50 Formula 10-51 Formula 10-52 Formula 10-53 Formula 10-54 Formula 10-55

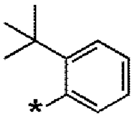
Formula 10-56

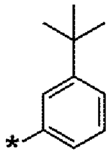
Formula 10-57

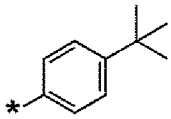
Formula 10-58

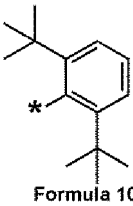
Formula 10-59

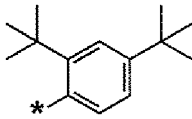
Formula 10-60

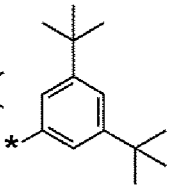
Formula 10-61

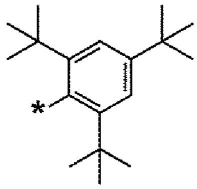
Formula 10-62

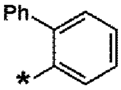
Formula 10-63

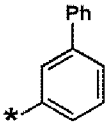
Formula 10-64

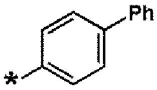
Formula 10-65

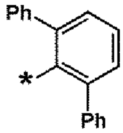
Formula 10-66

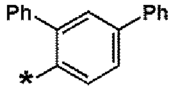
Formula 10-67

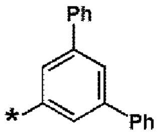
Formula 10-68

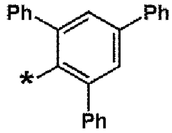
Formula 10-69

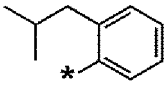
Formula 10-70

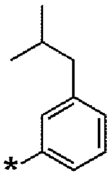
Formula 10-71

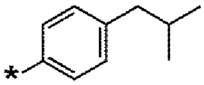
Formula 10-72

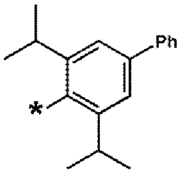
Formula 10-73

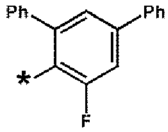
Formula 10-74

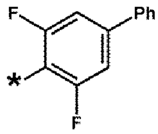
Formula 10-75

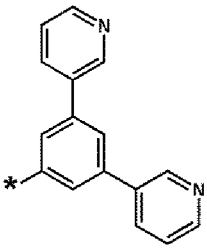
Formula 10-76

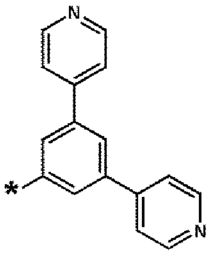
Formula 10-77

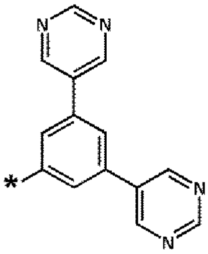
Formula 10-78

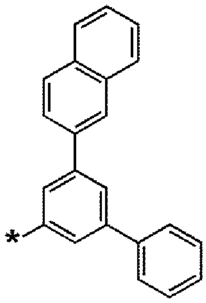
Formula 10-79

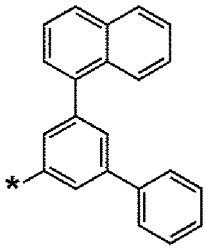
Formula 10-80

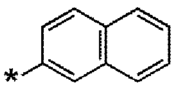
Formula 10-81

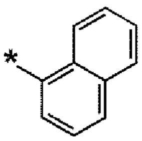
Formula 10-82

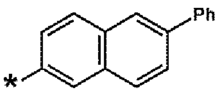
Formula 10-83

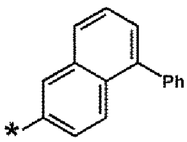
Formula 10-84

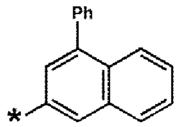
Formula 10-85

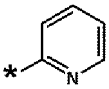
Formula 10-86

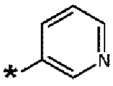
Formula 10-87

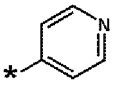
Formula 10-88

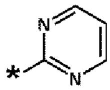
Formula 10-89

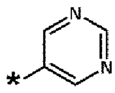
Formula 10-90

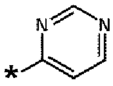
Formula 10-91

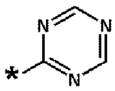
Formula 10-92

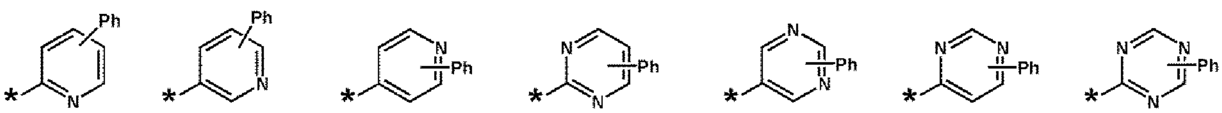
Formula 10-93 Formula 10-94 Formula 10-95 Formula 10-96 Formula 10-97 Formula 10-98 Formula 10-99

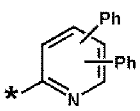 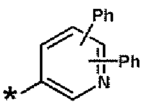 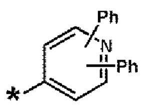 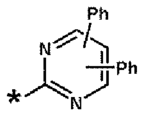 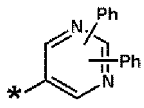 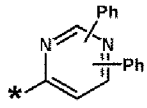 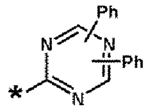

Formula 10-100 Formula 10-101 Formula 10-102 Formula 10-103 Formula 10-104 Formula 10-105 Formula 10-106

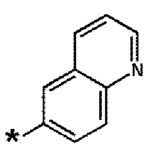 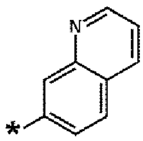 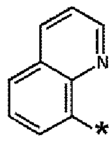 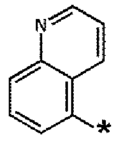 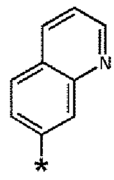 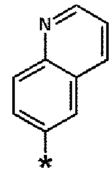

Formula 10-107 Formula 10-108 Formula 10-109 Formula 10-110 Formula 10-111 Formula 10-112

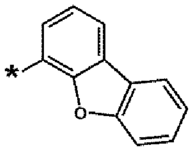 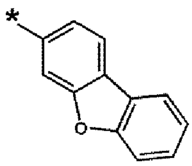 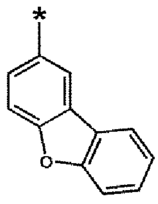 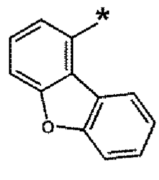 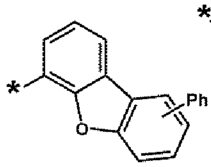 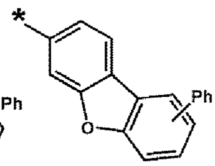

Formula 10-113 Formula 10-114 Formula 10-115 Formula 10-116 Formula 10-117 Formula 10-118

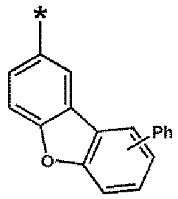 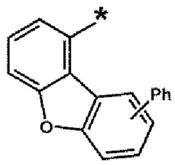 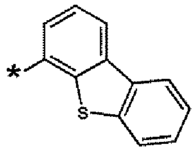 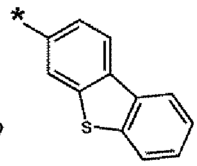 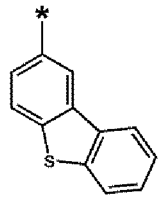 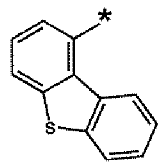

Formula 10-119 Formula 10-120 Formula 10-121 Formula 10-122 Formula 10-123 Formula 10-124

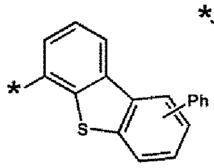 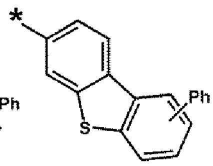 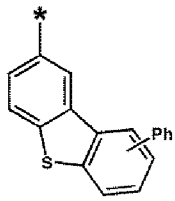 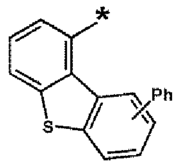 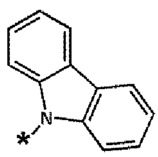 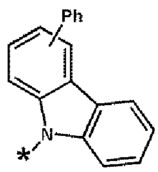

Formula 10-125 Formula 10-126 Formula 10-127 Formula 10-128 Formula 10-129 Formula 10-130

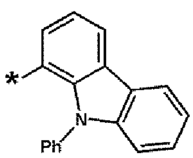 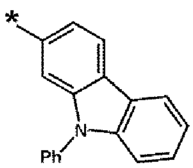 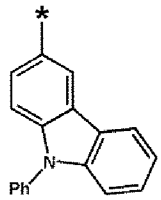 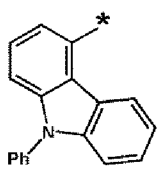 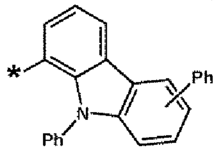 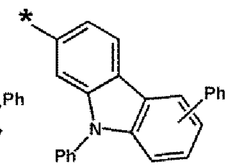

Formula 10-131 Formula 10-132 Formula 10-133 Formula 10-134 Formula 10-135 Formula 10-136

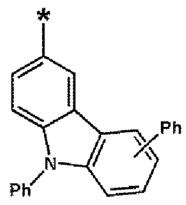
Formula 10-137

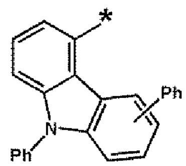
Formula 10-138

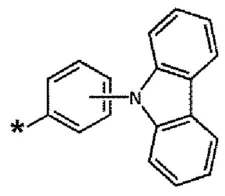
Formula 10-139

.

In Formulae 9-1 to 9-19 and 10-1 to 10-139, "Ph" indicates a phenyl group, "TMS" indicates a trimethylsilyl group, and * indicates a binding site to a neighboring atom.

a1, a3, and a4 in Formula 1 respectively indicate the number of groups $R_1$, the number of groups $R_3$, and the number of groups $R_4$, and may each independently be 0, 1, 2, 3, 4, or 5. When a1 is two or more, two or more groups $R_1$ may be identical to or different from each other, when a3 is two or more, two or more groups $R_3$ may be identical to or different from each other, and when a4 is two or more, two or more groups $R_4$ may be identical to or different from each other, but embodiments of the present disclosure are not limited thereto.

In Formula 1, two of groups $R_1$ in the number of a1 may optionally be linked to form a substituted or unsubstituted $C_5$-$C_{30}$ carbocyclic group or a substituted or unsubstituted $C_1$-$C_{30}$ heterocyclic group, two of groups $R_3$ in the number of a3 may optionally be linked to form a substituted or unsubstituted $C_5$-$C_{30}$ carbocyclic group or a substituted or unsubstituted $C_1$-$C_{30}$ heterocyclic group, two of groups $R_4$ in the number of a4 may optionally be linked to form a substituted or unsubstituted $C_5$-$C_{30}$ carbocyclic group or a substituted or unsubstituted $C_1$-$C_{30}$ heterocyclic group, two of $R_{11}$ to $R_{17}$ may optionally be linked to form a substituted or unsubstituted $C_5$-$C_{30}$ carbocyclic group or a substituted or unsubstituted $C_1$-$C_{30}$ heterocyclic group, two of $R_{21}$ to $R_{26}$ may optionally be linked to form a substituted or unsubstituted $C_5$-$C_{30}$ carbocyclic group or a substituted or unsubstituted $C_1$-$C_{30}$ heterocyclic group, two of $R_{31}$ to $R_{36}$ may optionally be linked to form a substituted or unsubstituted $C_5$-$C_{30}$ carbocyclic group or a substituted or unsubstituted $C_1$-$C_{30}$ heterocyclic group, and two of $R_{41}$ to $R_{47}$ may optionally be linked to form a substituted or unsubstituted $C_5$-$C_{30}$ carbocyclic group or a substituted or unsubstituted $C_1$-$C_{30}$ heterocyclic group.

For example, i) a substituted or unsubstituted $C_5$-$C_{30}$ carbocyclic group or a substituted or unsubstituted $C_1$-$C_{30}$ heterocyclic group, formed by linking two of groups $R_1$ in the number of a1, ii) a substituted or unsubstituted $C_5$-$C_{30}$ carbocyclic group or a substituted or unsubstituted $C_1$-$C_{30}$ heterocyclic group, formed by linking two of groups $R_3$ in the number of a3, iii) a substituted or unsubstituted $C_5$-$C_{30}$ carbocyclic group or a substituted or unsubstituted $C_1$-$C_{30}$ heterocyclic group, two of groups $R_4$ in the number of a4, iv) a substituted or unsubstituted $C_5$-$C_{30}$ carbocyclic group or a substituted or unsubstituted $C_1$-$C_{30}$ heterocyclic group, formed by linking two of $R_{11}$ to $R_{17}$, v) a substituted or unsubstituted $C_5$-$C_{30}$ carbocyclic group or a substituted or unsubstituted $C_1$-$C_{30}$ heterocyclic group, formed by linking two of $R_{21}$ to $R_{26}$, vi) a substituted or unsubstituted $C_5$-$C_{30}$carbocyclic group or a substituted or unsubstituted $C_1$-$C_{30}$ heterocyclic group, formed by linking two of $R_{31}$ to $R_{36}$, and v) a substituted or unsubstituted $C_5$-$C_{30}$ carbocyclic group or a substituted or unsubstituted $C_1$-$C_{30}$ heterocyclic group, formed by linking two of $R_{41}$ to $R_{47}$, in Formula 1, may each independently be selected from:

a pentadiene group, a cyclohexane group, a cycloheptane group, an adamantane group, a bicycle-heptane group, a bicyclo-octane group, a benzene group, a pyridine group, a pyrimidine group, a pyrazine group, a pyridazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group; and

a pentadiene group, a cyclohexane group, a cycloheptane group, an adamantane group, a bicycle-heptane group, a bicyclo-octane group, a benzene group, a pyridine group, a pyrimidine group, a pyrazine group, a pyridazine group, a naphthalene group, an anthracene group, a tetracene group, a phenanthrene group, a dihydronaphthalene group, a phenalene group, a benzothiophene group, a benzofuran group, an indene group, an indole group, a benzosilole group, an azabenzothiophene group, an azabenzofuran group, an azaindene group, an azaindole group, and an azabenzosilole group, each substituted with at least one $R_{100}$,

but embodiments of the present disclosure are not limited thereto. $R_{100}$ is the same as described in connection with $R_1$.

In an embodiment, a moiety represented by

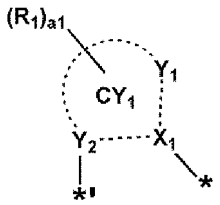

in Formula 1 may be selected from groups represented by Formulae CY1-1 to CY1-39 and CZ1-1 to CZ1-8:

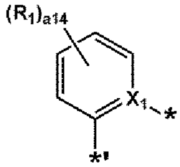
Formula CY1-1

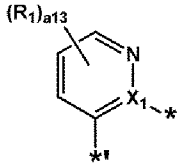
Formula CY1-2

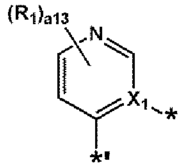
Formula CY1-3

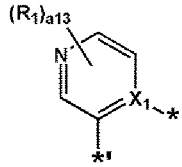
Formula CY1-4

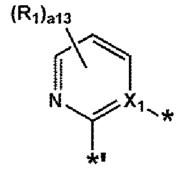
Formula CY1-5

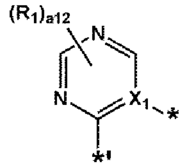
Formula CY1-6

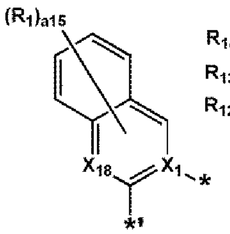
Formula CY1-7

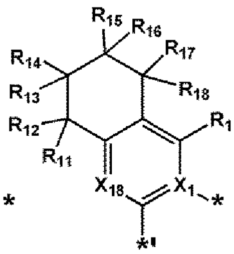
Formula CY1-8

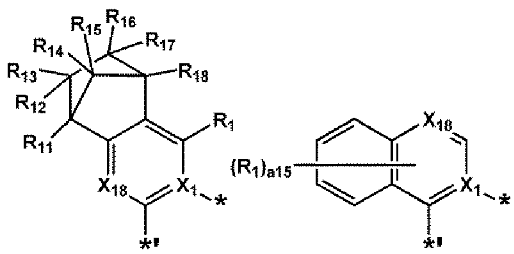
Formula CY1-9

Formula CY1-10

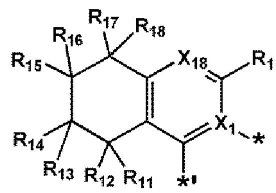
Formula CY1-11

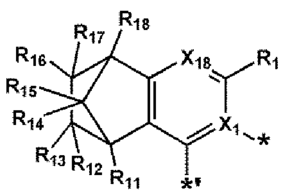
Formula CY1-12

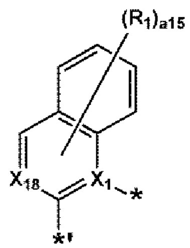
Formula CY1-13

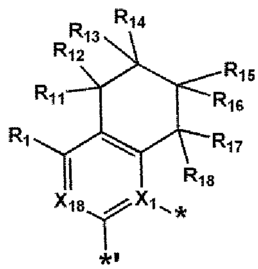
Formula CY1-14

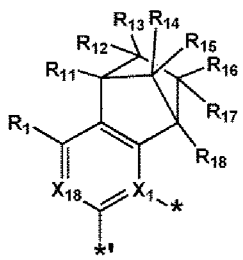
Formula CY1-15

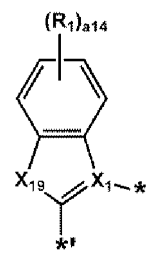
Formula CY1-16

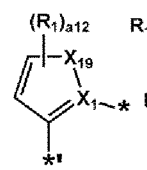
Formula CY1-17

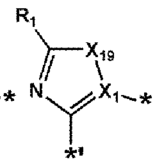
Formula CY1-18

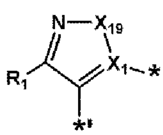
Formula CY1-19

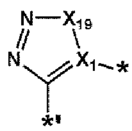
Formula CY1-20

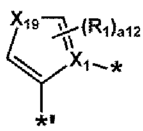
Formula CY1-21

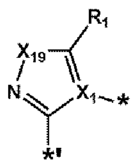
Formula CY1-22

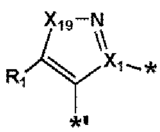
Formula CY1-23

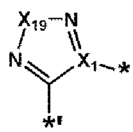
Formula CY1-24

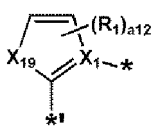
Formula CY1-25

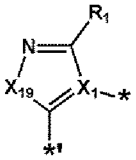
Formula CY1-26

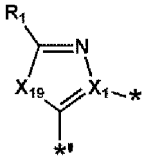
Formula CY1-27

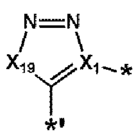
Formula CY1-28

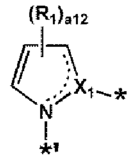
Formula CY1-29

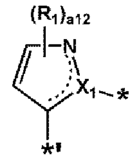
FormulaCY1-30

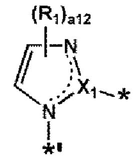
Formula CY1-31

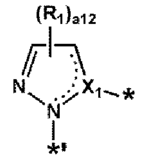
Formula CY1-32

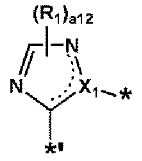
Formula CY1-33

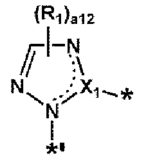
Formula CY1-34

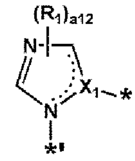
Formula CY1-35

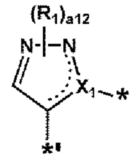
Formula CY1-36

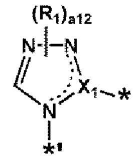
Formula CY1-37

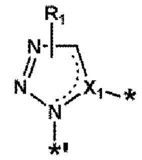
Formula CY1-38

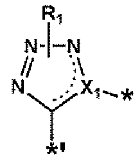
Formula CY1-39

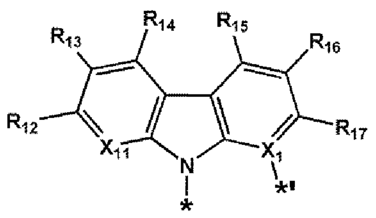
Formula CZ1-1

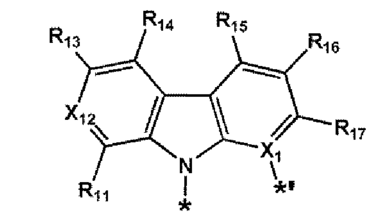
Formula CZ1-2

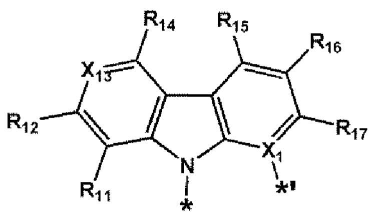
Formula CZ1-3

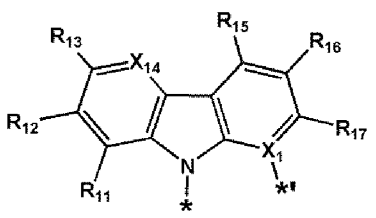
Formula CZ1-4

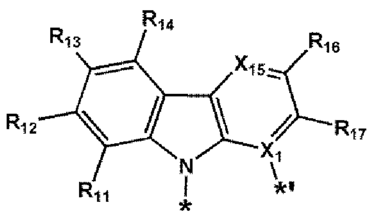
Formula CZ1-5

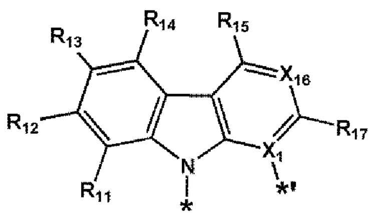
Formula CZ1-6

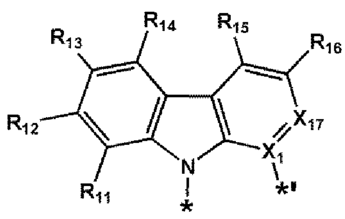
Formula CZ1-7

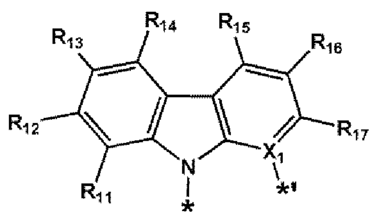
Formula CZ1-8

.

In Formulae CY1-1 to CY1-39 and CZ1-1 to CZ1-8,

$X_1$ and $R_1$ are each independently the same as described herein, $X_{18}$ may be N or $C(R_{18})$,
$X_{19}$ may be O, S, $N[(L_{19})_{b19}-(R_{19})]$, or $C(R_{19a})(R_{19b})$,
$R_{11}$ to $R_{18}$ are each independently the same as described in connection with $R_1$,
$L_{19}$ and b19 are each independently the same as described in connection with $L_5$ and b5,
$R_{19}$, $R_{19a}$, and $R_{19b}$ are each independently the same as described in connection with $R_5$,
$X_{11}$ to $X_{17}$ may each independently be N or C(CN),
a15 may be an integer from 0 to 5,
a14 may be an integer from 0 to 4,
a13 may be an integer from 0 to 3,
a12 may be an integer from 0 to 2, and
* and *' each indicate a binding site to a neighboring atom.

In one or more embodiments, a moiety represented by

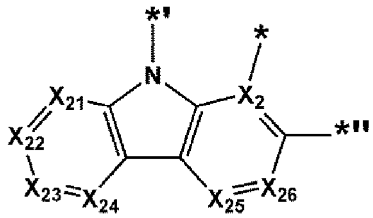

in Formula 1 may be selected from groups represented by Formulae CZ2-1 to CZ2-7:

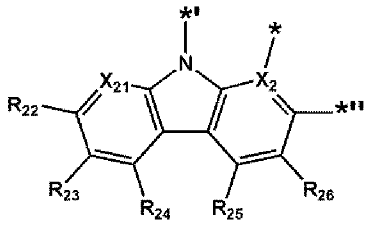

Formula CZ2-1

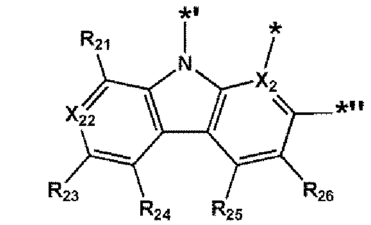

Formula CZ2-2

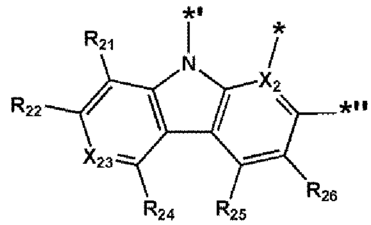

Formula CZ2-3

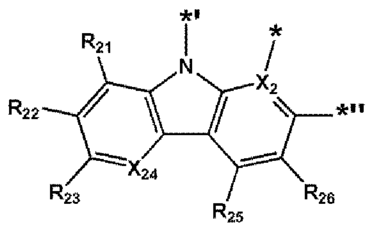

Formula CZ2-4

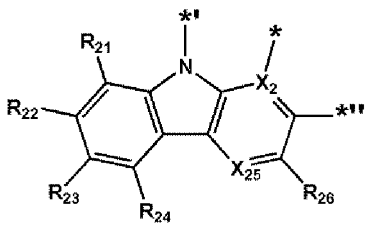

Formula CY2-5

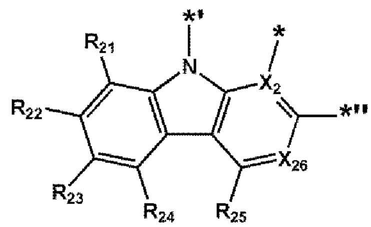

Formula CZ2-6

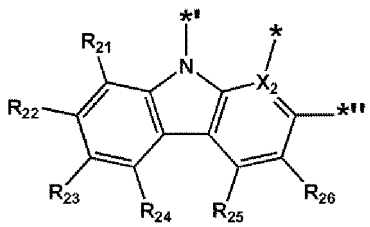

Formula CZ2-7

.

In Formulae CZ2-1 to CZ2-7,

$X_2$ and $R_{21}$ to $R_{26}$ are each independently the same as described herein,
$X_{21}$ to $X_{26}$ may each independently be N or C(CN), and
*, *', and *" each indicate a binding site to a neighboring atom.

In one or more embodiments, a moiety represented by

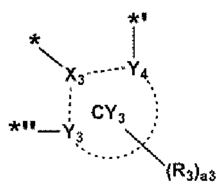

in Formula 1 may be selected from groups represented by Formulae CY3-1 to CY3-27 and CZ3-1 to CZ3-7:

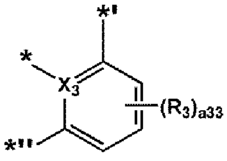
Formula CY3-1

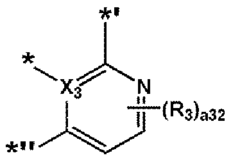
Formula CY3-2

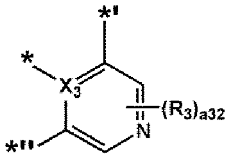
Formula CY3-3

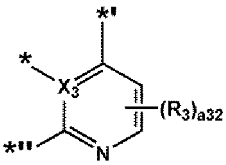
Formula CY3-4

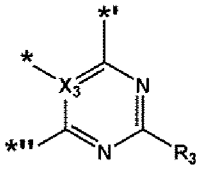
Formula CY3-5

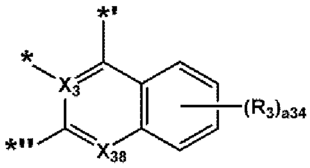
Formula CY3-6

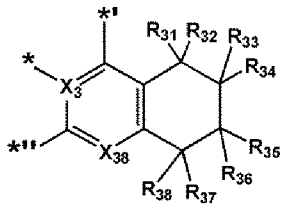
Formula CY3-7

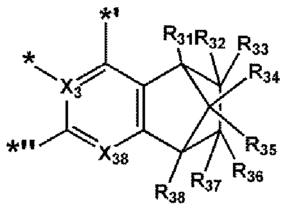
Formula CY3-8

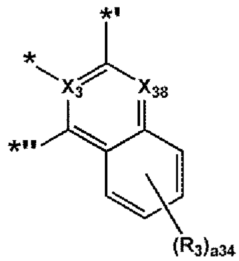
Formula CY3-9

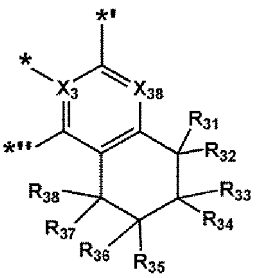
Formula CY3-10

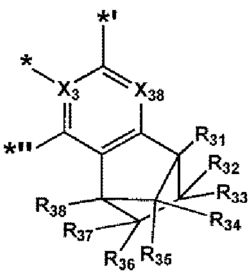
Formula CY3-11

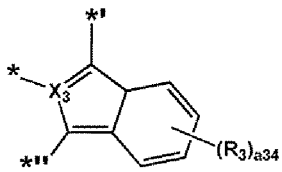
Formula CY3-12

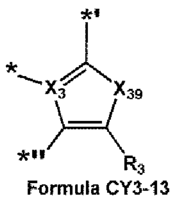
Formula CY3-13

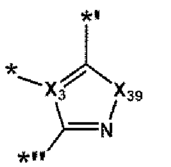
Formula CY3-14

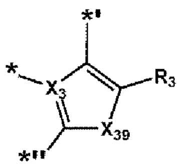
Formula CY3-15

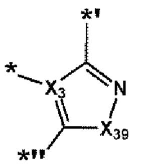
Formula CY3-16

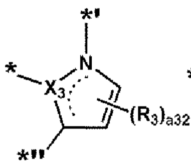
Formula CY3-17

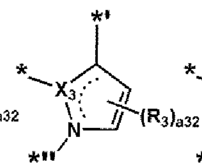
Formula CY3-18

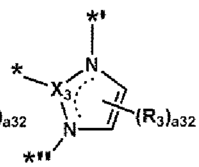
Formula CY3-19

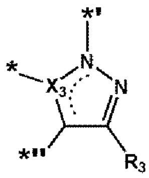
Formula CY3-20

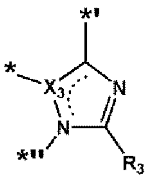
Formula CY3-21

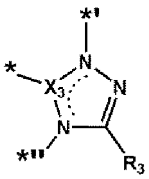
Formula CY3-22

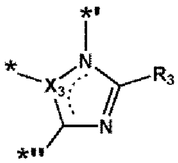
Formula CY3-23

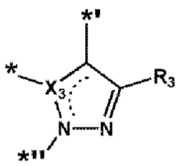
Formula CY3-24

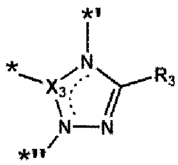
Formula CY3-25

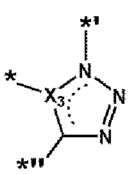
Formula CY3-26

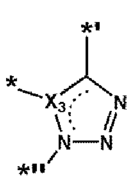
Formula CY3-27

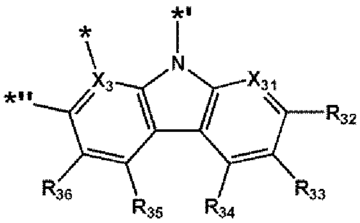
Formula CZ3-1

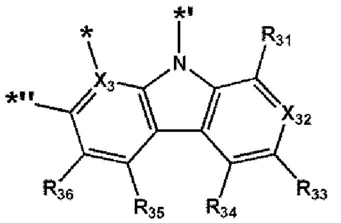
Formula CZ3-2

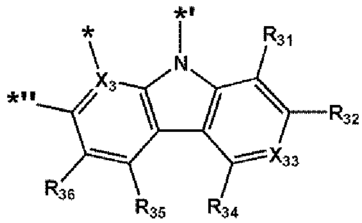
Formula CZ3-3

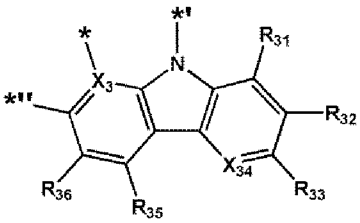
Formula CZ3-4

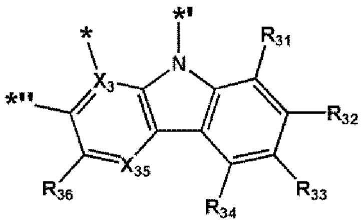
Formula CZ3-5

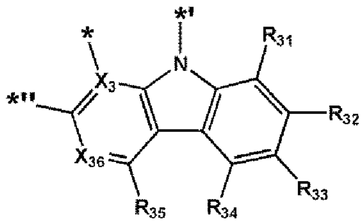
Formula CZ3-6

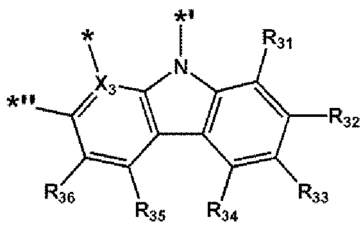
Formula CZ3-7

In Formulae CY3-1 to CY3-27 and CZ3-1 to CZ3-7,

$X_3$ and $R_3$ are each independently the same as described herein,
$X_{38}$ may be N or $C(R_{38})$,
$X_{39}$ may be O, S, $N[(L_{39})_{b39}-(R_{39})]$, or $C(R_{39a})(R_{39b})$,
$R_{31}$ to $R_{38}$ are each independently the same as described in connection with $R_1$,
$L_{39}$ and b39 are each independently the same as described in connection with $L_5$ and b5,
$R_{39}$, $R_{39a}$, and $R_{39b}$ are each independently the same as described in connection with $R_5$,
$X_{31}$ to $X_{36}$ may each be N or C(CN),
a34 may be an integer from 0 to 4,
a33 may be an integer from 0 to 3,
a32 may be an integer from 0 to 2, and
*, *', and *" each indicate a binding site to a neighboring atom.

In one or more embodiments, a moiety represented by

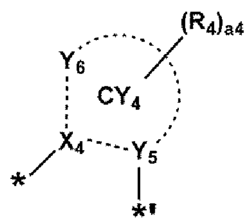

in Formula 1 may be selected from groups represented by Formulae CY4-1 to CY3-39 and CZ4-1 to CZ4-8:

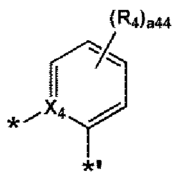
Formula CY4-1
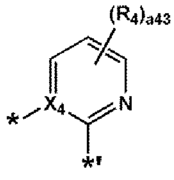
Formula CY4-2
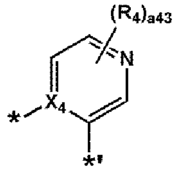
Formula CY4-3
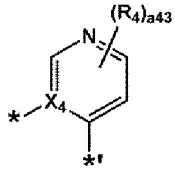
Formula CY4-4
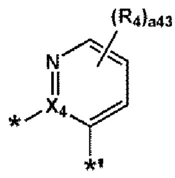
Formula CY4-5
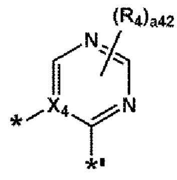
Formula CY4-6

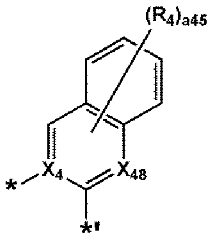
Formula CY4-7
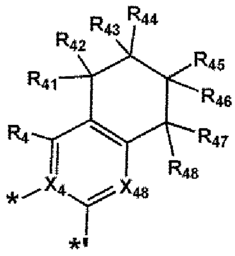
Formula CY4-8
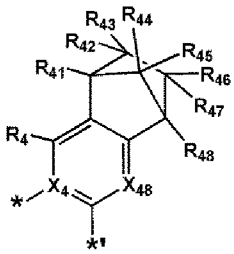
Formula CY4-9
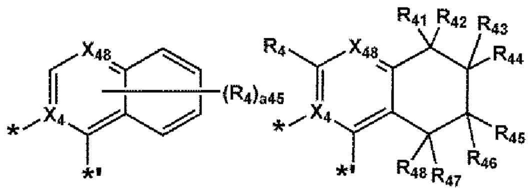
Formula CY4-10
Formula CY4-11

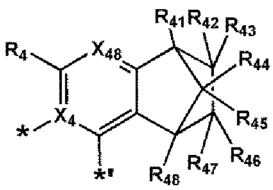
Formula CY4-12
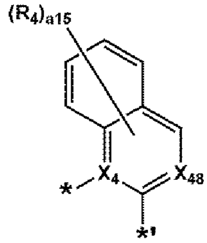
Formula CY4-13
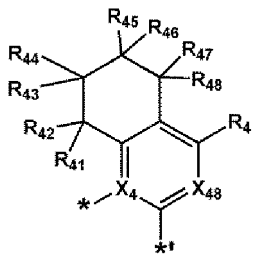
FormulaCY4-14
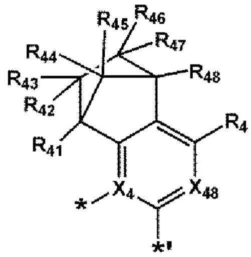
Formula CY4-15
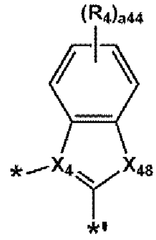
Formula CY4-16

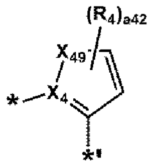
Formula CY4-17
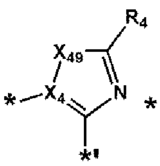
Formula CY4-18
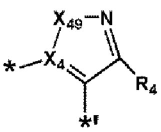
Formula CY4-19
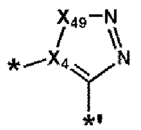
Formula CY4-20
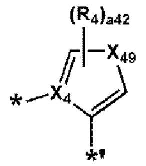
Formula CY4-21
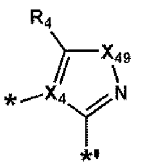
Formula CY4-22
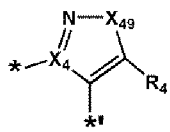
Formula CY4-23
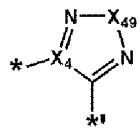
Formula CY4-24

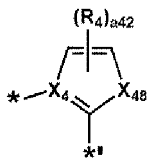
Formula CY4-25
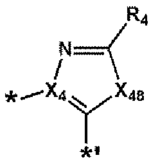
Formula CY4-26
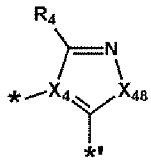
Formula CY4-27
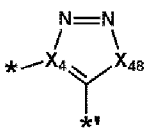
Formula CY4-28
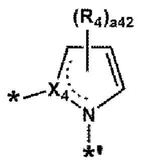
Formula CY4-29
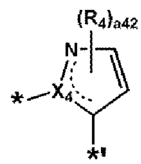
Formula CY4-30
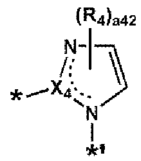
Formula CY4-31

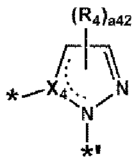
Formula CY4-32
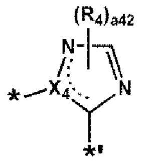
Formula CY4-33
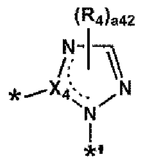
Formula CY4-34
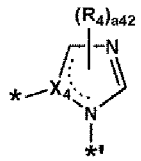
Formula CY4-35
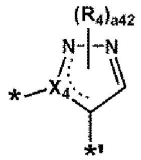
Formula CY4-36
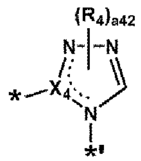
Formula CY4-37

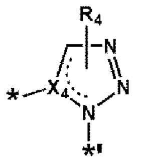

Formula CY4-38

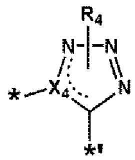

Formula CY4-39

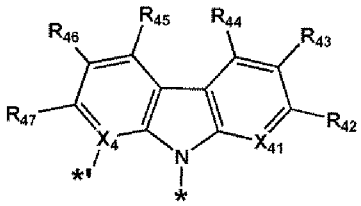

Formula CZ4-1

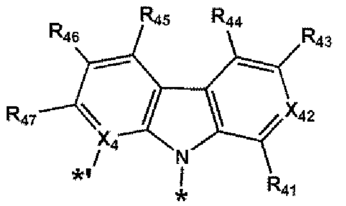

Formula CZ4-2

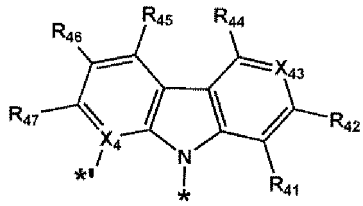

Formula CZ4-3

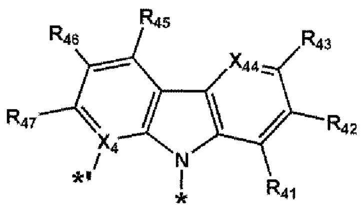

Formula CZ4-4

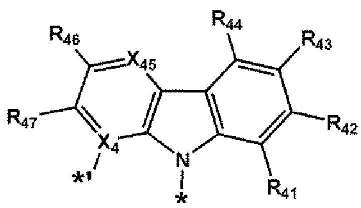

Formula CZ4-5

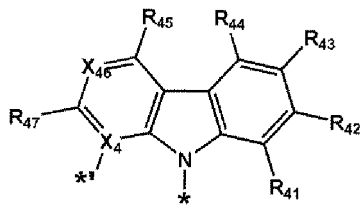

Formula CZ4-6

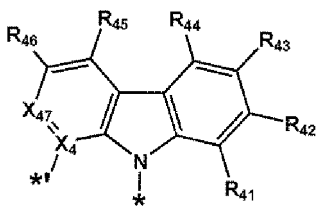

Formula CZ4-7

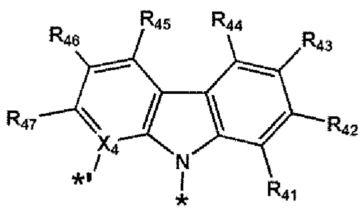

Formula CZ4-8

.

In Formulae CY4-1 to CY4-39 and CZ4-1 to CZ4-8,

$X_4$ and $R_4$ are each independently the same as described herein,
$X_{48}$ may be N or $C(R_{48})$,
$X_{49}$ may be O, S, $N[(L_{49})_{b49}-(R_{49})]$, or $C(R_{49a})(R_{49b})$,
$R_{41}$ to $R_{48}$ are each independently the same as described in connection with $R_1$,
$L_{49}$ and b49 are each independently the same as described in connection with $L_5$ and b5,
$R_{49}$, $R_{49a}$, and $R_{49b}$ are each independently the same as described in connection with $R_5$,
$X_{41}$ to $X_{47}$ may each be N or C(CN),
a45 may be an integer from 0 to 5,
a44 may be an integer from 0 to 4,
a43 may be an integer from 0 to 3,
a42 may be an integer from 0 to 2, and
* and *' each indicate a binding site to a neighboring atom.

In one or more embodiments, a moiety represented by

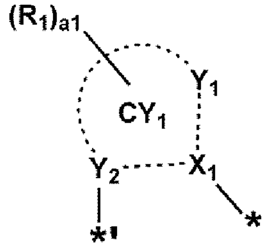

in Formula 1 may be selected from groups represented by Formulae CY1(1) to CY1(8) and CZ1-1 to CZ1-8, and/or a moiety represented by

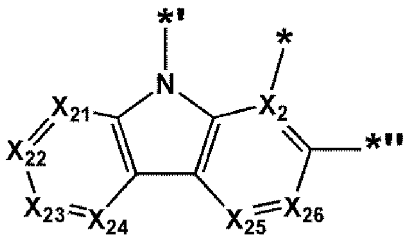

in Formula 1 may be selected from groups represented by Formulae CZ2-1 to CZ2-7, and/or a moiety represented by

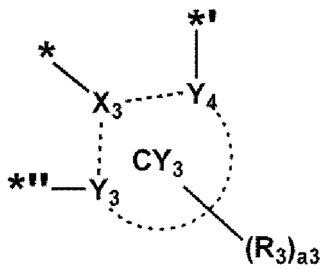

in Formula 1 may be selected from groups represented by Formulae CY3(1) to CY3(6) and CZ3-1 to CZ3-7, and/or a moiety represented by

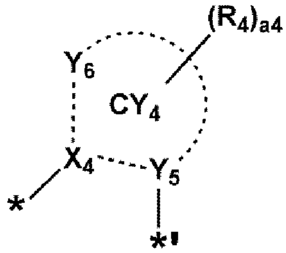

in Formula 1 may be selected from groups represented by Formulae CY4(1) to CY4(8) and CZ4-1 to CZ4-8:

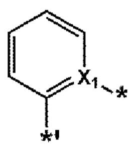
Formula CY1(1)

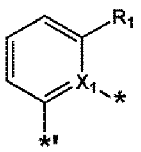
Formula CY1(2)

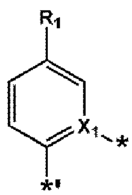
Formula CY1(3)

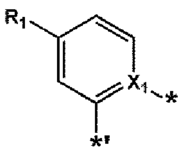
Formula CY1(4)

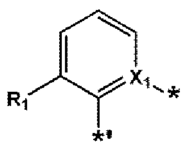
Formula CY1(5)

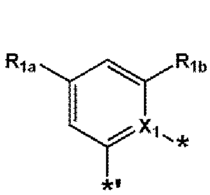
Formula CY1(6)

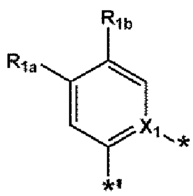
Formula CY1(7)

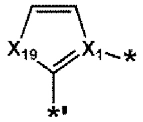
Formula CY1(8)

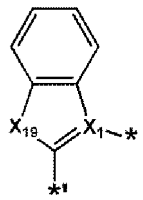
Formula CY(9)

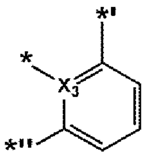
Formula CY3(1)

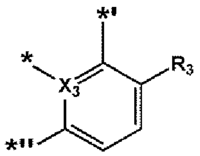
Formula CY3(2)

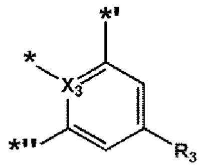
Formula CY3(3)

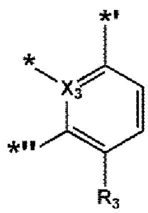
Formula CY3(4)

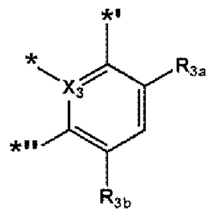
Formula CY3(5)

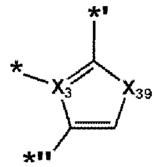
Formula CY3(6)

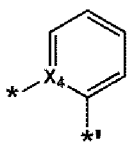
Formula CY4(1)

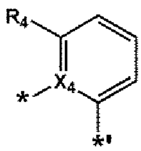
Formula CY4(2)

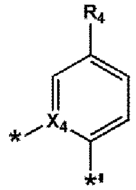
Formula CY4(3)

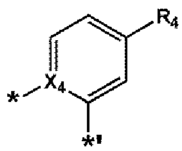
Formula CY4(4)

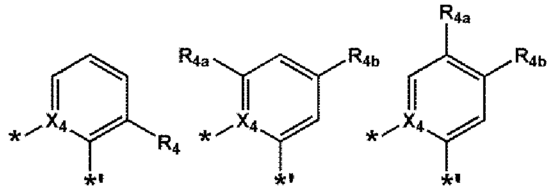
Formula CY4(5) Formula CY4(6) Formula CY4(7)

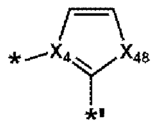
Formula CY4(8)

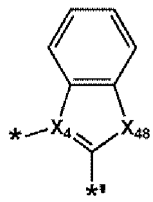
Formula CY4(9)

.

In Formulae CY1 (1) to CY4(9), CY3(1) to CY3(6), and CY4(1) to CY4(9),

$X_1$, $R_1$, $X_2$, $R_2$, $X_3$, $R_3$, $X_4$, $R_4$, $X_{19}$, $X_{39}$, and $X_{49}$ are each independently the same as described herein,
$R_{1a}$ and $R_{1b}$ are each independently the same as described in connection with $R_1$,
$R_{3a}$ and $R_{3b}$ are each independently the same as described in connection with $R_3$,
$R_{4a}$ and $R_{4b}$ are each independently the same as described in connection with $R_4$,
$R_1$, $R_{1a}$, $R_{1b}$, $R_3$, $R_{3a}$, $R_{3b}$, $R_4$, $R_{4a}$, and $R_{4b}$ may not be hydrogen, and
*, *', and *" each indicate a binding site to a neighboring atom.

In one or more embodiments, the organometallic compound represented by Formula 1 may satisfy at least one of Condition 1-1 to Condition 4-1:

Condition 1-1 a moiety represented by

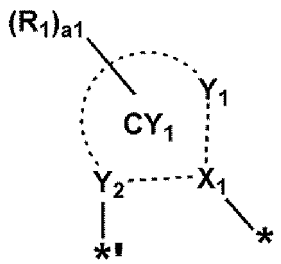

in Formula 1 is selected from groups represented by Formulae CZ1-1 to CZ1-7,
Condition 2-1 a moiety represented by

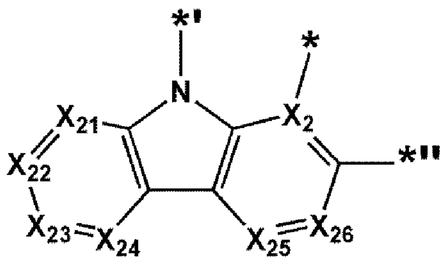

in Formula 1 is selected from groups represented by Formulae CZ2-1 to CZ2-6,
Condition 3-1 a moiety represented by

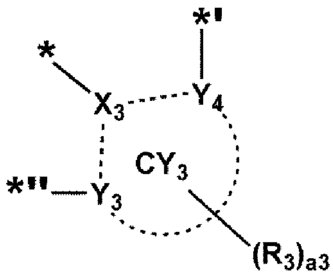

in Formula 1 is selected from groups represented by Formulae CZ3-1 to CZ3-6, and
Condition 4-1 a moiety represented

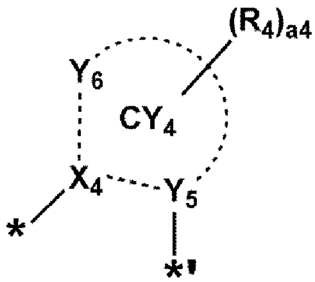

in by Formula 1 is selected from groups represented by Formulae CZ4-1 to CZ4-7.

For example, the organometallic compound represented by Formula 1 may be selected from Compounds 1 to 136, but embodiments of the present disclosure are not limited thereto:

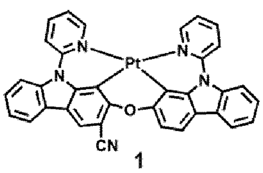
1

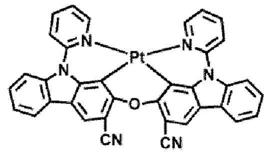
2

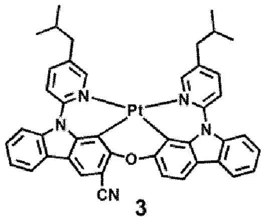
3

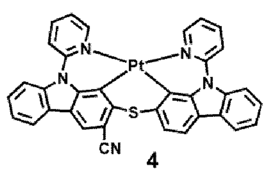
4

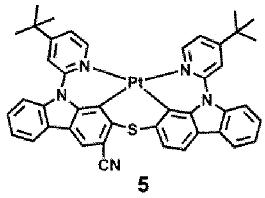
5

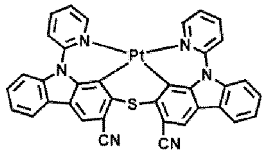
6

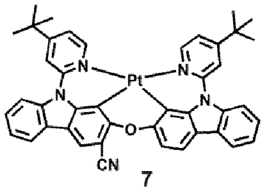
7

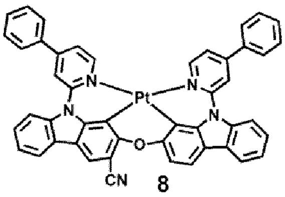
8

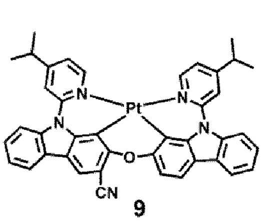
9

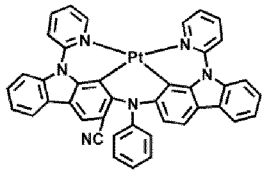
10

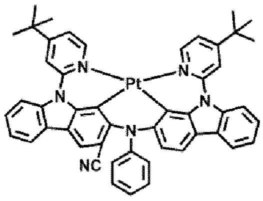
11

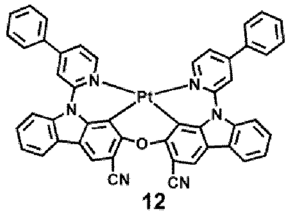
12

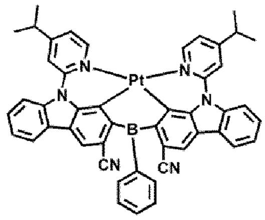
13

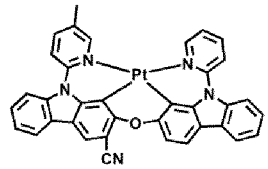
14

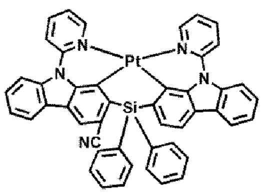
15

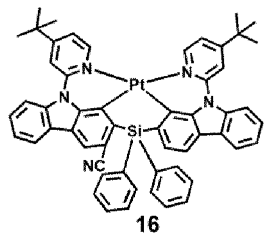
16

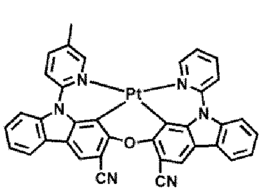
17

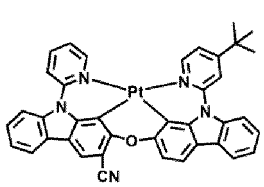
18

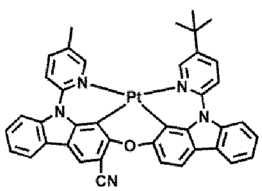
19

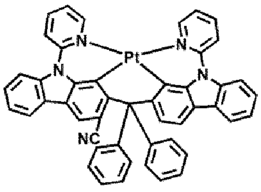
20

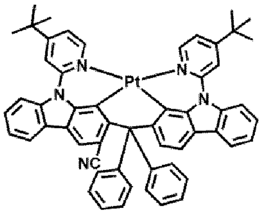
21

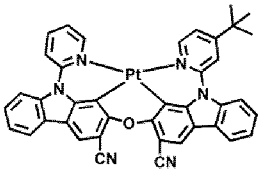
22

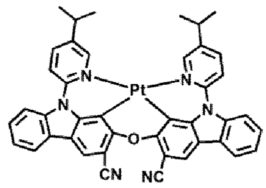
23

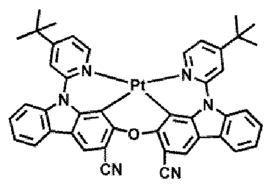
24

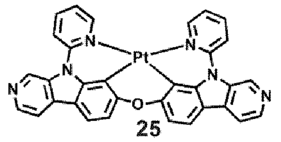
25

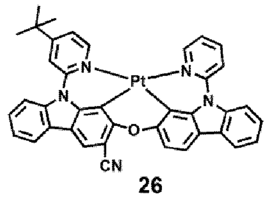
26

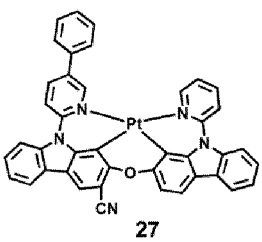
27

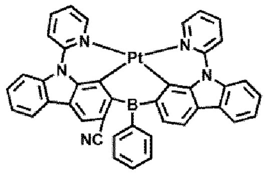
28

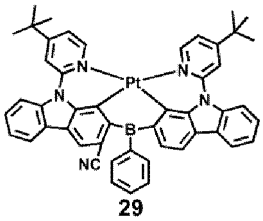
29

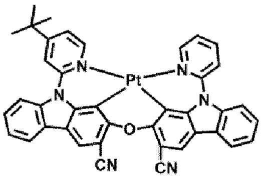
30

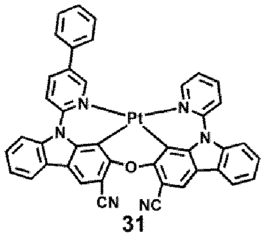
31

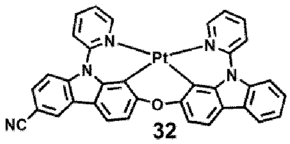
32

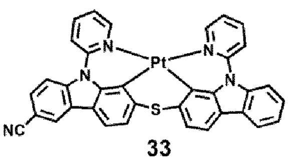
33

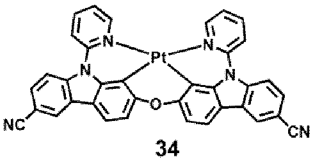
34

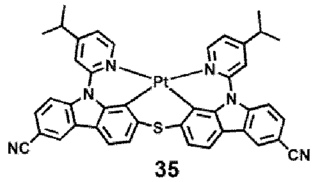
35

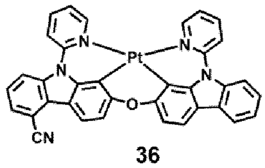
36

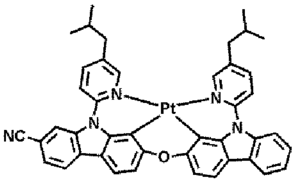
37

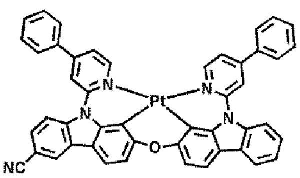
38

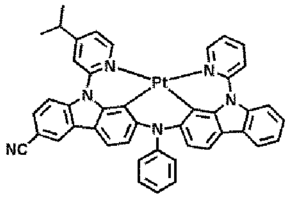
39

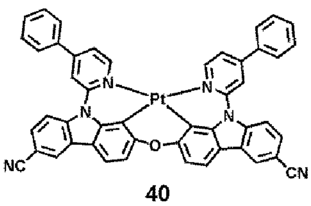
40

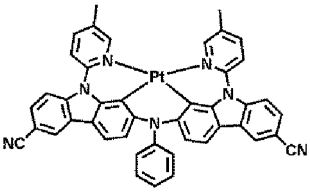
41

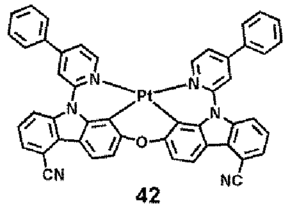
42

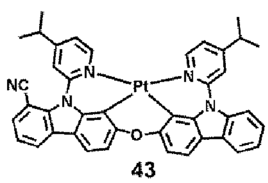
43

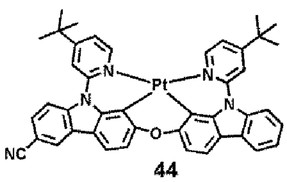
44

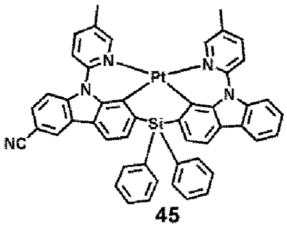
45

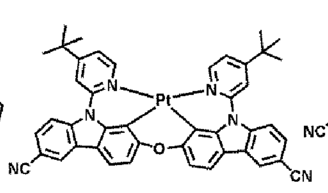
46

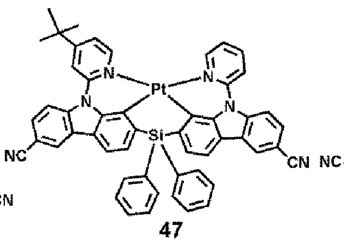
47

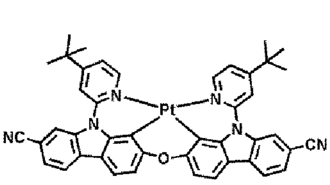
48

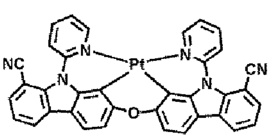
49

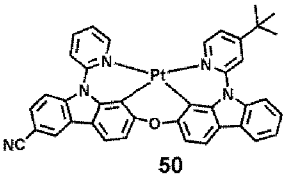
50

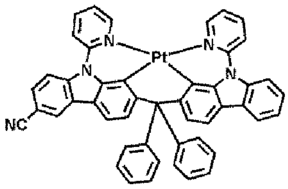
51

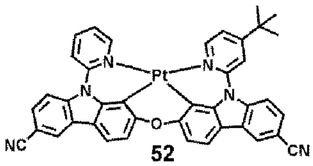
52

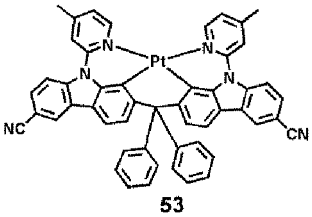
53

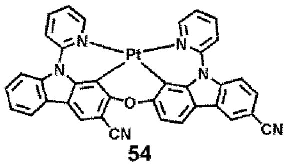
54

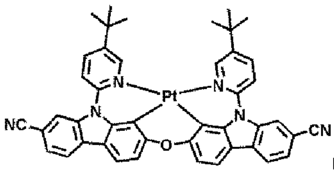
55

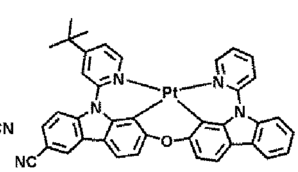
56

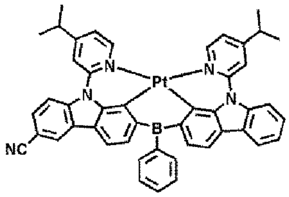
57

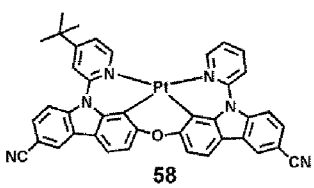
58

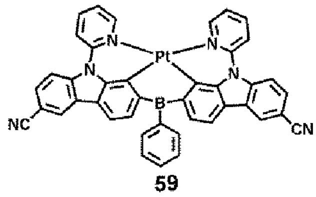
59

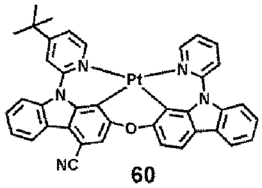
60

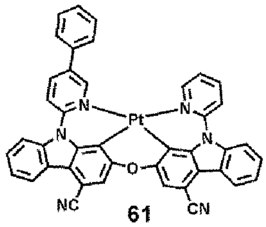
61

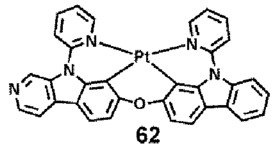
62

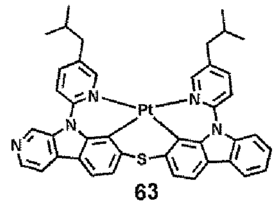
63

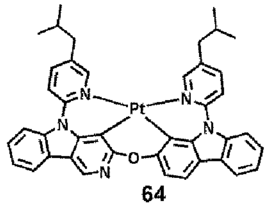
64

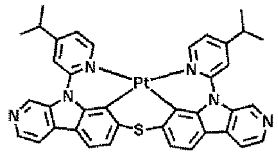
65

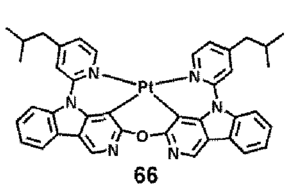
66

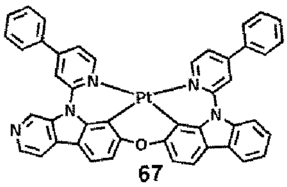
67

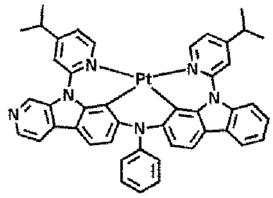
68

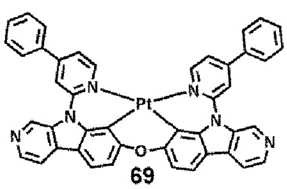
69

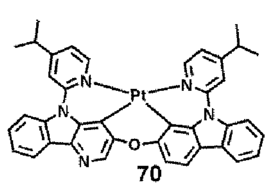
70

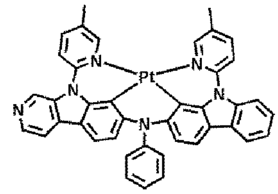
71

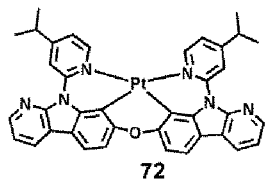
72

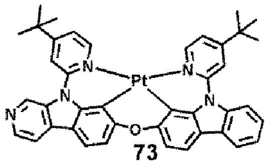
73

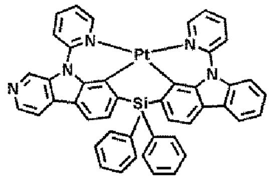
74

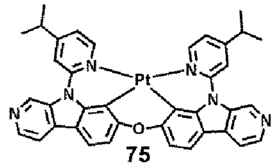
75

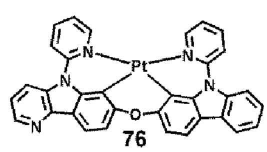
76

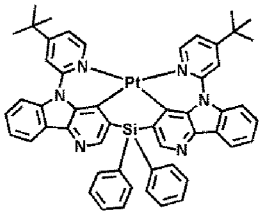
77

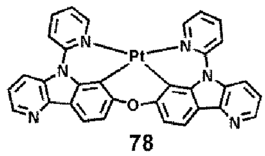
78

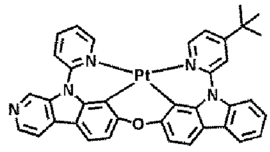
79

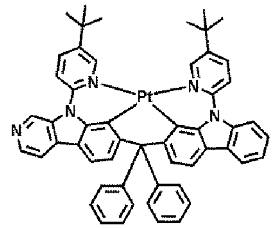
80

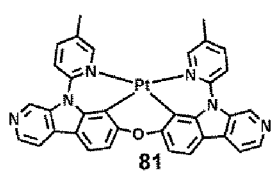
81

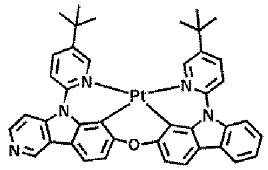
82

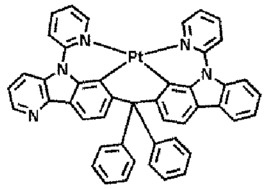
83

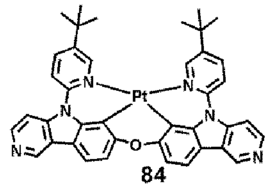
84

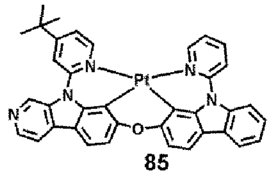
85

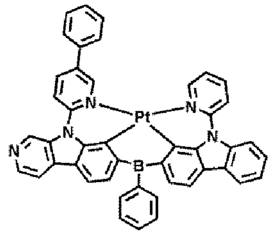
86

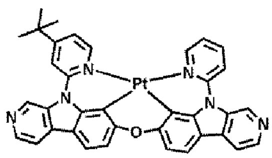
87

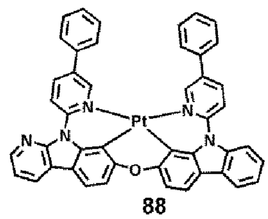
88

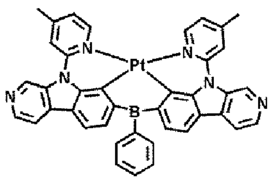
89

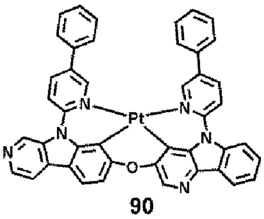
90

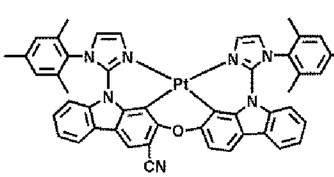
91

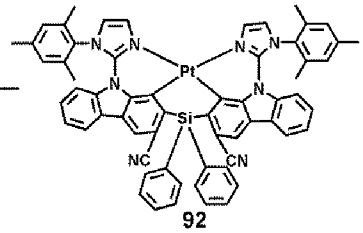
92

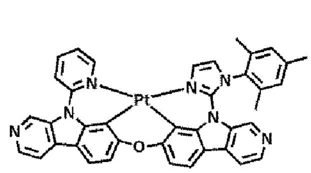
93

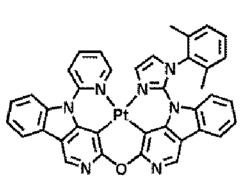
94

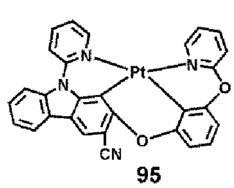
95

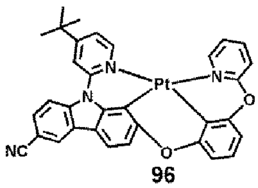
96

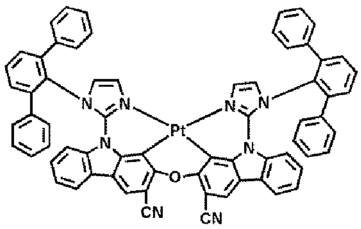
97
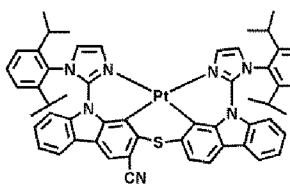
98
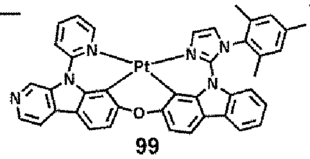
99
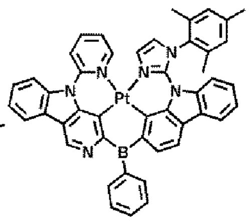
100

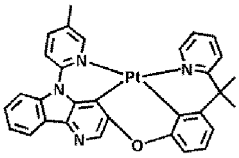
101
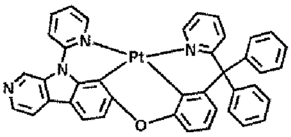
102
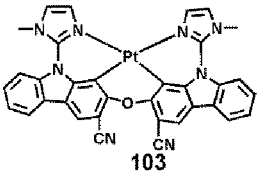
103
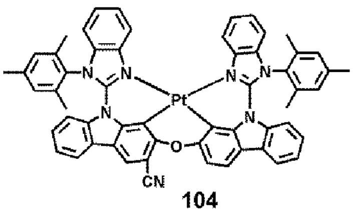
104

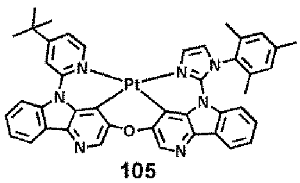
105
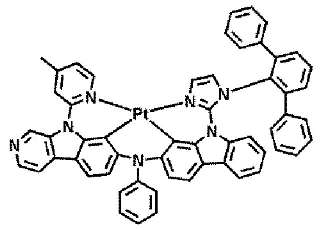
106
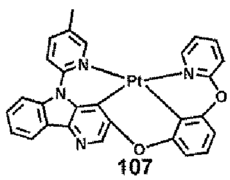
107
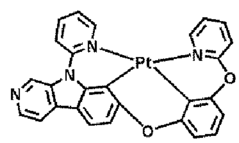
108

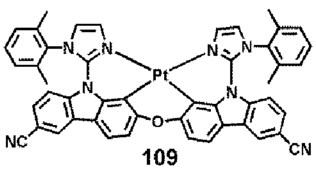
109
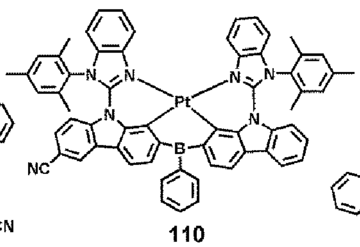
110
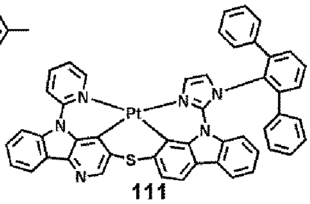
111
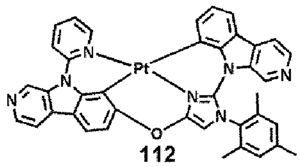
112

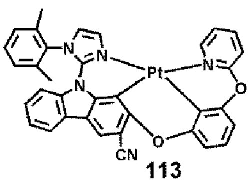
113
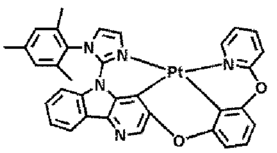
114
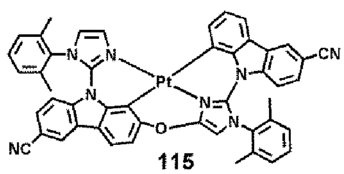
115
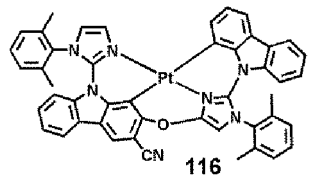
116

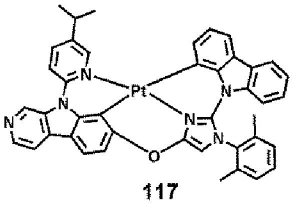
117
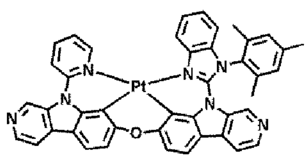
118
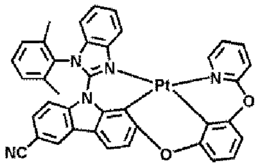
119
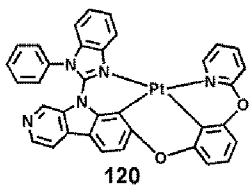
120

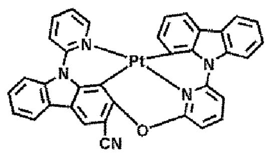
121
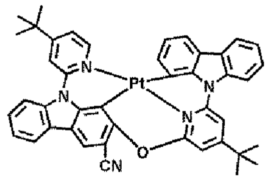
122
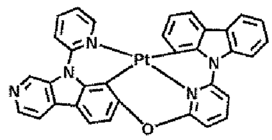
123
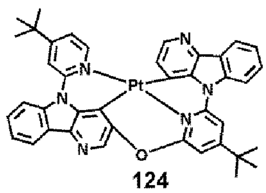
124
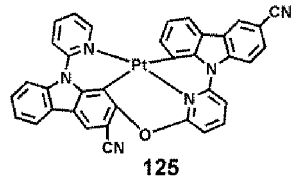
125
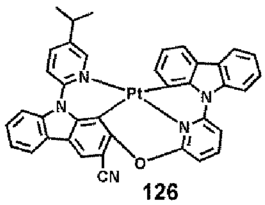
126
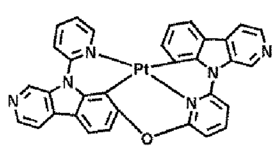
127
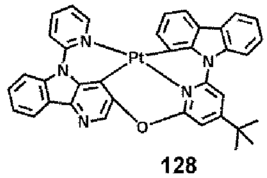
128
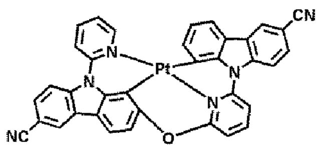
129
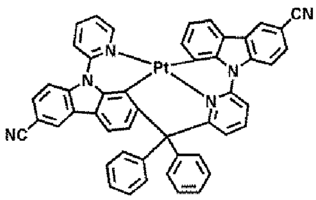
130
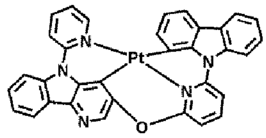
131
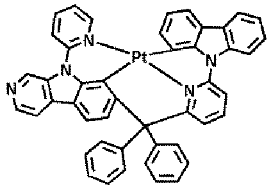
132
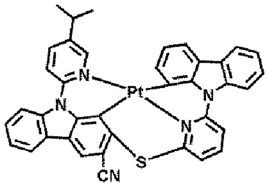
133
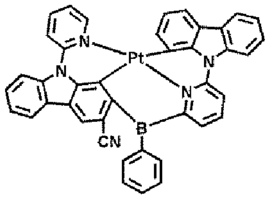
134
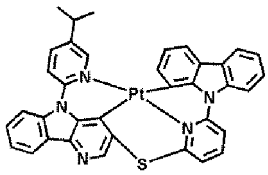
135
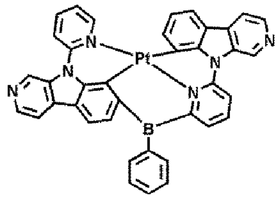
136

.

The organometallic compound represented by Formula 1 has the same backbone as Formula 1 and satisfies at least one of Condition 1 to Condition 4 at the same time:

Condition 1
$CY_1$ in Formula 1 is a group represented by Formula CZ1, provided that at least one of $X_{11}$ to $X_{17}$ in Formula CZ1 is each independently N or C(CN),
Condition 2
at least one of $X_{21}$ to $X_{26}$ in Formula 1 is each independently N or C(CN),
Condition 3
$CY_3$ in Formula 1 is a group represented by Formula CZ3, provided that at least one of $X_{31}$ to $X_{36}$ in Formula CZ3 is each independently N or C(CN), and
Condition 4
$CY_4$ in Formula 1 is a group represented by Formula CZ4, provided that at least one of $X_{41}$ to $X_{47}$ in Formula CZ4 is each independently N or C(CN).

Accordingly, the highest occupied molecular orbital (HOMO) and the lowest unoccupied molecular orbital (LUMO) energy levels of the organometallic compound represented by Formula 1 are adjustable, and in particular, the organometallic compound may have relatively low HOMO and LUMO energy levels (that is, large absolute values of HOMO and LUMO energy levels) and high triplet energy. Thus, an electronic device, for example, an organic light-emitting device, which includes the organometallic compound represented by Formula 1, may have improved efficiency and lifespan.

For example, a HOMO energy level, a LUMO energy level, and a triplet ($T_1$) energy level of Compounds 1, 2, 7, 17, 24, 25, and A were evaluated by using a density functional theory (DFT) method of a Gaussian program (B3LYP,

structurally optimized at a level of 6-31 G(d,p)). Evaluation results thereof are shown in Table 1.

Table 1

| Compound No. | HOMO energy level (eV) | LUMO energy level (eV) | $T_1$ energy level (eV) |
|---|---|---|---|
| 1 | -4.96 | -1.89 | 2.68 |
| 2 | -5.27 | -1.70 | 2.79 |
| 7 | -4.85 | -1.52 | 2.78 |
| 17 | -5.00 | -1.67 | 2.75 |
| 24 | -5.15 | -1.69 | 2.88 |
| 25 | -5.04 | -1.65 | 2.72 |
| A | -4.64 | -1.44 | 2.58 |

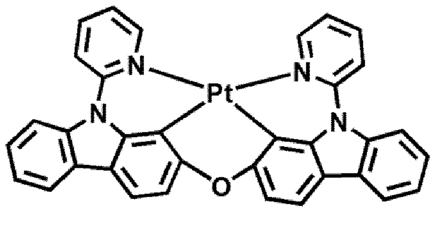

A

From Table 1, it has been determined that the organometallic compound represented by Formula 1 has such electrical characteristics that are suitable for use in an electronic device, for example, for use as a dopant for an organic light-emitting device.

Synthesis methods of the organometallic compound represented by Formula 1 may be recognizable by one of ordinary skill in the art by referring to Synthesis Examples provided below.

The organometallic compound represented by Formula 1 is suitable for use in an organic layer of an organic light-emitting device, for example, for use as a dopant in an emission layer of the organic layer. Thus, another aspect of the present description provides an organic light-emitting device that includes:

a first electrode;
a second electrode; and
an organic layer that is disposed between the first electrode and the second electrode, wherein the organic layer includes an emission layer and at least one organometallic compound represented by Formula 1.

The organic light-emitting device may have, due to the inclusion of an organic layer including the organometallic compound represented by Formula 1, a low driving voltage, high efficiency, high power, high quantum efficiency, a long lifespan, a low roll-off ratio, and excellent color purity.

The organometallic compound of Formula 1 may be used between a pair of electrodes of an organic light-emitting device. For example, the organometallic compound represented by Formula 1 may be included in the emission layer. In this embodiment, the organometallic compound may act as a dopant, and the emission layer may further include a host (that is, an amount of the organometallic compound represented by Formula 1 is smaller than an amount of the host).

The expression "(an organic layer) includes at least one of organometallic compounds" as used herein may include an embodiment in which "(an organic layer) includes identical organometallic compounds represented by Formula 1" and an embodiment in which "(an organic layer) includes two or more different organometallic compounds represented by Formula 1."

For example, the organic layer may include, as the organometallic compound, only Compound 1. In this embodiment, Compound 1 may be included in an emission layer of the organic light-emitting device. In one or more embodiments, the organic layer may include, as the organometallic compound, Compound 1 and Compound 2. In this embodiment, Compound 1 and Compound 2 may be included in an identical layer (for example, Compound 1 and Compound 2 may both be included in an emission layer).

The first electrode may be an anode, which is a hole injection electrode, and the second electrode may be a cathode, which is an electron injection electrode; or the first electrode may be a cathode, which is an electron injection

electrode, and the second electrode may be an anode, which is a hole injection electrode.

In an embodiment, in the organic light-emitting device, the first electrode is an anode, and the second electrode is a cathode, and the organic layer further includes a hole transport region disposed between the first electrode and the emission layer and an electron transport region disposed between the emission layer and the second electrode, wherein the hole transport region includes a hole injection layer, a hole transport layer, an electron blocking layer, or any combination thereof, and wherein the electron transport region includes a hole blocking layer, an electron transport layer, an electron injection layer, or any combination thereof.

The term "organic layer" as used herein refers to a single layer and/or a plurality of layers between the first electrode and the second electrode of the organic light-emitting device. The "organic layer" may include, in addition to an organic compound, an organometallic complex including metal.

FIG. 1 is a schematic view of an organic light-emitting device 10 according to an embodiment. Hereinafter, the structure of an organic light-emitting device according to an embodiment and a method of manufacturing an organic light-emitting device according to an embodiment will be described in connection with FIG. 1. The organic light-emitting device 10 includes a first electrode 11, an organic layer 15, and a second electrode 19, which are sequentially stacked.

A substrate may be additionally disposed under the first electrode 11 or above the second electrode 19. For use as the substrate, any substrate that is used in general organic light-emitting devices may be used, and the substrate may be a glass substrate or a transparent plastic substrate, each having excellent mechanical strength, thermal stability, transparency, surface smoothness, ease of handling, and water resistance.

The first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode may be, for example, indium tin oxide (ITO), indium zinc oxide (IZO), tin oxide ($SnO_2$), and zinc oxide (ZnO). In one or more embodiments, magnesium (Mg), aluminum (Al), aluminum-lithium (Al-Li), calcium (Ca), magnesium-indium (Mg-In), or magnesium-silver (Mg-Ag) may be used as the material for forming the first electrode.

The first electrode 11 may have a single-layered structure or a multi-layered structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, which are sequentially stacked in this stated order from the first electrode 11.

A hole injection layer may be formed on the first electrode 11 by using one or more suitable methods selected from vacuum deposition, spin coating, casting, or Langmuir-Blodgett (LB) deposition.

When a hole injection layer is formed by vacuum deposition, the deposition conditions may vary according to a compound that is used to form the hole injection layer, and the structure and thermal characteristics of the hole injection layer. For example, the deposition conditions may include a deposition temperature of about 100°C to about 500°C, a vacuum pressure of about $1.33 \times 10^{-6}$ Pa ($10^{-8}$ Torr) to about 0.133 Pa ($10^{-3}$ Torr), and a deposition rate of about 0.01 Angstroms per second (Å/sec) to about 100 Å/sec. However, the deposition conditions are not limited thereto.

When the hole injection layer is formed using spin coating, coating conditions may vary according to the material used to form the hole injection layer, and the structure and thermal properties of the hole injection layer. For example, a coating speed may be from about 2,000 revolutions per minute (rpm) (33.33 Hz) to about 5,000 rpm (83.33 Hz), and a temperature at which a heat treatment is performed to remove a solvent after coating may be from about 80°C to about 200°C. However, the coating conditions are not limited thereto.

Conditions for forming a hole transport layer and an electron blocking layer may be understood by referring to conditions for forming the hole injection layer.

The hole transport region may include at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (PANI/DBSA), poly(3,4-ethylenedioxythiophene)/poly(4-styrene sulfonate) (PEDOT/PSS), polyaniline/camphor sulfonic acid (PANI/CSA), polyaniline/poly(4-styrene sulfonate) (PANI/PSS), a compound represented by Formula 201 below, and a compound represented by Formula 202 below:

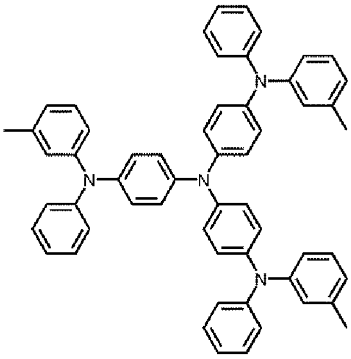

m-MTDATA

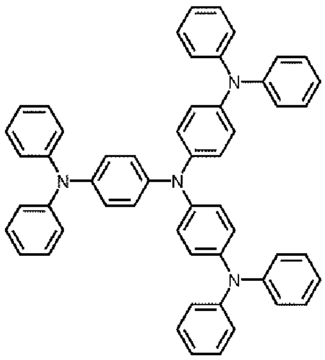

TDATA

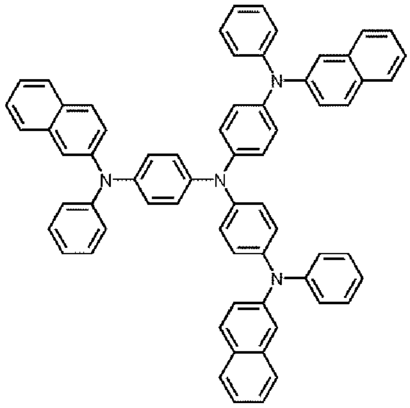

2-TNATA

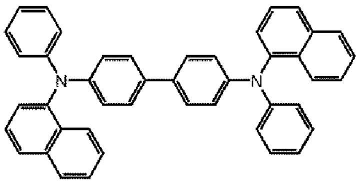

NPB

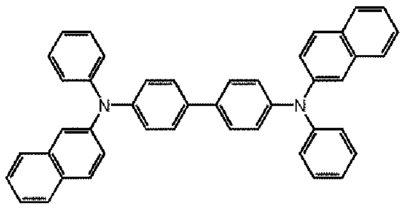

β-NPB

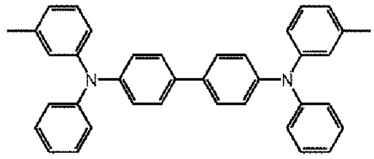

TPD

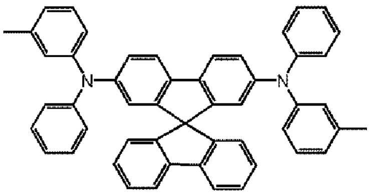

Spiro-TPD

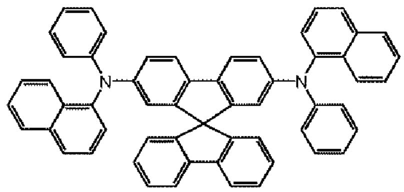

Spiro-NPB

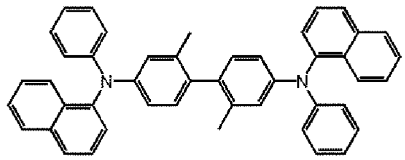

methylated NPB

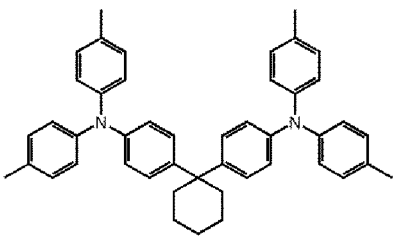

TAPC

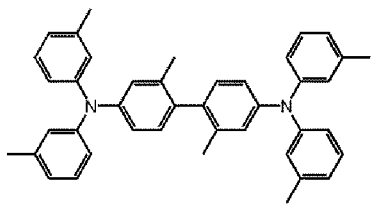

HMTPD

Formula 201

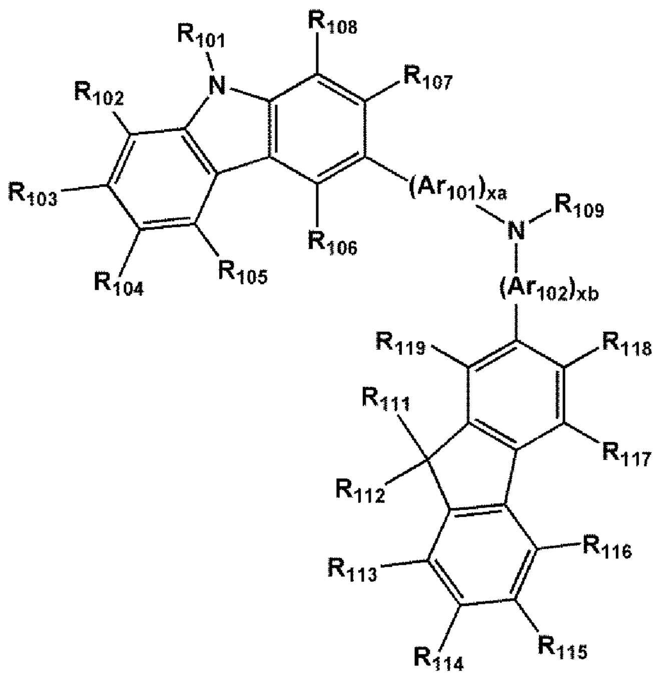

Formula 202

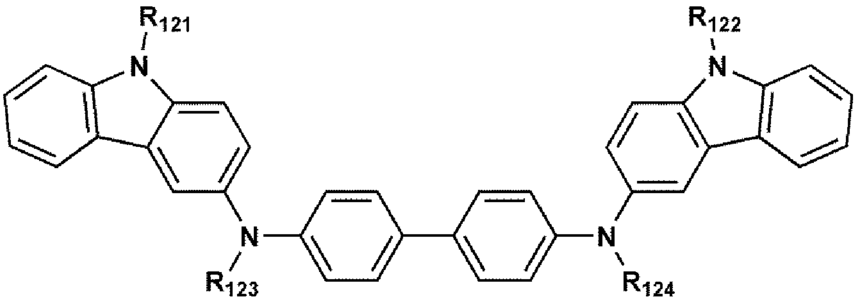

.

$Ar_{101}$ and $Ar_{102}$ in Formula 201 may each independently be selected from:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

In Formula 201, xa and xb may each independently be an integer from 0 to 5, or 0, 1, or 2. For example, xa is

1 and xb is 0, but xa and xb are not limited thereto.

$R_{101}$ to $R_{108}$, $R_{111}$ to $R_{119}$, and $R_{121}$ to $R_{124}$ in Formulae 201 and 202 may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, and so on), or a $C_1$-$C_{10}$ alkoxy group (for example, a methoxy group, an ethoxy group, a propoxy group, a butoxy group, a pentoxy group, and so on);
a $C_1$-$C_{10}$ alkyl group or a $C_1$-$C_{10}$ alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, and a $C_1$-$C_{10}$ alkoxy group;
but embodiments of the present disclosure are not limited thereto. $R_{109}$ in Formula 201 may be selected from:

a phenyl group, a naphthyl group, an anthracenyl group, and a pyridinyl group; and
a phenyl group, a naphthyl group, an anthracenyl group, and a pyridinyl group, each substituted with at least one selected from deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, and a pyridinyl group.

According to an embodiment, the compound represented by Formula 201 may be represented by Formula 201A, but embodiments of the present disclosure are not limited thereto:

Formula 201A

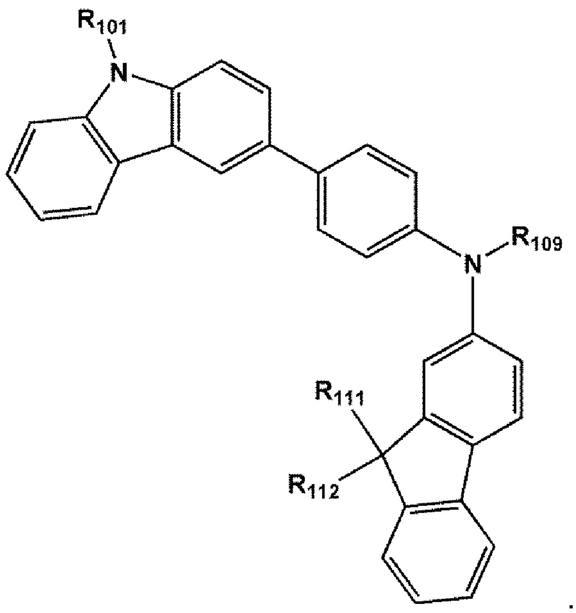

$R_{101}$, $R_{111}$, $R_{112}$, and $R_{109}$ in Formula 201A may be understood by referring to the description provided herein.

For example, the compound represented by Formula 201, and the compound represented by Formula 202 may include compounds HT1 to HT20 illustrated below, but are not limited thereto:

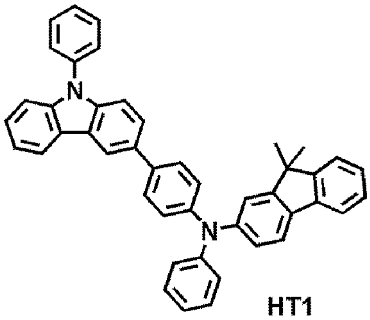

HT1

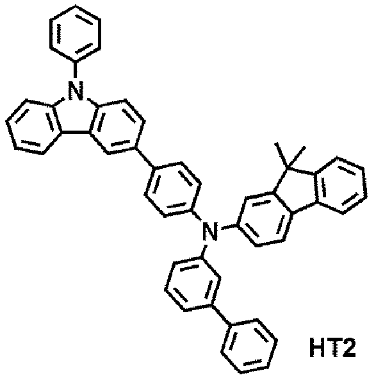

HT2

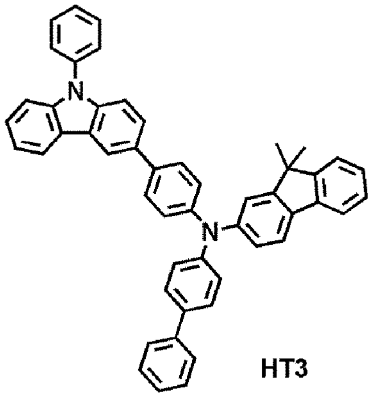

HT3

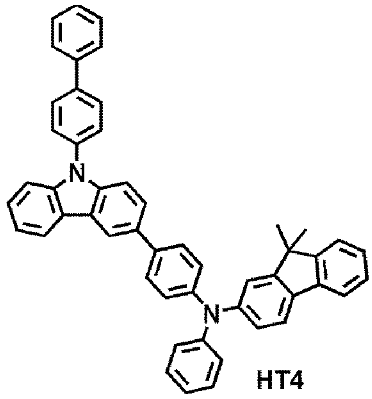

HT4

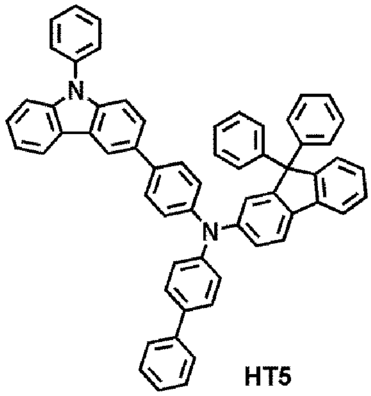

HT5

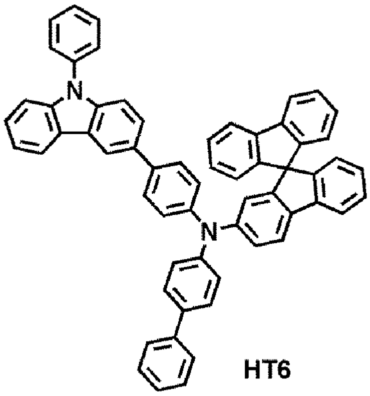

HT6

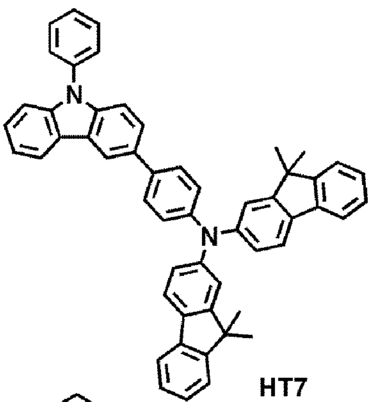

HT7

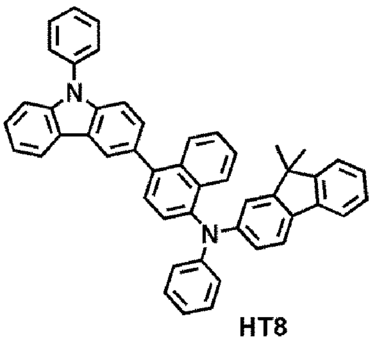

HT8

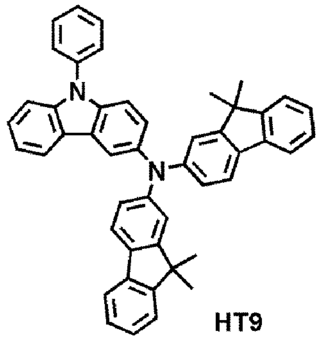

HT9

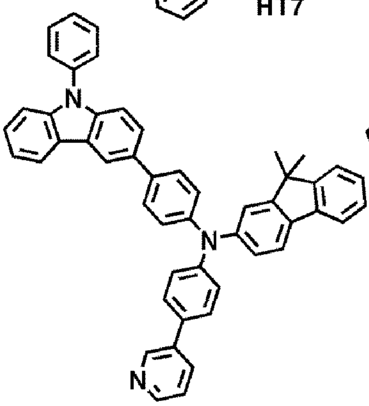

HT10

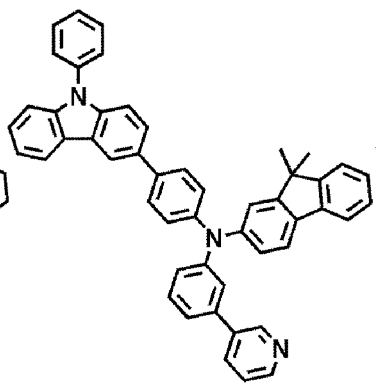

HT11

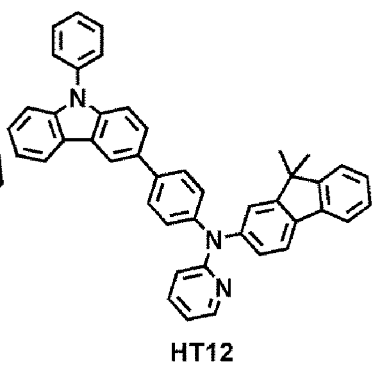

HT12

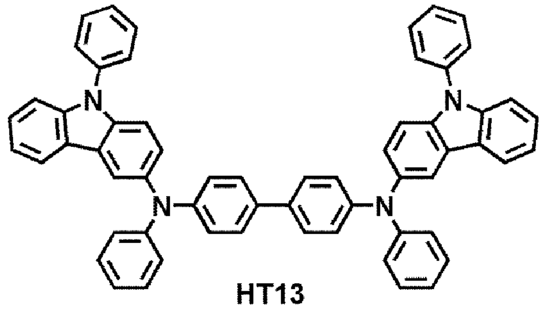
HT13

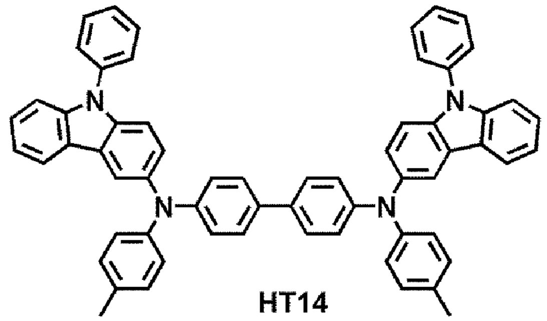
HT14

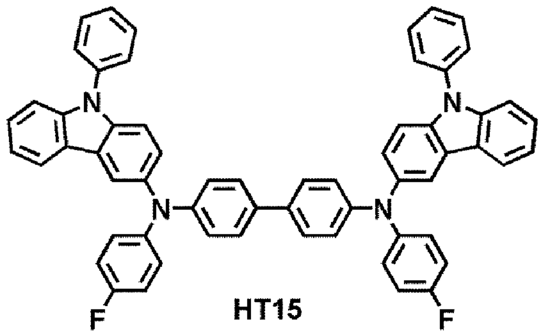
HT15

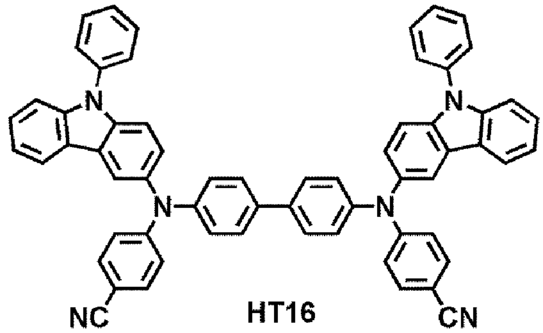
HT16

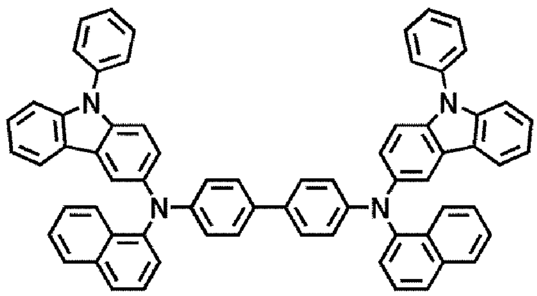
HT17

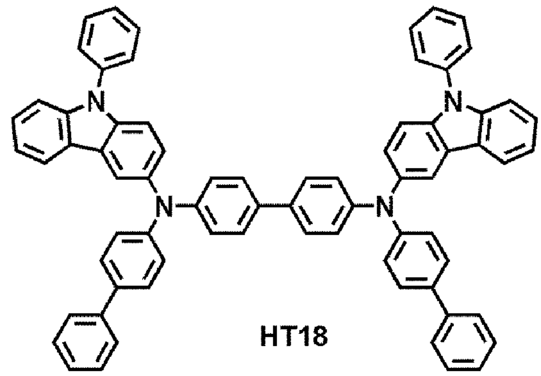
HT18

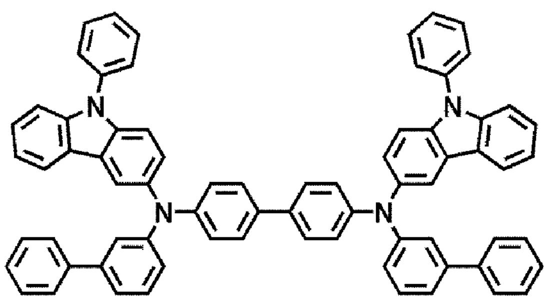
HT19

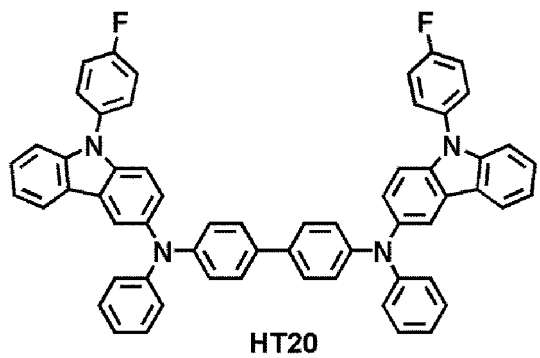
HT20

A thickness of the hole transport region may be in a range of about 100 Angstroms (Å) to about 10,000 Å, for example, about 100 Å to about 1,000 Å. When the hole transport region includes at least one of a hole injection layer and a hole transport layer, the thickness of the hole injection layer may be in a range of about 100 Å to about 10,000 Å, for example, about 100 Å to about 1,000 Å, and the thickness of the hole transport layer may be in a range of about 50 Å to about 2,000 Å, for example, about 100 Å to about 1,500 Å. While not wishing to be bound by theory, it is understood that when the thicknesses of the hole transport region, the hole injection layer, and the hole transport layer are within these ranges, satisfactory hole transporting characteristics may be obtained without a substantial increase in driving

voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one selected from a quinone derivative, a metal oxide, and a cyano group-containing compound, but embodiments of the present disclosure are not limited thereto. Non-limiting examples of the p-dopant are a quinone derivative, such as tetracyanoquinonedimethane (TCNQ) or 2,3,5,6-tetrafluoro-tetracyano-1,4-benzoquinonedimethane (F4-TCNQ); a metal oxide, such as a tungsten oxide or a molybdenium oxide; and a cyano group-containing compound, such as Compound HT-D1 below, but are not limited thereto:

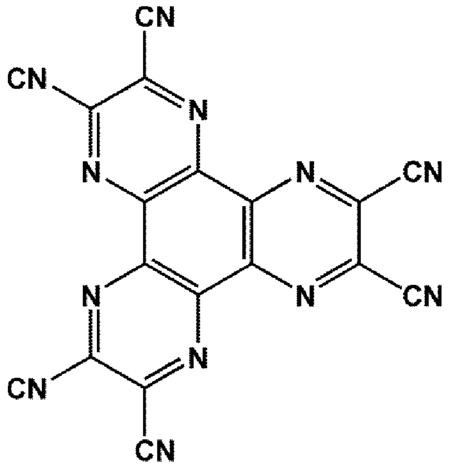

HT-D1

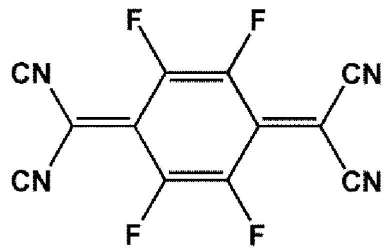

F4-TCNQ

.

The hole transport region may include a buffer layer.

Also, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a compound that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the organometallic compound represented by Formula 1.

The host may include at least one selected from TPBi, TBADN, ADN (also referred to as "DNA"), CBP, CDBP, TCP, mCP, Compound H50, and Compound H51:

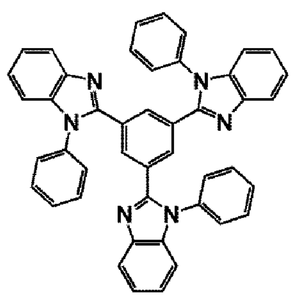

TPBi

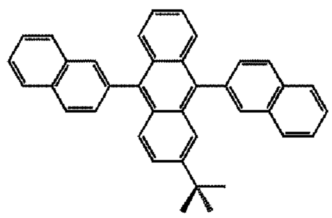

TBADN

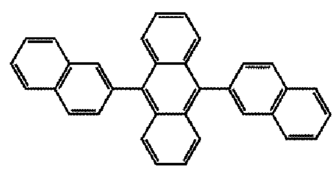

ADN

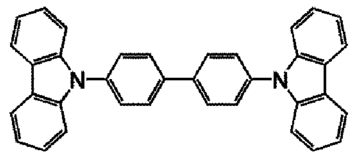
CBP

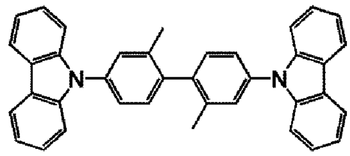
CDBP

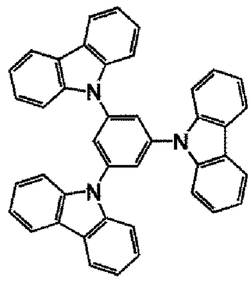
TCP

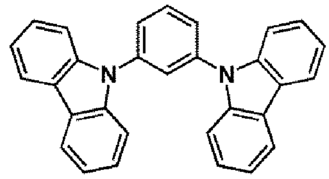
mCP

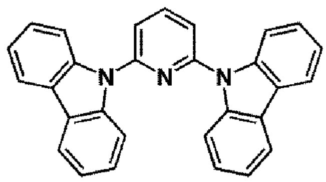
H50

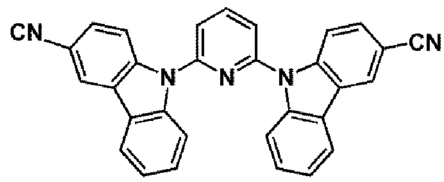
H51

.

In one or more embodiments, the host may further include a compound represented by Formula 301 below:

Formula 301

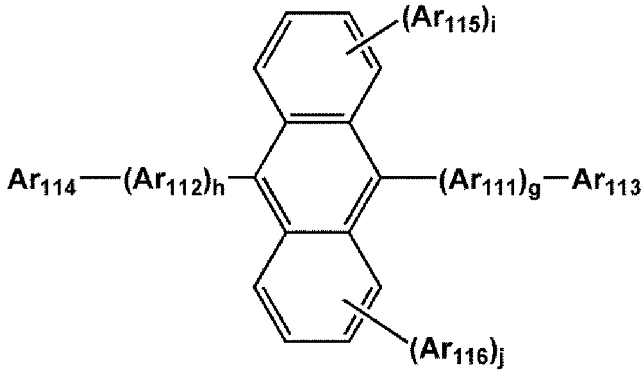

.

In Formula 301, $Ar_{111}$ and $Ar_{112}$ may each independently be selected from:

a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.

In Formula 301, $Ar_{113}$ to $Ar_{116}$ may each independently be selected from:

a $C_1$-$C_{10}$ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.

In Formula 301, g, h, i, and j may each independently be an integer from 0 to 4, and for example, may be 0, 1, or 2.
In Formula 301, $Ar_{113}$ to $Ar_{116}$ may each independently be selected from:

a $C_1$-$C_{10}$ alkyl group substituted with at least one selected from a phenyl group, a naphthyl group, and an anthracenyl group;
a phenyl group, a naphthyl group, an anthracenyl group, a pyrenyl group, a phenanthrenyl group, and a fluorenyl group;

a phenyl group, a naphthyl group, an anthracenyl group, a pyrenyl group, a phenanthrenyl group, and a fluorenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a phenyl group, a naphthyl group, an anthracenyl group, a pyrenyl group, a phenanthrenyl group, and a fluorenyl group; and

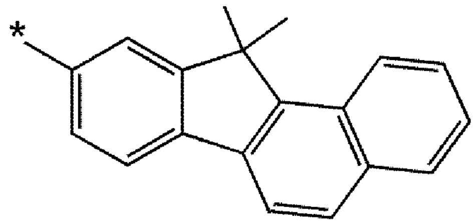

,

but embodiments of the present disclosure are not limited thereto.

In one or more embodiments, the host may include a compound represented by Formula 302 below:

Formula 302

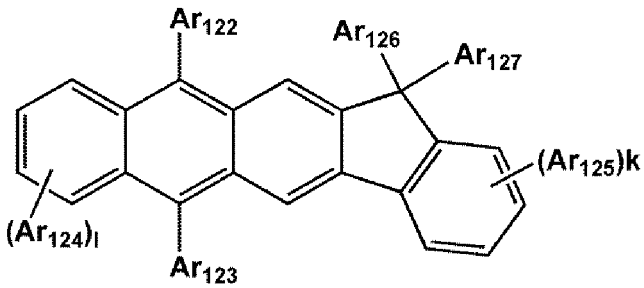

.

$Ar_{122}$ to $Ar_{125}$ in Formula 302 are the same as described in detail in connection with $Ar_{113}$ in Formula 301.

$Ar_{126}$ and $Ar_{127}$ in Formula 302 may each independently be a $C_1$-$C_{10}$ alkyl group (for example, a methyl group, an ethyl group, or a propyl group).

k and l in Formula 302 may each independently be an integer from 0 to 4. For example, k and l may be 0, 1, or 2.

The compound represented by Formula 301 and the compound represented by Formula 302 may include Compounds H1 to H42 illustrated below, but are not limited thereto:

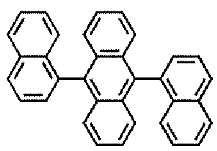

H1

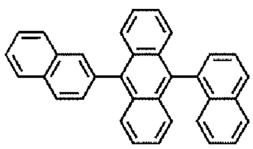

H2

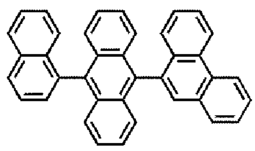

H3

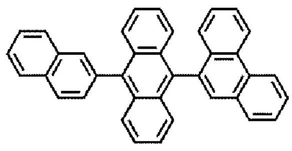

H4

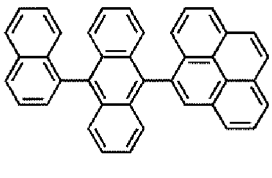

H5

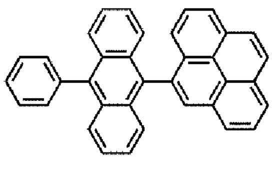

H6

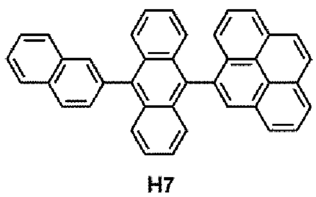

H7

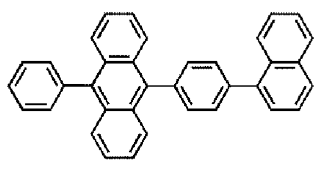

H8

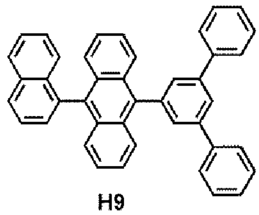
H9

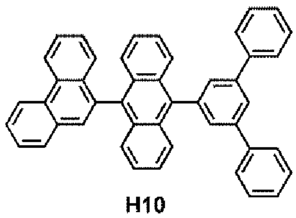
H10

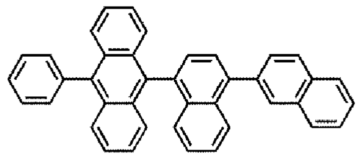
H11

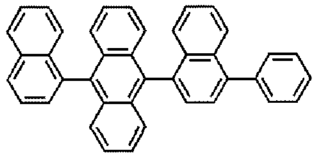
H12

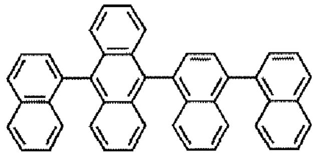
H13

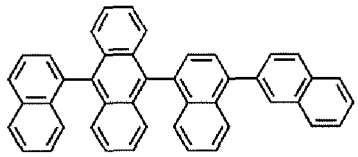
H14

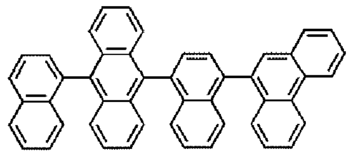
H15

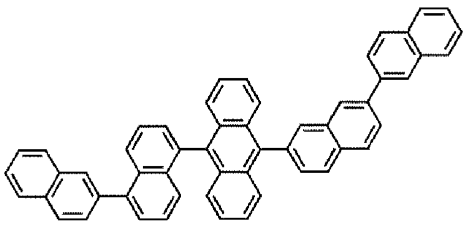
H16

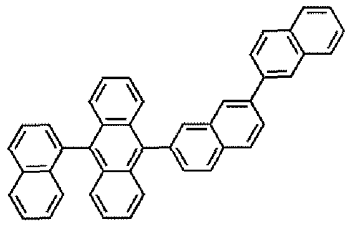
H17

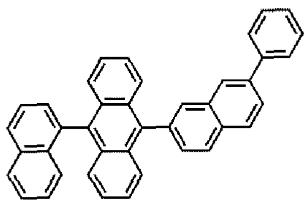
H18

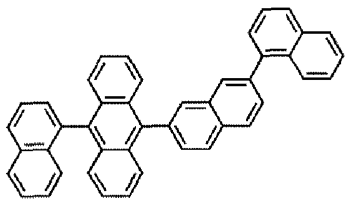
H19

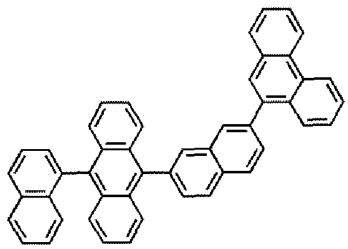
H20

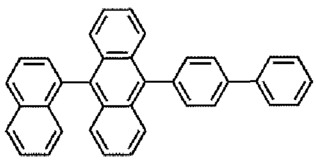
H21

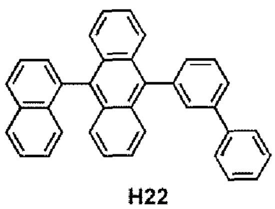
H22

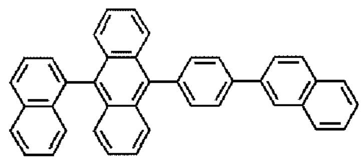
H23

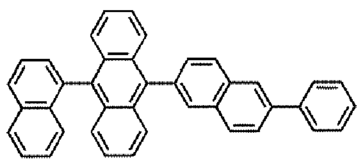
H24

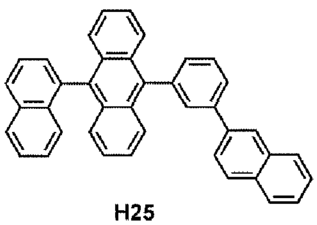
H25

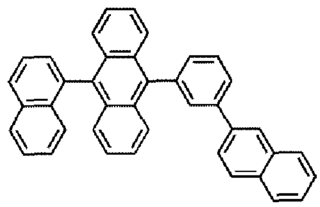
H26

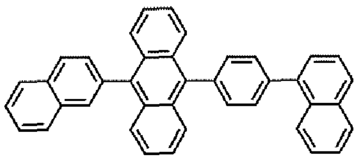
H27

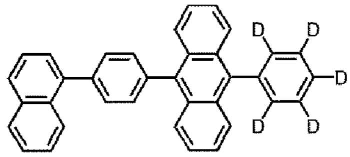
H28

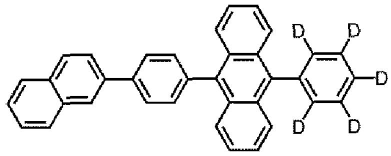
H29

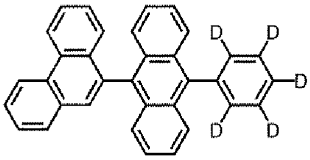
H30

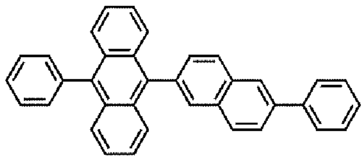
H31

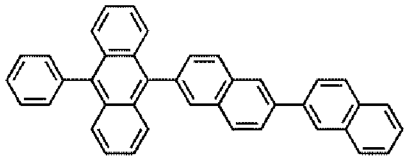
H32

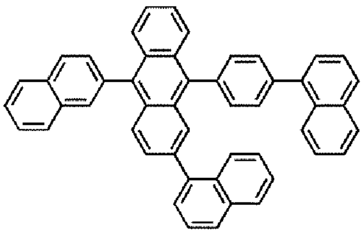
H33

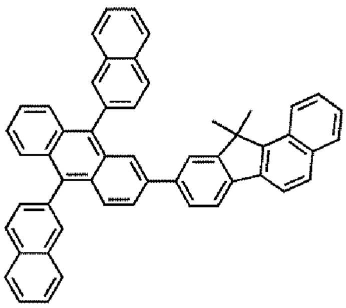
H34

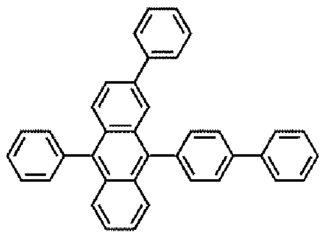
H35

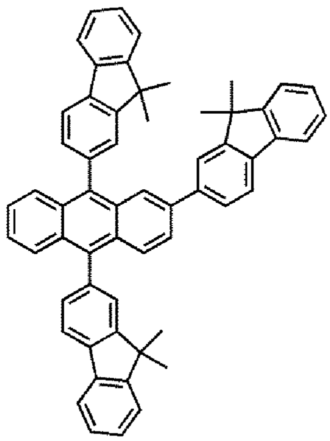
H36

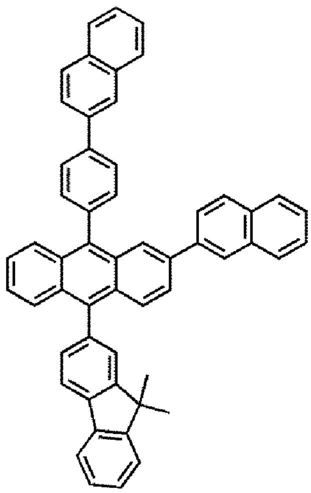
H37

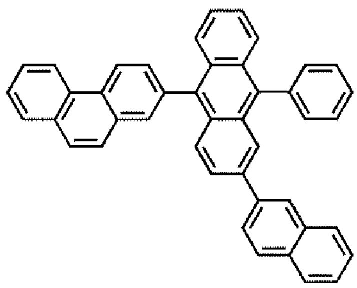
H38

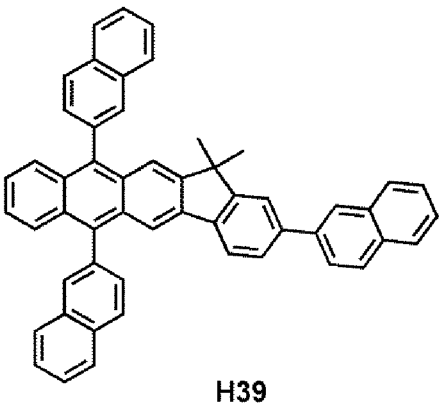

H39

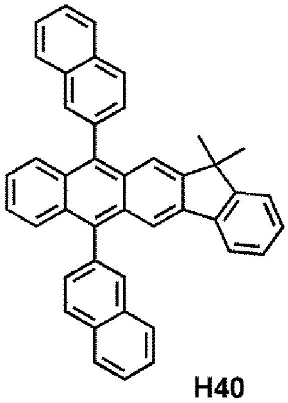

H40

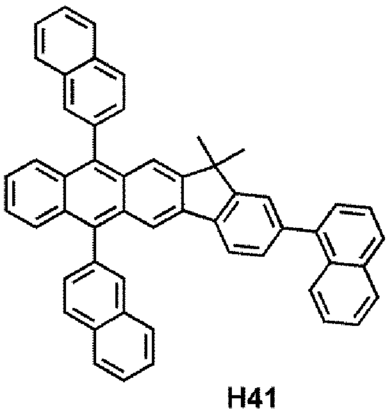

H41

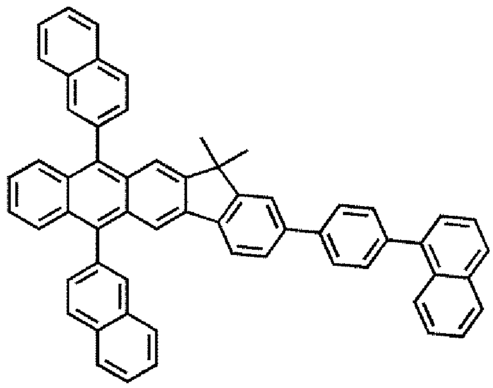

H42

.

When the organic light-emitting device is a full-color organic light-emitting device, the emission layer may be patterned into a red emission layer, a green emission layer, and a blue emission layer. In one or more embodiments, due to a stacked structure including a red emission layer, a green emission layer, and/or a blue emission layer, the emission layer may emit white light.

When the emission layer includes a host and dopant, an amount of the dopant may be typically in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 200 Å to about 600 Å. While not wishing to be bound by theory, it is understood that when the thickness of the emission layer is within this range, excellent light-emission characteristics may be obtained without a substantial increase in driving voltage.

Then, an electron transport region may be disposed on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq but embodiments of the present disclosure are not limited thereto:

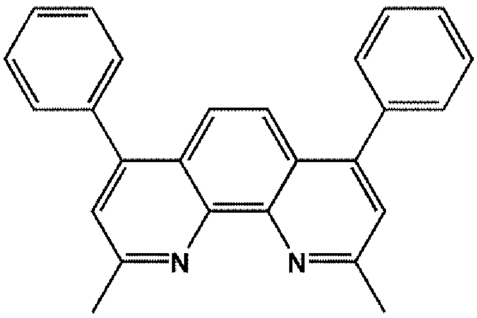

BCP

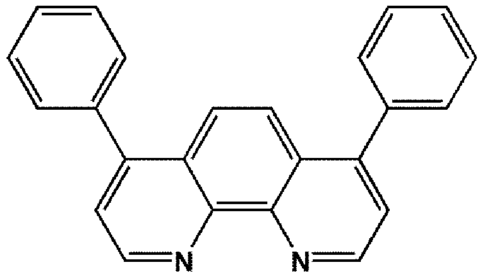

Bphen .

A thickness of the hole blocking layer may be in a range of about 20 Å to about 1,000 Å, for example, about 30 Å to about 300 Å. While not wishing to be bound by theory, it is understood that when the thickness of the hole blocking layer is within these ranges, the hole blocking layer may have improved hole blocking ability without a substantial increase in driving voltage.

The electron transport layer may include at least one selected from BCP, Bphen, $Alq_3$, BAlq, TAZ, and NTAZ:

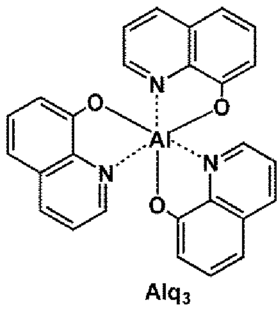

$Alq_3$

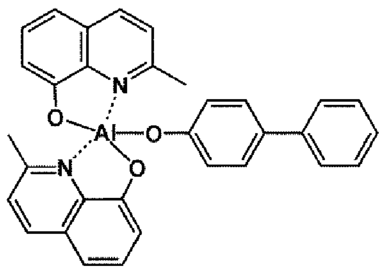

BAlq

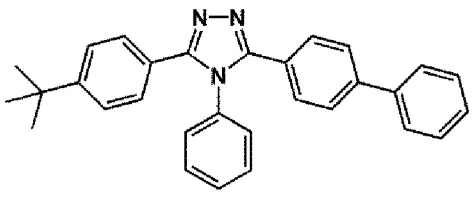

TAZ

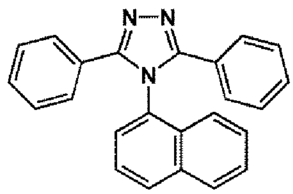

NTAZ .

In one or more embodiments, the electron transport layer may include at least one of ET1 and ET2, but are not limited thereto:

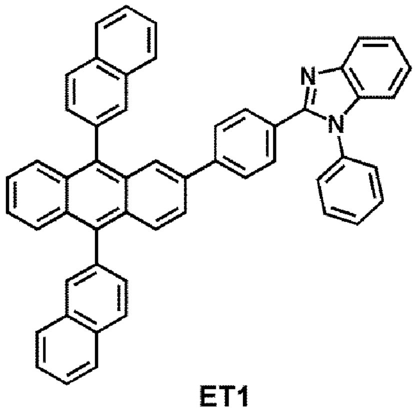

ET1

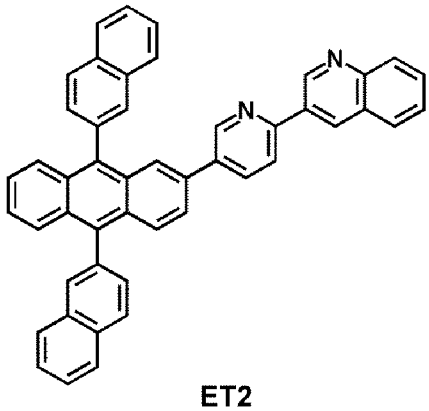

ET2 .

A thickness of the electron transport layer may be in a range of about 100 A to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 (lithium 8-hydroxyquinolate, LiQ) or ET-D2:

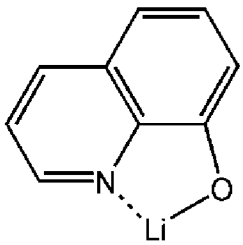

ET-D1

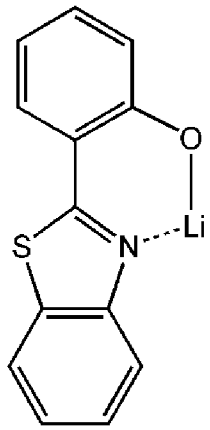

ET-D2

.

The electron transport region may include an electron injection layer that promotes flow of electrons from the second electrode 19 thereinto.

The electron injection layer may include at least one selected from LiF, NaCl, CsF, $Li_2O$, and BaO.

A thickness of the electron injection layer may be in a range of about 1 Å to about 100 Å, for example, about 3 A to about 90 Å. While not wishing to be bound by theory, it is understood that when the thickness of the electron injection layer is within the range described above, the electron injection layer may have satisfactory electron injection characteristics without a substantial increase in driving voltage.

The second electrode 19 is disposed on the organic layer 15. The second electrode 19 may be a cathode. A material for forming the second electrode 19 may be selected from metal, an alloy, an electrically conductive compound, and a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as a material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 1, but embodiments of the present disclosure are not limited thereto.

Another aspect of the present disclosure provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "$C_1$-$C_{60}$ alkyl group" as used herein refers to a linear or branched saturated aliphatic hydrocarbon monovalent group having 1 to 60 carbon atoms, and non-limiting examples thereof include a methyl group, an ethyl group, a propyl group, an iso-butyl group, a sec-butyl group, a tert-butyl group, a pentyl group, an iso-amyl group, and a hexyl group. The term "$C_1$-$C_{60}$ alkylene group" as used herein refers to a divalent group having the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof include a methoxy group, an ethoxy group, and an iso-propyloxy group.

The term "$C_2$-$C_{60}$ alkenyl group" as used herein refers to a hydrocarbon group formed by including at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a

divalent group having the same structure as the $C_2$-$C_{60}$ alkenyl group.

The term "$C_2$-$C_{60}$ alkynyl group" as used herein refers to a hydrocarbon group formed by including at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having the same structure as the $C_3$-$C_{10}$ cycloalkyl group.

The term "$C_1$-$C_{10}$ heterocycloalkyl group" as used herein refers to a monovalent saturated monocyclic group having at least one heteroatom selected from N, O, P, Si and S as a ring-forming atom and 1 to 10 carbon atoms, and non-limiting examples thereof include a tetrahydrofuranyl group, and a tetrahydrothiophenyl group. The term "$C_1$-$C_{10}$ heterocycloalkylene group" as used herein refers to a divalent group having the same structure as the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and that has no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, P, Si, and S as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_1$-$C_{60}$ heteroaryl group" as used herein refers to a monovalent group having a carbocyclic aromatic system that has at least one heteroatom selected from N, O, P, Si, and S as a ring-forming atom, and 1 to 60 carbon atoms. The term "$C_1$-$C_{60}$ heteroarylene group" as used herein refers to a divalent group having a carbocyclic aromatic system that has at least one heteroatom selected from N, O, P, and S as a ring-forming atom, and 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused to each other.

The term "$C_6$-$C_{60}$ aryloxy group" as used herein indicates $-OA_{102}$ (wherein $A_{102}$ is the $C_6$-$C_{60}$ aryl group), the term "$C_6$-$C_{60}$ arylthio group" as used herein indicates $-SA_{103}$ (wherein $A_{103}$ is the $C_6$-$C_{60}$ aryl group), and the term "$C_7$-$C_{60}$ arylalkyl group" as used herein indicates $-A_{104}A_{105}$ (wherein $A_{104}$ is the $C_6$-$C_{59}$ aryl group and $A_{105}$ is the $C_1$-$C_{53}$ alkyl group).

The term "$C_1$-$C_{60}$ heteroaryloxy group" as used herein refers to $-OA_{106}$ (wherein $A_{106}$ is the $C_1$-$C_{60}$ heteroaryl group), and the term "$C_1$-$C_{60}$ heteroarylthio group" as used herein indicates $-SA_{107}$ (wherein $A_{107}$ is the $C_1$-$C_{60}$ heteroaryl group).

The term "$C_2$-$C_{60}$ heteroarylalkyl group" as used herein refers to $-A_{108}A_{109}$ ($A_{109}$ is a $C_1$-$C_{59}$ heteroaryl group, and $A_{108}$ is a $C_1$-$C_{58}$ alkylene group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group," as used herein, refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed to each other, a heteroatom selected from N, O, P, Si, and S, other than carbon atoms, as a ring-forming atom, and no aromaticity in its entire molecular structure. Non-limiting examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group.

The term "$C_1$-$C_{30}$ heterocyclic group" as used herein refers to a saturated or unsaturated cyclic group having, as a ring-forming atom, at least one heteroatom selected from N, O, Si, P, and S other than 1 to 30 carbon atoms. The $C_1$-$C_{30}$ heterocyclic group may be a monocyclic group or a polycyclic group.

Wherein the substituents of the selected substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group are selected from:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, and $-P(=O)(Q_{18})(Q_{19})$;
a $C_3$-$C_{16}$ cycloalkyl group, a $C_1$-$C_{10}$ heterocycloalkyl group, a $C_3$-$C_{16}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a C1-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;
a $C_3$-$C_{16}$ cycloalkyl group, a $C_1$-$C_{10}$ heterocycloalkyl group, a $C_3$-$C_{16}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a C1-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{16}$ cycloalkyl group, a $C_1$-$C_{10}$ heterocycloalkyl group, a $C_3$-$C_{16}$ cycloalkenyl group, a $C_1$-$C_{10}$ heterocycloalkenyl group, a $C_6$-$C_{60}$ aryl group, a $C_6$-$C_{60}$ aryloxy group, a C6-$C_{60}$ arylthio group, a $C_7$-$C_{60}$ arylalkyl group, a $C_1$-$C_{60}$ heteroaryl group, a C1-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and $-N(Q_{31})(Q_{32})$, $-Si(Q_{33})(Q_{34})(Q_{35})$, $-B(Q_{36})(Q_{37})$, and $-P(=O)(Q_{38})(Q_{39})$, and $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{16}$ cycloalkyl group, a $C_1$-$C_{10}$ heterocycloalkyl group, a $C_3$-$C_{16}$ cycloalkenyl group, a $C_1$-$C_{10}$ heterocycloalkenyl group, a $C_6$-$C_{60}$ aryl group, a $C_6$-$C_{60}$ aryl group substituted with at least one selected from a $C_1$-$C_{60}$ alkyl group, and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group.

Hereinafter, a compound and an organic light-emitting device according to embodiments are described in detail with reference to Synthesis Examples and Examples. However, the organic light-emitting device is not limited thereto. The wording "B was used instead of A" used in describing Synthesis Examples means that an amount of A used was identical to an amount of B used, in terms of molar equivalents.

Examples

Synthesis Example 1: Synthesis of Compound 1

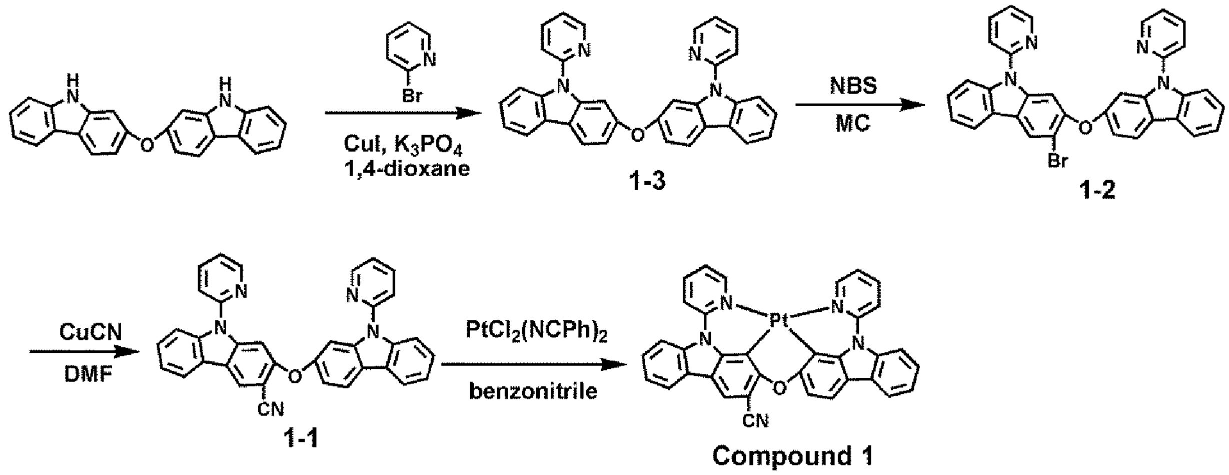


Synthesis of Ligand 1-3

28.7 millimoles (mmol) (10 grams, g) of 3,3'-oxybis(9H-carbazole), 86.1 mmol (13.6 g) of 2-bromopyridine, 28.7 mmol (5.4 g) of CuI, 115 mmol (24.4 g) of $K_3PO_4$, and 57.4 mmol (6.5 g) of 1,2-diaminocyclohexane were added to 250 milliliters (mL) of dioxane, and the resultant mixture was refluxed at a temperature of 120°C for 12 hours. A reaction mixture obtained therefrom was cooled, and an organic layer was extracted by using a mixture of ethyl acetate and water. The extracted organic layer was washed with water three times and dried by using magnesium sulfate, and a solvent was removed therefrom under reduced pressure. The crude product was purified by silica gel column chromatography (eluent: dichloromethane and hexane) to obtain Ligand 1-3 (yield: 80%).
MALDI-TOF (m/z): 502.33 $[M]^+$.

Synthesis of Ligand 1-2

Methylene chloride (MC) and 22.9 mmol (11.5 g) of Ligand 1-3 were mixed, and 23 mmol (1 equivalent (equiv.), 4.1 g) of n-bromosuccinimide was added thereto. The resultant mixture was refluxed at a temperature of 40°C for 12 hours. A reaction mixture obtained therefrom was cooled, and an organic layer was extracted by using a mixture of ethyl acetate and water. The extracted organic layer was washed with water three times and dried by using magnesium sulfate, and a solvent was removed therefrom under reduced pressure. The obtained crude product (Ligand 1-2) was used in a subsequent reaction.
MALDI-TOF (m/z): 581.23 $[M]^+$.

Synthesis of Ligand 1-1

22.9 mmol (13.3 g) of Ligand 1-2 was added to a mixture of 22.9 mmol (1 equiv.) of copper cyanide (CuCN) and 90 mL of dimethylformamide (DMF). The resultant mixture was refluxed at a temperature of 150°C for 12 hours. A reaction mixture obtained therefrom was cooled, and an organic layer was extracted by using a mixture of ethyl acetate and water. The extracted organic layer was washed with water three times and dried by using magnesium sulfate, and a solvent was removed therefrom under reduced pressure. The crude product was purified by silica gel column chromatography (eluent: ethyl acetate and hexane) to obtain Ligand 1-1 (yield: 30%).
MALDI-TOF (m/z): 527.37 $[M]^+$.

Synthesis of Compound 1

1.9 mmol (0.9 g) of $PtCl_2(NCPh)_2$ and 1.9 mmol (1 g) of Ligand 1-1 were added to 10 mL of benzonitrile. The resultant mixture was refluxed in a nitrogen atmosphere for 5 hours. After the reaction was completed, the resultant mixture was cooled to room temperature and 50 mL of distilled water was added to a reaction vessel. After a solid obtained therefrom was filtered, washed with distilled water, and then dried, the crude product was purified by silica gel column chromatography (eluent: dichloromethane and hexane) to obtain Compound 1 (yield: 23%).
MALDI-TOF (m/z): 720.10 $[M]^+$.

Synthesis Example 2: Synthesis of Compound 2

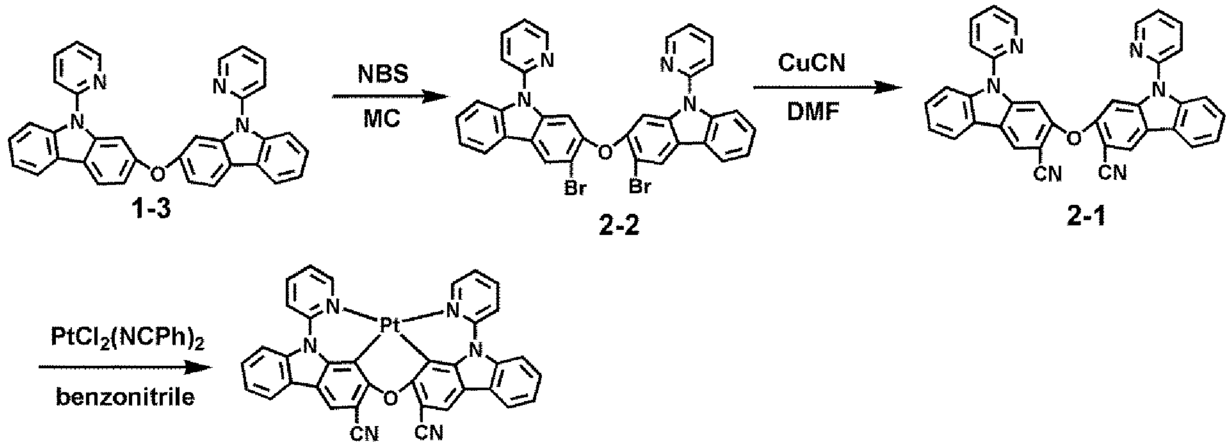

1-3 2-2 2-1

Compound 2

Synthesis of Ligand 2-2

Ligand 2-2 was synthesized in the same manner as Ligand 1-2 in Synthesis Example 1, except that an amount of n-bromosuccinimide used was changed to 2 equiv.
MALDI-TOF (m/z): 660.10 $[M]^+$.

Synthesis of Ligand 2-1

Ligand 2-1 (yield: 27%) was synthesized in the same manner as Ligand 1-1 in Synthesis Example 1, except that an amount of copper cyanide (CuCN) used was changed to 2 equiv.
MALDI-TOF (m/z): 552.17 $[M]^+$.

Synthesis of Compound 2

Compound 2 (yield: 25%) was synthesized in the same manner as Compound 1 in Synthesis Example 1, except that Ligand 2-1 was used instead of Ligand 1-1.
MALDI-TOF (m/z): 745.01$[M]^+$.

Synthesis Example 3: Synthesis of Compound 7

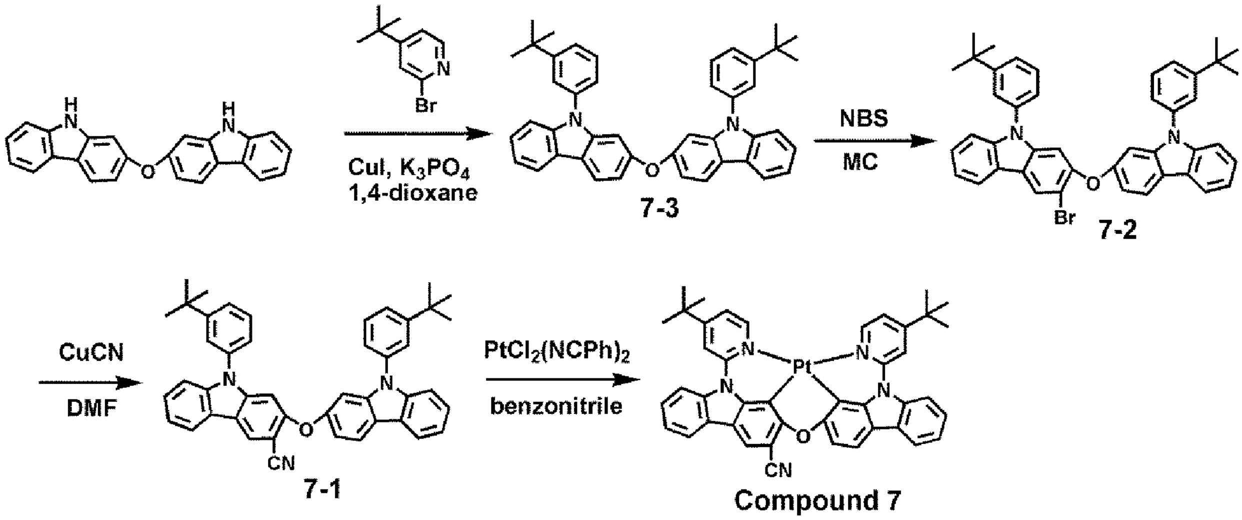


Synthesis of Ligand 7-3

Ligand 7-3 (yield: 85%) was synthesized in the same manner as Ligand 1-3 in Synthesis Example 1, except that 2-bromo-4-(tert-butyl)pyridine was used instead of 2-bromopyridine.

MALDI-TOF (m/z): 612.65 $[M]^+$.

Synthesis of Ligand 7-2

Ligand 7-2 (yield: 85%) was synthesized in the same manner as Ligand 1-2 in Synthesis Example 1, except that Ligand 7-3 was used instead of Ligand 1-3.

Synthesis of Ligand 7-1

Ligand 7-1 (yield: 27%) was synthesized in the same manner as used to synthesize Ligand 1-1 in Synthesis Example 1, except that Ligand 7-2 was used instead of Ligand 1-2.
MALDI-TOF (m/z): 639.32 $[M]^+$.

Synthesis of Compound 7

Compound 7 (yield: 27%) was synthesized in the same manner as used to synthesize Compound 1 in Synthesis Example 1, except that Ligand 7-1 was used instead of Ligand 1-1.
MALDI-TOF (m/z): 832.54 $[M]^+$.

Synthesis Example 4: Synthesis of Compound 24

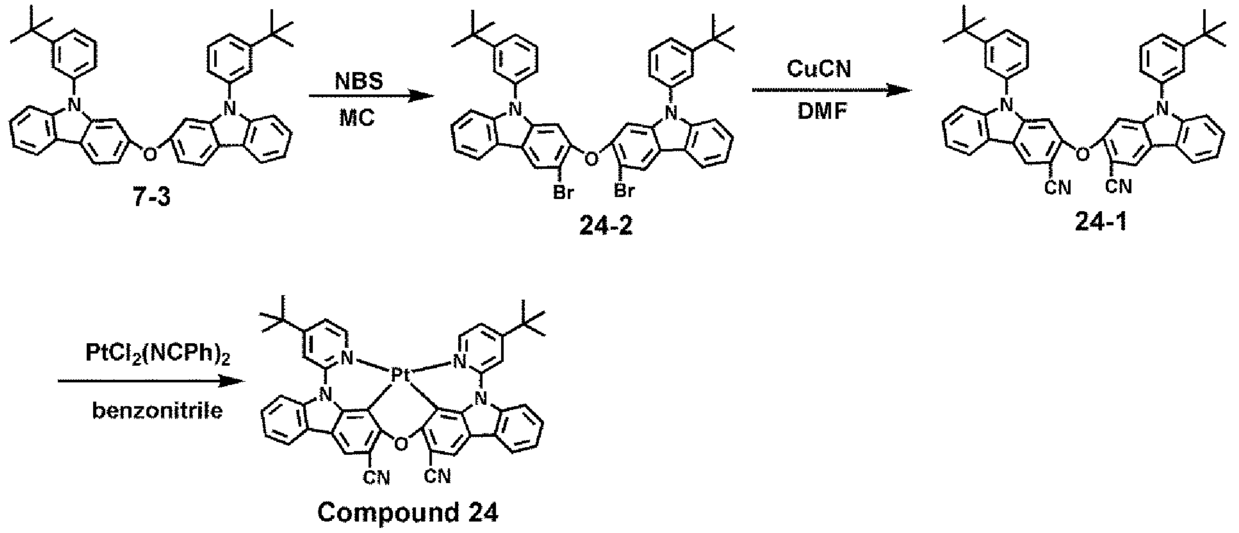


7-3 24-2 24-1

Compound 24

Synthesis of Ligand 24-2

Ligand 24-2 was synthesized in the same manner as Ligand 7-2 in Synthesis Example 3, except that an amount of n-bromosuccinimide used was changed to 2 equiv.

Synthesis of Ligand 24-1

Ligand 24-1 (yield: 23%) was synthesized in the same manner as Ligand 7-1 in Synthesis Example 3, except that an amount of copper cyanide (CuCN) used was changed to 2 equiv.
MALDI-TOF (m/z): 662.90 $[M]^+$.

Synthesis of Compound 24

Compound 24 (yield: 23%) was synthesized in the same manner as Compound 7 in Synthesis Example 3, except that Ligand 24-1 was used instead of Ligand 7-1.
MALDI-TOF (m/z): 857.18 $[M]^+$.

Synthesis Example 5: Synthesis of Compound 25

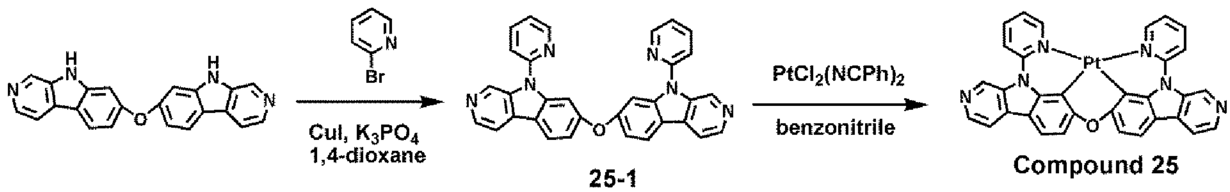


25-1

Compound 25

Synthesis of Ligand 25-1

Ligand 25-1 (yield: 60%) was synthesized in the same manner as Ligand 1-3 in Synthesis Example 1, except that 7,7'-oxybis(9H-pyrido[3,4-b]indole) was used instead of 3,3'-oxybis(9H-carbazole).
MALDI-TOF (m/z): 505.14 $[M]^+$.

Synthesis of Compound 25

2.0 mmol (0.9 g) of $PtCl_2(NCPh)_2$, 2.0 mmol (1 g) of Ligand 25-1, and 10 mL of benzonitrile were mixed and refluxed in a nitrogen atmosphere for 5 hours. After the reaction was completed, the resultant mixture was cooled to room temperature and 50 mL of distilled water was added to a reaction vessel. A solid obtained therefrom was filtered

and washed by using ethyl acetate to obtain Compound 25 (yield: 18%).
MALDI-TOF (m/z): 697.84 $[M]^+$.

Evaluation Example 1: Evaluation of PL spectrum

After Compound 1 was diluted at a concentration of 10 millimolar (mM) in toluene, a photoluminescence (PL) spectrum thereof was measured at room temperature by using an ISC PC1 spectrofluorometer equipped with a xenon lamp. This process was repeated on Compounds 2, 7, A, 7, 24, and B. Results thereof are shown in Table 2 and FIG. 2.

Table 2

| Compound No. | Maximum emission wavelength (nm) | FWHM (nm) |
|---|---|---|
| 1 | 489 | 31 |
| 2 | 461 | 76 |
| A | 511 | 95 |
| 7 | 442, 465 | 59 |
| 24 | 434, 462 | 43 |
| B | 480 | 89 |

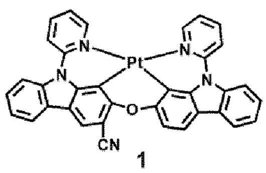
1

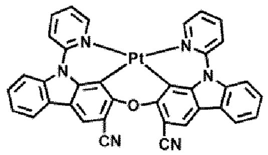
2

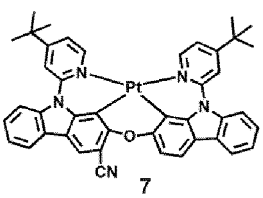
7

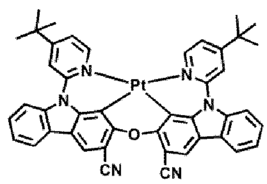
24

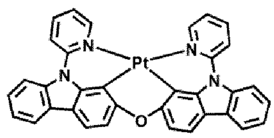
A

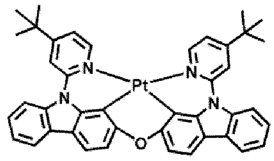
B

Referring to Table 2 and FIG. 2, it has been determined that Compounds 1 and 2 can emit light relatively shifted to a blue light-emitting area and having an improved (that is, reduced) full width at half maximum (FWHM), as compared with Compound A, and Compounds 7 and 24 can emit light relatively shifted to a blue light-emitting area and having an improved (that is, reduced) FWHM, as compared with Compound B.

Evaluation Example 2: Evaluation of HOMO, LUMO, and T1 energy levels HOMO and LUMO energy levels of Compounds 7, A, and B and $T_1$ energy levels of Compounds 1, 2, 7, 24, A, and B were measured according to methods described in Table 3, and results thereof are shown in Table 4:

Table 3

| | |
|---|---|
| HOMO energy level evaluation method | A voltage-current (V-A) graph of each Compound was obtained by using a cyclic voltammetry (CV) (electrolyte: 0.1 molar (M) $Bu_4NPF_6$ / solvent: $CH_2Cl_2$ / electrode: 3-electrode system (working electrode: Pt disc (1 millimeter (mm) diameter), reference electrode: Pt wire, and auxiliary electrode: Pt wire)), and the HOMO energy level of each Compound was calculated from an oxidation onset of the V-A graph. |
| LUMO energy level evaluation method | Each compound was diluted at a concentration of $1x10^{-5}$ M in $CHCl_3$, and an UV absorption spectrum thereof was measured at room temperature by using a Shimadzu UV-350 spectrometer, and a LUMO energy level thereof was calculated by using an optical band gap (Eg) and HOMO energy levels from an edge of the absorption spectrum. |

(continued)

| | |
|---|---|
| $T_1$ energy level evaluation method | After a mixture of toluene and each Compound (1 milligram (mg) of each Compound was dissolved in 3 cubic centimeters (cc) of toluene) was added to a quartz cell and then added to liquid nitrogen (77 Kelvin, K), a photoluminescence spectrum was measured by using a photoluminescence measurement apparatus. The $T_1$ energy level was calculated by analyzing peaks alone observed only at a low temperature through comparison between the photoluminescence spectrum and a general room-temperature photoluminescence spectrum. |

Table 4

| Compound No. | HOMO (eV) | LUMO (eV) | $T_1$ (eV) |
|---|---|---|---|
| 1 | - | - | 2.69 |
| 2 | - | - | 2.54 |
| A | -5.17 | -2.75 | 2.42 |
| 7 | -5.41 | -2.60 | 2.81 |
| 24 | - | - | 2.86 |
| B | -5.18 | -2.60 | 2.58 |

Referring to Table 4, it has been determined that Compound 7 has a lower HOMO energy level (that is, a large absolute value of a HOMO energy level) than Compounds A and B, Compounds 1 and 2 has a higher $T_1$ energy level than Compound A, and Compounds 7 and 24 has a higher $T_1$ energy level than Compound B.

Example 1

As an anode, a glass substrate, on which ITO/Ag/ITO were respectively deposited to thicknesses of 70 Å/1,000 Å/70 Å, was cut to a size of 50 mm x 50 mm x 0.5 mm (mm = millimeters), sonicated with iso-propyl alcohol and pure water each for 5 minutes, and then cleaned by exposure ultraviolet (UV) rays for 30 minutes. Then, the glass substrate was provided to a vacuum deposition apparatus.

2-TNATA was deposited on the anode to form a hole injection layer having a thickness of 600 Å, and 4,4'-bis[N-(1-naphthyl)-N-phenylamino]biphenyl (NPB) was deposited on the hole injection layer to form a hole transport layer having a thickness of 1,350 Å.

CBP (host) and Compound 1 (dopant) was co-deposited on the hole transport layer at a weight ratio of 94:6 to form an emission layer having a thickness of 400 Å, and BCP was deposited on the emission layer to form a hole blocking layer having a thickness of 50 Å. Then, $Alq_3$ was deposited on the hole blocking layer to form an electron transport layer having a thickness of 350 Å, LiF was deposited on the electron transport layer to form an electron injection layer having a thickness of 10 Å, and MgAg was deposited on the electron injection layer at a weight ratio of 90:10 to form a cathode having a thickness of 120 Å, thereby completing the manufacture of an organic light-emitting device.

Examples 2 to 4

Organic light-emitting devices were manufactured in the same manner as in Example 1, except that Compounds 2, 7, and 24 were each used instead of Compound 1 as a dopant in forming an emission layer.

Evaluation Example 3: Evaluation on characteristics of organic light-emitting devices.

The driving voltage, emission efficiency, quantum emission efficiency, and roll-off ratio of the organic light-emitting device manufactured according to Example 3 were evaluated by using a current-voltage meter (Keithley 2400) and a luminance meter (Minolta Cs-1000A), and results thereof are shown in Table 5. The roll-off ratio was calculated by using Equation 20.

Equation 20

$$\text{Roll off} = \{1 - (\text{efficiency (at 9000 nit)} / \text{maximum emission efficiency})\} \times 100\%$$

Table 5

| Example No. | Dopant compound No. | Driving voltage (V) | Emission efficiency (cd/A) | Quantum emission efficiency (%) | Roll-off ratio (%) |
|---|---|---|---|---|---|
| Example 3 | 7 | 5.6 | 15.4 | 5.5 | 17.5 |

Referring to Table 5, it has been determined that the organic light-emitting device of Example 3 has excellent driving voltage, emission efficiency, quantum emission efficiency, and roll-off ratio characteristics.

As described above, the organometallic compounds according to embodiments of the present disclosure have excellent electrical characteristics and thermal stability, and accordingly, organic light-emitting devices including such organometallic compounds may have excellent driving voltage, efficiency, power, color purity, and lifespan characteristics. Also, due to excellent phosphorescent luminescence characteristics, such organometallic compounds may provide a diagnostic composition having high diagnostic efficiency.

It should be understood that embodiments described herein should be considered in a descriptive sense only and not for purposes of limitation.

## Claims

1. An organometallic compound represented by Formula 1:

Formula 1

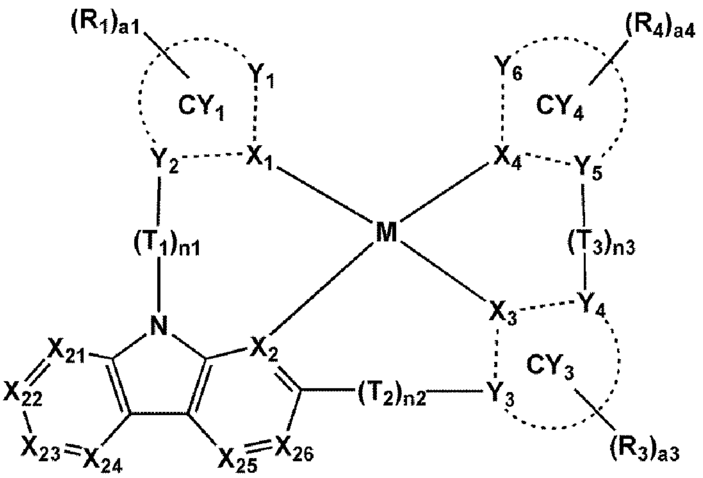

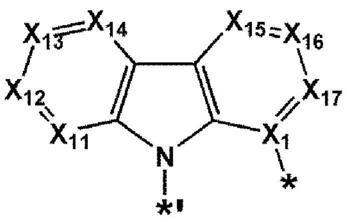

Formula CZ1

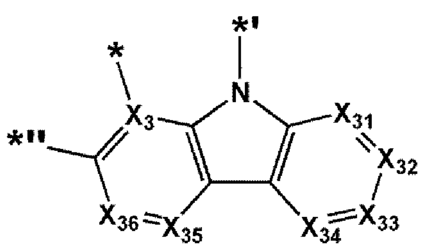

Formula CZ3

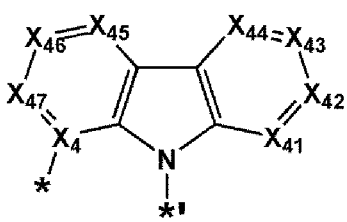

Formula CZ4

,

wherein, in Formulae 1, CZ1, CZ3, and CZ4,
M is selected from a first-row transition metal of the Periodic Table of Elements, a second-row transition metal of the Periodic Table of Elements, and a third-row transition metal of the Periodic Table of Elements,
$X_1$ to $X_4$ are each independently C or N,

two bonds selected from a bond between $X_1$ and M, a bond between $X_2$ and M, a bond between $X_3$ and M, and a bond between $X_4$ and M are each a coordinate bond, and the others thereof are each a covalent bond,
$Y_2$ to $Y_5$ are each independently C or N,
$Y_1$ and $Y_6$ are each independently C, N, O, Si, or S,
a bond between $X_1$ and $Y_1$, a bond between $X_1$ and $Y_2$, a bond between $X_3$ and $Y_3$, a bond between $X_3$ and $Y_4$, a bond between $X_4$ and $Y_5$, and a bond between $X_4$ and $Y_6$ are each a chemical bond that links the corresponding atoms,
$CY_1$ is selected from a $C_5$-$C_{30}$ carbocyclic group, a $C_1$-$C_{30}$ heterocyclic group, and a group represented by Formula CZ1,
$CY_3$ is selected from a $C_5$-$C_{30}$ carbocyclic group, a $C_1$-$C_{30}$ heterocyclic group, and a group represented by Formula CZ3,
$CY_4$ is selected from a $C_5$-$C_{30}$ carbocyclic group, a $C_1$-$C_{30}$ heterocyclic group, and a group represented by Formula CZ4,
$T_1$ to $T_3$ are each independently selected from *-N[$(L_5)_{b5}$-$(R_5)$]-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*' *-S(=O)-*', *-S(=O)$_2$-*', *-C($R_5$)=*', *=C($R_5$)-*', *-C($R_5$)=C($R_6$)-*', *-C(=S)-*', and *-C≡C-*',
$L_5$ is selected from a single bond, a substituted or unsubstituted $C_5$-$C_{30}$ carbocyclic group, and a substituted or unsubstituted $C_1$-$C_{30}$ heterocyclic group,
b5 is selected from 1 to 3, wherein, when b5 is two or more, two or more groups $L_5$ are identical to or different from each other,
$R_5$ and $R_6$ are optionally linked via a first linking group to form a substituted or unsubstituted $C_5$-$C_{30}$ carbocyclic group or a substituted or unsubstituted $C_1$-$C_{30}$ heterocyclic group,
n1 to n3 are each independently 0, 1, 2, or 3, wherein, when n1 is zero, *-$(T_1)_{n1}$-*' is a single bond, when n2 is zero, *-$(T_2)_{n2}$-*' is a single bond, and when n3 is zero, *-$(T_3)_{n3}$-*' is a single bond,
$X_{11}$ is N or C($R_{11}$), $X_{12}$ is N or C($R_{12}$), $X_{13}$ is N or C($R_{13}$), $X_{14}$ is N or C($R_{14}$), $X_{15}$ is N or C($R_{15}$), $X_{16}$ is N or C($R_{16}$), $X_{17}$ is N or C($R_{17}$), $X_{21}$ is N or C($R_{21}$), $X_{22}$ is N or C($R_{22}$), $X_{23}$ is N or C($R_{23}$), $X_{24}$ is N or C($R_{24}$), $X_{25}$ is N or C($R_{25}$), $X_{26}$ is N or C($R_{26}$), $X_{31}$ is N or C($R_{31}$), $X_{32}$ is N or C($R_{32}$), $X_{33}$ is N or C($R_{33}$), $X_{34}$ is N or C($R_{34}$), $X_{35}$ is N or C($R_{35}$), $X_{36}$ is N or C($R_{36}$), $X_{41}$ is N or C($R_{41}$), $X_{42}$ is N or C($R_{42}$), $X_{43}$ is N or C($R_{43}$), $X_{44}$ is N or C($R_{44}$), $X_{45}$ is N or C($R_{45}$), $X_{46}$ is N or C($R_{46}$), and $X_{47}$ is N or C($R_{47}$),
$R_1$, $R_3$ to $R_6$, $R_{11}$ to $R_{17}$, $R_{21}$ to $R_{26}$, $R_{31}$ to $R_{36}$, and $R_{41}$ to $R_{47}$ are each independently selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{16}$ heterocycloalkyl group, a substituted or unsubstituted $C_3$-$C_{10}$ cycloalkenyl group, a substituted or unsubstituted $C_1$-$C_{16}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_7$-$C_{60}$ arylalkyl group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$ heteroarylthio group, a substituted or unsubstituted $C_2$-$C_{60}$ heteroarylalkyl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$), -B($Q_6$)($Q_7$), and - P(=O)($Q_8$)($Q_9$),
a1, a3, and a4 are each independently 0, 1, 2, 3, 4, or 5,
two of groups $R_1$ in the number of a1 are optionally linked to form a substituted or unsubstituted $C_5$-$C_{30}$ carbocyclic group or a substituted or unsubstituted $C_1$-$C_{30}$ heterocyclic group,
two of groups $R_3$ in the number of a3 are optionally linked to form a substituted or unsubstituted $C_5$-$C_{30}$ carbocyclic group or a substituted or unsubstituted $C_1$-$C_{30}$ heterocyclic group,
two of groups $R_4$ in the number of a4 are optionally linked to form a substituted or unsubstituted $C_5$-$C_{30}$ carbocyclic group or a substituted or unsubstituted $C_1$-$C_{30}$ heterocyclic group,
two of $R_{11}$ to $R_{17}$ are optionally linked to form a substituted or unsubstituted $C_5$-$C_{30}$ carbocyclic group or a substituted or unsubstituted $C_1$-$C_{30}$ heterocyclic group,
two of $R_{21}$ to $R_{26}$ are optionally linked to form a substituted or unsubstituted $C_5$-$C_{30}$ carbocyclic group or a substituted or unsubstituted $C_1$-$C_{30}$ heterocyclic group,
two of $R_{31}$ to $R_{36}$ are optionally linked to form a substituted or unsubstituted $C_5$-$C_{30}$ carbocyclic group or a substituted or unsubstituted $C_1$-$C_{30}$ heterocyclic group,
two of $R_{41}$ to $R_{47}$ are optionally linked to form a substituted or unsubstituted $C_5$-$C_{30}$ carbocyclic group or a substituted or unsubstituted $C_1$-$C_{30}$ heterocyclic group,

*, *', and *" each indicate a binding site to a neighboring atom,

wherein the substituents of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{16}$ cycloalkyl group, the substituted $C_1$-$C_{16}$ heterocycloalkyl group, the substituted $C_3$-$C_{16}$ cycloalkenyl group, the substituted $C_1$-$C_{16}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_7$-$C_{60}$ arylalkyl group, the substituted $C_1$-$C_{60}$ heteroaryl group, the substituted $C_1$-$C_{60}$ heteroaryloxy group, the substituted $C_1$-$C_{60}$ heteroarylthio group, the substituted $C_2$-$C_{60}$ heteroarylalkyl group, the substituted monovalent non-aromatic condensed polycyclic group, and the substituted monovalent non-aromatic condensed heteropolycyclic group are selected from:

deuterium, -F, Cl, -Br, -I, $-CD_3$, $-CD_2H$, $-CDH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, - Cl, -Br, -I, $-CD_3$, $-CD_2H$, $-CDH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{16}$ cycloalkyl group, a $C_1$-$C_{16}$ heterocycloalkyl group, a $C_3$-$C_{16}$ cycloalkenyl group, a $C_1$-$C_{16}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{11})(Q_{12})$, - $Si(Q_{13})(Q_{14})(Q_{15})$, $-B(Q_{16})(Q_{17})$, and $-P(=O)(Q_{18})(Q_{19})$;

a $C_3$-$C_{16}$ cycloalkyl group, a $C_1$-$C_{16}$ heterocycloalkyl group, a $C_3$-$C_{16}$ cycloalkenyl group, a $C_1$-$C_{16}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group;

a $C_3$-$C_{16}$ cycloalkyl group, a $C_1$-$C_{16}$ heterocycloalkyl group, a $C_3$-$C_{16}$ cycloalkenyl group, a $C_1$-$C_{16}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, each substituted with at least one selected from deuterium, -F, -Cl, -Br, -I, $-CD_3$, $-CD_2H$, $-CDH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{16}$ cycloalkyl group, a $C_1$-$C_{16}$ heterocycloalkyl group, a $C_3$-$C_{16}$ cycloalkenyl group, a $C_1$-$C_{16}$ heterocycloalkenyl group, a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a $C_1$-$C_{60}$ heteroarylthio group, a $C_2$-$C_{60}$ heteroarylalkyl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, $-B(Q_{26})(Q_{27})$, and $-P(=O)(Q_{28})(Q_{29})$; and

$-N(Q_{31})(Q_{32})$, $-Si(Q_{33})(Q_{34})(Q_{35})$, $-B(Q_{36})(Q_{37})$, and $-P(=O)(Q_{38})(Q_{39})$,

$Q_1$ to $Q_9$, $Q_{11}$ to $Q_{19}$, $Q_{21}$ to $Q_{29}$, and $Q_{31}$ to $Q_{39}$ are each independently selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{16}$ cycloalkyl group, a $C_1$-$C_{16}$ heterocycloalkyl group, a $C_3$-$C_{16}$ cycloalkenyl group, a $C_1$-$C_{16}$ heterocycloalkenyl group, a $C_6$-$C_{60}$ aryl group, a $C_6$-$C_{60}$ aryl group substituted with at least one selected from a $C_1$-$C_{60}$ alkyl group and a $C_6$-$C_{60}$ aryl group, a $C_6$-$C_{60}$ aryloxy group, a $C_6$-$C_{60}$ arylthio group, a $C_7$-$C_{60}$ arylalkyl group, a $C_1$-$C_{60}$ heteroaryl group, a $C_1$-$C_{60}$ heteroaryloxy group, a C1-$C_{60}$ heteroarylthio group, a $C_2$-$C_{60}$ heteroarylalkyl group, a monovalent non-aromatic condensed polycyclic group, and a monovalent non-aromatic condensed heteropolycyclic group, and

Formula 1 satisfies at least one of Condition 1 to Condition 4:

Condition 1

$CY_1$ in Formula 1 is a group represented by Formula CZ1, provided that at least one of $X_{11}$ to $X_{17}$ in

Formula CZ1 is each independently N or C(CN),
Condition 2
at least one of $X_{21}$ to $X_{26}$ in Formula 1 is each independently N or C(CN),
Condition 3
$CY_3$ in Formula 1 is a group represented by Formula CZ3, provided that at least one of $X_{31}$ to $X_{36}$ in Formula CZ3 is each independently N or C(CN), and
Condition 4
$CY_4$ in Formula 1 is a group represented by Formula CZ4, provided that at least one of $X_{41}$ to $X_{47}$ in Formula CZ4 is each independently N or C(CN).

**2.** The organometallic compound of claim 1, wherein
M is Pt or Pd.

**3.** The organometallic compound of claims 1 or 2, wherein

i) $X_1$ and $X_4$ are each N, $X_2$ and $X_3$ are each C, a bond between $X_1$ and M and a bond between $X_4$ and M are each a coordinate bond, and a bond between $X_2$ and M and a bond between $X_3$ and M are each a covalent bond;
ii) $X_1$ and $X_3$ are each N, $X_2$ and $X_4$ are each C, a bond between $X_1$ and M and a bond between $X_3$ and M are each a coordinate bond, and a bond between $X_2$ and M and a bond between $X_4$ and M are each a covalent bond; or
iii) $X_3$ and $X_4$ are each N, $X_1$ and $X_2$ are each C, a bond between $X_3$ and M and a bond between $X_4$ and M are each a coordinate bond, and a bond between $X_1$ and M and a bond between $X_2$ and M are each a covalent bond.

**4.** The organometallic compound of any of claims 1-3, wherein
$CY_1$, $CY_3$, and $CY_4$ are each independently selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a pyrrole group, a thiophene group, a furan group, an indole group, an isoindole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-on group, a dibenzothiophene 5,5-dioxide group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-on group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group;
$CY_1$ is a group represented by Formula CZ1;
$CY_3$ is a group represented by Formula CZ3; or
$CY_4$ is a group represented by Formula CZ4.

**5.** The organometallic compound of any of claims 1-4, wherein,
in Formula 1, a moiety represented by

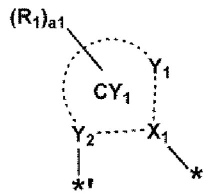

and a moiety represented by

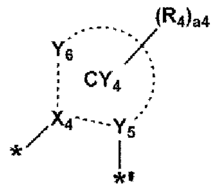

are identical to each other; a moiety represented by

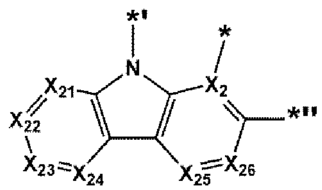

and a moiety represented by

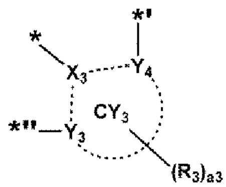

are identical to each other; a moiety represented by

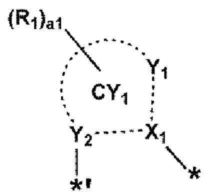

and a moiety represented by

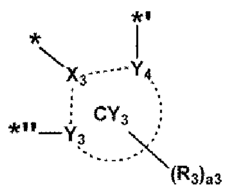

are identical to each other; a moiety represented by

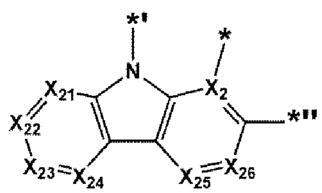

and a moiety represented

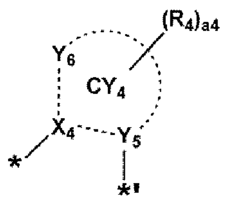

by

are identical to each other; or a moiety represented by

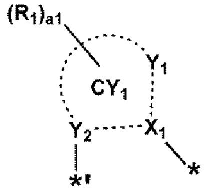

,

a moiety represented by

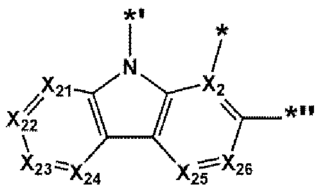

,

a moiety represented by

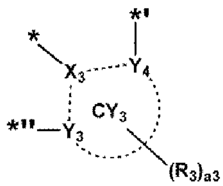

,

and a moiety represented by

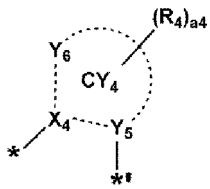

are different from one another.

**6.** The organometallic compound of any of claims 1-5, wherein
the organometallic compound has a symmetrical structure with respect to an axis connecting M and $T_2$ in Formula 1; and/or
wherein
$T_1$ to $T_3$ are each independently *-N[$(L_5)_{b5}$-$(R_5)$]-*', *-B($R_5$)-*', *-C($R_5$)($R_6$)-*', *-Si($R_5$)($R_6$)-*', *-S-*', or *-O-*', and the sum of n1, n2, and n3 is 1 or 2.

**7.** The organometallic compound of any of claims 1-6, wherein

$R_1$, $R_3$ to $R_6$, $R_{11}$ to $R_{17}$, $R_{21}$ to $R_{26}$, $R_{31}$ to $R_{36}$, and $R_{41}$ to $R_{47}$ are each independently selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{16}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
$-N(Q_1)(Q_2)$, $-Si(Q_3)(Q_4)(Q_5)$, $-B(Q_6)(Q_7)$, and $-P(=O)(Q_8)(Q_9)$, and
$Q_1$ to $Q_9$ are each independently selected from:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, and $-CD_2CDH_2$;
an n-propyl group, an iso-propyl group, an n-butyl group, an iso-butyl group, a sec-butyl group, a tert-butyl

group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group, each substituted with at least one selected from deuterium, a $C_1$-$C_{16}$ alkyl group, and a phenyl group;

preferably wherein

$R_1$, $R_3$ to $R_6$, $R_{11}$ to $R_{17}$, $R_{21}$ to $R_{26}$, $R_{31}$ to $R_{36}$, and $R_{41}$ to $R_{47}$ are each independently hydrogen, deuterium, -F, a cyano group, a nitro group, $-SF_5$, $-CH_3$, $-CD_3$, $-CD_2H$, $-CDH_2$, $-CF_3$, $-CF_2H$, $-CFH_2$, groups represented by Formulae 9-1 to 9-19, groups represented by Formulae 10-1 to 10-139, and $-Si(Q_3)(Q_4)(Q_5)$:

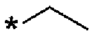
Formula 9-1

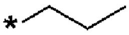
Formula 9-2

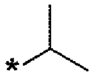
Formula 9-3

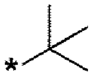
Formula 9-4

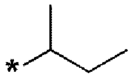
Formula 9-5

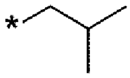
Formula 9-6

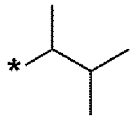
Formula 9-7

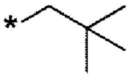
Formula 9-8

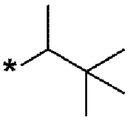
Formula 9-9

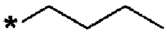
Formula 9-10

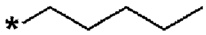
Formula 9-11

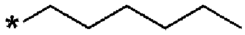
Formula 9-12

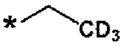
Formula 9-13

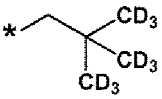
Formula 9-14

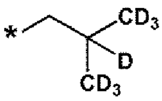
Formula 9-15

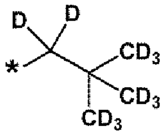
Formula 9-16

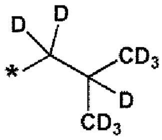
Formula 9-17

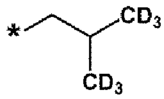
Formula 9-18

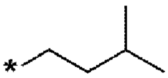
Formula 9-19

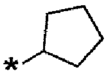
Formula 10-1

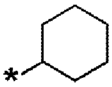
Formula 10-2

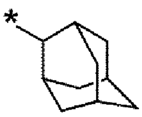
Formula 10-3

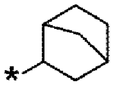
Formula 10-4

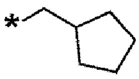
Formula 10-5

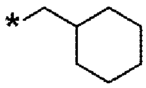
Formula 10-6

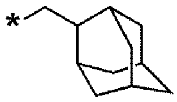
Formula 10-7

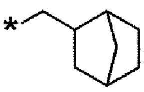
Formula 10-8

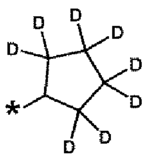
Formula 10-9

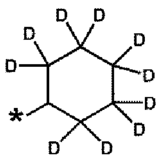
Formula 10-10

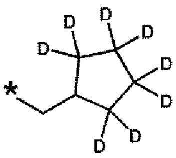
Formula 10-11

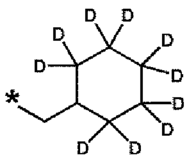
Formula 10-12

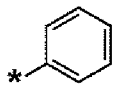
Formula 10-13

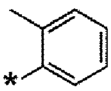
Formula 10-14

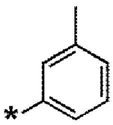
Formula 10-15

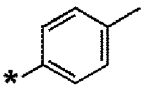
Formula 10-16

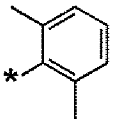
Formula 10-17

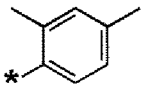
Formula 10-18

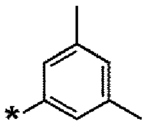
Formula 10-19

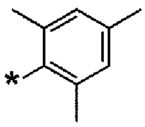
Formula 10-20

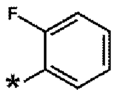 Formula 10-21
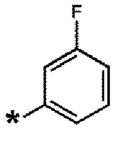 Formula 10-22
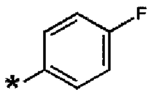 Formula 10-23
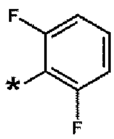 Formula 10-24
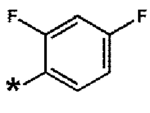 Formula 10-25
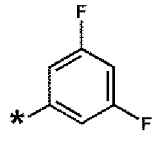 Formula 10-26
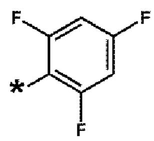 Formula 10-27

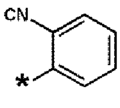 Formula 10-28
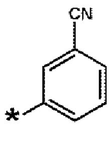 Formula 10-29
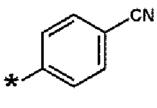 Formula 10-30
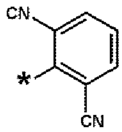 Formula 10-31
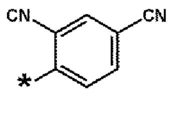 Formula 10-32
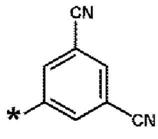 Formula 10-33
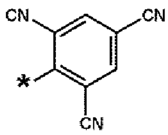 Formula 10-34

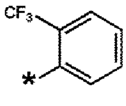 Formula 10-35
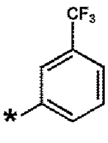 Formula 10-36
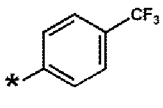 Formula 10-37
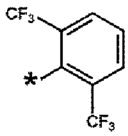 Formula 10-38
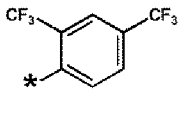 Formula 10-39
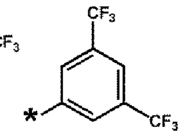 Formula 10-40
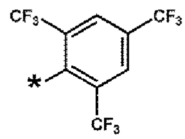 Formula 10-41

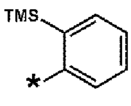 Formula 10-42
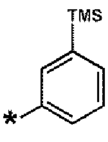 Formula 10-43
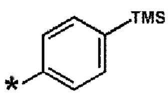 Formula 10-44
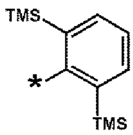 Formula 10-45
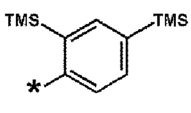 Formula 10-46
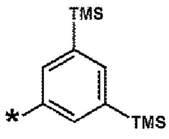 Formula 10-47
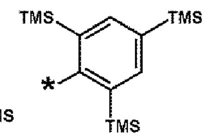 Formula 10-48

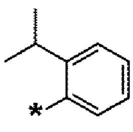 Formula 10-49
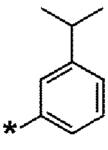 Formula 10-50
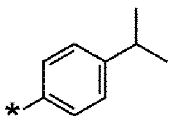 Formula 10-51
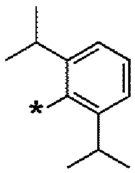 Formula 10-52
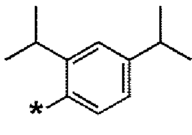 Formula 10-53
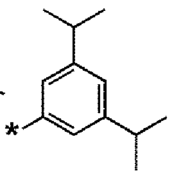 Formula 10-54
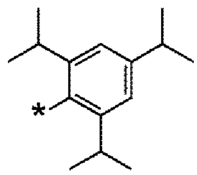 Formula 10-55

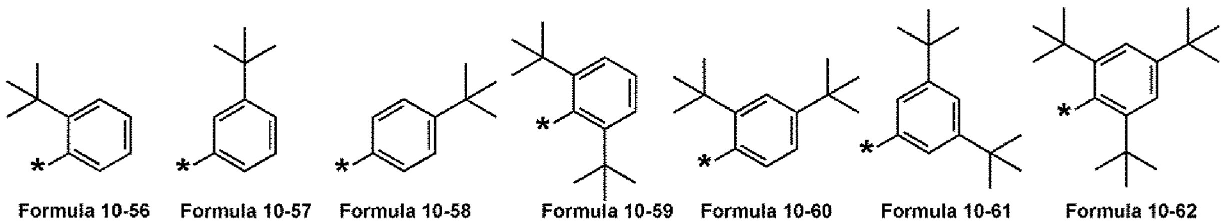

Formula 10-56 Formula 10-57 Formula 10-58 Formula 10-59 Formula 10-60 Formula 10-61 Formula 10-62

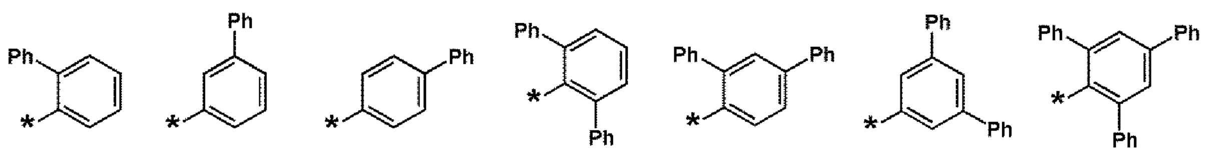

Formula 10-63 Formula 10-64 Formula 10-65 Formula 10-66 Formula 10-67 Formula 10-68 Formula 10-69

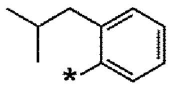
Formula 10-70

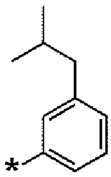
Formula 10-71

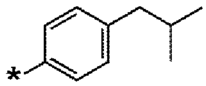
Formula 10-72

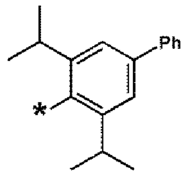
Formula 10-73

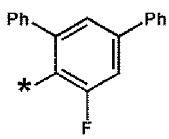
Formula 10-74

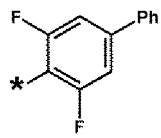
Formula 10-75

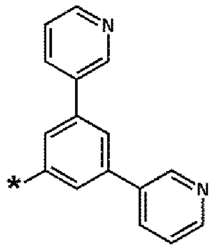
Formula 10-76

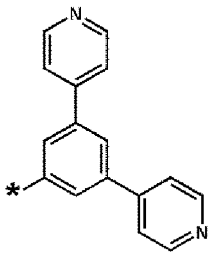
Formula 10-77

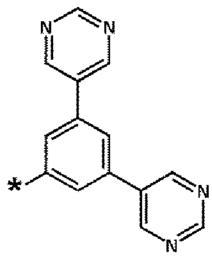
Formula 10-78

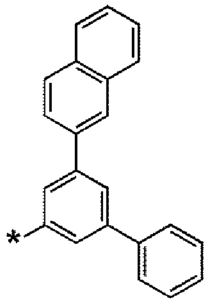
Formula 10-79

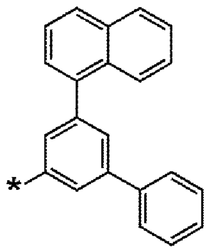
Formula 10-80

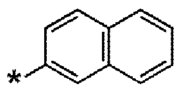
Formula 10-81

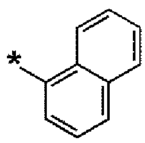
Formula 10-82

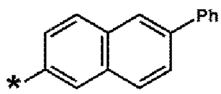
Formula 10-83

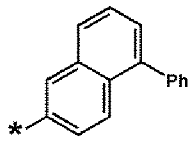
Formula 10-84

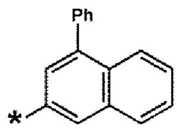
Formula 10-85

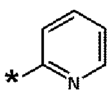
Formula 10-86

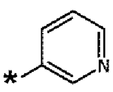
Formula 10-87

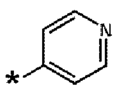
Formula 10-88

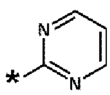
Formula 10-89

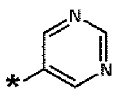
Formula 10-90

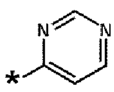
Formula 10-91

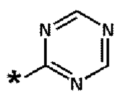
Formula 10-92

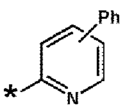
Formula 10-93

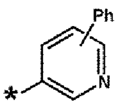
Formula 10-94

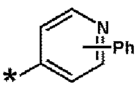
Formula 10-95

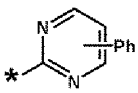
Formula 10-96

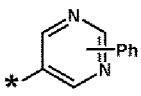
Formula 10-97

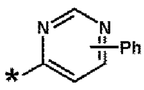
Formula 10-98

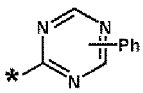
Formula 10-99

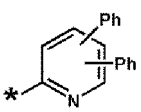
Formula 10-100

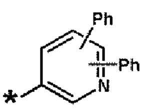
Formula 10-101

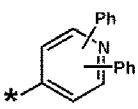
Formula 10-102

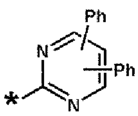
Formula 10-103

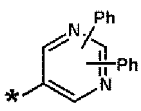
Formula 10-104

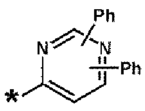
Formula 10-105

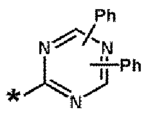
Formula 10-106

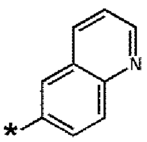
Formula 10-107

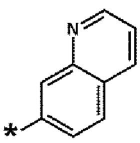
Formula 10-108

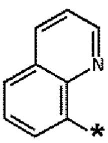
Formula 10-109

Formula 10-110

Formula 10-111

Formula 10-112

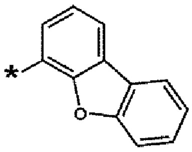
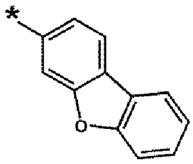
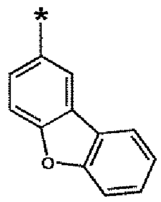
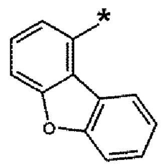
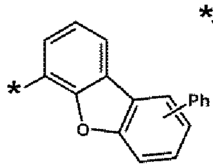
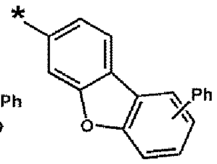

Formula 10-113 Formula 10-114 Formula 10-115 Formula 10-116 Formula 10-117 Formula 10-118

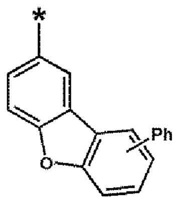
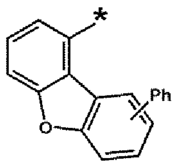
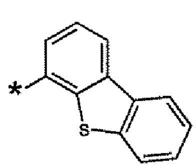
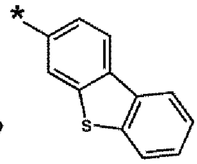
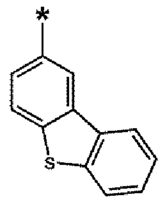
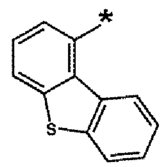

Formula 10-119 Formula 10-120 Formula 10-121 Formula 10-122 Formula 10-123 Formula 10-124

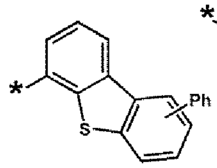
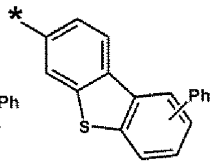
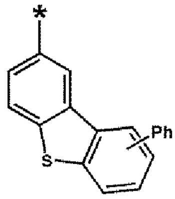
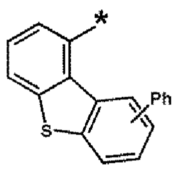
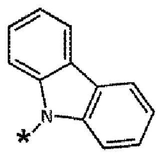
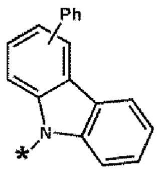

Formula 10-125 Formula 10-126 Formula 10-127 Formula 10-128 Formula 10-129 Formula 10-130

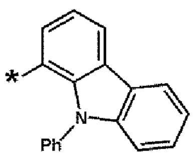
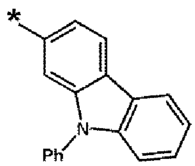
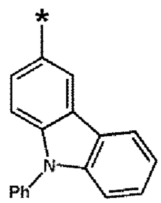
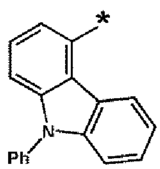
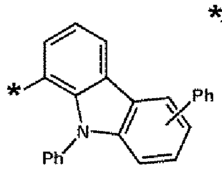
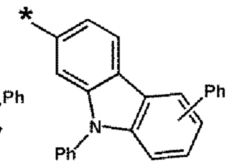

Formula 10-131 Formula 10-132 Formula 10-133 Formula 10-134 Formula 10-135 Formula 10-136

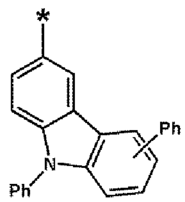
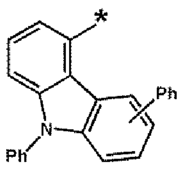
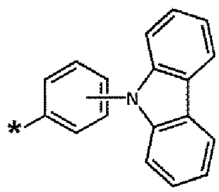

Formula 10-137 Formula 10-138 Formula 10-139

,

wherein, in Formulae 9-1 to 9-19 and 10-1 to 10-139, "Ph" indicates a phenyl group, "TMS" indicates a trimethylsilyl group, and * indicates a binding site to a neighboring atom.

**8.** The organometallic compound of any of claims 1-7, wherein a moiety represented by Formula 1

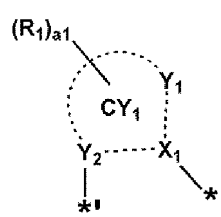

is selected from groups represented by Formulae CY1-1 to CY1-39 and CZ1-1 to CZ1-8:

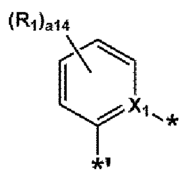
Formula CY1-1

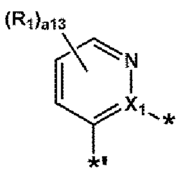
Formula CY1-2

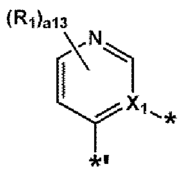
Formula CY1-3

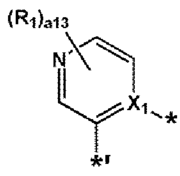
Formula CY1-4

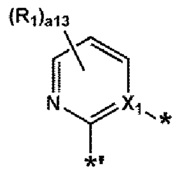
Formula CY1-5

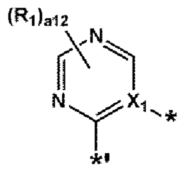
Formula CY1-6

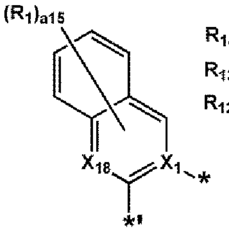
Formula CY1-7

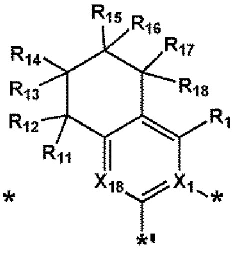
Formula CY1-8

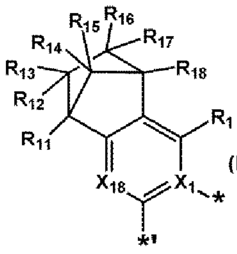
Formula CY1-9

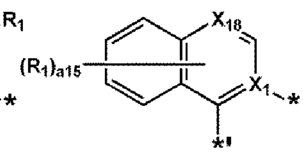
Formula CY1-10

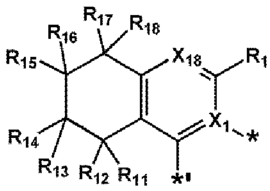
Formula CY1-11

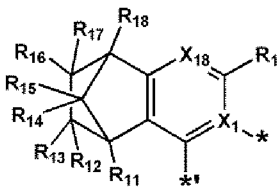
Formula CY1-12

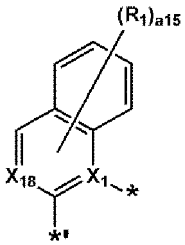
Formula CY1-13

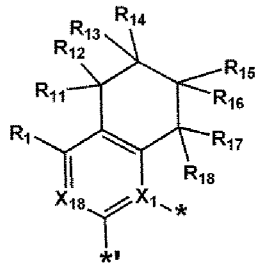
Formula CY1-14

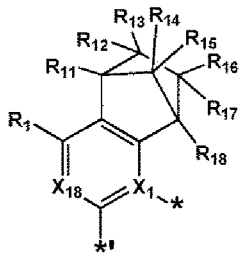
Formula CY1-15

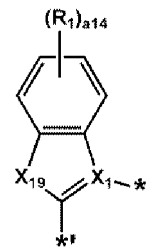
Formula CY1-16

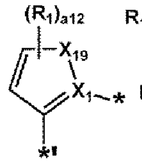
Formula CY1-17

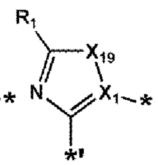
Formula CY1-18

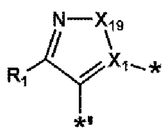
Formula CY1-19

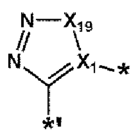
Formula CY1-20

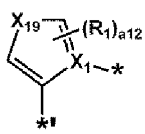
Formula CY1-21

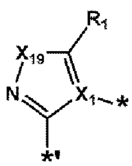
Formula CY1-22

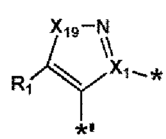
Formula CY1-23

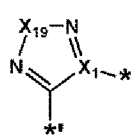
Formula CY1-24

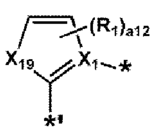
Formula CY1-25

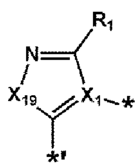
Formula CY1-26

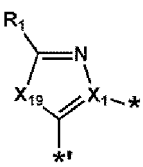
Formula CY1-27

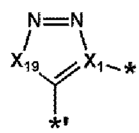
Formula CY1-28

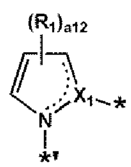
Formula CY1-29

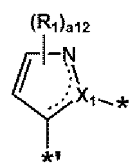
FormulaCY1-30

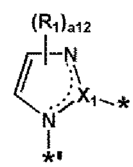
Formula CY1-31

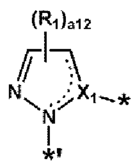
Formula CY1-32

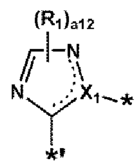
Formula CY1-33

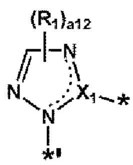
Formula CY1-34

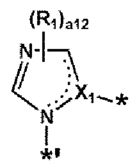
Formula CY1-35

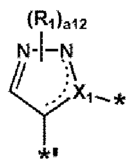
Formula CY1-36

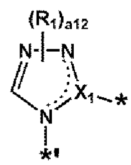
Formula CY1-37

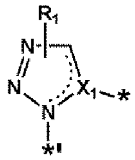
Formula CY1-38

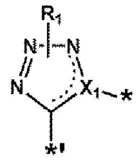
Formula CY1-39

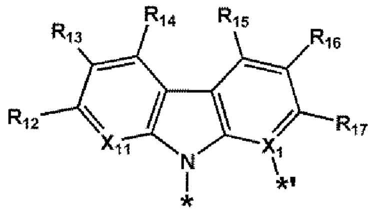
Formula CZ1-1

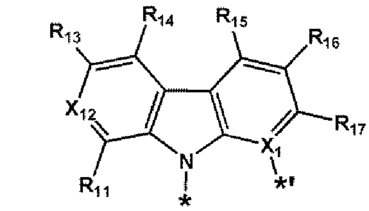
Formula CZ1-2

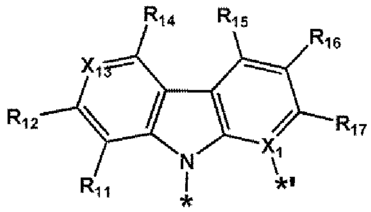
Formula CZ1-3

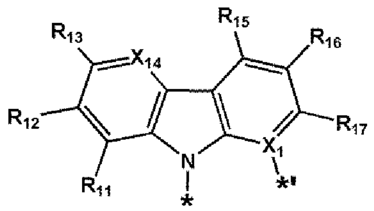
Formula CZ1-4

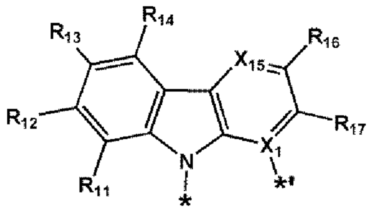
Formula CZ1-5

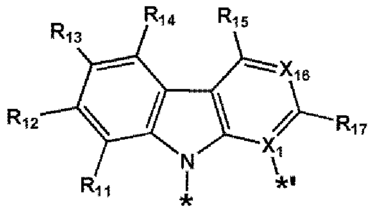
Formula CZ1-6

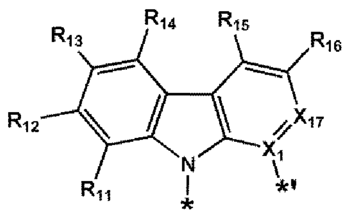
Formula CZ1-7

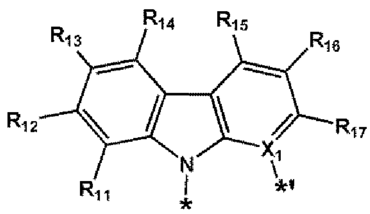
Formula CZ1-8

,

wherein, in Formulae CY1-1 to CY1-39 and CZ1-1 to CZ1-8,

$X_1$ and $R_1$ are each independently the same as described in claim 1,
$X_{18}$ is N or $C(R_{18})$,
$X_{19}$ is O, S, $N[(L_{19})_{b19}-(R_{19})]$, or $C(R_{19a})(R_{19b})$,
$R_{11}$ to $R_{18}$ are each independently the same as described in connection with $R_1$ in claim 1,
$L_{19}$ and b19 are each independently the same as described in connection with $L_5$ and b5 in claim 1,
$R_{19}$, $R_{19a}$, and $R_{19b}$ are each independently the same as described in connection with $R_5$ in claim 1,
$X_{11}$ to $X_{17}$ are each N or C(CN),
a15 is an integer from 0 to 5,
a14 is an integer from 0 to 4,
a13 is an integer from 0 to 3,
a12 is an integer from 0 to 2, and
* and *' each indicate a binding site to a neighboring atom; and/or

wherein a moiety represented by

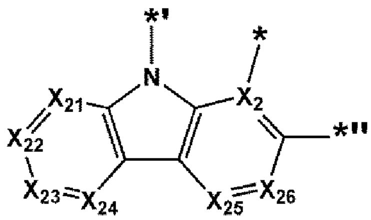

in Formula 1 is selected from groups represented by Formulae CZ2-1 to CZ2-7:

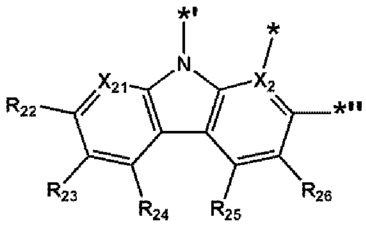

**Formula CZ2-1**

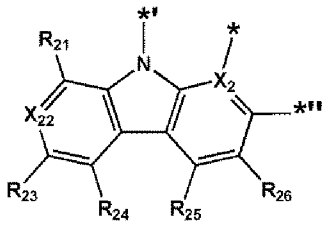

**Formula CZ2-2**

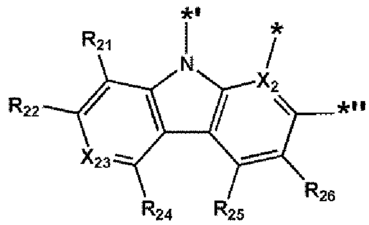

**Formula CZ2-3**

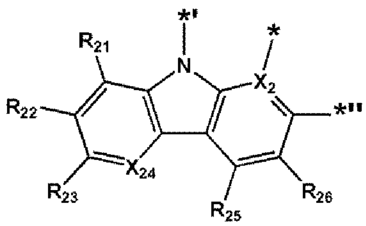

**Formula CZ2-4**

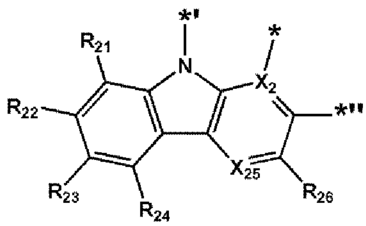

**Formula CY2-5**

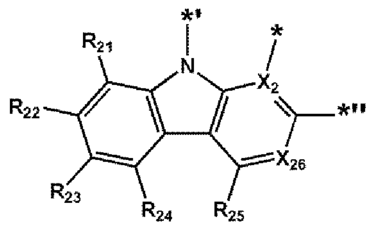

**Formula CZ2-6**

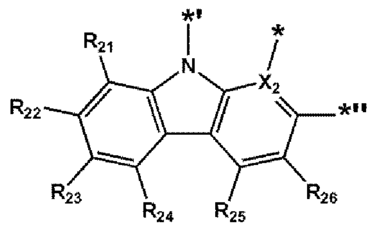

**Formula CZ2-7**

,

wherein, in Formulae CZ2-1 to CZ2-7,

$X_2$ and $R_{21}$ to $R_{26}$ are each independently the same as described in claim 1,
$X_{21}$ to $X_{26}$ are each N or C(CN), and
*, *', and *" each indicate a binding site to a neighboring atom.

**9.** The organometallic compound of any of claims 1-8, wherein a moiety represented by

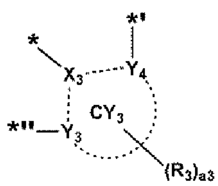

in Formula 1 is selected from groups represented by Formulae CY3-1 to CY3-27 and CZ3-1 to CZ3-7:

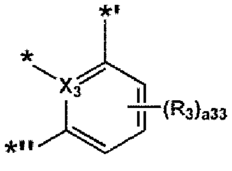
Formula CY3-1

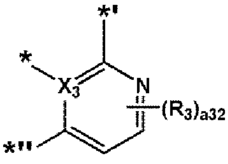
Formula CY3-2

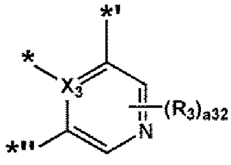
Formula CY3-3

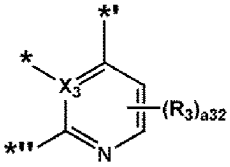
Formula CY3-4

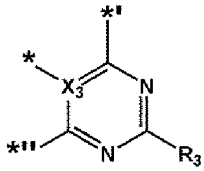
Formula CY3-5

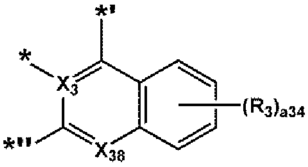
Formula CY3-6

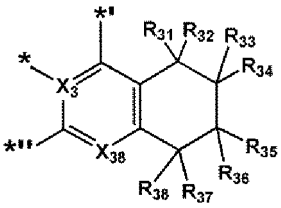
Formula CY3-7

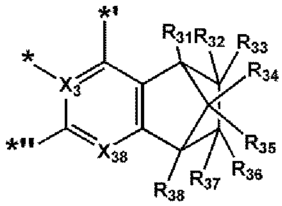
Formula CY3-8

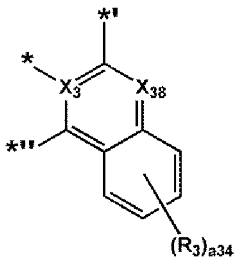
Formula CY3-9

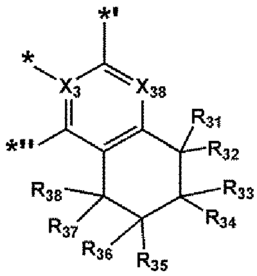
Formula CY3-10

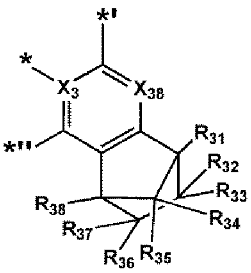
Formula CY3-11

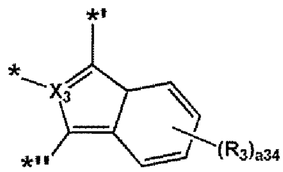
Formula CY3-12

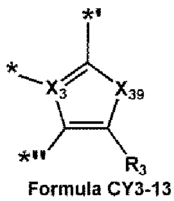
Formula CY3-13

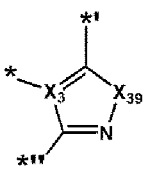
Formula CY3-14

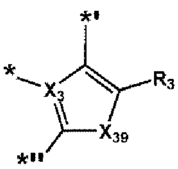
Formula CY3-15

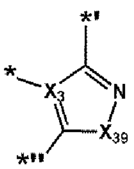
Formula CY3-16

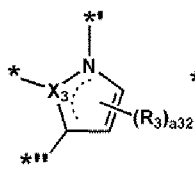
Formula CY3-17

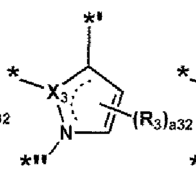
Formula CY3-18

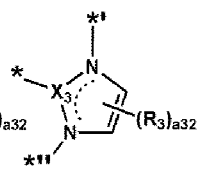
Formula CY3-19

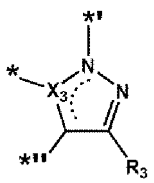
Formula CY3-20

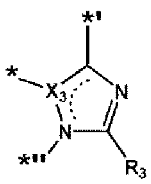
Formula CY3-21

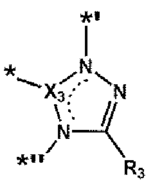
Formula CY3-22

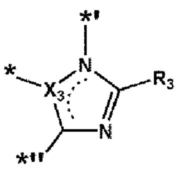
Formula CY3-23

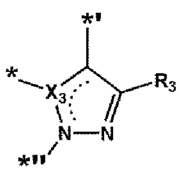
Formula CY3-24

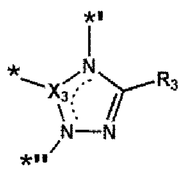
Formula CY3-25

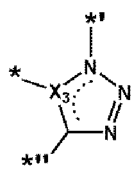
Formula CY3-26

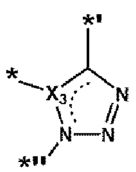
Formula CY3-27

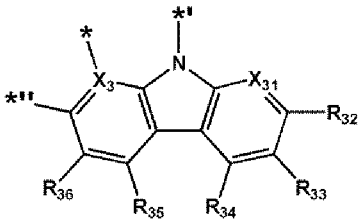

Formula CZ3-1

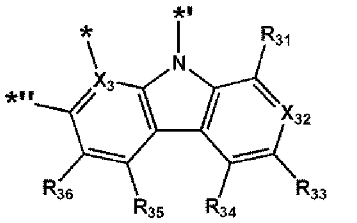

Formula CZ3-2

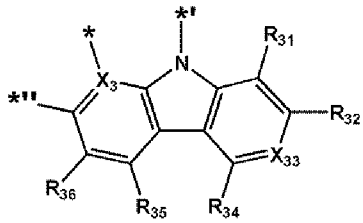

Formula CZ3-3

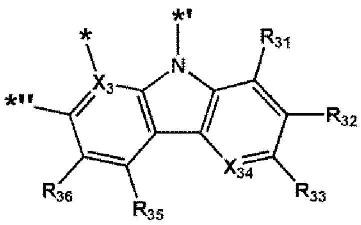

Formula CZ3-4

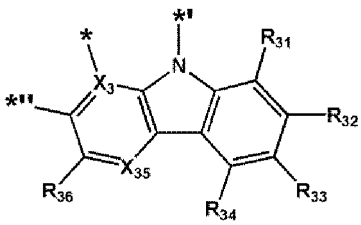

Formula CZ3-5

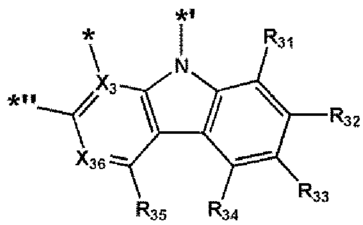

Formula CZ3-6

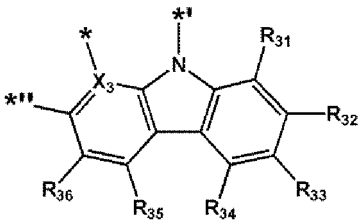

Formula CZ3-7

,

wherein, in Formulae CY3-1 to CY3-27 and CZ3-1 to CZ3-7,

$X_3$ and $R_3$ are each independently the same as described in claim 1,
$X_{38}$ is N or $C(R_{38})$,
$X_{39}$ is O, S, $N[(L_{39})_{b39}-(R_{39})]$, or $C(R_{39a})(R_{39b})$,
$R_{31}$ to $R_{38}$ are each independently the same as described in connection with $R_1$ in claim 1,
$L_{39}$ and b39 are each independently the same as described in connection with $L_5$ and b5 in claim 1,
$R_{39}$, $R_{39a}$, and $R_{39b}$ are each independently the same as described in connection with $R_5$ in claim 1,
$X_{31}$ to $X_{36}$ are each N or C(CN),
a34 is an integer from 0 to 4,
a33 is an integer from 0 to 3,
a32 is an integer from 0 to 2, and
*, *', and *" each indicate a binding site to a neighboring atom.

**10.** The organometallic compound of any of claims 1-9, wherein a moiety represented by

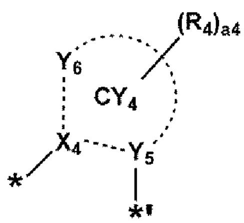

in Formula 1 is selected from groups represented by Formulae CY4-1 to CY3-39 and CZ4-1 to CZ4-8:

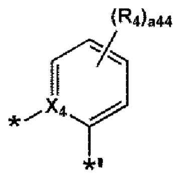
Formula CY4-1

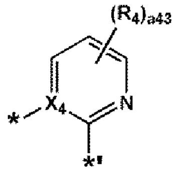
Formula CY4-2

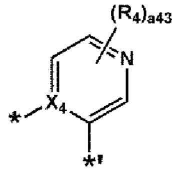
Formula CY4-3

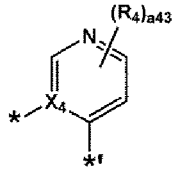
Formula CY4-4

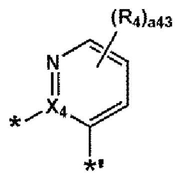
Formula CY4-5

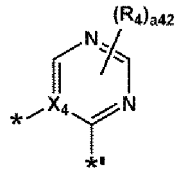
Formula CY4-6

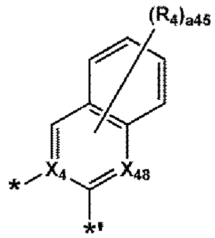
Formula CY4-7

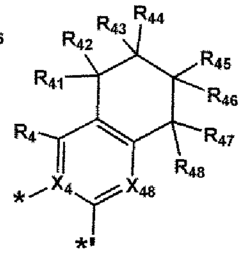
Formula CY4-8

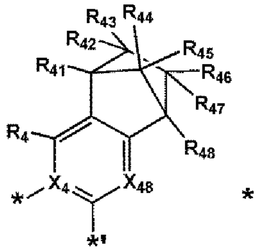
Formula CY4-9

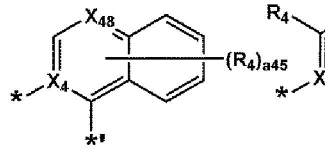
Formula CY4-10

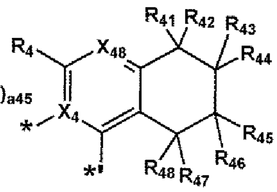
Formula CY4-11

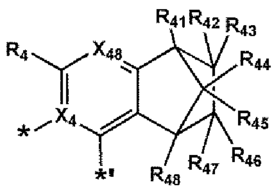
Formula CY4-12

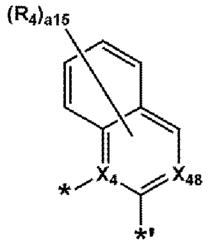
Formula CY4-13

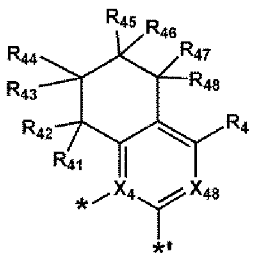
FormulaCY4-14

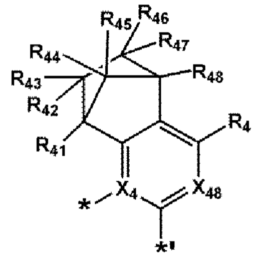
Formula CY4-15

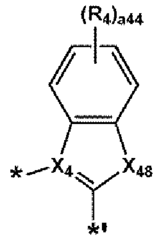
Formula CY4-16

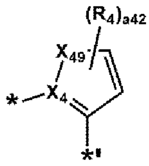
Formula CY4-17

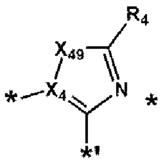
Formula CY4-18

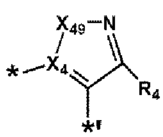
Formula CY4-19

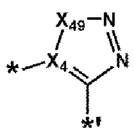
Formula CY4-20

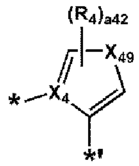
Formula CY4-21

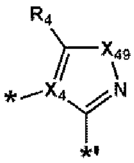
Formula CY4-22

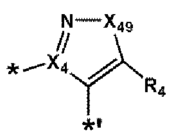
Formula CY4-23

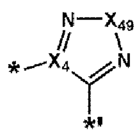
Formula CY4-24

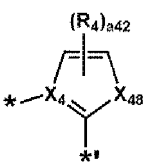
Formula CY4-25

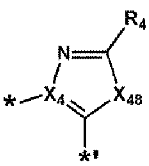
Formula CY4-26

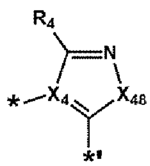
Formula CY4-27

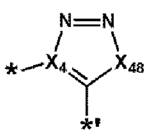
Formula CY4-28

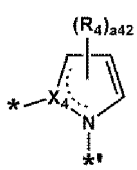
Formula CY4-29

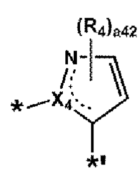
Formula CY4-30

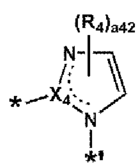
Formula CY4-31

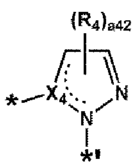
Formula CY4-32

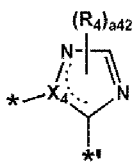
Formula CY4-33

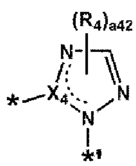
Formula CY4-34

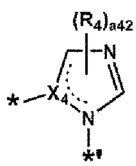
Formula CY4-35

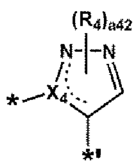
Formula CY4-36

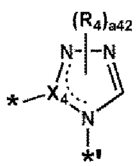
Formula CY4-37

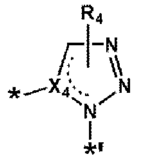

Formula CY4-38

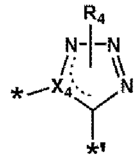

Formula CY4-39

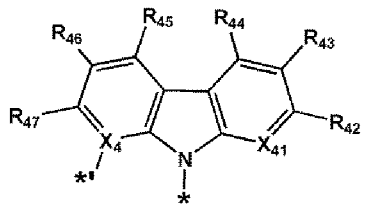

Formula CZ4-1

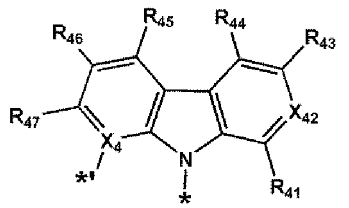

Formula CZ4-2

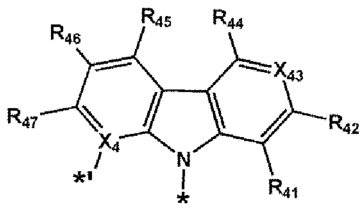

Formula CZ4-3

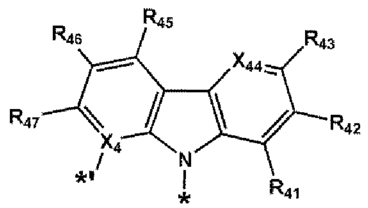

Formula CZ4-4

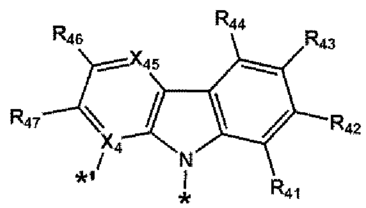

Formula CZ4-5

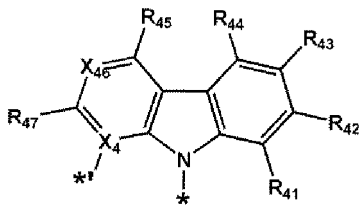

Formula CZ4-6

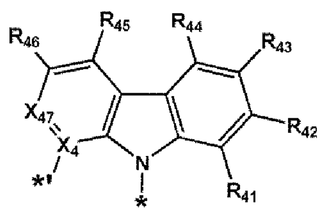

Formula CZ4-7

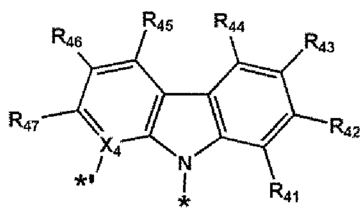

Formula CZ4-8

,

wherein, in Formulae CY4-1 to CY4-39 and CZ4-1 to CZ4-8,

$X_4$ and $R_4$ are each independently the same as described in claim 1,
$X_{48}$ is N or $C(R_{48})$,
$X_{49}$ is O, S, $N[(L_{49})_{b49}-(R_{49})]$, or $C(R_{49a})(R_{49b})$,
$R_{41}$ to $R_{48}$ are each independently the same as described in connection with $R_1$ in claim 1,
$L_{49}$ and b49 are each independently the same as described in connection with $L_5$ and b5 in claim 1,
$R_{49}$, $R_{49a}$, and $R_{49b}$ are each independently the same as described in connection with $R_5$ in claim 1,
$X_{41}$ to $X_{47}$ are each N or C(CN),
a45 is an integer from 0 to 5,
a44 is an integer from 0 to 4,
a43 is an integer from 0 to 3,
a42 is an integer from 0 to 2, and
* and *' each indicate a binding site to a neighboring atom.

**11.** The organometallic compound of any of claims 1-10, wherein the organometallic compound satisfies at least one of Condition 1-1 to Condition 4-1:

Condition 1-1
a moiety represented by

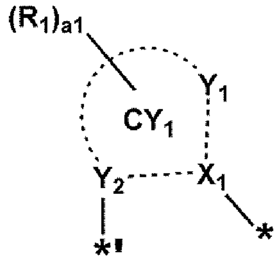

in Formula 1 is selected from groups represented by Formulae CZ1-1 to CZ1-7,
Condition 2-1
a moiety represented by

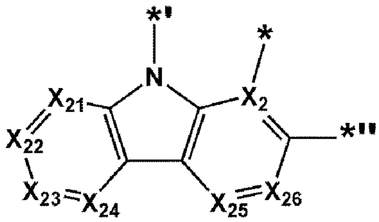

in Formula 1 is selected from groups represented by Formulae CZ2-1 to CZ2-6,
Condition 3-1
a moiety represented by

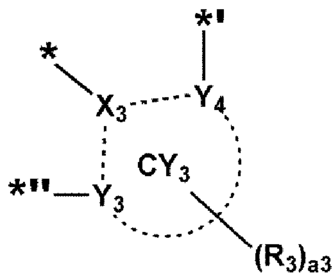

in Formula 1 is selected from groups represented by Formulae CZ3-1 to CZ3-6, and
Condition 4-1
a moiety represented by

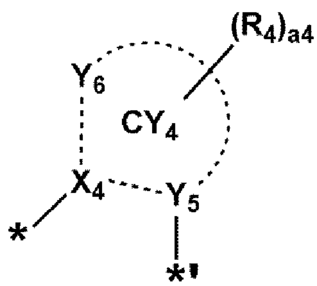

in Formula 1 is selected from groups represented by Formulae CZ4-1 to CZ4-7:

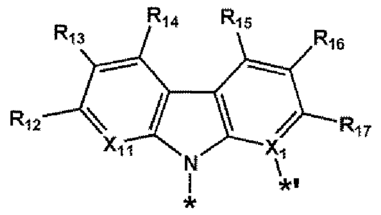

Formula CZ1-1

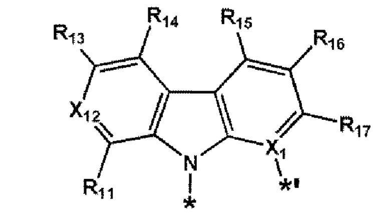

Formula CZ1-2

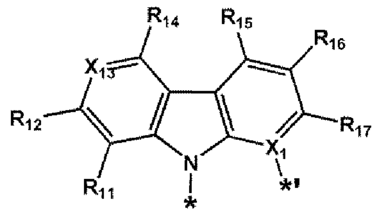

Formula CZ1-3

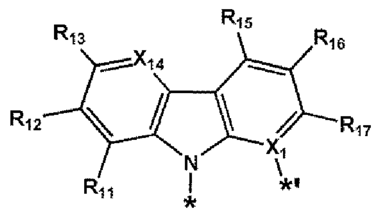

Formula CZ1-4

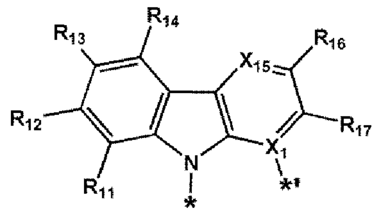

Formula CZ1-5

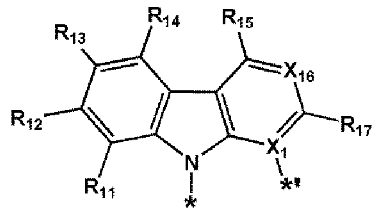

Formula CZ1-6

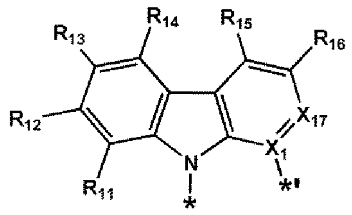

Formula CZ1-7

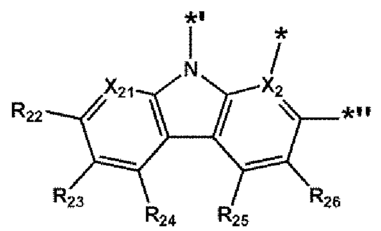

Formula CZ2-1

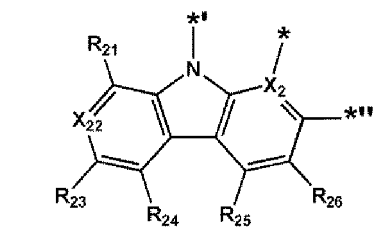

Formula CZ2-2

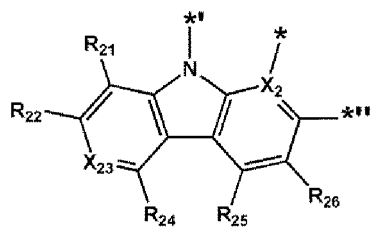

Formula CZ2-3

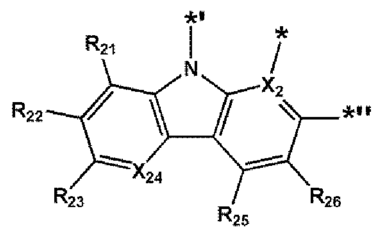

Formula CZ2-4

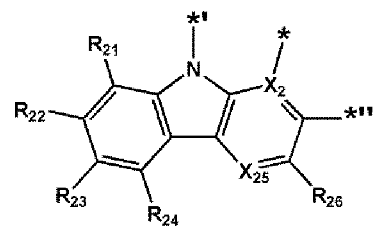

Formula CY2-5

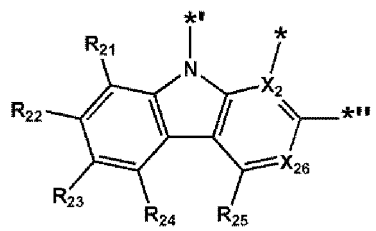

Formula CZ2-6

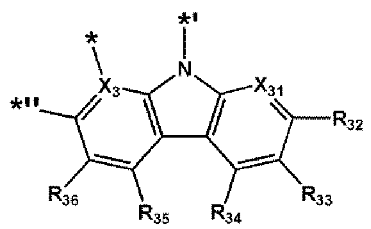

Formula CZ3-1

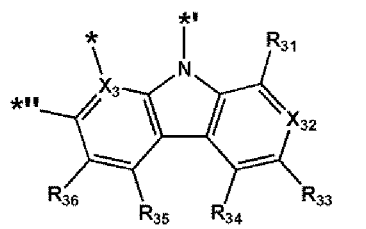

Formula CZ3-2

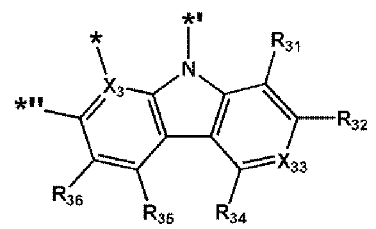

Formula CZ3-3

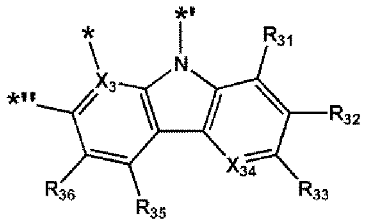

Formula CZ3-4

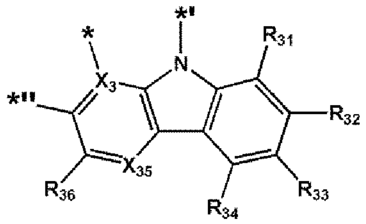

Formula CZ3-5

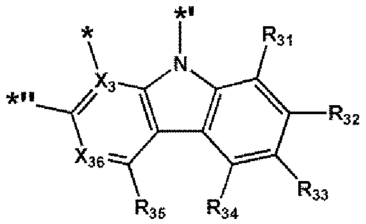

Formula CZ3-6

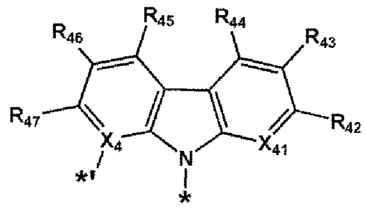

Formula CZ4-1

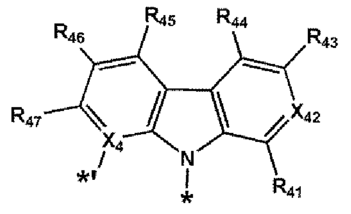

Formula CZ4-2

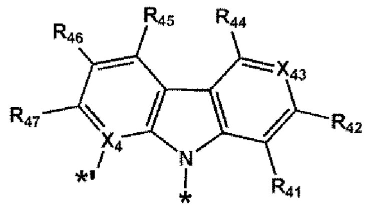

Formula CZ4-3

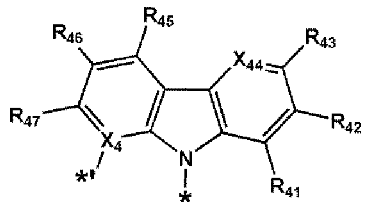

Formula CZ4-4

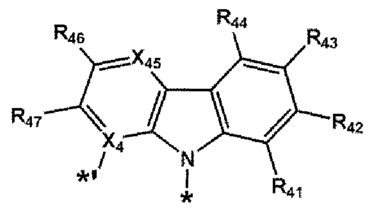

Formula CZ4-5

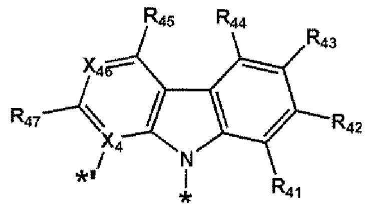

Formula CZ4-6

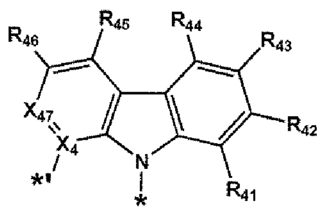

Formula CZ4-7

,

wherein, in Formulae CZ1-1 to CZ1-7, CZ2-1 to CZ2-6, CZ3-1 to CZ3-6, and CZ4-1 to CZ4-7,

$X_1$, $X_2$, $X_3$, $X_4$, $R_{11}$ to $R_{17}$, $R_{21}$ to $R_{26}$, $R_{31}$ to $R_{36}$, and $R_{41}$ to $R_{47}$ are each independently the same as described in claim 1,
$X_{11}$ to $X_{17}$, $X_{21}$ to $X_{26}$, $X_{31}$ to $X_{36}$, and $X_{41}$ to $X_{47}$ are each independently N or C(CN), and
*, *', and *'' each indicate a binding site to a neighboring atom.

**12.** The organometallic compound of any of claims 1-11, wherein the organometallic compound is selected from Compounds 1 to 136:

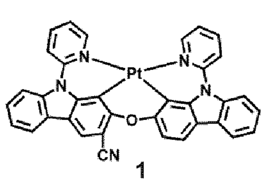

1

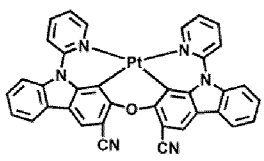

2

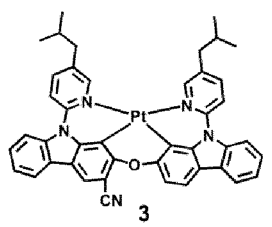

3

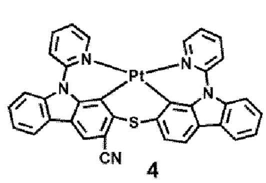

4

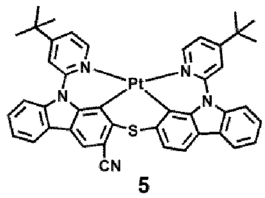
5

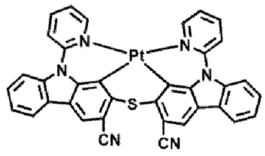
6

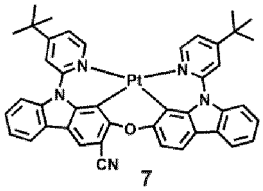
7

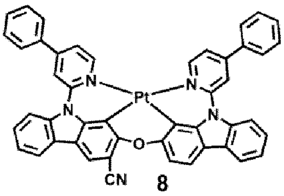
8

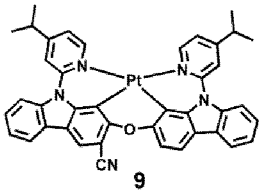
9

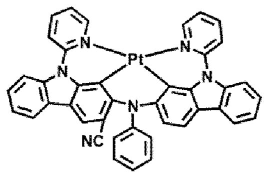
10

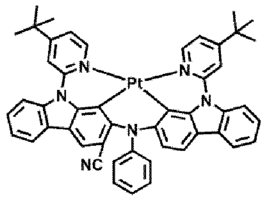
11

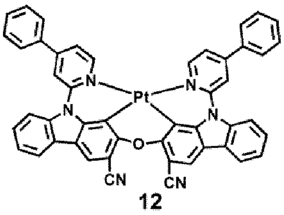
12

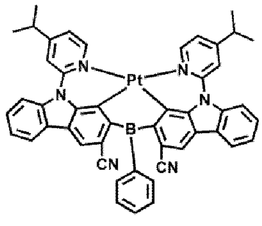
13

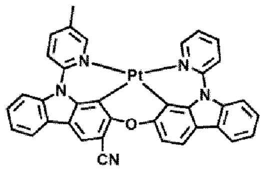
14

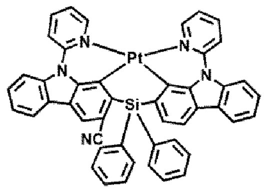
15

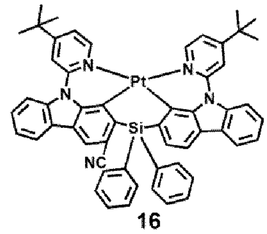
16

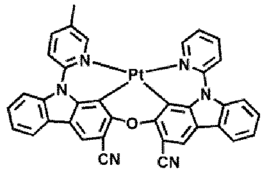
17

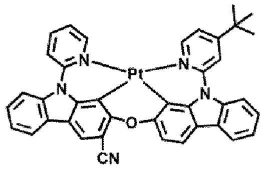
18

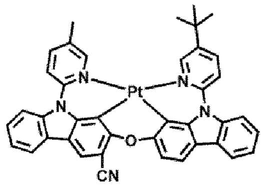
19

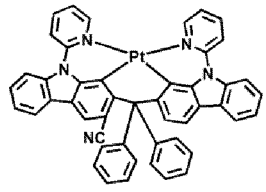
20

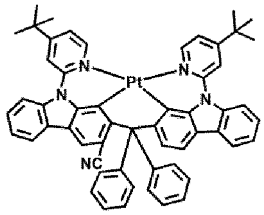
21

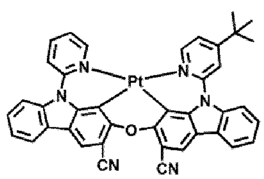
22

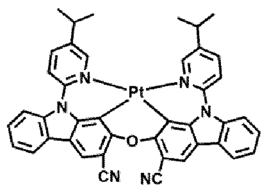
23

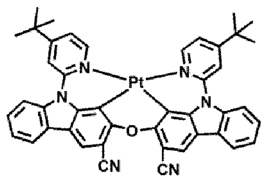
24

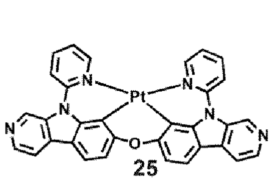
25

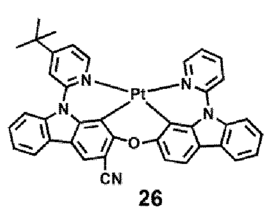
26

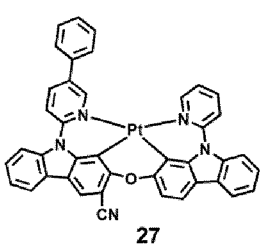
27

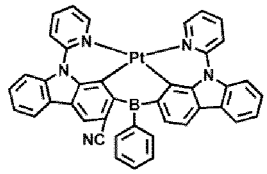
28

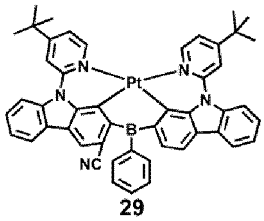
29

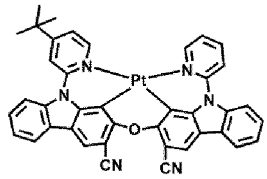
30

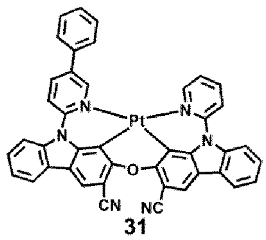
31

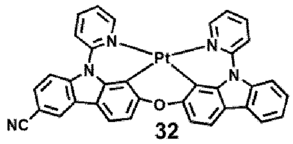
32

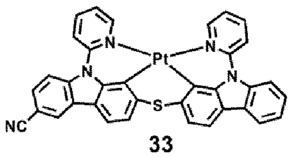
33

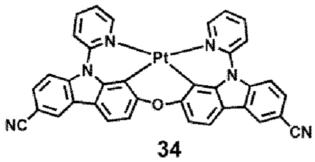
34

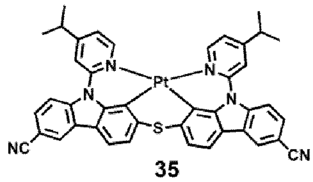
35

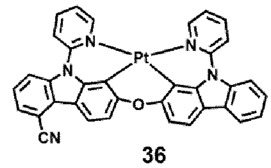
36

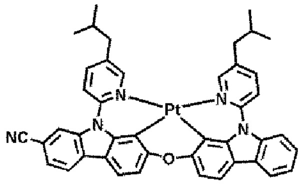
37

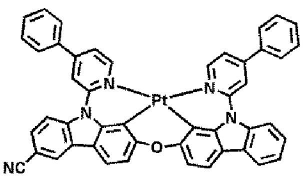
38

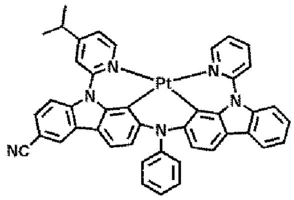
39

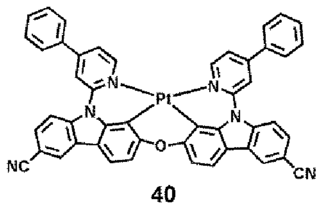
40

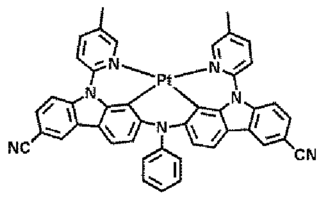
41

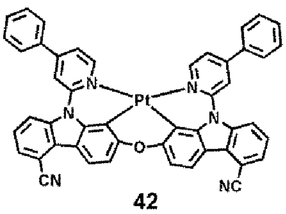
42

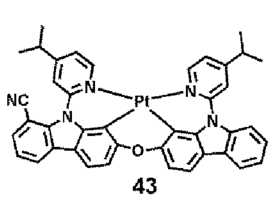
43

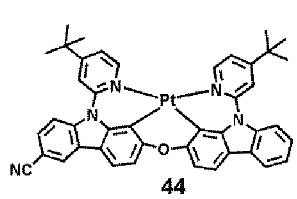
44

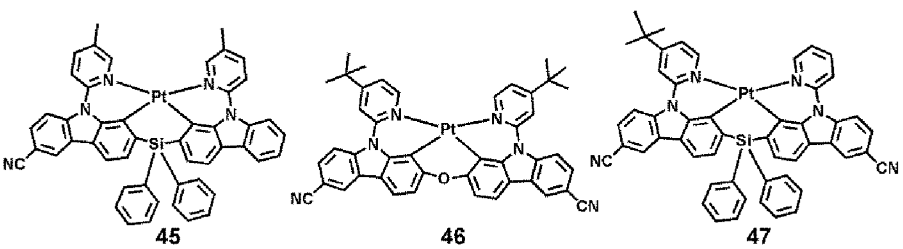
45

46

47

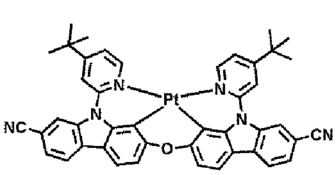
48

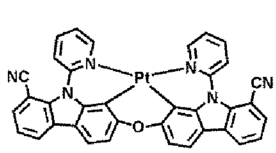
49

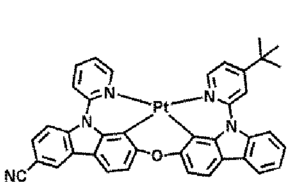
50

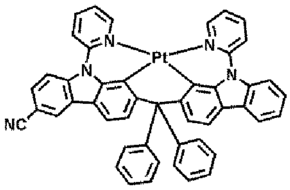
51

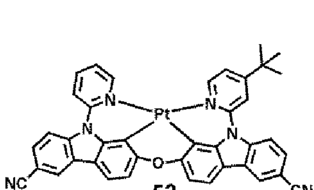
52

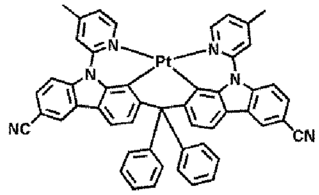
53
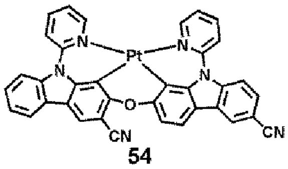
54
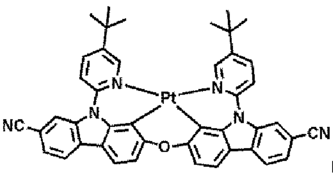
55
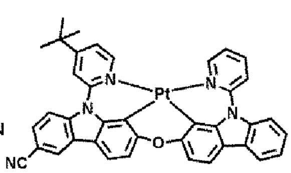
56

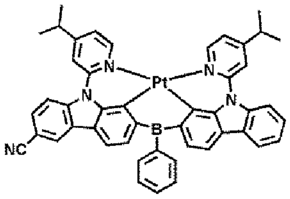
57
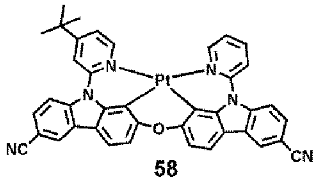
58
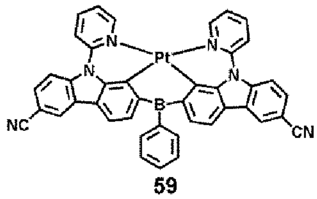
59
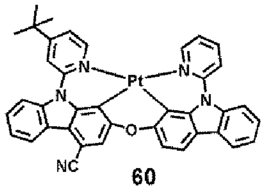
60

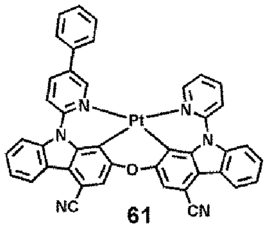
61
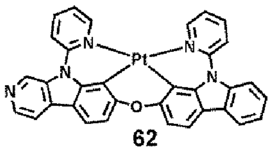
62
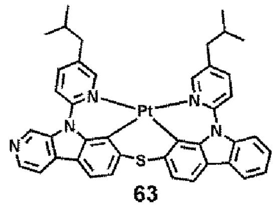
63
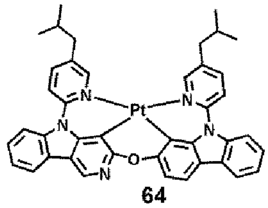
64

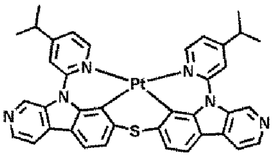
65
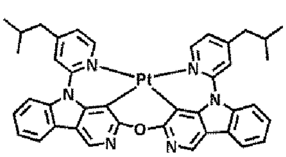
66
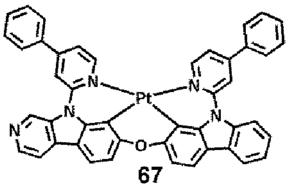
67
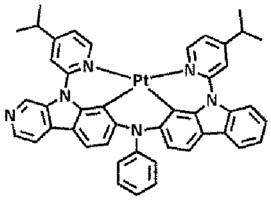
68

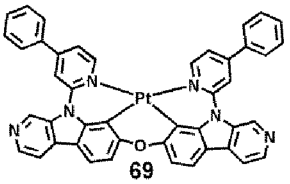
69
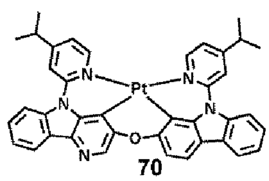
70
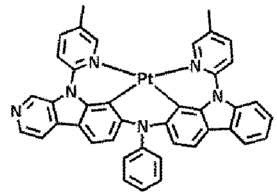
71
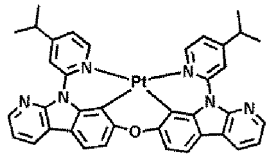
72

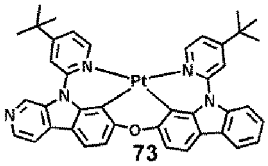
73
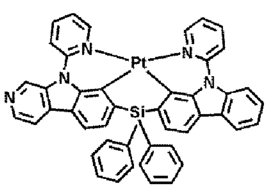
74
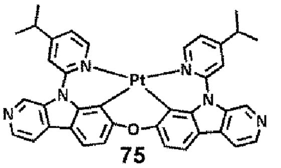
75
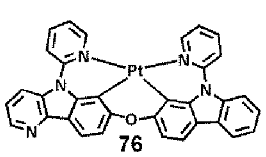
76

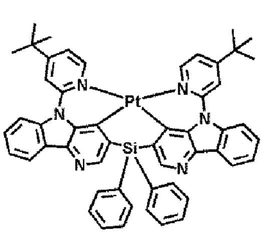
77

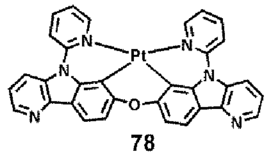
78

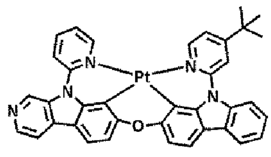
79

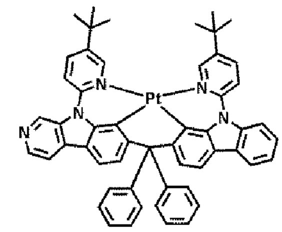
80

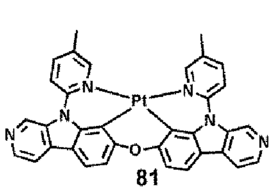
81

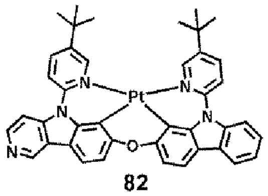
82

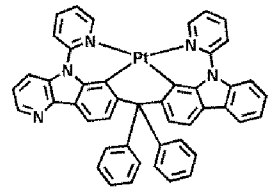
83

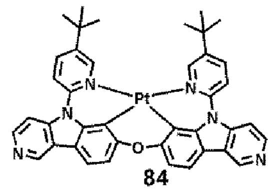
84

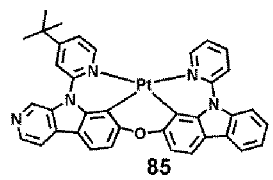
85

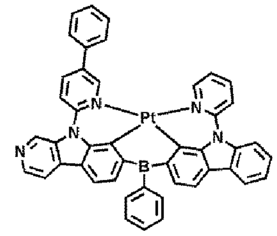
86

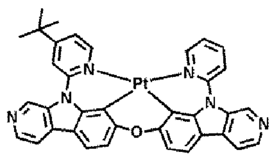
87

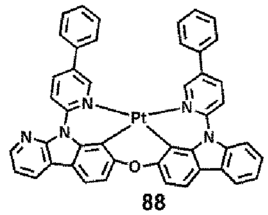
88

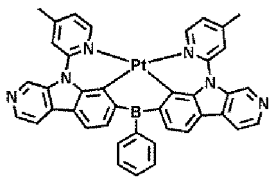
89

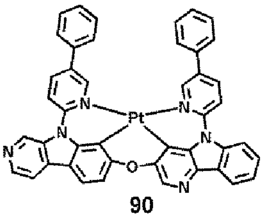
90

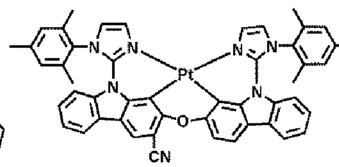
91

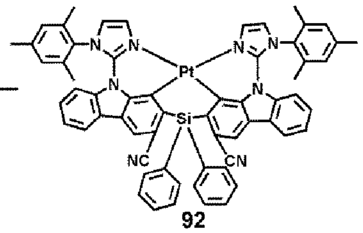
92

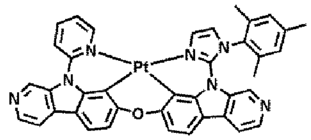
93

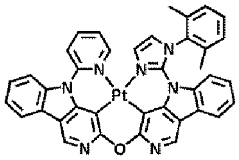
94

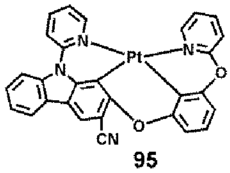
95

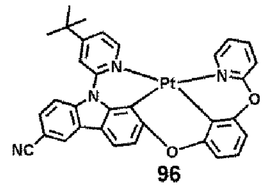
96

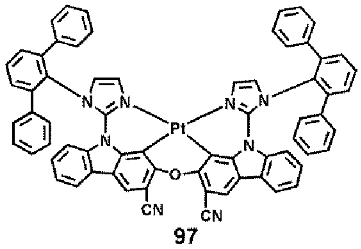
97

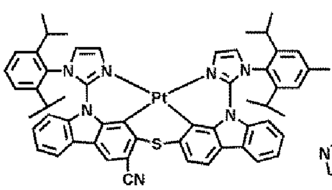
98

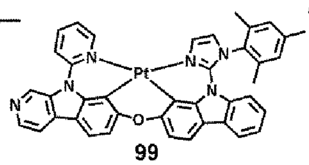
99

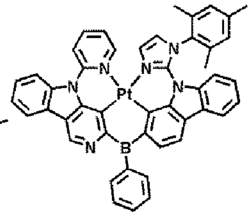
100

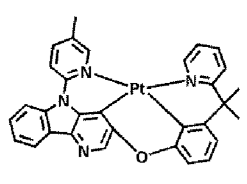
101

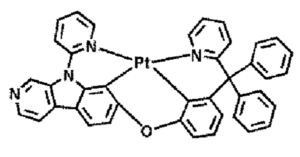
102

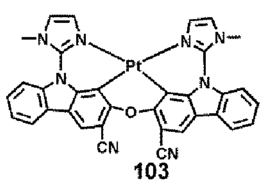
103

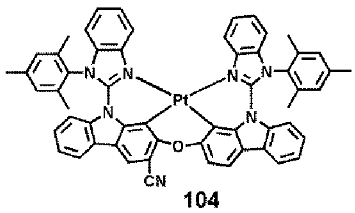
104

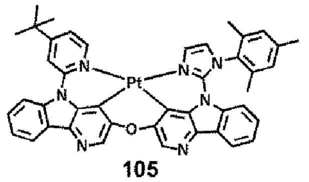
105

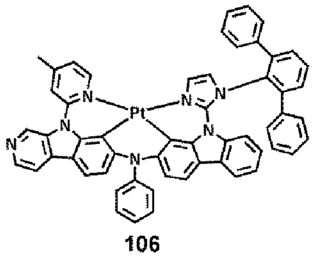
106

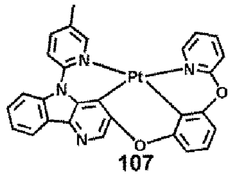
107

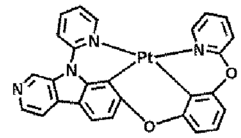
108

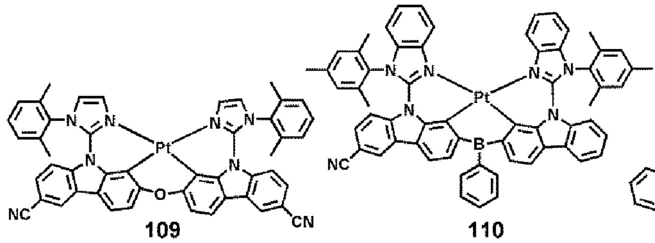
109

110

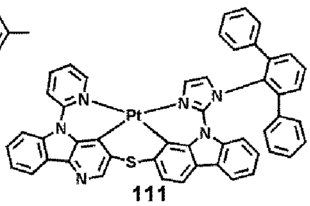
111

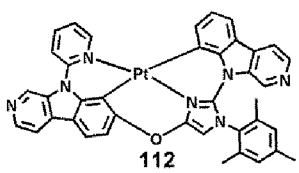
112

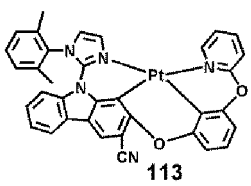
113

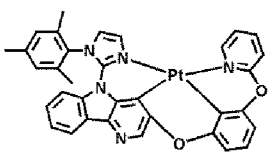
114

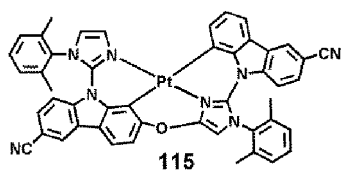
115

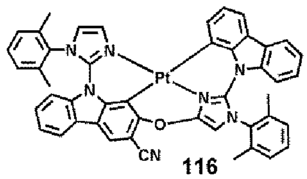
116

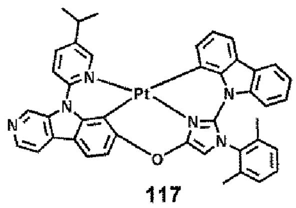
117

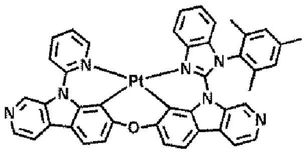
118

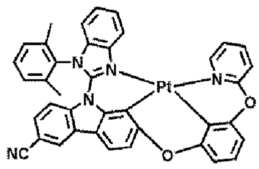
119

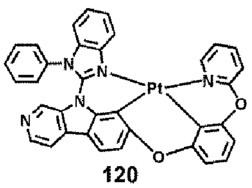
120

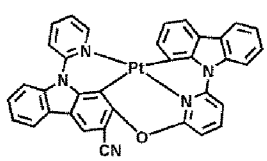
121

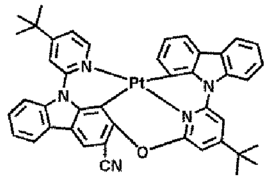
122

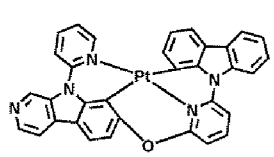
123

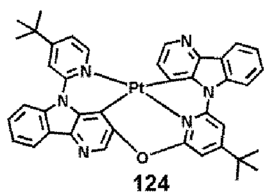
124

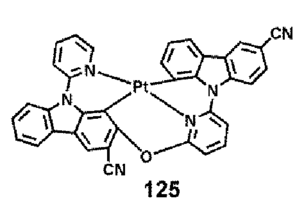
125

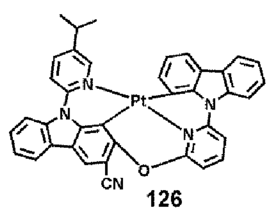
126

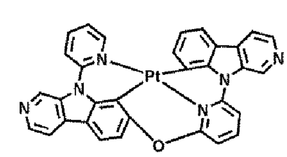
127

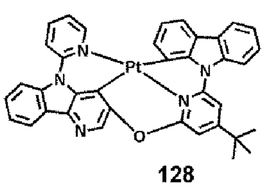
128

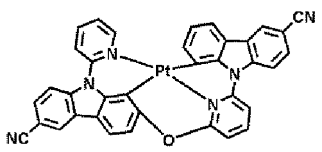
129

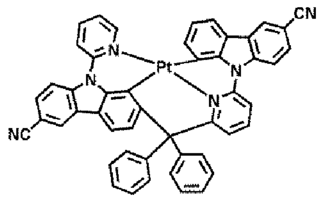
130

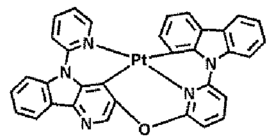
131

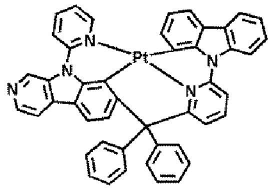
132

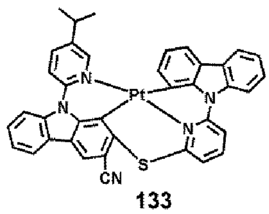
133

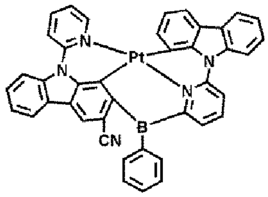
134

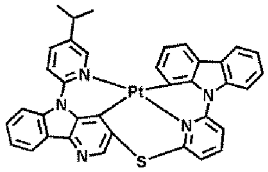
135

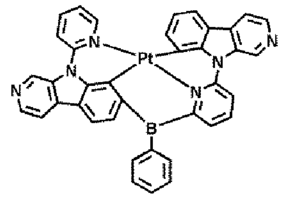
136

.

**13.** An organic light-emitting device comprising:

a first electrode;
a second electrode; and
an organic layer disposed between the first electrode and the second electrode,
wherein the organic layer comprises an emission layer and at least one organometallic compound of any of claims 1-12;
preferably wherein
the first electrode is an anode,
the second electrode is a cathode,
the organic layer further comprises a hole transport region disposed between the first electrode and the emission layer and an electron transport region disposed between the emission layer and the second electrode,
the hole transport region comprises a hole injection layer, a hole transport layer, an electron blocking layer, or any combination thereof, and
the electron transport region comprises a hole blocking layer, an electron transport layer, an electron injection layer, or any combination thereof.

**14.** The organic light-emitting device of claim 13, wherein
the emission layer comprises the organometallic compound;
preferably wherein
the emission layer further comprises a host, and
an amount of the host in the emission layer is larger than an amount of the organometallic compound in the emission layer.

**15.** A diagnostic composition comprising at least one organometallic compound of any of claims 1-12.

**Patentansprüche**

**1.** Organometallverbindung, dargestellt durch Formel 1:

Formel 1

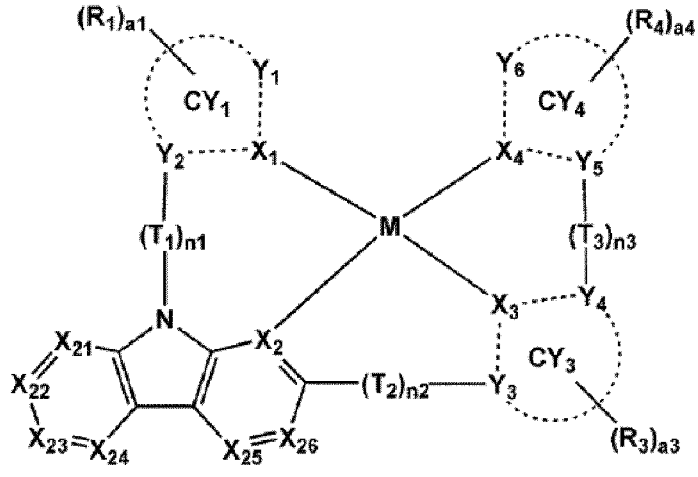

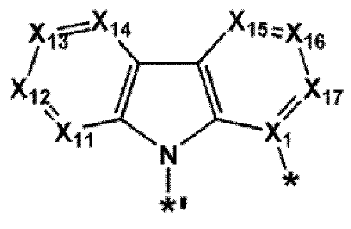

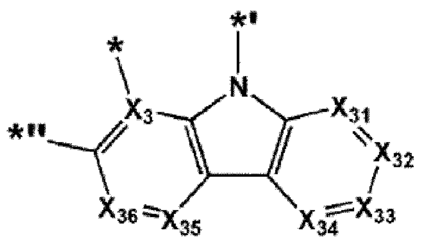

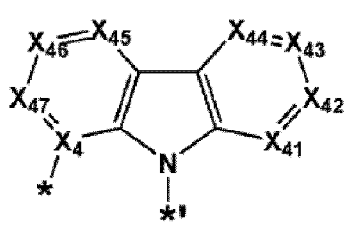

Formel CZ1 Formel CZ3 Formel CZ4

wobei in den Formeln 1, CZ1, CZ3 und CZ4

M aus einem Übergangsmetall der ersten Reihe des Periodensystems der Elemente, einem Übergangsmetall der zweiten Reihe des Periodensystems der Elemente und einem Übergangsmetall der dritten Reihe des Periodensystems der Elemente ausgewählt ist,
$X_1$ bis $X_4$ jeweils unabhängig C oder N sind,
zwei Bindungen, ausgewählt aus einer Bindung zwischen $X_1$ und M, einer Bindung zwischen $X_2$ und M, einer Bindung zwischen $X_3$ und M und einer Bindung zwischen $X_4$ und M jeweils eine Koordinatenbindung sind und die anderen jeweils eine kovalente Bindung sind,
$Y_2$ bis $Y_5$ jeweils unabhängig C oder N sind,
$Y_1$ und $Y_6$ jeweils unabhängig C, N, O, Si oder S sind,
eine Bindung zwischen $X_1$ und $Y_1$, eine Bindung zwischen $X_1$ und $Y_2$, eine Bindung zwischen $X_3$ und $Y_3$, eine Bindung zwischen $X_3$ und $Y_4$, eine Bindung zwischen $X_4$ und $Y_5$ und eine Bindung zwischen $X_4$ und $Y_6$ jeweils eine chemische Bindung sind, welche die entsprechenden Atome verknüpft,
$CY_1$ aus einer carbocyclischen $C_5$-$C_{30}$-Gruppe, einer heterocyclischen $C_1$-$C_{30}$-Gruppe und einer durch die Formel CZ1 dargestellten Gruppe ausgewählt ist,
$CY_3$ aus einer carbocyclischen $C_5$-$C_{30}$-Gruppe, einer heterocyclischen $C_1$-$C_{30}$-Gruppe und einer durch die Formel CZ3 dargestellten Gruppe ausgewählt ist,
$CY_4$ aus einer carbocyclischen $C_5$-$C_{30}$-Gruppe, einer heterocyclischen $C_1$-$C_{30}$-Gruppe und einer durch die Formel CZ4 dargestellten Gruppe ausgewählt ist,
$T_1$ bis $T_3$ jeweils unabhängig aus *-N[($L_5$)$_{b5}$-($R_5$)]-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O)-*', *-S(=O)-*', *-S(=O)$_2$-*', *-C($R_5$)=*', *=C($R_5$)-*', *-C($R_5$)=C($R_6$)-*', *-C(=S)-*' und *-C≡C-*' ausgewählt sind,
$L_5$ aus einer Einfachbindung, einer substituierten oder unsubstituierten carbocyclischen $C_5$-$C_{30}$-Gruppe und einer substituierten oder unsubstituierten heterocyclischen $C_1$-$C_{30}$-Gruppe ausgewählt ist,
b5 aus 1 bis 3 ausgewählt ist, wobei, wenn b5 zwei oder mehr ist, zwei oder mehr Gruppen $L_5$ identisch oder voneinander verschieden sind,
$R_5$ und $R_6$ gegebenenfalls über eine erste Verknüpfungsgruppe unter Bildung einer substituierten oder unsub-

stituierten carbocyclischen $C_5$-$C_{30}$-Gruppe oder einer substituierten oder unsubstituierten heterocyclischen $C_1$-$C_{30}$-Gruppe verknüpft sind,

n1 bis n3 jeweils unabhängig 0, 1, 2 oder 3 sind, wobei, wenn n1 Null ist, *-$(T_1)_{n1}$-*' eine Einfachbindung ist, wenn n2 Null ist, *-$(T_2)_{n2}$-*' eine Einfachbindung ist, und wenn n3 Null ist, *-$(T_3)_{n3}$-*' eine Einfachbindung ist,

$X_{11}$ N oder $C(R_{11})$ ist, $X_{12}$ N oder $C(R_{12})$ ist, $X_{13}$ N oder $C(R_{13})$ ist, $X_{14}$ N oder $C(R_{14})$ ist, $X_{15}$ N oder $C(R_{15})$ ist, $X_{16}$ N oder $C(R_{16})$ ist, $X_{17}$ N oder $C(R_{17})$ ist, $X_{21}$ N oder $C(R_{21})$ ist, $X_{22}$ N oder $C(R_{22})$ ist, $X_{23}$ N oder $C(R_{23})$ ist, $X_{24}$ N oder $C(R_{24})$ ist, $X_{25}$ N oder $C(R_{25})$ ist, $X_{26}$ N oder $C(R_{26})$ ist, $X_{31}$ N oder $C(R_{31})$ ist, $X_{32}$ N oder $C(R_{32})$ ist, $X_{33}$ N oder $C(R_{33})$ ist, $X_{34}$ N oder $C(R_{34})$ ist, $X_{35}$ N oder $C(R_{35})$ ist, $X_{36}$ N oder $C(R_{36})$ ist, $X_{41}$ N oder $C(R_{41})$ ist, $X_{42}$ N oder $C(R_{42})$ ist, $X_{43}$ N oder $C(R_{43})$ ist, $X_{44}$ N oder $C(R_{44})$ ist, $X_{45}$ N oder $C(R_{45})$ ist, $X_{46}$ N oder $C(R_{46})$ und $X_{47}$ N oder $C(R_{47})$ ist,

$R_1$, $R_3$ bis $R_6$, $R_{11}$ bis $R_{17}$, $R_{21}$ bis $R_{26}$, $R_{31}$ bis $R_{36}$ und $R_{41}$ bis $R_{47}$ jeweils unabhängig aus Wasserstoff, Deuterium, -F, -Cl, -Br, -I, $-SF_5$, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten $C_1$-$C_{60}$-Alkylgruppe, einer substituierten oder unsubstituierten $C_2$-$C_{60}$-Alkenylgruppe, einer substituierten oder unsubstituierten $C_2$-$C_{60}$-Alkinylgruppe, einer substituierten oder unsubstituierten $C_1$-$C_{60}$-Alkoxygruppe, einer substituierten oder unsubstituierten $C_3$-$C_{10}$-Cycloalkylgruppe, einer substituierten oder unsubstituierten $C_1$-$C_{10}$-Heterocycloalkylgruppe, einer substituierten oder unsubstituierten $C_3$-$C_{10}$-Cycloalkenylgruppe, einer substituierten oder unsubstituierten $C_1$-$C_{10}$-Heterocycloalkenylgruppe, einer substituierten oder unsubstituierten $C_6$-$C_{60}$-Arylgruppe, einer substituierten oder unsubstituierten $C_6$-$C_{60}$-Aryloxygruppe, einer substituierten oder unsubstituierten $C_6$-$C_{60}$-Arylthiogruppe, einer substituierten oder unsubstituierten $C_7$-$C_{60}$-Arylalkylgruppe, einer substituierten oder unsubstituierten $C_1$-$C_{60}$-Heteroarylgruppe, einer substituierten oder unsubstituierten $C_1$-$C_{60}$-Heteroaryloxygruppe, einer substituierten oder unsubstituierten $C_1$-$C_{60}$-Heteroarylthiogruppe, einer substituierten oder unsubstituierten $C_2$-$C_{60}$-Heteroarylalkylgruppe, einer substituierten oder unsubstituierten, monovalenten, nichtaromatischen, kondensierten, polycyclischen Gruppe, einer substituierten oder unsubstituierten, monovalenten, nichtaromatischen, kondensierten, heteropolycyclischen Gruppe, $-N(Q_1)(Q_2)$, $-Si(Q_3)(Q_4)(Q_5)$, $-B(Q_6)(Q_7)$ und - $P(=O)(Q_8)(Q_9)$ ausgewählt sind,

a1, a3 und a4 jeweils unabhängig 0, 1, 2, 3, 4 oder 5 sind,

zwei der Gruppen $R_1$ in der Zahl a1 gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

zwei der Gruppen $R_3$ in der Zahl a3 gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

zwei der Gruppen $R_4$ in der Zahl a4 gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

zwei von $R_{11}$ bis $R_{17}$ gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

zwei von $R_{21}$ bis $R_{26}$ gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

zwei von $R_{31}$ bis $R_{36}$ gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

zwei von $R_{41}$ bis $R_{47}$ gegebenenfalls zur Bildung einer substituierten oder unsubstituierten carbocyclische $C_5$-$C_{30}$-Gruppe oder einer substituierten oder unsubstituierten heterocyclischen $C_1$-$C_{30}$-Gruppe verknüpft sind,

*, *' und *'' jeweils eine Bindungsstelle mit einem Nachbaratom bezeichnen,

wobei die Substituenten der substituierten carbocyclischen $C_5$-$C_{30}$-Gruppe, der substituierten heterocyclischen $C_1$-$C_{30}$-Gruppe, der substituierten $C_1$-$C_{60}$-Alkylgruppe, der substituierten $C_2$-$C_{60}$-Alkenylgruppe, der substituierten $C_2$-$C_{60}$-Alkinylgruppe, der substituierten $C_1$-$C_{60}$-Alkoxygruppe, der substituierten $C_3$-$C_{10}$-Cycloalkylgruppe, der substituierten $C_1$-$C_{10}$-Heterocycloalkylgruppe, der substituierten $C_3$-$C_{10}$-Cycloalkenylgruppe, der substituierten $C_1$-$C_{10}$-Heterocycloalkenylgruppe, der substituierten $C_6$-$C_{60}$-Arylgruppe, der substituierten $C_6$-$C_{60}$-Aryloxygruppe, der substituierten $C_6$-$C_{60}$-Arylthiogruppe, der substituierten $C_7$-$C_{60}$-Arylalkylgruppe, der substituierten $C_1$-$C_{60}$-Heteroarylgruppe, der substituierten $C_1$-$C_{60}$-Heteroaryloxygruppe, der substituierten $C_1$-$C_{60}$-Heteroarylthiogruppe, der substituierten $C_2$-$C_{60}$-Heteroarylalkylgruppe, der substituierten monovalenten, nichtaromatischen, kondensierten, polycyclischen Gruppe und der substituierten, monovalenten, nichtaromatischen, kondensierten, heteropolycyclischen Gruppe ausgewählt sind aus:

Deuterium, -F, Cl, -Br, -I, $-CD_3$, $-CD_2H$, $-CDH_2$, einer Hydroxylgruppe, einer Cyanogruppe, einer Nitrogruppe,

einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe und einer $C_1$-$C_{60}$-Alkoxygruppe;

einer $C_1$-$C_{60}$-Alkylgruppe, einer $C_2$-$C_{60}$-Alkenylgruppe, einer $C_2$-$C_{60}$-Alkinylgruppe und einer $C_1$-$C_{60}$-Alkoxygruppe, jeweils substituiert mit mindestens einem ausgewählt aus Deuterium, - F, -Cl, -Br, -I, $-CD_3$, $-CD_2H$, $-CDH_2$, einer Hydroxylgruppe, einer Cyanogruppe, einer Nitrogruppe, einer Amidinogruppe, einer Hydrazingruppe, eine Hydrazongruppe, einer Carbonsäuregruppe oder einem Salz davon, einer Sulfonsäuregruppe oder einem Salz davon, einer Phosphorsäuregruppe oder einem Salz davon, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nichtaromatischen, kondensierten, polycyclischen Gruppe, einer monovalenten, nichtaromatischen, kondensierten, heteropolycyclischen Gruppe, - $N(Q_{11})(Q_{12})$, $-Si(Q_{13})(Q_{14})(Q_{15})$, $-B(Q_{16})(Q_{17})$ und $-P(=O)(Q_{15})(Q_{19})$;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nichtaromatischen, kondensierten, polycyclische Gruppe und einer monovalenten, nichtaromatischen, kondensierten, heteropolycyclischen Gruppe;

einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nichtaromatischen, kondensierten, polycyclische Gruppe und einer monovalenten, nichtaromatischen, kondensierten, heteropolycyclischen Gruppe, jeweils substituiert mit mindestens einem ausgewählt aus Deuterium, -F, -Cl, -Br, -I, $-CD_3$, $-CD_2H$, - $CDH_2$, einer Hydroxylgruppe, einer Cyanogruppe, einer Nitrogruppe, einer Amidinogruppe, einer Hydrazingruppe, eine Hydrazongruppe, einer Carbonsäuregruppe oder einem Salz davon, einer Sulfonsäuregruppe oder einem Salz davon, einer Phosphorsäuregruppe oder einem Salz davon, $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nichtaromatischen, kondensierten, polycyclischen Gruppe, einer monovalenten, nichtaromatischen, kondensierten, heteropolycyclischen Gruppe, - $N(Q_{21})(Q_{22})$, $-Si(Q_{23})(Q_{24})(Q_{25})$, $-B(Q_{26})(Q_{27})$ und $-P(=O)(Q_{28})(Q_{29})$; und

$-N(Q_{31})(Q_{32})$, $-Si(Q_{33})(Q_{34})(Q_{35})$, $-B(Q_{36})(Q_{37})$ und $-P(=O)(Q_{38})(Q_{39})$,

$Q_1$ bis $Q_9$, $Q_{11}$ bis $Q_{19}$, $Q_{21}$ bis $Q_{29}$ und $Q_{31}$ bis $Q_{39}$ jeweils unabhängig ausgewählt sind aus Wasserstoff, Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{60}$-Alkylgruppe, einer $C_2$-$C_{60}$-Alkenylgruppe, einer $C_2$-$C_{60}$-Alkinylgruppe, einer $C_1$-$C_{60}$-Alkoxygruppe, einer $C_3$-$C_{10}$-Cycloalkylgruppe, einer $C_1$-$C_{10}$-Heterocycloalkylgruppe, einer $C_3$-$C_{10}$-Cycloalkenylgruppe, einer $C_1$-$C_{10}$-Heterocycloalkenylgruppe, einer $C_6$-$C_{60}$-Arylgruppe, einer $C_6$-$C_{60}$-Arylgruppe, substituiert mit mindestens einem ausgewählt aus einer $C_1$-$C_{60}$-Alkylgruppe und einer $C_6$-$C_{60}$-Arylgruppe, einer $C_6$-$C_{60}$-Aryloxygruppe, einer $C_6$-$C_{60}$-Arylthiogruppe, einer $C_7$-$C_{60}$-Arylalkylgruppe, einer $C_1$-$C_{60}$-Heteroarylgruppe, einer $C_1$-$C_{60}$-Heteroaryloxygruppe, einer $C_1$-$C_{60}$-Heteroarylthiogruppe, einer $C_2$-$C_{60}$-Heteroarylalkylgruppe, einer monovalenten, nichtaromatischen, kondensierten, polycyclischen Gruppe und eine monovalenten, nichtaromatischen, kondensierten, heteropolycyclischen Gruppe und

Formel 1 mindestens eine der Bedingungen 1 bis 4 erfüllt:

Bedingung 1

$CY_1$ in Formel 1 ist eine durch die Formel CZ1 dargestellte Gruppe mit der Maßgabe, dass mindestens eins von $X_{11}$ bis $X_{17}$ in der Formel CZ1 jeweils unabhängig N oder C(CN) ist,

Bedingung 2

mindestens eins von $X_{21}$ bis $X_{26}$ in der Formel 1 ist jeweils unabhängig N oder C(CN),

Bedingung 3
$CY_3$ in der Formel 1 ist eine durch die Formel CZ3 dargestellte Gruppe mit der Maßgabe, dass mindestens eins von $X_{31}$ bis $X_{36}$ in der Formel CZ3 jeweils unabhängig N oder C(CN) ist, und
Bedingung 4
$CY_4$ in der Formel 1 ist eine durch die Formel CZ4 dargestellte Gruppe mit der Maßgabe, dass mindestens eins von $X_{41}$ bis $X_{47}$ in der Formel CZ4 jeweils unabhängig N oder C(CN) ist.

**2.** Organometallverbindung nach Anspruch 1, wobei
M Pt oder Pd ist.

**3.** Organometallverbindung nach Anspruch 1 oder 2, wobei

i) $X_1$ und $X_4$ jeweils N sind, $X_2$ und $X_3$ jeweils C sind, eine Bindung zwischen $X_1$ und M und eine Bindung zwischen $X_4$ und M jeweils eine Koordinatenbindung sind und eine Bindung zwischen $X_2$ und M und eine Bindung zwischen $X_3$ und M jeweils eine kovalente Bindung sind;
ii) $X_1$ und $X_3$ jeweils N sind, $X_2$ und $X_4$ jeweils C sind, eine Bindung zwischen $X_1$ und M und eine Bindung zwischen $X_3$ und M jeweils eine Koordinatenbindung sind und eine Bindung zwischen $X_2$ und M und eine Bindung zwischen $X_4$ und M jeweils eine kovalente Bindung sind; oder
iii) $X_3$ und $X_4$ jeweils N sind, $X_1$ und $X_2$ jeweils C sind, eine Bindung zwischen $X_3$ und M und eine Bindung zwischen $X_4$ und M jeweils eine Koordinatenbindung sind und eine Bindung zwischen $X_1$ und M und eine Bindung zwischen $X_2$ und M jeweils eine kovalente Bindung sind.

**4.** Organometallverbindung nach einem der Ansprüche 1 bis 3, wobei
$CY_1$, $CY_3$ und $CY_4$ jeweils unabhängig aus einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer 1,2,3,4-Tetrahydronaphthalingruppe, einer Pyrrolgruppe, einer Thiophengruppe, einer Furangruppe, einer Indolgruppe, einer Isoindolgruppe, einer Benzoborolgruppe, einer Benzophospholgruppe, einer Indengruppe, einer Benzosilolgruppe, einer Benzogermolgruppe, einer Benzothiophengruppe, einer Benzoselenophengruppe, einer Benzofurangruppe, einer Carbazolgruppe, einer Dibenzoborolgruppe, einer Dibenzophospholgruppe, einer Fluorengruppe, einer Dibenzosilolgruppe, einer Dibenzogermolgruppe, einer Dibenzothiophengruppe, einer Dibenzoselenophengruppe, einer Dibenzofurangruppe, einer Dibenzothiophen-5-oxidgruppe, einer 9H-Fluoren-9-ongruppe, einer Dibenzothiophen-5,5-dioxidgruppe, einer Azacarbazolgruppe, einer Azadibenzoborolgruppe, einer Azadibenzophospholgruppe, einer Azafluorengruppe, einer Azadibenzosilolgruppe, einer Azadibenzogermolgruppe, einer Azadibenzothiophengruppe, einer Azadibenzoselenophengruppe, einer Azadibenzofurangruppe, einer Azadibenzothiophen-5-oxidgruppe, einer Aza-9H-fluoren-9-ongruppe, einer Azadibenzothiophen-5,5-dioxidgruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrazolgruppe, einer Imidazolgruppe, einer Triazolgruppe, einer Tetrazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzoxadiazolgruppe, einer Benzothiadiazolgruppe, einer 5,6,7,8-Tetrahydroisochinolingruppe und einer 5,6,7,8-Tetrahydrochinolingruppe ausgewählt sind;
$CY_1$ eine durch die Formel CZ1 dargestellte Gruppe ist;
$CY_3$ eine durch die Formel CZ3 dargestellt Gruppe ist; oder
$CY_4$ eine durch die Formel CZ4 dargestellte Gruppe ist.

**5.** Organometallverbindung nach einem der Ansprüche 1 bis 4, wobei
in Formel 1, eine durch

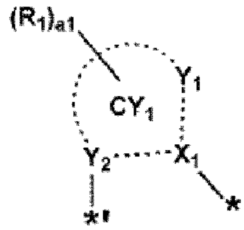

dargestellte Gruppierung und eine durch

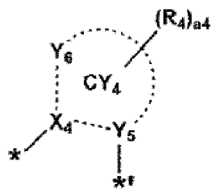

dargestellte Gruppierung identisch sind; eine durch

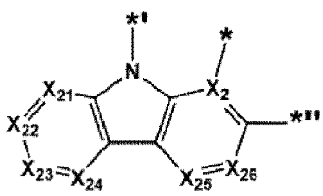

dargestellte Gruppierung und eine durch

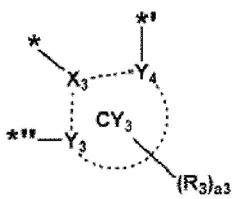

dargestellte Gruppierung identisch sind; eine durch

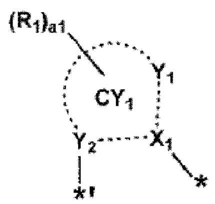

dargestellte Gruppierung und eine durch

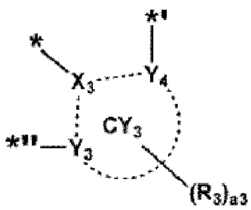

dargestellte Gruppierung identisch sind; eine durch

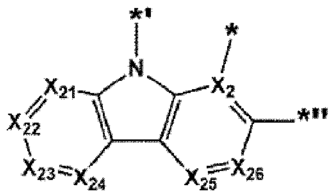

dargestellte Gruppierung und eine durch

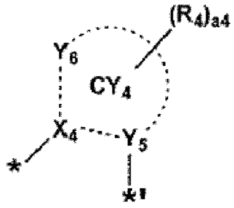

dargestellte Gruppierung identisch sind; oder eine durch

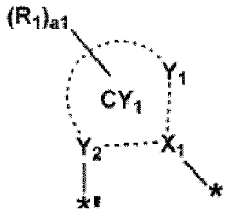

dargestellte Gruppierung, eine durch

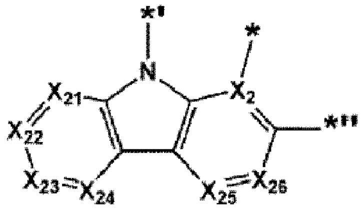

dargestellte Gruppierung, eine durch

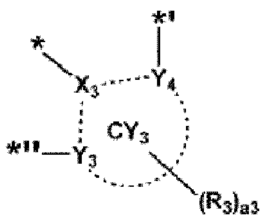

dargestellte Gruppierung und eine durch

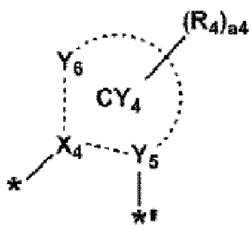

dargestellte Gruppierung voneinander verschieden sind.

**6.** Organometallverbindung nach einem der Ansprüche 1-5, wobei
die Organometallverbindung eine symmetrische Struktur in Bezug auf eine Achse aufweist, die M und $T_2$ in Formel 1 verbindet; und/oder
wobei
$T_1$ bis $T_3$ jeweils unabhängig *-N[$(L_5)_{b5}$-($R_5$)]-*', *-B($R_5$)-*', *-C($R_5$)($R_6$)-*', *-Si($R_5$)($R_6$)-*', *-S-*' oder *-O-*' sind, und die Summe von n1, n2 und n3 1 oder 2 ist.

**7.** Organometallverbindung nach einem der Ansprüche 1-6, wobei
$R_1$, $R_3$ bis $R_6$, $R_{11}$ bis $R_{17}$, $R_{21}$ bis $R_{26}$, $R_{31}$ bis $R_{36}$ und $R_{41}$ bis $R_{47}$ jeweils unabhängig ausgewählt sind aus:

Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -$SF_5$, einer $C_1$-$C_{20}$-Alkylgruppe und einer $C_1$-$C_{20}$-Alkoxygruppe;
einer $C_1$-$C_{20}$-Alkylgruppe und einer $C_1$-$C_{20}$-Alkoxygruppe, substituiert jeweils mit mindestens einem ausgewählt aus Deuterium, -F, -Cl, -Br, -I, -$CD_3$, -$CD_2H$, -$CDH_2$, -$CF_3$, -$CF_2H$, - $CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer $C_1$-$C_{10}$-Alkylgruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Zinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Zinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe jeweils substituiert mit mindestens einem ausgewählt aus Deuterium, -F, -Cl, -Br, -I, -$CD_3$, -$CD_2H$, - $CDH_2$, -$CF_3$, -$CF_2H$, -$CFH_2$, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon,

einer $C_1$-$C_{20}$-Alkylgruppe, einer $C_1$-$C_{20}$-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Zinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; und
$-N(Q_1)(Q_2)$, $-Si(Q_3)(Q_4)(Q_5)$, $-B(Q_6)(Q_7)$ und $-P(=O)(Q_8)(Q_9)$ und $Q_1$ bis $Q_9$ jeweils unabhängig ausgewählt sind aus:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, - $CHDCD_2H$, $-CHDCDH_2$, $-CHDCD_3$, $-CD_2CD_3$, $-CD_2CD_2H$ und $-CD_2CDH_2$;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, substituiert jeweils mit mindestens einem ausgewählt aus Deuterium, einer $C_1$-$C_{10}$-Alkylgruppe und einer Phenylgruppe;
vorzugsweise wobei
$R_1$, $R_3$ bis $R_6$, $R_{11}$ bis $R_{17}$, $R_{21}$ bis $R_{26}$, $R_{31}$ bis $R_{36}$ und $R_{41}$ bis $R_{47}$ jeweils unabhängig Wasserstoff, Deuterium, -F, eine Cyanogruppe, eine Nitrogruppe, $-SF_5$, $-CH_3$, - $CD_3$, $-CD_2H$, - $CDH_2$, $-CF_3$, $-CF_2H$, $-CFH_2$, durch die Formeln 9-1 bis 9-19 dargestellte Gruppen, durch die Formeln 10-1 bis 10-139 dargestellte Gruppen und $-Si(Q_3)(Q_4)(Q_5)$ sind:

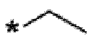
Formel 9-1
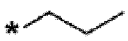
Formel 9-2
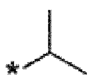
Formel 9-3
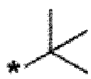
Formel 9-4
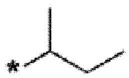
Formel 9-5
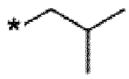
Formel 9-6
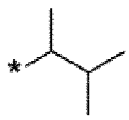
Formel 9-7
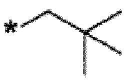
Formel 9-8
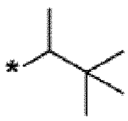
Formel 9-9
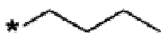
Formel 9-10
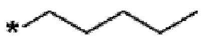
Formel 9-11
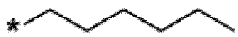
Formel 9-12
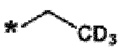
Formel 9-13
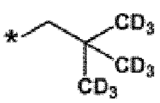
Formel 9-14
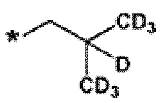
Formel 9-15
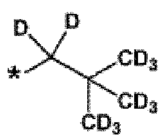
Formel 9-16
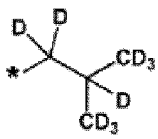
Formel 9-17
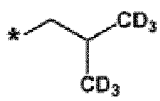
Formel 9-18
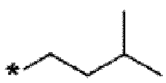
Formel 9-19

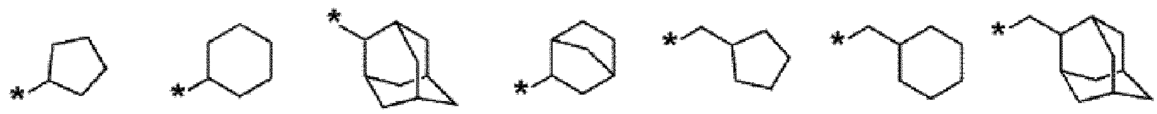

Formel 10-1 Formel 10-2 Formel 10-3 Formel 10-4 Formel 10-5 Formel 10-6 Formel 10-7

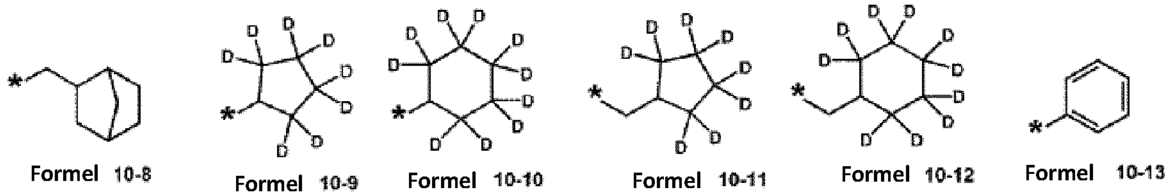

Formel 10-8 Formel 10-9 Formel 10-10 Formel 10-11 Formel 10-12 Formel 10-13

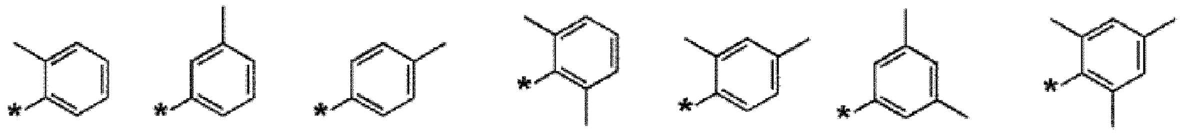

Formel 10-14 Formel 10-15 Formel 10-16 Formel 10-17 Formel 10-18 Formel 10-19 Formel 10-20

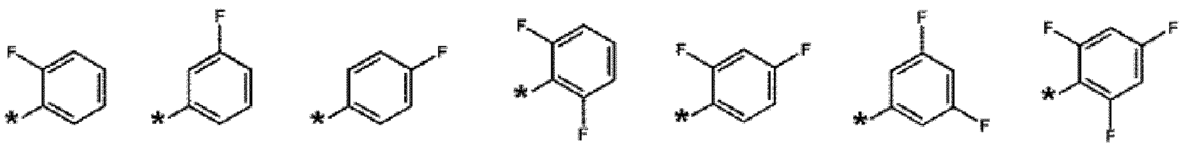

Formel 10-21 Formel 10-22 Formel 10-23 Formel 10-24 Formel 10-25 Formel 10-26 Formel 10-27

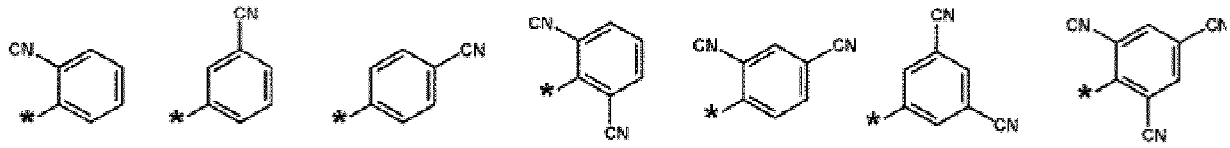

Formel 10-28 Formel 10-29 Formel 10-30 Formel 10-31 Formel 10-32 Formel 10-33 Formel 10-34

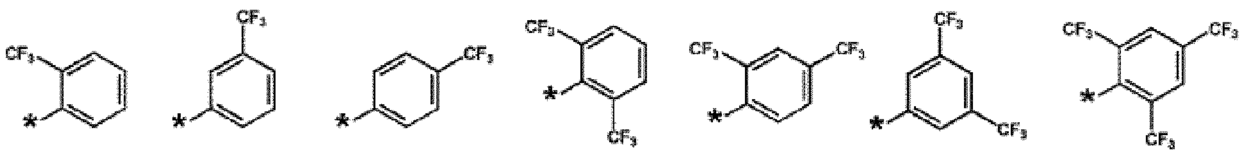

Formel 10-35 Formel 10-36 Formel 10-37 Formel 10-38 Formel 10-39 Formel 10-40 Formel 10-41

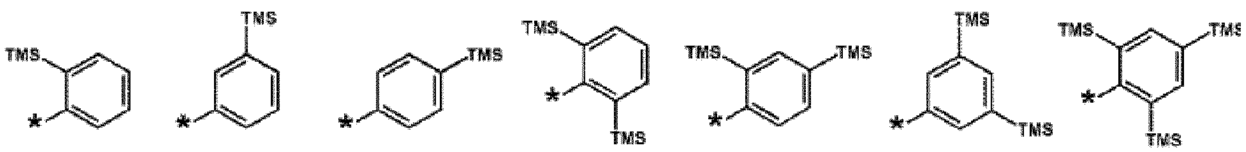

Formel 10-42 Formel 10-43 Formel 10-44 Formel 10-45 Formel 10-46 Formel 10-47 Formel 10-48

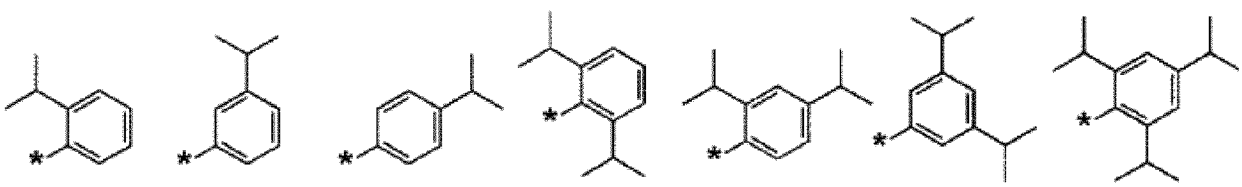

Formel 10-49 Formel 10-50 Formel 10-51 Formel 10-52 Formel 10-53 Formel 10-54 Formel 10-55

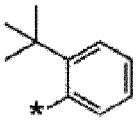
Formel 10-56
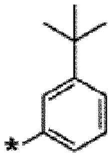
Formel 10-57
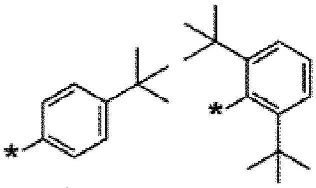
Formel 10-58
Formel 10-59
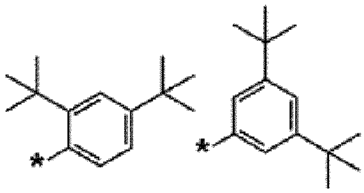
Formel 10-60
Formel 10-61
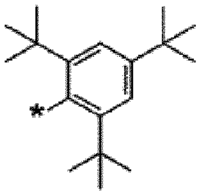
Formel 10-62

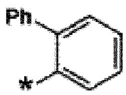
Formel 10-63
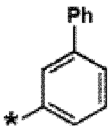
Formel 10-64
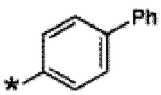
Formel 10-65
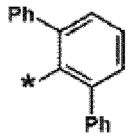
Formel 10-66
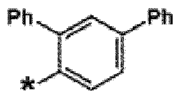
Formel 10-67
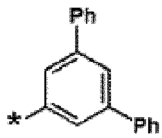
Formel 10-68
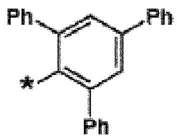
Formel 10-69

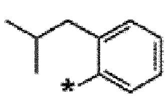
Formel 10-70
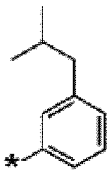
Formel 10-71
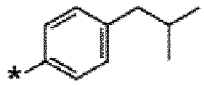
Formel 10-72
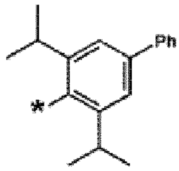
Formel 10-73
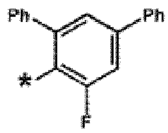
Formel 10-74
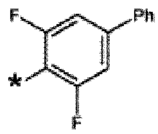
Formel 10-75

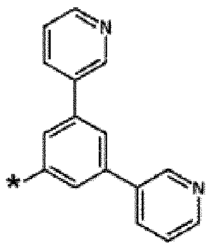
Formel 10-76
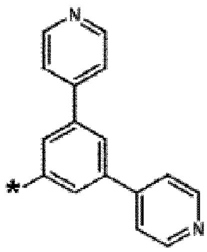
Formel 10-77
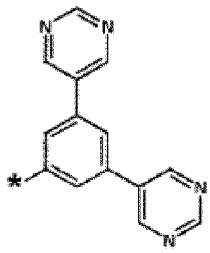
Formel 10-78
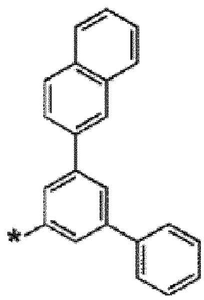
Formel 10-79
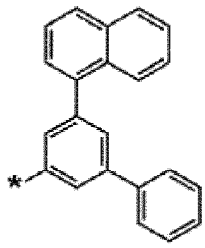
Formel 10-80

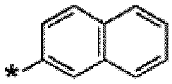
Formel 10-81
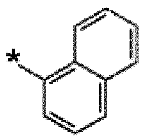
Formel 10-82
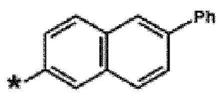
Formel 10-83
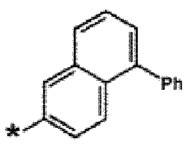
Formel 10-84
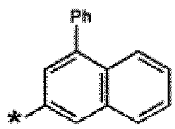
Formel 10-85

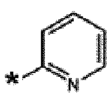
Formel 10-86
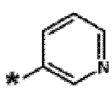
Formel 10-87
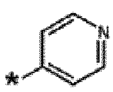
Formel 10-88
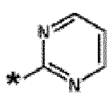
Formel 10-89
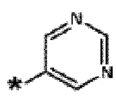
Formel 10-90
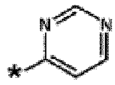
Formel 10-91
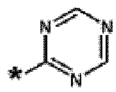
Formel 10-92

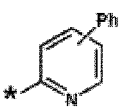
Formel 10-93
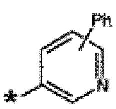
Formel 10-94
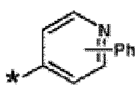
Formel 10-95
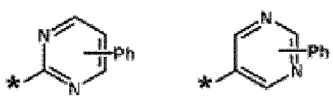
Formel 10-96
Formel 10-97
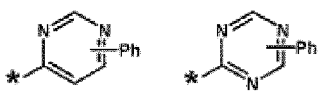
Formel 10-98
Formel 10-99

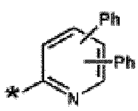 Formel 10-100 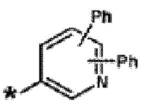 Formel 10-101 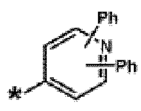 Formel 10-102 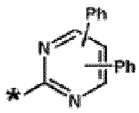 Formel 10-103 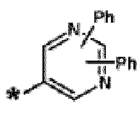 Formel 10-104 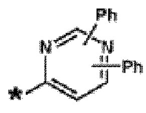 Formel 10-105 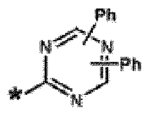 Formel 10-106

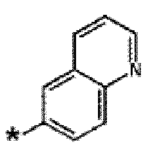 Formel 10-107 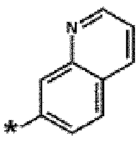 Formel 10-108 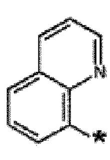 Formel 10-109 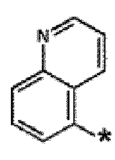 Formel 10-110 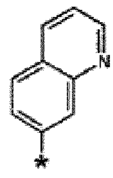 Formel 10-111 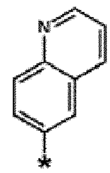 Formel 10-112

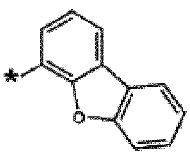 Formel 10-113 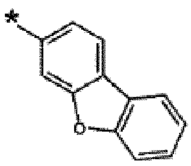 Formel 10-114 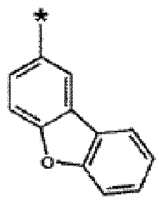 Formel 10-115 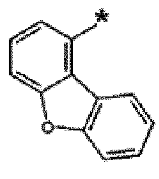 Formel 10-116 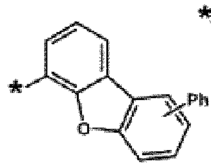 Formel 10-117 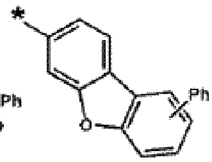 Formel 10-118

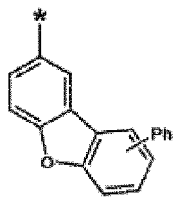 Formel 10-119 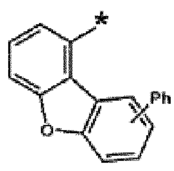 Formel 10-120 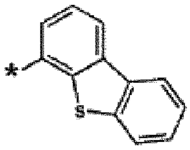 Formel 10-121 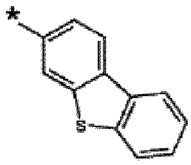 Formel 10-122 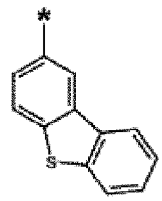 Formel 10-123 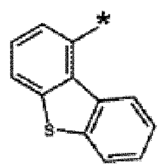 Formel 10-124

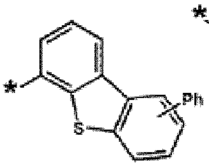 Formel 10-125 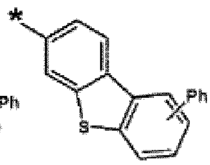 Formel 10-126 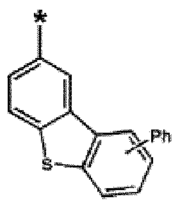 Formel 10-127 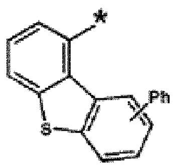 Formel 10-128 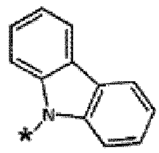 Formel 10-129 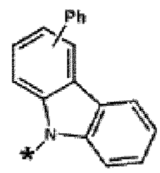 Formel 10-130

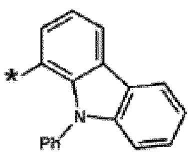 Formel 10-131 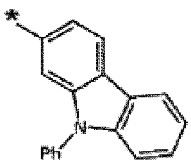 Formel 10-132 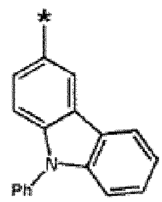 Formel 10-133 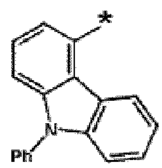 Formel 10-134 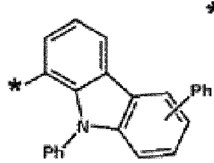 Formel 10-135 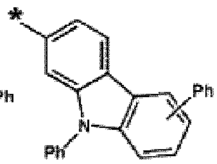 Formel 10-136

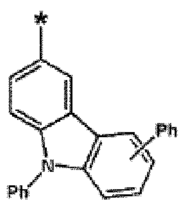 Formel 10-137 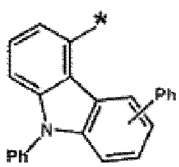 Formel 10-138 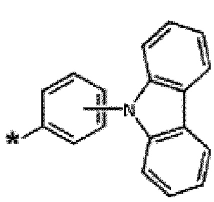 Formel 10-139

wobei in den Formeln 9-1 bis 9-19 und 10-1 bis 10-139 "Ph" eine Phenylgruppe bezeichnet, "TMS" eine Trimethylsilylgruppe bezeichnet und * eine Bindungsstelle mit einem Nachbaratom bezeichnet.

**8.** Organometallverbindung nach einem der Ansprüche 1-7, wobei eine durch Formel 1

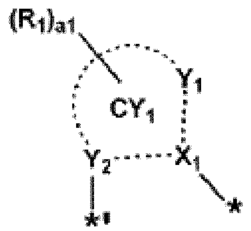

dargestellte Gruppierung aus durch die Formeln CY1-1 bis CY1-39 und CZ1-1 bis CZ1-8 dargestellten Gruppen ausgewählt ist:

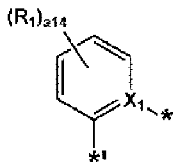
Formel CY1-1

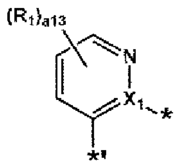
Formel CY1-2

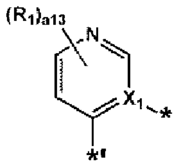
Formel CY1-3

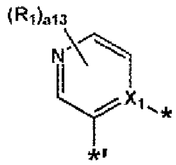
Formel CY1-4

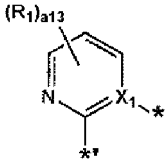
Formel CY1-5

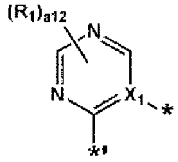
Formel CY1-6

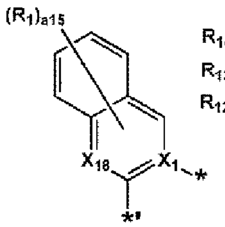
Formel CY1-7

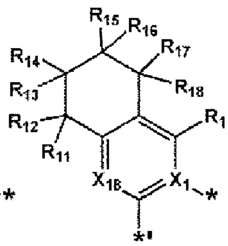
Formel CY1-8

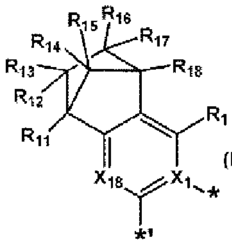
Formel CY1-9

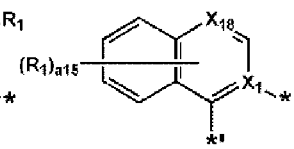
Formel CY1-10

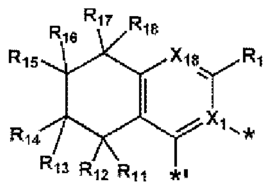
Formel CY1-11

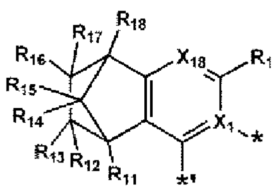
Formel CY1-12

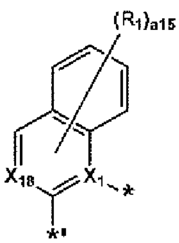
Formel CY1-13

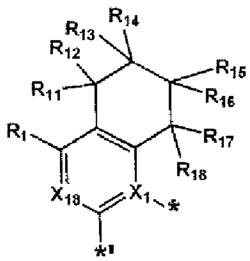
Formel CY1-14

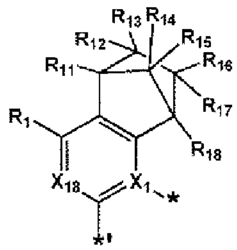
Formel CY1-15

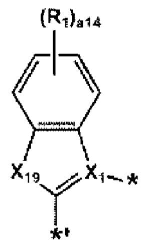
Formel CY1-16

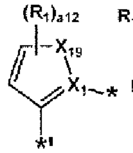
Formel CY1-17

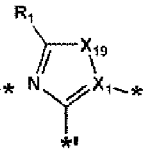
Formel CY1-18

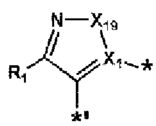
Formel CY1-19

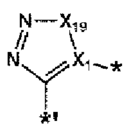
Formel CY1-20

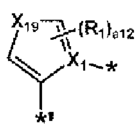
Formel CY1-21

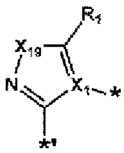
Formel CY1-22

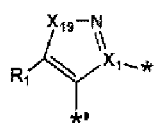
Formel CY1-23

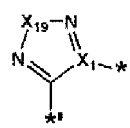
Formel CY1-24

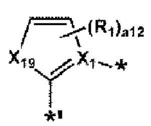
Formel CY1-25

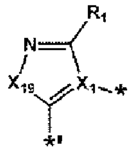
Formel CY1-26

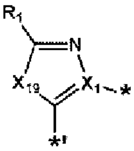
Formel CY1-27

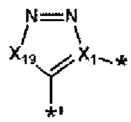
Formel CY1-28

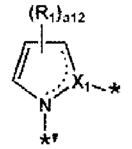
Formel CY1-29

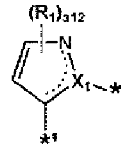
Formel CY1-30

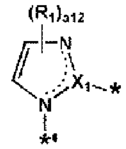
Formel CY1-31

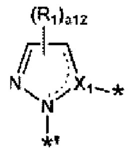
Formel CY1-32

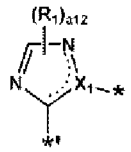
Formel CY1-33

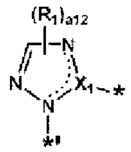
Formel CY1-34

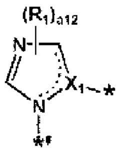
Formel CY1-35

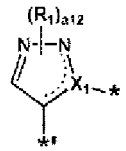
Formel CY1-36

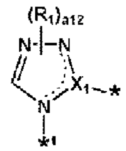
Formel CY1-37

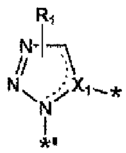
Formel CY1-38

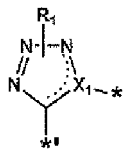
Formel CY1-39

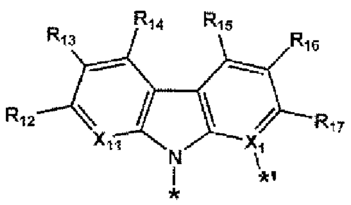
Formel CZ1-1

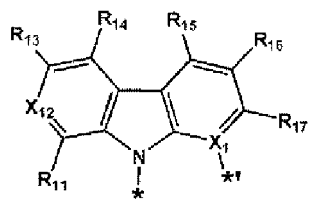
Formel CZ1-2

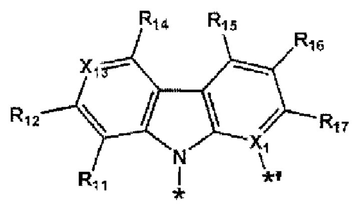
Formel CZ1-3

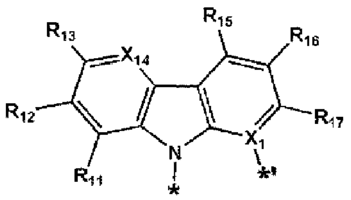
Formel CZ1-4

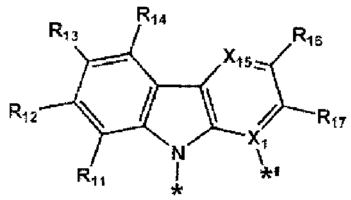
Formel CZ1-5

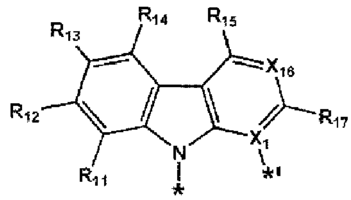
Formel CZ1-6

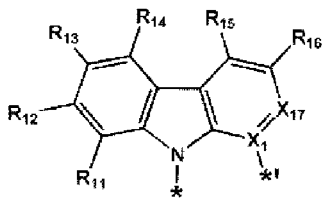
Formel CZ1-7

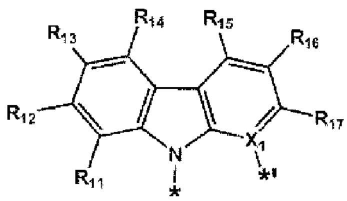
Formel CZ1-8

wobei in den Formeln CY1-1 bis CY1-39 und CZ1-1 bis CZ1-8,

$X_1$ und $R_1$ jeweils unabhängig gleich sind, wie in Anspruch 1 beschrieben,
$X_{18}$ N oder $C(R_{18})$ ist,
$X_{19}$ O, S, $N[(L_{19})_{b19}\text{-}(R_{19})]$ oder $C(R_{19a})(R_{19b})$ ist,
$R_{11}$ bis $R_{18}$ unabhängig gleich sind, wie im Zusammenhang mit $R_1$ in Anspruch 1 beschrieben,
$L_{19}$ und b19 jeweils unabhängig gleich sind, wie im Zusammenhang mit $L_5$ und b5 in Anspruch 1 beschrieben,
$R_{19}$, $R_{19a}$ und $R_{19b}$ jeweils unabhängig gleich sind, wie im Zusammenhang mit $R_5$ in Anspruch 1 beschrieben,
$X_{11}$ bis $X_{17}$ jeweils N oder C(CN) sind,
a15 eine ganze Zahl von 0 bis 5 ist,

a14 eine ganze Zahl von 0 bis 4 ist,
a13 eine ganze Zahl von 0 bis 3 ist,
a12 eine ganze Zahl von 0 bis 2 und
* und *' jeweils eine Bindungsstelle mit einem Nachbaratom bezeichnen; und/oder wobei eine in Formel 1 durch

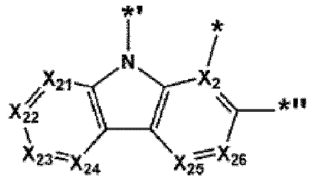

dargestellte Gruppierung aus durch die Formeln CZ2-1 bis CZ2-7 dargestellten Gruppen ausgewählt ist:

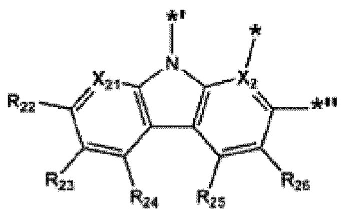
Formel CZ2-1

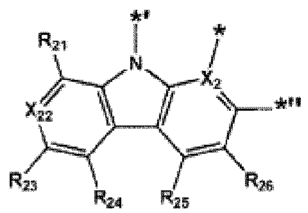
Formel CZ2-2

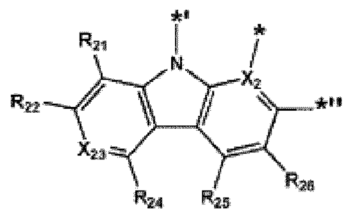
Formel CZ2-3

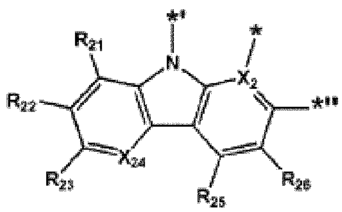
Formel CZ2-4

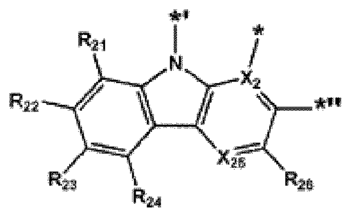
Formel CY2-5

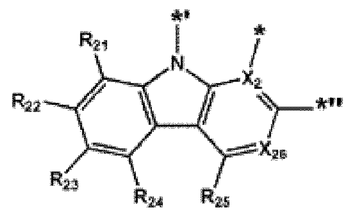
Formel CZ2-6

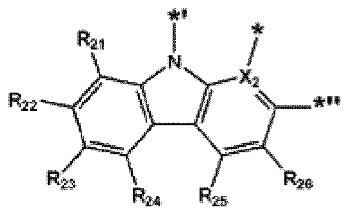
Formel CZ2-7

wobei in den Formeln CZ2-1 bis CZ2-7,

$X_2$ und $R_{21}$ bis $R_{26}$ jeweils unabhängig gleich sind, wie in Anspruch 1 beschrieben,
$X_{21}$ bis $X_{26}$ jeweils N oder C(CN) sind und
*, *' und *'' jeweils eine Bindungsstelle mit einem Nachbaratom bezeichnen.

**9.** Organometallverbindung nach einem der Ansprüche 1-8, wobei eine in Formel 1 durch

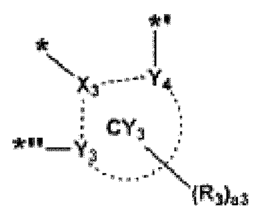

dargestellte Gruppierung aus durch die Formeln CY3-1 bis CY3-27 und CZ3-1 bis CZ3-7 dargestellten Gruppen ausgewählt ist:

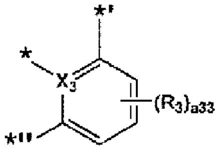
Formel CY3-1

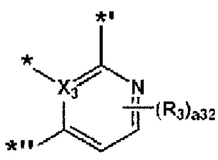
Formel CY3-2

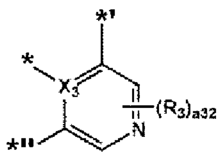
Formel CY3-3

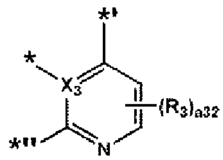
Formel CY3-4

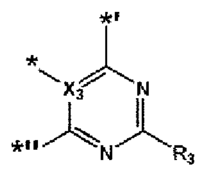
Formel CY3-5

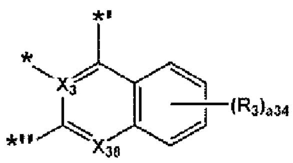
Formel CY3-6

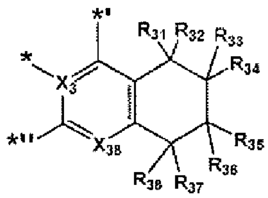
Formel CY3-7

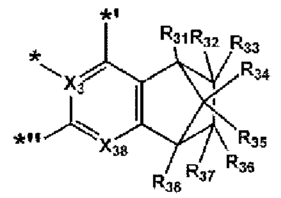
Formel CY3-8

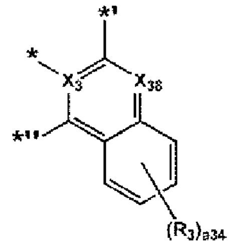
Formel CY3-9

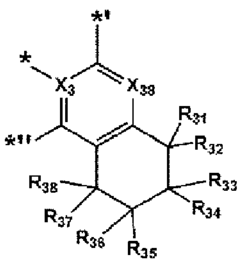
Formel CY3-10

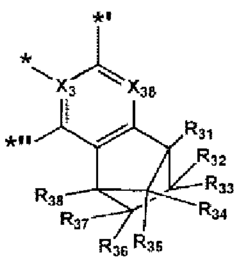
Formel CY3-11

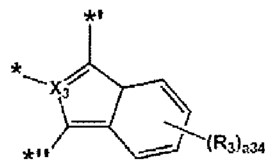
Formel CY3-12

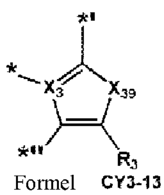
Formel CY3-13

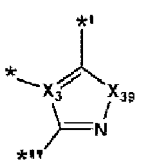
Formel CY3-14

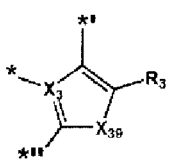
Formel CY3-15

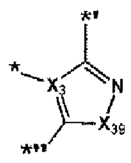
Formel CY3-16

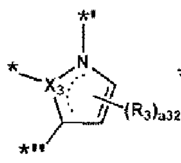
Formel CY3-17

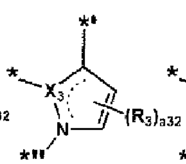
Formel CY3-18

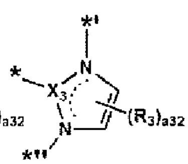
Formel CY3-19

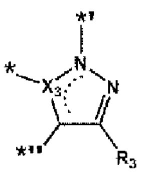
Formel CY3-20

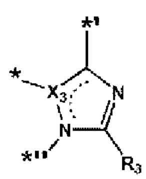
Formel CY3-21

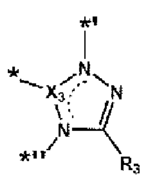
Formel CY3-22

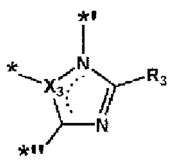
Formel CY3-23

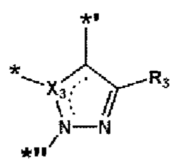
Formel CY3-24

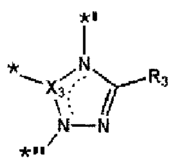
Formel CY3-25

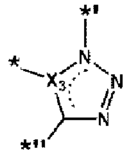
Formel CY3-26

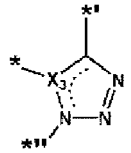
Formel CY3-27

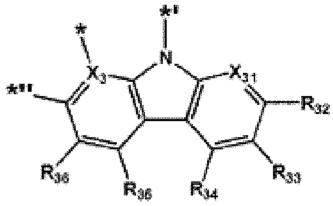
Formel CZ3-1

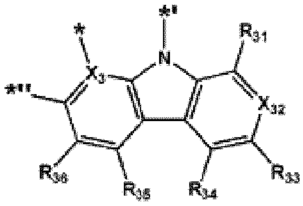
Formel CZ3-2

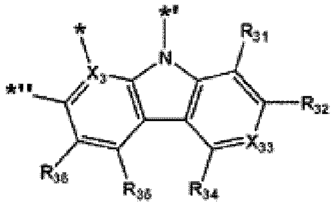
Formel CZ3-3

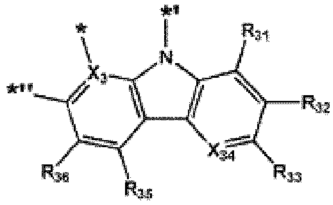
Formel CZ3-4

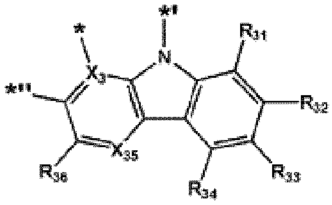
Formel CZ3-5

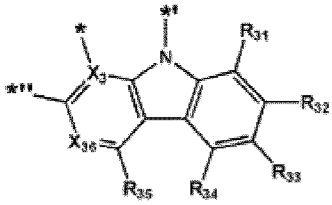
Formel CZ3-6

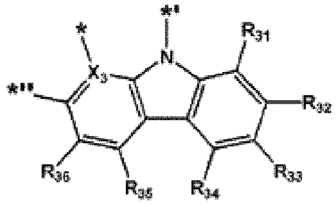
Formel CZ3-7

,

wobei in den Formeln CY3-1 bis CY3-27 und CZ3-1 bis CZ3-7,

$X_3$ und $R_3$ jeweils unabhängig gleich sind, wie in Anspruch 1 beschrieben,
$X_{38}$ N oder $C(R_{38})$ ist,
$X_{39}$ O, S, $N[(L_{39})_{b39}-(R_{39})]$ oder $C(R_{39a})(R_{39b})$ ist,
$R_{31}$ bis $R_{38}$ unabhängig gleich sind, wie im Zusammenhang mit $R_1$ in Anspruch 1 beschrieben,
$L_{39}$ und b39 jeweils unabhängig gleich sind, wie im Zusammenhang mit $L_5$ und b5 in Anspruch 1 beschrieben,
$R_{39}$, $R_{39a}$ und $R_{39b}$ jeweils unabhängig gleich sind, wie im Zusammengang mit $R_5$ in Anspruch 1 beschrieben,
$X_{31}$ bis $X_{36}$ jeweils N oder C(CN) sind,
a34 eine ganze Zahl von 0 bis 4 ist,
a33 eine ganze Zahl von 0 bis 3 ist,
a32 eine ganze Zahl von 0 bis 2 ist, und
*, *' und *" jeweils eine Bindungsstelle mit einem Nachbaratom bezeichnen.

**10.** Organometallverbindung nach einem der Ansprüche 1-9, wobei eine in Formel 1 durch

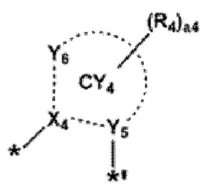

dargestellte Gruppierung aus durch die Formeln CY4-1 bis CY3-39 und CZ4-1 bis CZ4-8 dargestellten Gruppen ausgewählt ist:

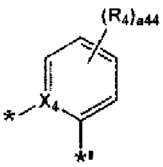
Formel CY4-1
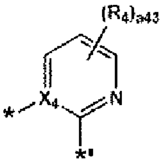
Formel CY4-2
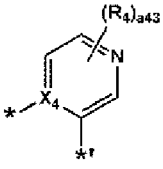
Formel CY4-3
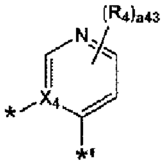
Formel CY4-4
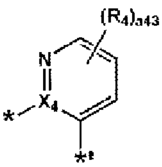
Formel CY4-5
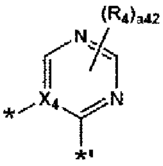
Formel CY4-6

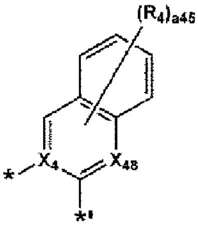
Formel CY4-7
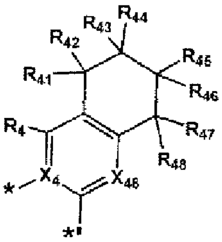
Formel CY4-8
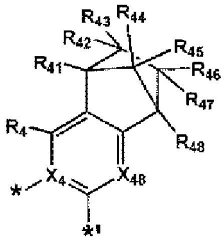
Formel CY4-9
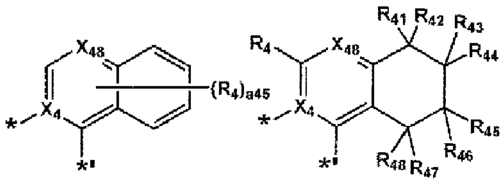
Formel CY4-10
Formel CY4-11

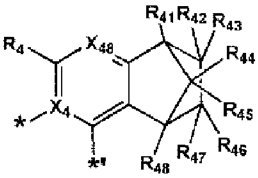
Formel CY4-12
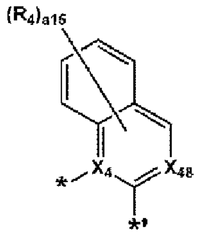
Formel CY4-13
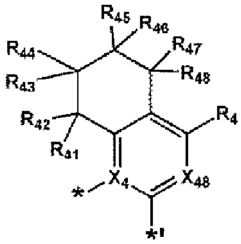
Formel CY4-14
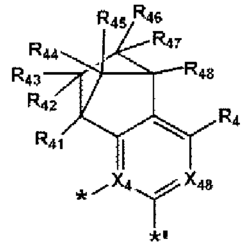
Formel CY4-15
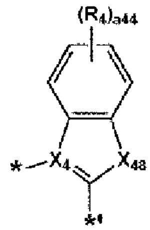
Formel CY4-16

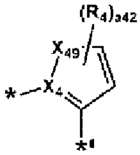
Formel CY4-17
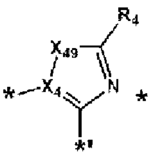
Formel CY4-18
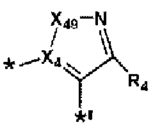
Formel CY4-19
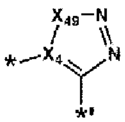
Formel CY4-20
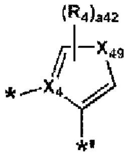
Formel CY4-21
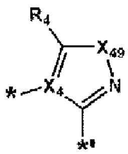
Formel CY4-22
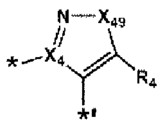
Formel CY4-23
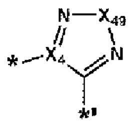
Formel CY4-24

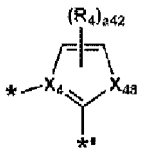
Formel CY4-25
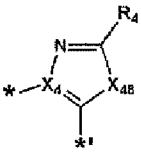
Formel CY4-26
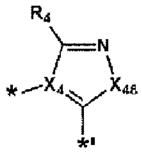
Formel CY4-27
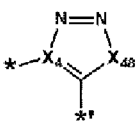
Formel CY4-28
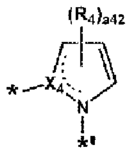
Formel CY4-29
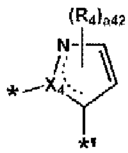
Formel CY4-30
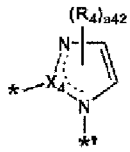
Formel CY4-31

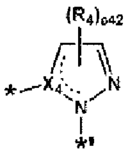
Formel CY4-32
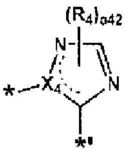
Formel CY4-33
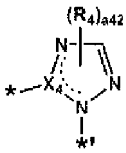
Formel CY4-34
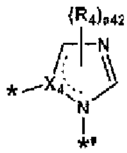
Formel CY4-35
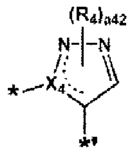
Formel CY4-36
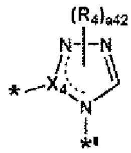
Formel CY4-37

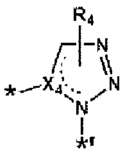
Formel CY4-38
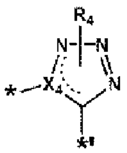
Formel CY4-39

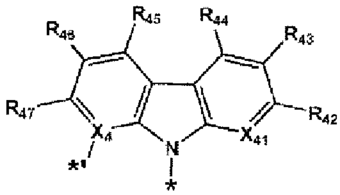

Formel **CZ4-1**

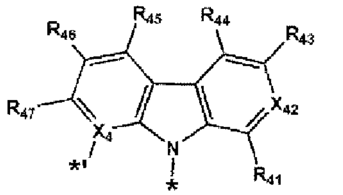

Formel **CZ4-2**

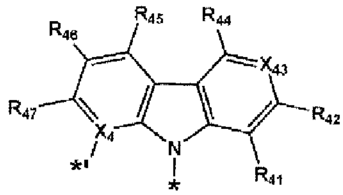

Formel **CZ4-3**

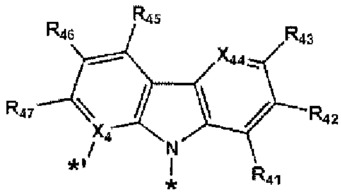

Formel **CZ4-4**

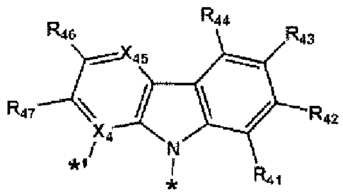

Formel **CZ4-5**

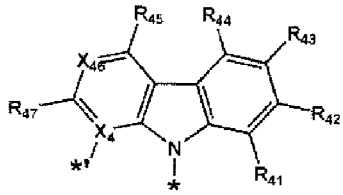

Formel **CZ4-6**

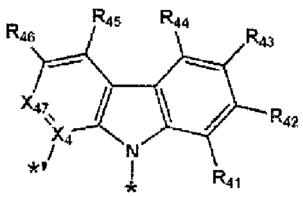

Formel **CZ4-7**

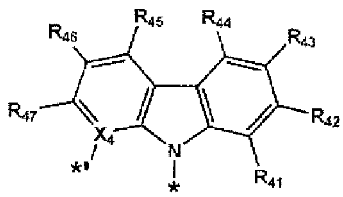

Formel **CZ4-8**

,

wobei in den Formeln CY4-1 bis CY4-39 und CZ4-1 bis CZ4-8

$X_4$ und $R_4$ jeweils unabhängig gleich sind, wie in Anspruch 1 beschrieben,
$X_{48}$ N oder $C(R_{48})$ ist,
$X_{49}$ O, S, $N[(L_{49})_{b49}-(R_{49})]$ oder $C(R_{49a})(R_{49b})$ ist,
$R_{41}$ bis $R_{48}$ jeweils unabhängig gleich sind, wie im Zusammenhang mit $R_1$ in Anspruch 1 beschrieben,
$L_{49}$ und b49 jeweils unabhängig gleich sind, wie im Zusammenhang mit $L_5$ und b5 in Anspruch 1 beschrieben,
$R_{49}$, $R_{49a}$ und $R_{49b}$ jeweils unabhängig gleich sind, wie im Zusammenhang mit $R_5$ in Anspruch 1 beschrieben,
$X_{41}$ bis $X_{47}$ jeweils N oder C(CN) sind,
a45 eine ganze Zahl von 0 bis 5 ist,
a44 eine ganze Zahl von 0 bis 4 ist,
a43 eine ganze Zahl von 0 bis 3 ist,
a42 eine ganze Zahl von 0 bis 2 ist und
* und *'jeweils eine Bindungsstelle mit einem Nachbaratom bezeichnen.

**11.** Organometallverbindung nach einem der Ansprüche 1 bis 10, wobei die Organometallverbindung mindestens eine der Bedingungen 1-1 bis 4-1 erfüllt:

Bedingung 1-1
eine in Formel 1 durch

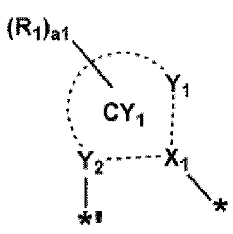

dargestellte Gruppierung aus durch die Formeln CZ1-1 bis CZ1-7 dargestellten Gruppen ausgewählt ist,

Bedingung 2-1
eine in Formel 1 durch

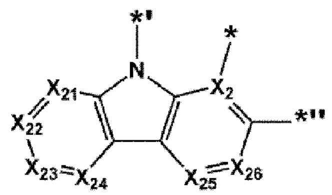

dargestellte Gruppierung aus durch die Formeln CZ2-1 bis CZ2-6 dargestellten Gruppen ausgewählt ist:
Bedingung 3-1
eine in Formel 1 durch

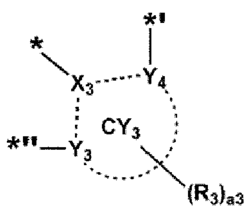

dargestellte Gruppierung aus durch die Formeln CZ3-1 bis CZ3-6 dargestellten Gruppen ausgewählt ist, und
Bedingung 4-1
eine in Formel 1 durch

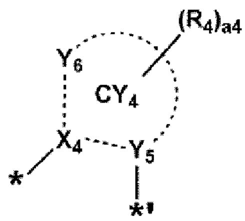

dargestellte Gruppierung aus durch die Formeln CZ4-1 bis CZ4-7 dargestellten Gruppen ausgewählt ist:

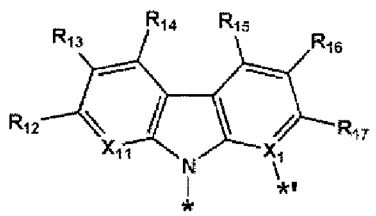

Formel CZ1-1

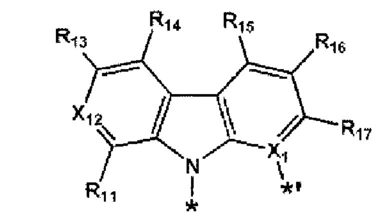

Formel CZ1-2

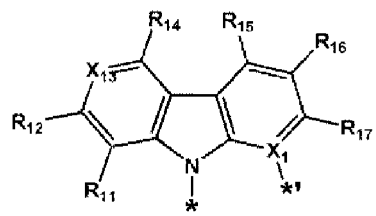

Formel CZ1-3

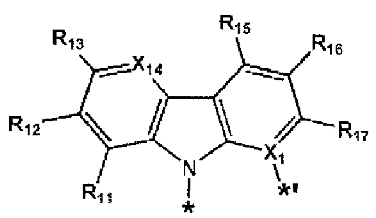

Formel CZ1-4

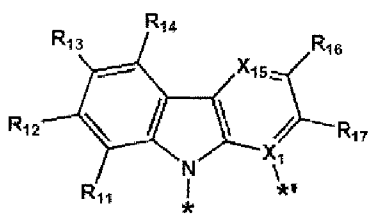

Formel CZ1-5

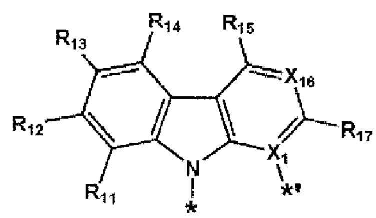

Formel CZ1-6

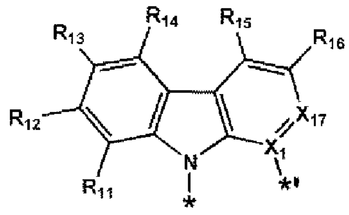

Formel **CZ1-7**

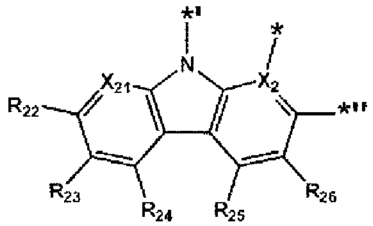

Formel **CZ2-1**

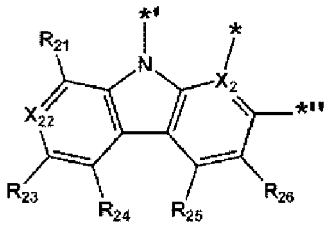

Formel **CZ2-2**

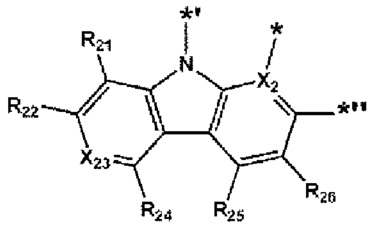

Formel **CZ2-3**

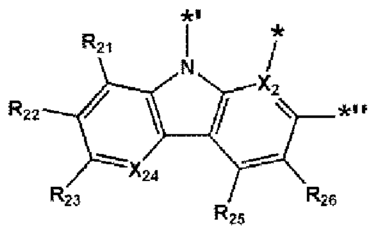

Formel **CZ2-4**

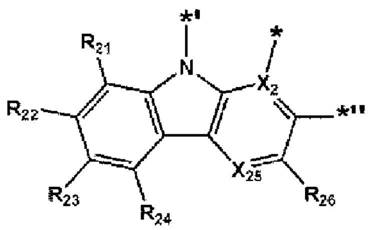

Formel **CY2-5**

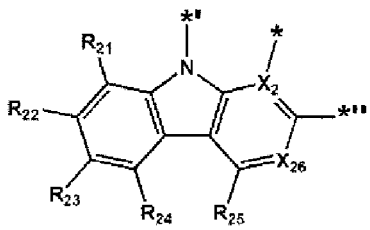

Formel **CZ2-6**

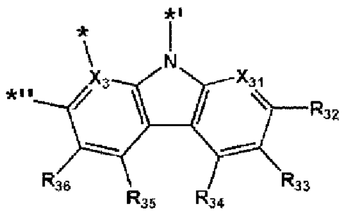

Formel **CZ3-1**

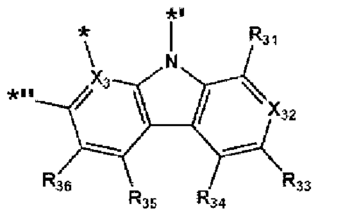

Formel **CZ3-2**

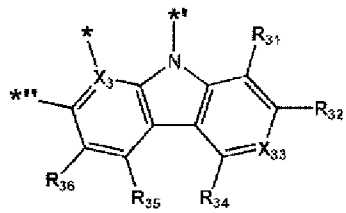

Formel **CZ3-3**

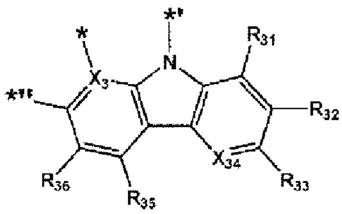

Formel **CZ3-4**

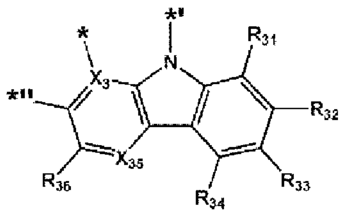

Formel **CZ3-5**

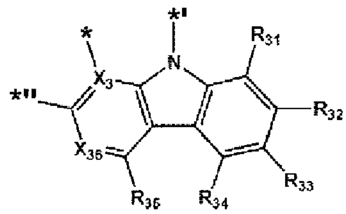

Formel **CZ3-6**

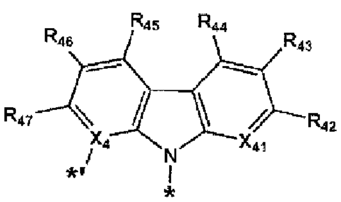

Formel **CZ4-1**

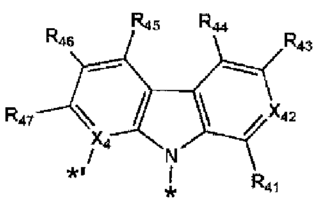

Formel **CZ4-2**

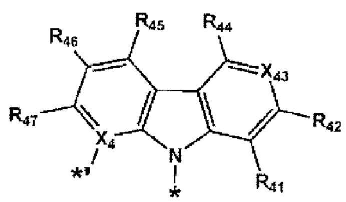

Formel **CZ4-3**

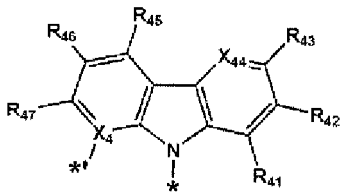

Formel CZ4-4

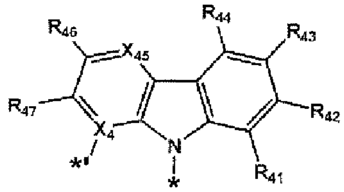

Formel CZ4-5

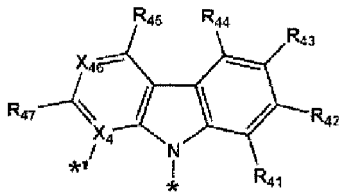

Formel CZ4-6

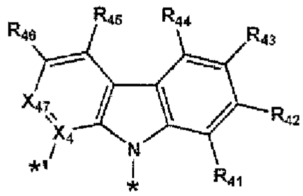

Formel CZ4-7

,

wobei in den Formeln CZ1-1 bis CZ1-7, CZ2-1 bis CZ2-6, CZ3-1 bis CZ3-6 und CZ4-1 bis CZ4-7,

$X_1$, $X_2$, $X_3$, $X_4$, $R_{11}$ bis $R_{17}$, $R_{21}$ bis $R_{26}$, $R_{31}$ bis $R_{36}$, und $R_{41}$ bis $R_{47}$ jeweils unabhängig gleich sind, wie in Anspruch 1 beschrieben,

$X_{11}$ bis $X_{17}$, $X_{21}$ bis $X_{26}$, $X_{31}$ bis $X_{36}$ und $X_{41}$ bis $X_{47}$ jeweils unabhängig N oder C(CN) sind, und

*, *' und *" jeweils eine Bindungsstelle mit einem Nachbaratom bezeichnen.

**12.** Organometallverbindung nach einem der Ansprüche 1 bis 11, wobei die Organometallverbindung aus den Verbindungen 1 bis 136 ausgewählt ist:

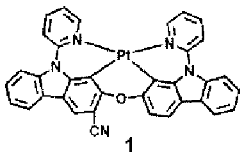

1

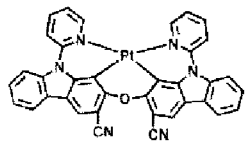

2

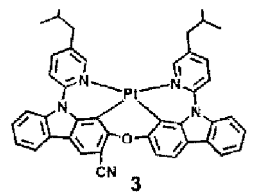

3

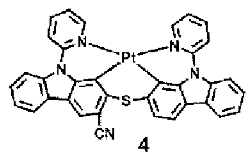

4

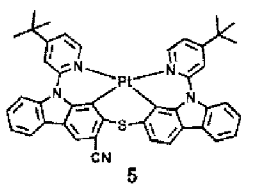

5

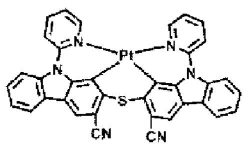

6

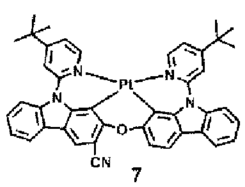

7

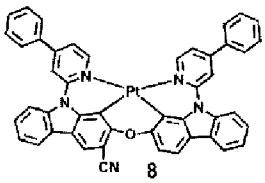

8

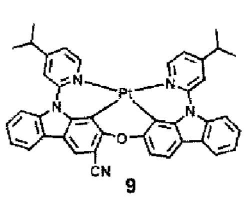

9

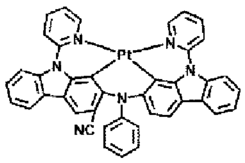

10

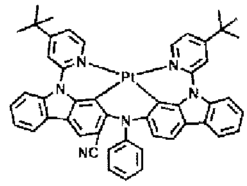

11

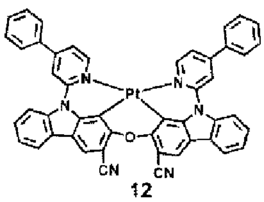

12

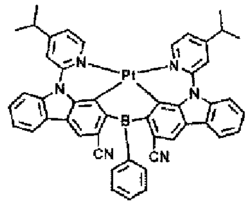
13

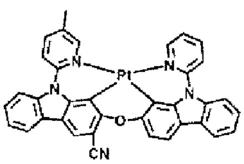
14

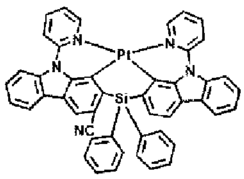
15

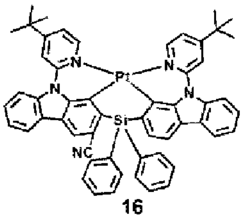
16

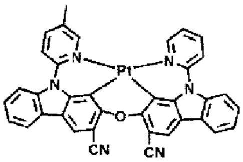
17

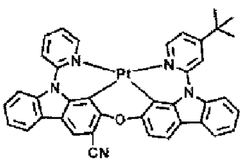
18

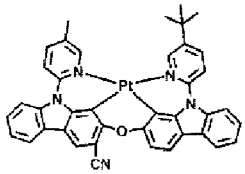
19

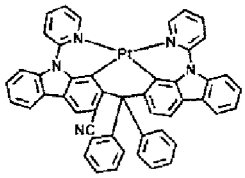
20

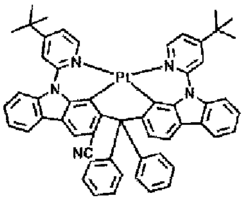
21

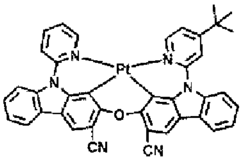
22

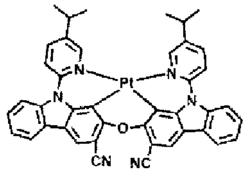
23

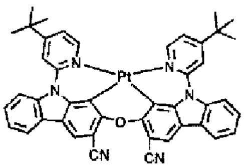
24

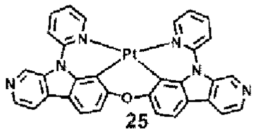
25

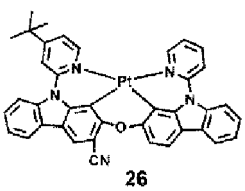
26

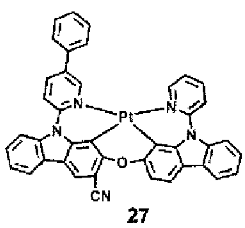
27

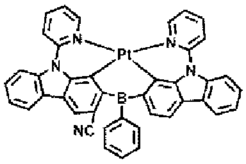
28

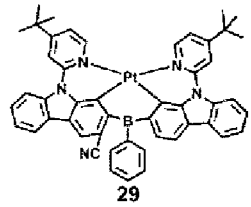
29

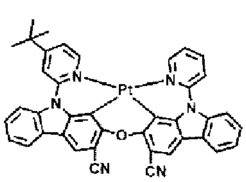
30

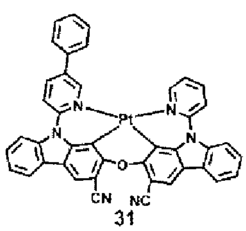
31

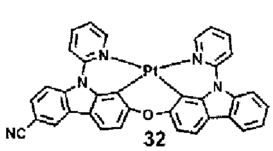
32

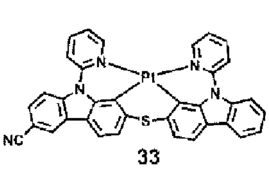
33

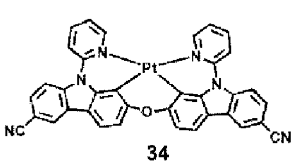
34

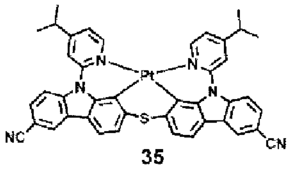
35

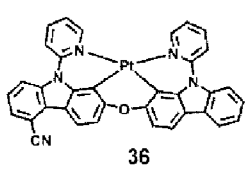
36

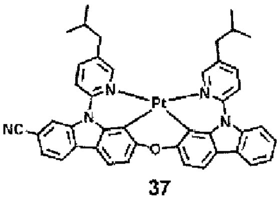
37

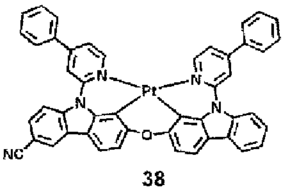
38

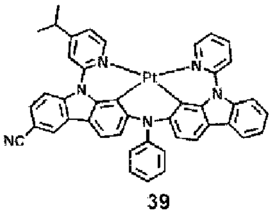
39

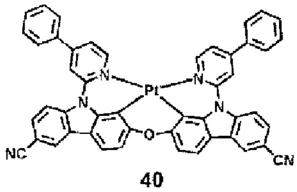
40

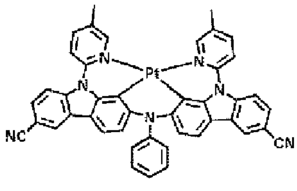
41
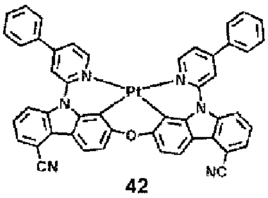
42
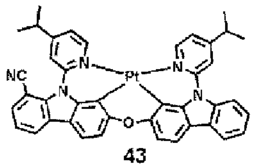
43
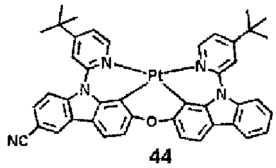
44

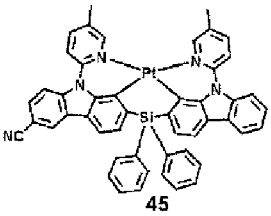
45
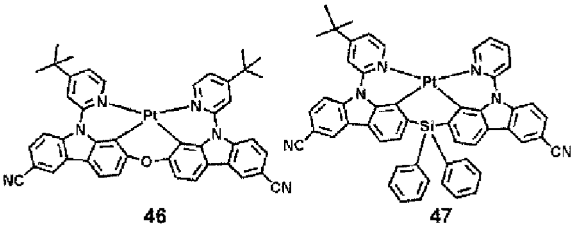
46

47
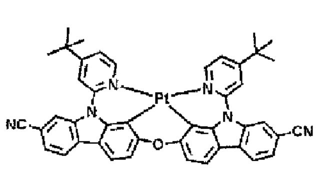
48

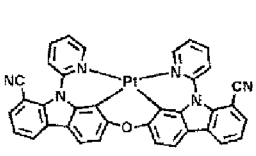
49
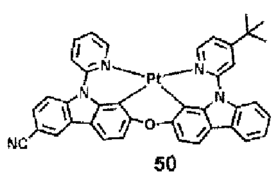
50
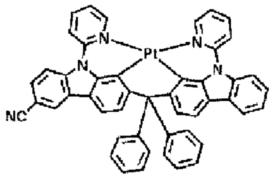
51
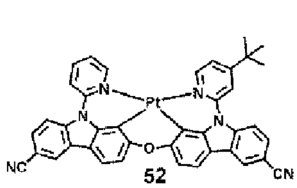
52

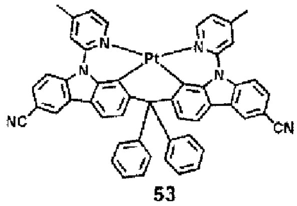
53
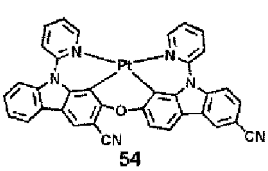
54
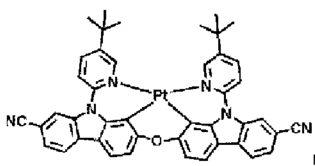
55
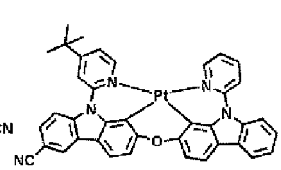
56

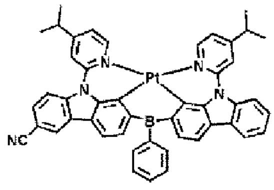
57
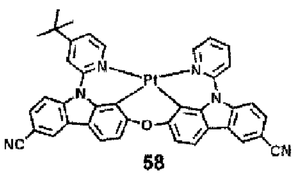
58
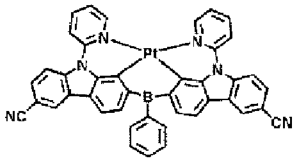
59
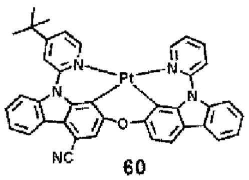
60

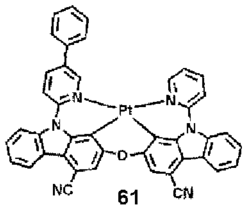
61
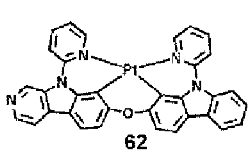
62
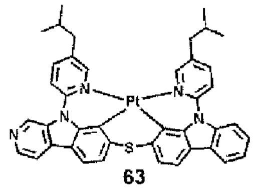
63
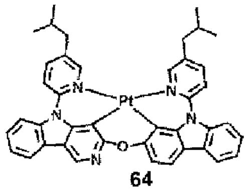
64

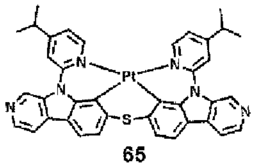
65
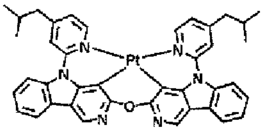
66
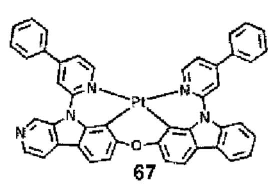
67
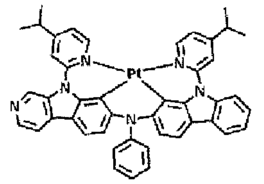
68

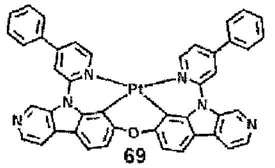
69

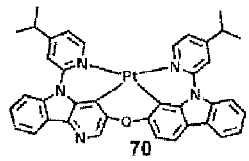
70

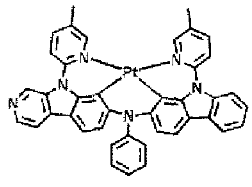
71

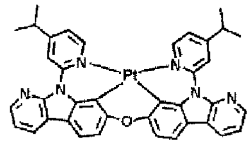
72

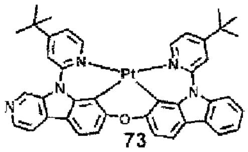
73

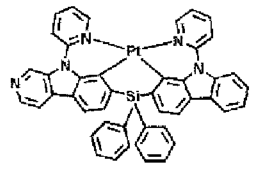
74

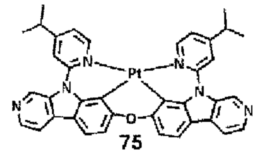
75

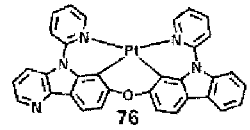
76

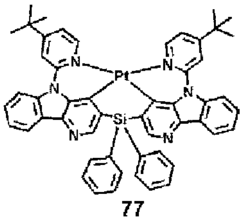
77

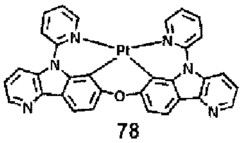
78

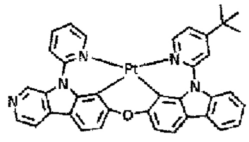
79

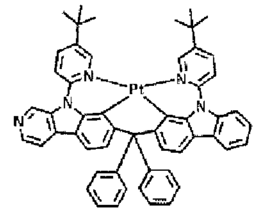
80

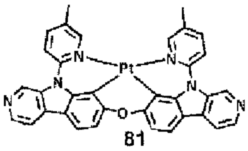
81

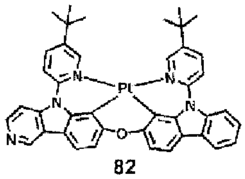
82

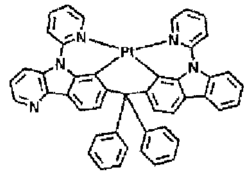
83

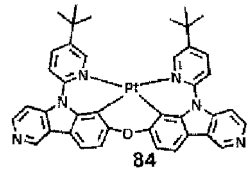
84

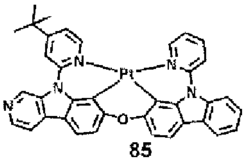
85

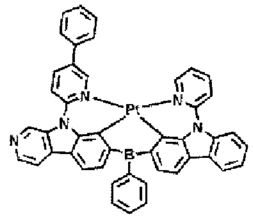
86

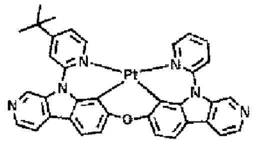
87

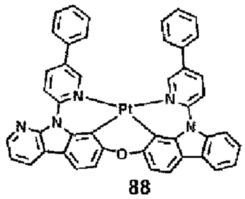
88

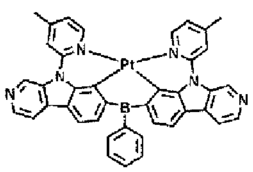
89

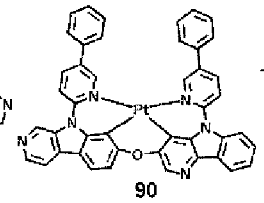
90

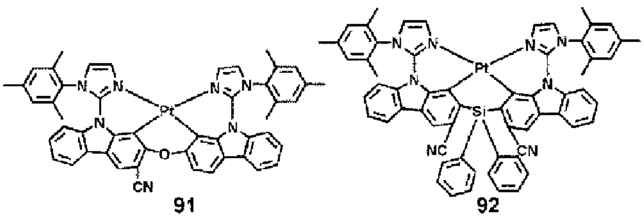
91

92

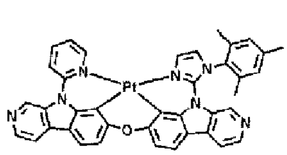
93

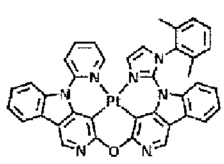
94

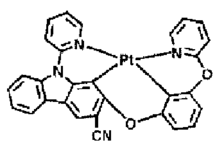
95

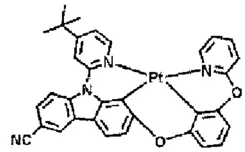
96

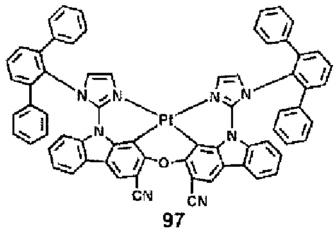
97

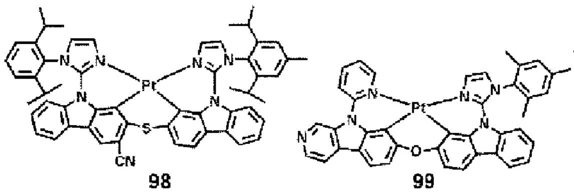
98

99

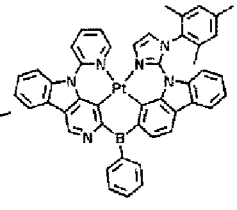
100

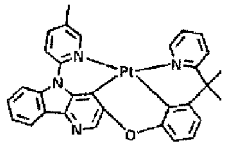
101

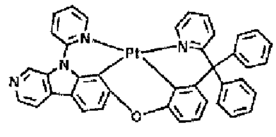
102

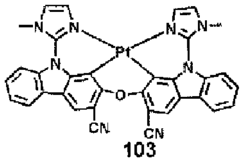
103

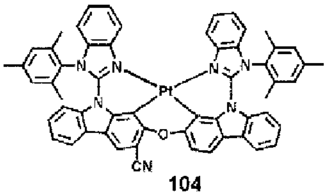
104

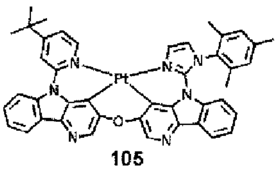
105

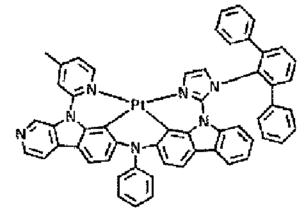
106

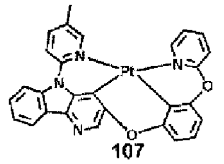
107

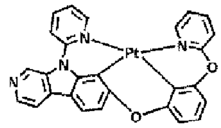
108

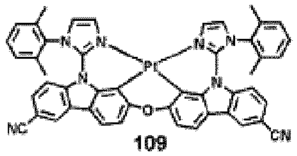
109

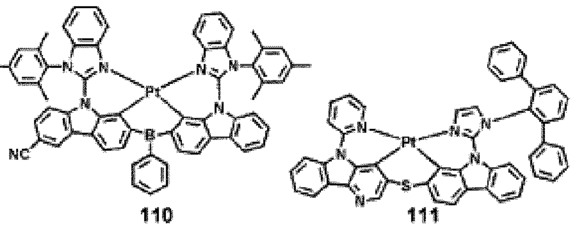
110

111

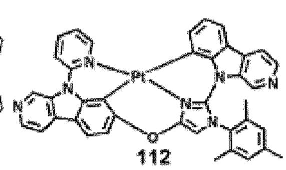
112

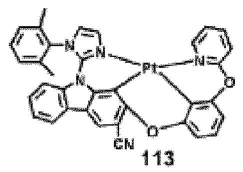
113

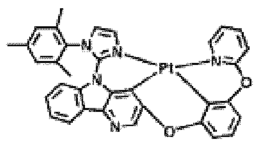
114

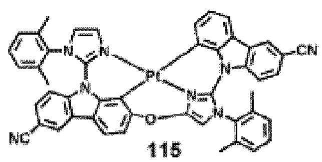
115

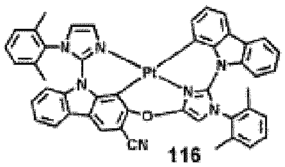
116

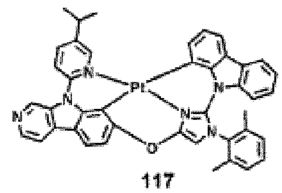
117

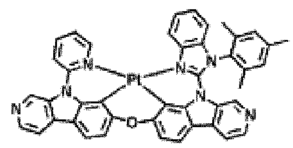
118

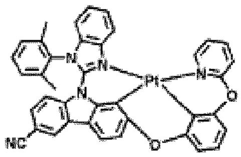
119

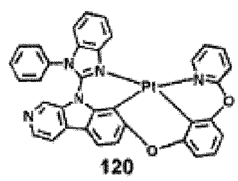
120

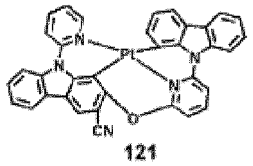
121

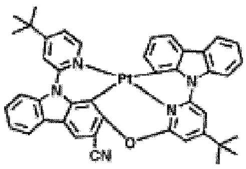
122

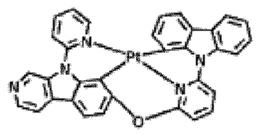
123

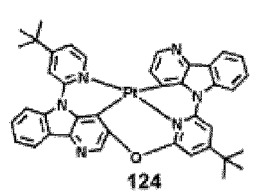
124

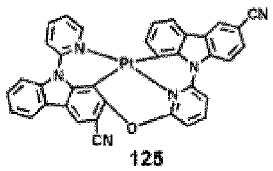
125

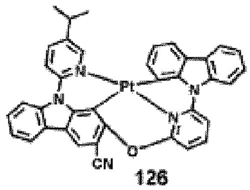
126

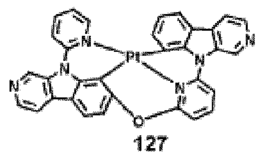
127

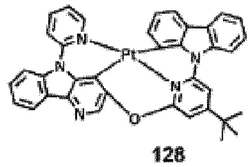
128

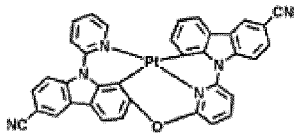
129

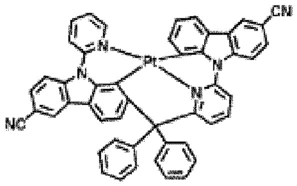
130

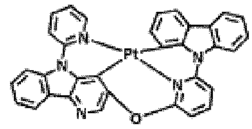
131

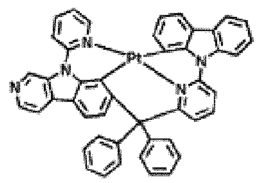
132

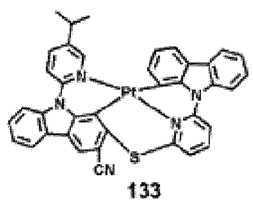
133

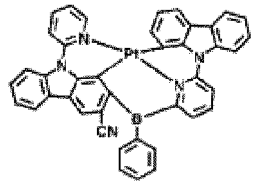
134

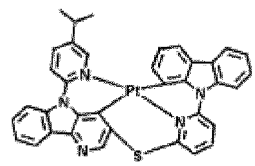
135

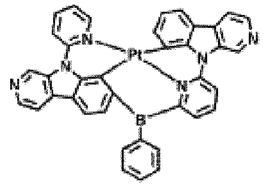
136

**13.** Organische lichtemittierende Vorrichtung, umfassend:

eine erste Elektrode;
eine zweite Elektrode; und
eine organische Schicht, die zwischen der ersten Elektrode und der zweiten Elektrode angeordnet ist,
wobei die organische Schicht eine Emissionsschicht und mindestens eine Organometallverbindung nach einem der Ansprüche 1-12 umfasst;
vorzugsweise wobei
die erste Elektrode eine Anode ist,
die zweite Elektrode eine Kathode ist,
die organische Schicht ferner einen Lochtransportbereich, der zwischen der ersten Elektrode und der Emissionsschicht angeordnet ist, und einen Elektronentransportbereich umfasst, der zwischen der Emissionsschicht und der zweiten Elektrode angeordnet ist,
der Lochtransportbereich eine Lochinjektionsschicht, eine Lochtransportschicht, eine Elektronenblockierschicht oder eine beliebige Kombination davon umfasst, und
der Elektronentransportbereich eine Lochblockierschicht, eine Elektronentransportschicht, eine Elektroneninjektionsschicht oder eine beliebige Kombination davon umfasst.

**14.** Organische lichtemittierende Vorrichtung nach Anspruch 13, wobei
die Emissionsschicht die Organometallverbindung umfasst;
vorzugsweise wobei
die Emissionsschicht ferner einen Wirt umfasst, und
eine Menge des Wirts in der Emissionsschicht größer als eine Menge der Organometallverbindung in der Emissionsschicht ist.

**15.** Diagnostische Zusammensetzung, umfassend mindestens eine Organometallverbindung nach einem der Ansprüche 1-12.

## Revendications

**1.** Composé organométallique représenté par la formule 1 :

Formule 1

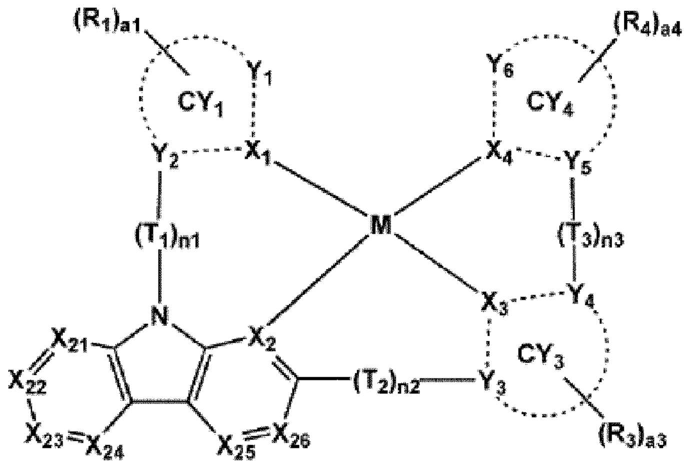

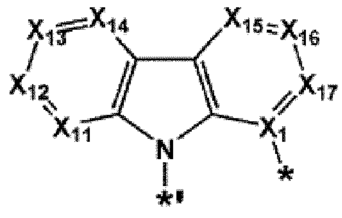

Formule CZ1

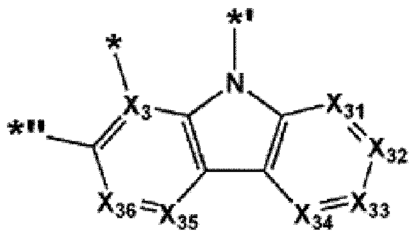

Formule CZ3

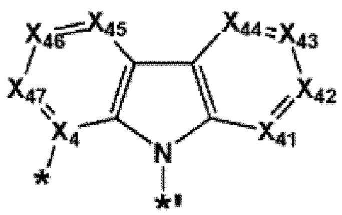

Formule CZ4

,

dans lesquelles, dans les formules 1, CZ1, CZ3 et CZ4,

M est choisi parmi un métal de transition de la première ligne du tableau périodique des éléments, un métal de transition de la deuxième ligne du tableau périodique des éléments et un métal de transition de la troisième ligne du tableau périodique des éléments,
$X_1$ à $X_4$ représentent chacun indépendamment un atome C ou N,
deux liaisons choisies parmi une liaison entre $X_1$ et M, une liaison entre $X_2$ et M, une liaison entre $X_3$ et M, et une liaison entre $X_4$ et M représentent chacune une liaison de coordination et les autres de celles-ci représentent chacune une liaison covalente,
$Y_2$ à $Y_5$ représentent chacun indépendamment un atome C ou N,
$Y_1$ et $Y_6$ représentent chacun indépendamment un atome C, N, O, Si ou S,
une liaison entre $X_1$ et $Y_1$, une liaison entre $X_1$ et $Y_2$, une liaison entre $X_3$ et $Y_3$, une liaison entre $X_3$ et $Y_4$, une liaison entre $X_4$ et $Y_5$, et une liaison entre $X_4$ et $Y_6$ représentent chacune une liaison chimique qui lie les atomes correspondants,
$CY_1$ est choisi parmi un groupe ($C_5$ à $C_{30}$)carbocyclique, un groupe ($C_1$ à $C_{30}$)hétérocyclique, et un groupe représenté par la formule CZ1,
$CY_3$ est choisi parmi un groupe ($C_5$ à $C_{30}$)carbocyclique, un groupe ($C_1$ à $C_{30}$)hétérocyclique, et un groupe représenté par la formule CZ3,
$CY_4$ est choisi parmi un groupe ($C_5$ à $C_{30}$)carbocyclique, un groupe ($C_1$ à $C_{30}$)hétérocyclique, et un groupe représenté par la formule CZ4,
$T_1$ à $T_3$ sont chacun indépendamment choisis parmi *-N[$(L_5)_{b5}$-$(R_5)$]-*', *-B($R_5$)-*', *-P($R_5$)-*', *-C($R_5$)($R_6$)-*', *-Si($R_5$)($R_6$)-*', *-Ge($R_5$)($R_6$)-*', *-S-*', *-Se-*', *-O-*', *-C(=O) -*', *-S(=O)-*' *-S$(=O)_2$-*' *-C($R_5$)=*', *=C($R_5$)-*', *-C($R_5$)=C($R_6$)-*', *-C(=S)-*' et *-C≡C-*',
$L_5$ est choisi parmi une liaison simple, un groupe ($C_5$ à $C_{30}$)carbocyclique substitué ou non substitué, et un groupe ($C_1$ à $C_{30}$)hétérocyclique substitué ou non substitué,
$b_5$ est choisi parmi 1 à 3, lorsque $b_5$ vaut 2 ou plus, deux groupes $L_5$ ou plus étant identiques les uns aux autres ou différents les uns des autres,
$R_5$ et $R_6$ sont éventuellement liés via un premier groupe de liaison pour former un groupe ($C_5$ à $C_{30}$)carbocyclique

substitué ou non substitué ou un groupe ($C_1$ à $C_{30}$)hétérocyclique substitué ou non substitué,

n1 à n3 valent chacun indépendamment 0, 1, 2 ou 3, lorsque n1 vaut zéro, *-$(T_1)_{n1}$-*' représentant une liaison simple, lorsque n2 vaut zéro, *-$(T_2)_{n2}$-*' représentant une liaison simple, et lorsque n3 vaut zéro, *-$(T_3)_{n3}$-*' représentant une liaison simple,

$X_{11}$ représente un atome N ou un groupe $C(R_{11})$, $X_{12}$ représente un atome N ou un groupe $C(R_{12})$, $X_{13}$ représente un atome N ou un groupe $C(R_{13})$, $X_{14}$ représente un atome N ou un groupe $C(R_{14})$, $X_{15}$ représente un atome N ou un groupe $C(R_{15})$, $X_{16}$ représente un atome N ou un groupe $C(R_{16})$, $X_{17}$ représente un atome N ou un groupe $C(R_{17})$, $X_{21}$ représente un atome N ou un groupe $C(R_{21})$, $X_{22}$ représente un atome N ou un groupe $C(R_{22})$, $X_{23}$ représente un atome N ou un groupe $C(R_{23})$, $X_{24}$ représente un atome N ou un groupe $C(R_{24})$, $X_{25}$ représente un atome N ou un groupe $C(R_{25})$, $X_{26}$ représente un atome N ou un groupe $C(R_{26})$, $X_{31}$ représente un atome N ou un groupe $C(R_{31})$, $X_{32}$ représente un atome N ou un groupe $C(R_{32})$, $X_{33}$ représente un atome N ou un groupe $C(R_{33})$, $X_{34}$ représente un atome N ou un groupe $C(R_{34})$, $X_{35}$ représente un atome N ou un groupe $C(R_{35})$, $X_{36}$ représente un atome N ou un groupe $C(R_{36})$, $X_{41}$ représente un atome N ou un groupe $C(R_{41})$, $X_{42}$ représente un atome N ou un groupe $C(R_{42})$, $X_{43}$ représente un atome N ou un groupe $C(R_{43})$, $X_{44}$ représente un atome N ou un groupe $C(R_{44})$, $X_{45}$ représente un atome N ou un groupe $C(R_{45})$, $X_{46}$ représente un atome N ou un groupe $C(R_{46})$, et $X_{47}$ représente un atome N ou un groupe $C(R_{47})$,

$R_1$, $R_3$ à $R_6$, $R_{11}$ à $R_{17}$, $R_{21}$ à $R_{26}$, $R_{31}$ à $R_{36}$, et $R_{41}$ à $R_{47}$ sont chacun indépendamment choisis parmi un atome d'hydrogène, un atome de deutérium, un atome-F, -Cl, -Br, -I, un groupe $-SF_5$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle substitué ou non substitué, un groupe ($C_2$ à $C_{60}$)alcényle substitué ou non substitué, un groupe ($C_2$ à $C_{60}$)alcynyle substitué ou non substitué, un groupe ($C_1$ à $C_{60}$)alcoxy substitué ou non substitué, un groupe ($C_3$ à $C_{10}$)cycloalkyle substitué ou non substitué, un groupe ($C_1$ à $C_{10}$)hétérocycloalkyle substitué ou non substitué, un groupe ($C_3$ à $C_{10}$)cycloalcényle substitué ou non substitué, un groupe ($C_1$ à $C_{10}$)hétérocycloalcényle substitué ou non substitué, un groupe ($C_6$ à $C_{60}$)aryle substitué ou non substitué, un groupe ($C_6$ à $C_{60}$)aryloxy substitué ou non substitué, un groupe ($C_6$ à $C_{60}$)arylthio substitué ou non substitué, un groupe ($C_7$ à $C_{60}$)arylalkyle substitué ou non substitué, un groupe ($C_1$ à $C_{60}$)hétéroaryle substitué ou non substitué, un groupe ($C_1$ à $C_{60}$)hétéroaryloxy substitué ou non substitué, un groupe ($C_1$ à $C_{60}$)hétéroarylthio substitué ou non substitué, un groupe ($C_2$ à $C_{60}$)hétéroarylalkyle substitué ou non substitué, un groupe polycyclique condensé non aromatique monovalent substitué ou non substitué, un groupe hétéropolycyclique condensé non aromatique monovalent substitué ou non substitué, $-N(Q_1)(Q_2)$, $-Si(Q_3)(Q_4)(Q_5)$, $-B(Q_6)(Q_7)$, et $-P(=O)(Q_8)(Q_9)$,

a1, a3 et a4 valent chacun indépendamment 0, 1, 2, 3, 4 ou 5,

deux des groupes $R_1$ au nombre de a1 sont éventuellement liés pour former un groupe ($C_5$ à $C_{30}$)carbocyclique substitué ou non substitué ou un groupe ($C_1$ à $C_{30}$)hétérocyclique substitué ou non substitué,

deux des groupes $R_3$ au nombre de a3 sont éventuellement liés pour former un groupe ($C_5$ à $C_{30}$)carbocyclique substitué ou non substitué ou un groupe ($C_1$ à $C_{30}$)hétérocyclique substitué ou non substitué,

deux des groupes $R_4$ au nombre de a4 sont éventuellement liés pour former un groupe ($C_5$ à $C_{30}$)carbocyclique substitué ou non substitué ou un groupe ($C_1$ à $C_{30}$)hétérocyclique substitué ou non substitué,

deux des groupes $R_{11}$ à $R_{17}$ sont éventuellement liés pour former un groupe ($C_5$ à $C_{30}$)carbocyclique substitué ou non substitué ou un groupe ($C_1$ à $C_{30}$)hétérocyclique substitué ou non substitué,

deux des groupes $R_{21}$ à $R_{26}$ sont éventuellement liés pour former un groupe ($C_5$ à $C_{30}$)carbocyclique substitué ou non substitué ou un groupe ($C_1$ à $C_{30}$)hétérocyclique substitué ou non substitué,

deux des groupes $R_{31}$ à $R_{36}$ sont éventuellement liés pour former un groupe ($C_5$ à $C_{30}$)carbocyclique substitué ou non substitué ou un groupe ($C_1$ à $C_{30}$)hétérocyclique substitué ou non substitué,

deux des groupes $R_{41}$ à $R_{47}$ sont éventuellement liés pour former un groupe ($C_5$ à $C_{30}$)carbocyclique substitué ou non substitué ou un groupe ($C_1$ à $C_{30}$)hétérocyclique substitué ou non substitué,

*, *' et *" indiquent chacun un site de liaison à un atome voisin, lesdits substituants du groupe ($C_5$ à $C_{30}$)carbocyclique substitué, du groupe ($C_1$ à $C_{30}$)hétérocyclique substitué, du groupe ($C_1$ à $C_{60}$)alkyle substitué, du groupe ($C_2$ à $C_{60}$)alcényle substitué, du groupe ($C_2$ à $C_{60}$)alcynyle substitué, du groupe ($C_1$ à $C_{60}$)alcoxy substitué, du groupe ($C_3$ à $C_{10}$)cycloalkyle substitué, du groupe ($C_1$ à $C_{10}$)hétérocycloalkyle substitué, du groupe ($C_3$ à $C_{10}$)cycloalcényle substitué, du groupe ($C_1$ à $C_{10}$)hétérocycloalcényle substitué, du groupe ($C_6$ à $C_{60}$)aryle substitué, du groupe ($C_6$ à $C_{60}$)aryloxy substitué, du groupe ($C_6$ à $C_{60}$)arylthio substitué, du groupe ($C_7$ à $C_{60}$)arylalkyle substitué, du groupe ($C_1$ à $C_{60}$)hétéroaryle substitué, du groupe ($C_1$ à $C_{60}$)hétéroaryloxy substitué, du groupe ($C_1$ à $C_{60}$)hétéroarylthio substitué, du groupe ($C_2$ à $C_{60}$)hétéroarylalkyle substitué, du groupe polycyclique condensé non aromatique monovalent substitué, du groupe hétéropolycyclique condensé non aromatique monovalent substitué sont choisis parmi :

un atome de deutérium, un atome -F, -Cl, -Br, -I, un groupe $-CD_3$, $-CD_2H$, $-CDH_2$, un groupe hydroxy, un groupe

cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle, un groupe ($C_2$ à $C_{60}$)alcényle, un groupe ($C_2$ à $C_{60}$)alcynyle et un groupe ($C_1$ à $C_{60}$)alcoxy ;

un groupe ($C_1$ à $C_{60}$)alkyle, un groupe ($C_2$ à $C_{60}$)alcényle, un groupe ($C_2$ à $C_{60}$)alcynyle et un groupe ($C_1$ à $C_{60}$)alcoxy, chacun substitué par au moins un élément choisi parmi un atome de deutérium, un atome -F, -Cl, -Br, -I, un groupe $-CD_3$, $-CD_2H$, $-CDH_2$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_7$ à $C_{60}$)arylalkyle, un groupe ($C_1$ à $C_{60}$)hétéroaryle, un groupe ($C_1$ à $C_{60}$)hétéroaryloxy, un groupe ($C_1$ à $C_{60}$)hétéroarylthio, un groupe ($C_2$ à $C_{60}$)hétéroarylalkyle, un groupe polycyclique condensé non aromatique monovalent, un groupe hétéropolycyclique condensé non aromatique monovalent, $-N(Q_{11})(Q_{12})$, $-Si(Q_{13})(Q_{14})(Q_{15})$, $-B(Q_{16})(Q_{17})$, et $-P(=O)(Q_{18})(Q_{19})$ ;

un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_7$ à $C_{60}$)arylalkyle, un groupe ($C_1$ à $C_{60}$)hétéroaryle, un groupe ($C_1$ à $C_{60}$)hétéroaryloxy, un groupe ($C_1$ à $C_{60}$)hétéroarylthio, un groupe ($C_2$ à $C_{60}$)hétéroarylalkyle, un groupe polycyclique condensé non aromatique monovalent et un groupe hétéropolycyclique condensé non aromatique monovalent ;

un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_7$ à $C_{60}$)arylalkyle, un groupe ($C_1$ à $C_{60}$)hétéroaryle, un groupe ($C_1$ à $C_{60}$)hétéroaryloxy, un groupe ($C_1$ à $C_{60}$)hétéroarylthio, un groupe ($C_2$ à $C_{60}$)hétéroarylalkyle, un groupe polycyclique condensé non aromatique monovalent et un groupe hétéropolycyclique condensé non aromatique monovalent, chacun substitué par au moins un élément parmi un atome de deutérium, un atome -F, -Cl, -Br, -I, un groupe $-CD_3$, $-CD_2H$, $-CDH_2$, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle, un groupe ($C_2$ à $C_{60}$)alcényle, un groupe ($C_2$ à $C_{60}$)alcynyle, un groupe ($C_1$ à $C_{60}$)alcoxy, un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryloxy, un groupe ($C_6$ à $C_{60}$)arylthio, un groupe ($C_7$ à $C_{60}$)arylalkyle, un groupe ($C_1$ à $C_{60}$)hétéroaryle, un groupe ($C_1$ à $C_{60}$)hétéroaryloxy, un groupe ($C_1$ à $C_{60}$)hétéroarylthio, un groupe ($C_2$ à $C_{60}$)hétéroarylalkyle, un groupe polycyclique condensé non aromatique monovalent, un groupe hétéropolycyclique condensé non aromatique monovalent, $-N(Q_{21})(Q_{22})$, $-Si(Q_{23})(Q_{24})(Q_{25})$, $-B(Q_{26})(Q_{27})$, et $-P(=O)(Q_{28})(Q_{29})$ ; et

$-N(Q_{31})(Q_{32})$, $-Si(Q_{33})(Q_{34})(Q_{35})$, $-B(Q_{36})(Q_{37})$, et $-P(=O)(Q_{38})(Q_{39})$,

$Q_1$ à $Q_9$, $Q_{11}$ à $Q_{19}$, $Q_{21}$ à $Q_{29}$, et $Q_{31}$ à $Q_{39}$ sont chacun indépendamment choisis parmi un atome d'hydrogène, un atome de deutérium, un atome -F, -Cl, -Br, -I, un groupe hydroxy, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{60}$)alkyle, un groupe ($C_2$ à $C_{60}$)alcényle, un groupe ($C_2$ à $C_{60}$)alcynyle, un groupe ($C_1$ à $C_{60}$)alcoxy, un groupe ($C_3$ à $C_{10}$)cycloalkyle, un groupe ($C_1$ à $C_{10}$)hétérocycloalkyle, un groupe ($C_3$ à $C_{10}$)cycloalcényle, un groupe ($C_1$ à $C_{10}$)hétérocycloalcényle, un groupe ($C_6$ à $C_{60}$)aryle, un groupe ($C_6$ à $C_{60}$)aryle substitué par au moins un groupe choisi parmi un groupe ($C_1$ à $C_{60}$)alkyle et un groupe ($C_6$ à $C_{60}$)aryle, un groupe ($C_6$ à $C_{60}$)aryloxy, un groupe ($C_6$ à $C_{60}$)arylthio, un groupe ($C_7$ à $C_{60}$)arylalkyle, un groupe ($C_1$ à $C_{60}$)hétéroaryle, un groupe ($C_1$ à $C_{60}$)hétéroaryloxy, un groupe ($C_1$ à $C_{60}$)hétéroarylthio, un groupe ($C_2$ à $C_{60}$)hétéroarylalkyle, un groupe polycyclique condensé non aromatique monovalent, et un groupe hétéropolycyclique condensé non aromatique monovalent, et

la formule 1 satisfait au moins l'une de la condition 1 à la condition 4 :

Condition 1

$CY_1$ dans la formule 1 est un groupe représenté par la formule CZ1, à condition qu'au moins l'une des groupes $X_{11}$ à $X_{17}$ dans la formule CZ1 représente chacun indépendamment un atome N ou un groupe C(CN),

Condition 2

au moins l'un des groupes $X_{21}$ à $X_{26}$ dans la formule 1 ente chacun indépendamment un atome N ou un groupe C(CN),

Condition 3

$CY_3$ dans la formule 1 est un groupe représenté par la formule CZ3, à condition qu'au moins l'une des groupes $X_{31}$ à $X_{36}$ dans la formule CZ3 représente chacun indépendamment un atome N ou un groupe C(CN), et

Condition 4

$CY_4$ dans la formule 1 est un groupe représenté par la formule CZ4, à condition qu'au moins l'une des groupes $X_{41}$ à $X_{47}$ dans la formule CZ4 représente chacun indépendamment un atome N ou un groupe C(CN).

2. Composé organométallique selon la revendication 1, M représentant un atome Pt ou Pd.

3. Composé organométallique selon la revendication 1 ou 2,

i) $X_1$ et $X_4$ représentant chacun un atome N, $X_2$ et $X_3$ représentant chacun un atome C, une liaison entre $X_1$ et M et une liaison entre $X_4$ et M représentant chacune une liaison de coordination, et une liaison entre $X_2$ et M et une liaison entre $X_3$ et M représentant chacune une liaison covalente ;

ii) $X_1$ et $X_3$ représentant chacun un atome N, $X_2$ et $X_4$ représentant chacun un atome C, une liaison entre $X_1$ et M et une liaison entre $X_3$ et M représentant chacune une liaison de coordination, et une liaison entre $X_2$ et M et une liaison entre $X_4$ et M représentant chacune une liaison covalente ; ou

iii) $X_3$ et $X_4$ représentant chacun un atome N, $X_1$ et $X_2$ représentant chacun un atome C, une liaison entre $X_3$ et M et une liaison entre $X_4$ et M représentant chacune une liaison de coordination, et une liaison entre $X_1$ et M et une liaison entre $X_2$ et M représentant chacune une liaison covalente

4. Composé organométallique selon l'une quelconque des revendications 1 à 3, $CY_1$, $CY_3$ et $CY_4$ étant chacun indépendamment choisis parmi un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe pyrrole, un groupe thiophène, un groupe furane, un groupe indole, un groupe iso-indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe 5-oxyde de dibenzothiophène, un groupe 9H-fluoréne-9-on, un groupe 5,5-dioxyde de dibenzothiophène, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe 5-oxyde d'azadibenzothiophène, un groupe aza-9H-fluoréne-9-on, un groupe 5,5-dioxyde d'azadibenzothiophène, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrazole, un groupe imidazole, un groupe triazole, un groupe tétrazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, un groupe benzothiadiazole, un groupe 5,6,7,8-tétrahydroisoquinoline, et un groupe 5,6,7,8-tétrahydroquinoline ;

$CY_1$ étant un groupe représenté par la formule CZ1 ;

$CY_3$ étant un groupe représenté par la formule CZ3 ; ou

$CY_4$ étant un groupe représenté par la formule CZ4.

5. Composé organométallique selon l'une quelconque des revendications 1 à 4, dans la formule 1, un groupement représenté par

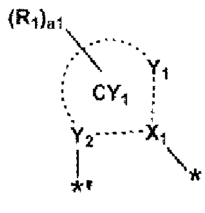

et un groupement représenté par

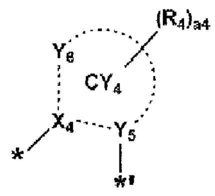

étant identiques l'un à l'autre ; un groupement représenté par

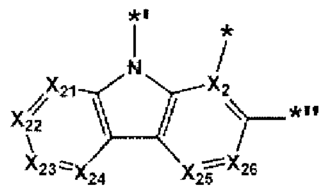

et un groupement représenté par

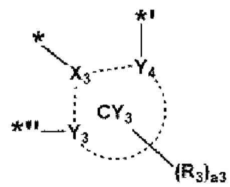

étant identiques l'un à l'autre ; un groupement représenté par

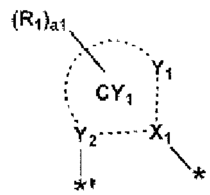

et un groupement représenté par

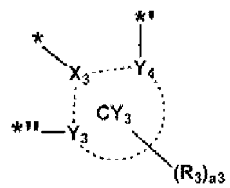

étant identiques l'un à l'autre ; un groupement représenté par

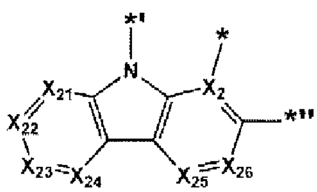

et un groupement représenté par

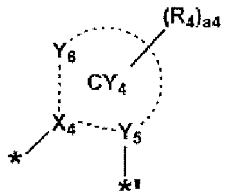

étant identiques l'un à l'autre ; ou
un groupement représenté par

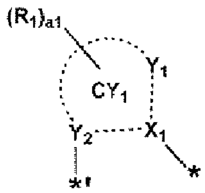

,

un groupement représenté par

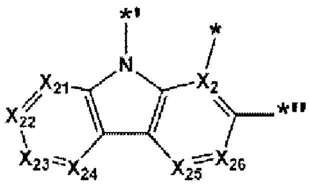

,

un groupement représenté par

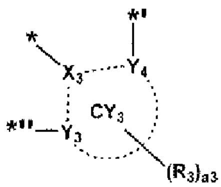

,

et un groupement représenté par

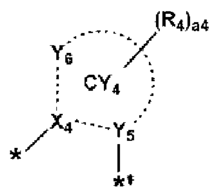

étant différents les uns des autres.

**6.** Composé organométallique selon l'une quelconque des revendications 1 à 5, le composé organométallique ayant une structure symétrique par rapport à un axe reliant M et $T_2$ dans la formule 1 ; et/ou
$T_1$ à $T_3$ représentant chacun indépendamment *-N[$(L_5)_{b5}$-($R_5$)] *-B($R_5$)-*', *-C($R_5$)($R_6$)-*', *-Si($R_5$)($R_6$)-*', *-S-*' ou *-O-*', et
la somme de n1, n2, et n3 valant 1 ou 2.

7. Composé organométallique selon l'une quelconque des revendications 1 à 6, $R_1$, $R_3$ à $R_6$, $R_{11}$ à $R_{17}$, $R_{21}$ à $R_{26}$, $R_{31}$ à $R_{36}$, et $R_{41}$ à $R_{47}$ étant chacun indépendamment choisis parmi :

un atome d'hydrogène, un atome de deutérium, un atome -F, -Cl, -Br, -I, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe $-SF_5$, un groupe ($C_1$ à $C_{20}$)alkyle, et un groupe ($C_1$ à $C_{20}$)alcoxy ;
un groupe ($C_1$ à $C_{20}$)alkyle et un groupe ($C_1$ à $C_{20}$)alcoxy, chacun substitué par au moins un élément choisi parmi un atome de deutérium, un atome -F, -Cl, -Br, -I, un groupe $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{10}$)alkyle, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué par au moins un élément choisi parmi un atome de deutérium, un atome -F, -Cl, -Br, -I, $-CD_3$, $-CD_2H$, $-CDH_2$, $-CF_3$, $-CF_2H$, $-CFH_2$, un groupe hydroxy, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe ($C_1$ à $C_{20}$)alkyle, un groupe ($C_1$ à $C_{20}$)alcoxy, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe

isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ; et

$-N(Q_1)(Q_2)$, $-Si(Q_3)(Q_4)(Q_5)$, $-B(Q_6)(Q_7)$, et $-P(=O)(Q_8)(Q_9)$, et

$Q_1$ à $Q_9$ sont chacun indépendamment choisis parmi :

un groupe $-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, et $-CD_2CDH_2$;

un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe phényle, et un groupe naphtyle ; et

un groupe n-propyle, un groupe iso-propyle, un groupe n-butyle, un groupe iso-butyle, un groupe sec-butyle, un groupe tert-butyle, un groupe n-pentyle, un groupe iso-pentyle, un groupe sec-pentyle, un groupe tert-pentyle, un groupe phényle, et un groupe naphtyle, chacun substitué par au moins un élément choisi parmi un atome de deutérium, un groupe ($C_1$ à $C_{10}$)alkyle et un groupe phényle ;

de préférence

$R_1$, $R_3$ à $R_6$, $R_{11}$ à $R_{17}$, $R_{21}$ à $R_{26}$, $R_{31}$ à $R_{36}$, et $R_{41}$ à $R_{47}$ représentant chacun indépendamment un atome d'hydrogène, un atome de deutérium, un atome -F, un groupe cyano, un groupe nitro, $-SF_5$, $-CH_3$, $-CD_3$, $-CD_2H$, $-CDH_2$, $-CF_3$, $-CF_2H$, $-CFH_2$, des groupes représentés par les formules 9-1 à 9-19, des groupes représentés par les formules 10-1 et 10-139, et le groupe $-Si(Q_3)(Q_4)(Q_5)$ :

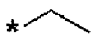
Formule 9-1

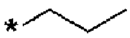
Formule 9-2

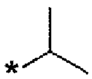
Formule 9-3

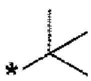
Formule 9-4

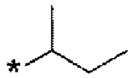
Formule 9-5

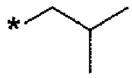
Formule 9-6

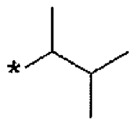
Formule 9-7

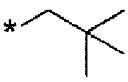
Formule 9-8

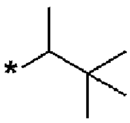
Formule 9-9

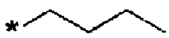
Formule 9-10

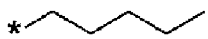
Formule 9-11

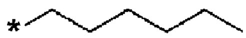
Formule 9-12

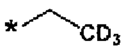
Formule 9-13

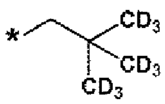
Formule 9-14

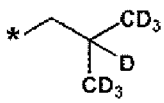
Formule 9-15

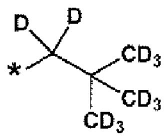
Formule 9-16

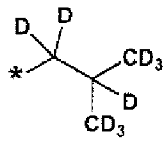
Formule 9-17

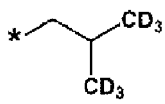
Formule 9-18

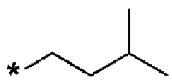
Formule 9-19

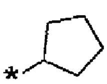
Formule 10-1

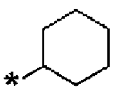
Formule 10-2

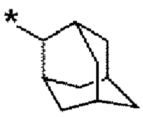
Formule 10-3

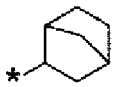
Formule 10-4

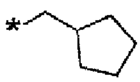
Formule 10-5

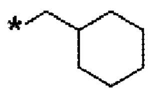
Formule 10-6

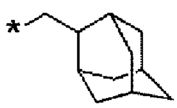
Formule 10-7

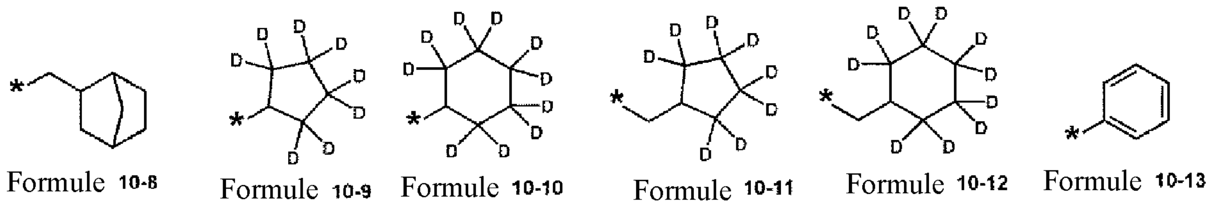

Formule 10-8 Formule 10-9 Formule 10-10 Formule 10-11 Formule 10-12 Formule 10-13

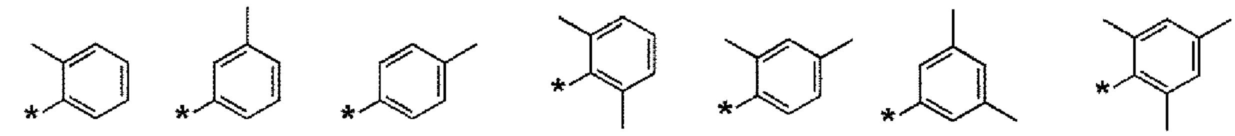

Formule 10-14 Formule 10-15 Formule 10-16 Formule 10-17 Formule 10-18 Formule 10-19 Formule 10-20

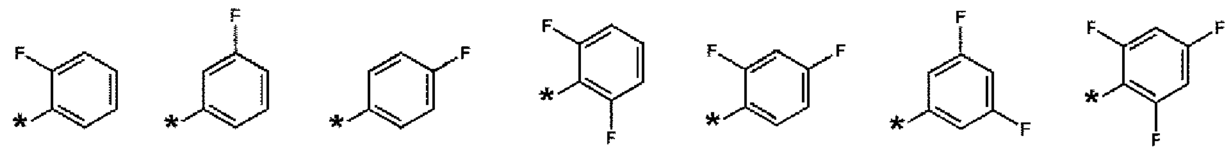

Formule 10-21 Formule 10-22 Formule 10-23 Formule 10-24 Formule 10-25 Formule 10-26 Formule 10-27

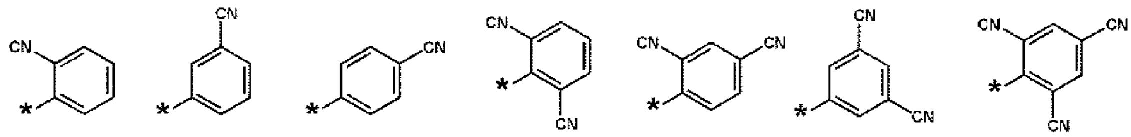

Formule 10-28 Formule 10-29 Formule 10-30 Formule 10-31 Formule 10-32 Formule 10-33 Formule 10-34

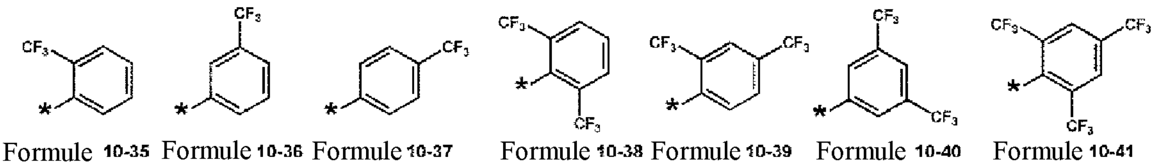

Formule 10-35 Formule 10-36 Formule 10-37 Formule 10-38 Formule 10-39 Formule 10-40 Formule 10-41

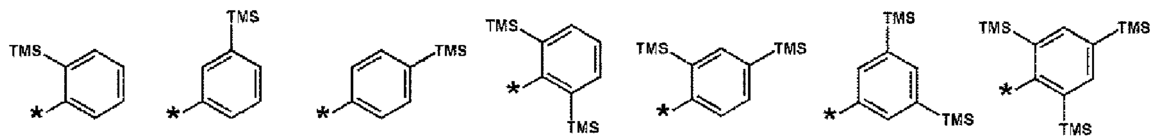

Formule 10-42 Formule 10-43 Formule 10-44 Formule 10-45 Formule 10-46 Formule 10-47 Formule 10-48

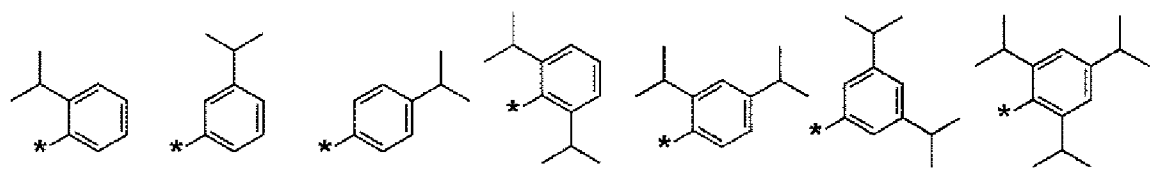

Formule 10-49 Formule 10-50 Formule 10-51 Formule 10-52 Formule 10-53 Formule 10-54 Formule 10-55

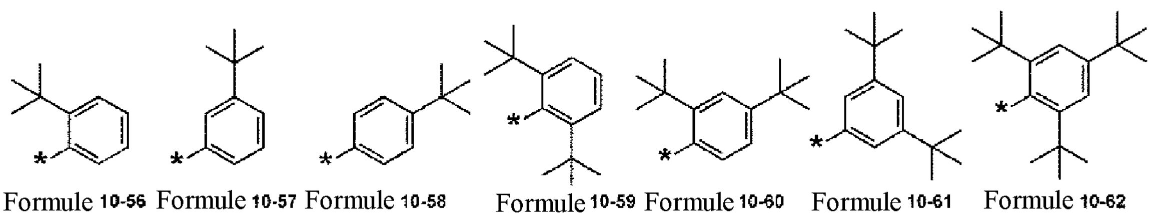

Formule 10-56 Formule 10-57 Formule 10-58 Formule 10-59 Formule 10-60 Formule 10-61 Formule 10-62

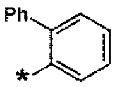
Formule 10-63

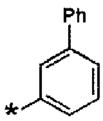
Formule 10-64

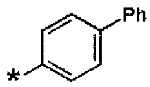
Formule 10-65

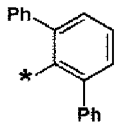
Formule 10-66

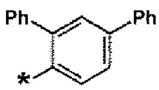
Formule 10-67

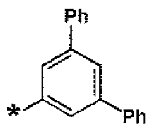
Formule 10-68

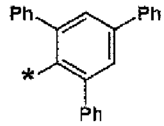
Formule 10-69

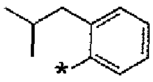
Formule 10-70

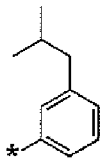
Formule 10-71

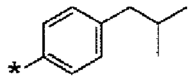
Formule 10-72

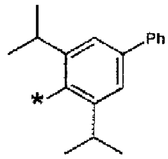
Formule 10-73

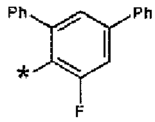
Formule 10-74

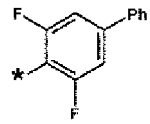
Formule 10-75

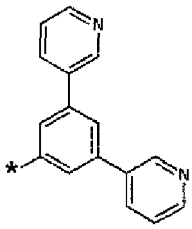
Formule 10-76

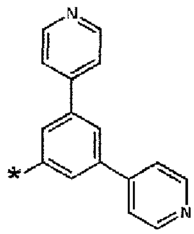
Formule 10-77

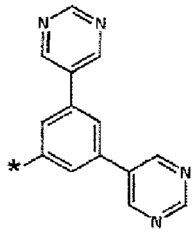
Formule 10-78

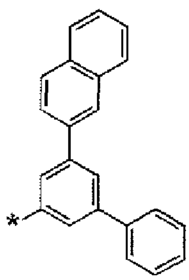
Formule 10-79

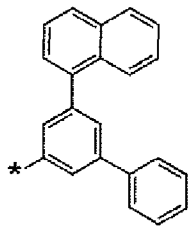
Formule 10-80

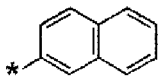
Formule 10-81

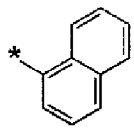
Formule 10-82

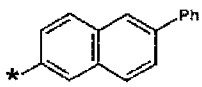
Formule 10-83

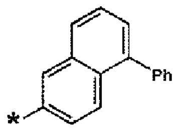
Formule 10-84

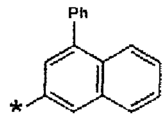
Formule 10-85

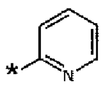
Formule 10-86

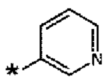
Formule 10-87

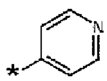
Formule 10-88

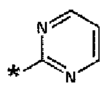
Formule 10-89

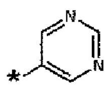
Formule 10-90

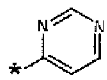
Formule 10-91

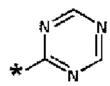
Formule 10-92

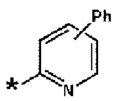
Formule 10-93

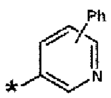
Formule 10-94

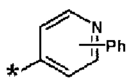
Formule 10-95

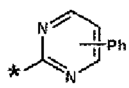
Formule 10-96

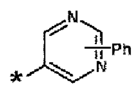
Formule 10-97

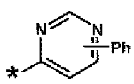
Formule 10-98

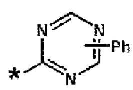
Formule 10-99

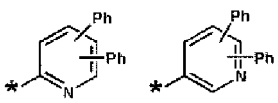
Formule 10-100 Formule 10-101

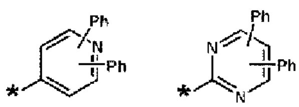
Formule 10-102 Formule 10-103

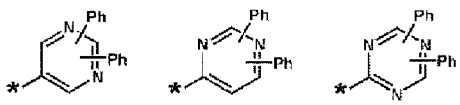
Formule 10-104 Formule 10-105 Formule 10-106

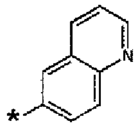 Formule 10-107
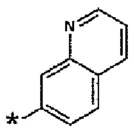 Formule 10-108
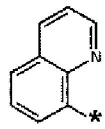 Formule 10-109
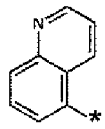 Formule 10-110
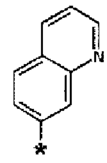 Formule 10-111
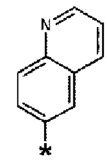 Formule 10-112

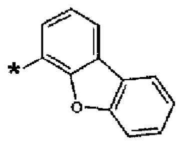 Formule 10-113
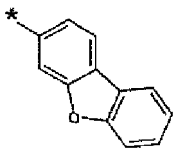 Formule 10-114
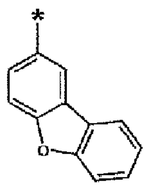 Formule 10-115
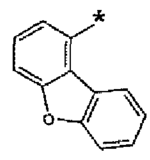 Formule 10-116
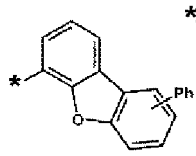 Formule 10-117
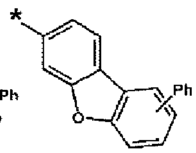 Formule 10-118

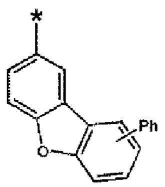 Formule 10-119
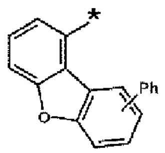 Formule 10-120
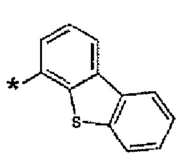 Formule 10-121
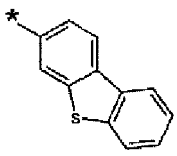 Formule 10-122
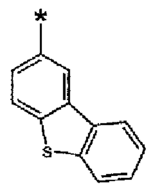 Formule 10-123
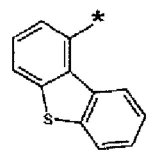 Formule 10-124

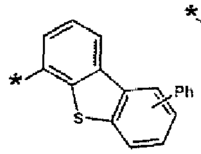 Formule 10-125
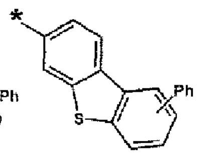 Formule 10-126
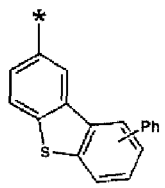 Formule 10-127
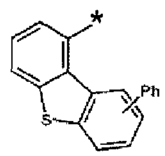 Formule 10-128
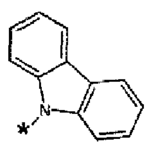 Formule 10-129
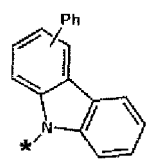 Formule 10-130

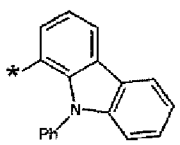 Formule 10-131
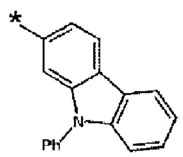 Formule 10-132
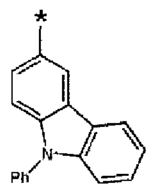 Formule 10-133
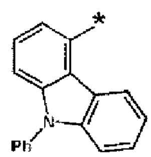 Formule 10-134
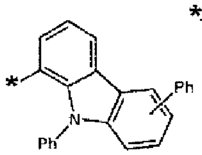 Formule 10-135
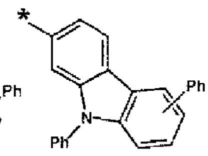 Formule 10-136

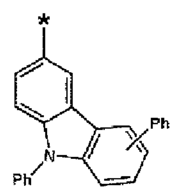 Formule 10-137
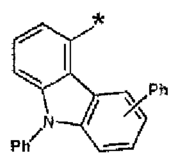 Formule 10-138
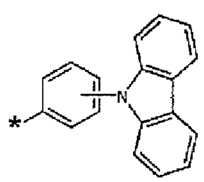 Formule 10-139

,

dans lesquelles, dans les formules 9-1 à 9-19 et 10-1 à 10-139, « Ph » indique un groupe phényle, « TMS » indique un groupe triméthylsilyle, et * indique un site de liaison à un atome voisin.

**8.** Composé organométallique selon l'une quelconque des revendications 1 à 7,

un groupement représenté par la formule 1

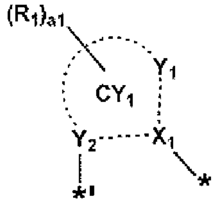

étant choisi parmi les groupes représentés par les formules CY1-1 à CY1-39 et CZ1-1 à CZ1-8 :

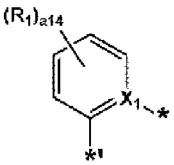
Formule CY1-1

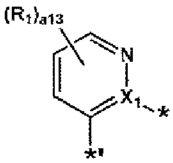
Formule CY1-2

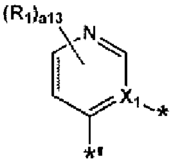
Formule CY1-3

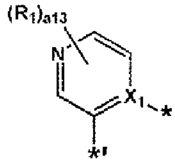
Formule CY1-4

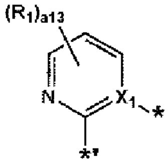
Formule CY1-5

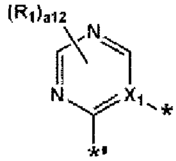
Formule CY1-6

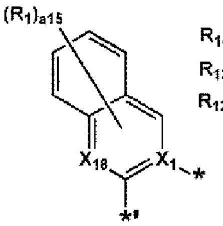
Formule CY1-7

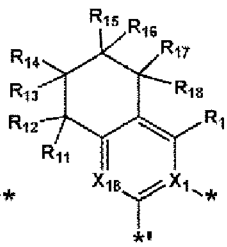
Formule CY1-8

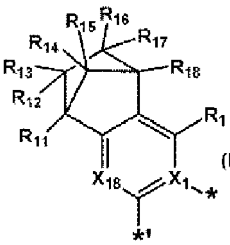
Formule CY1-9

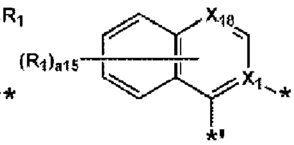
Formule CY1-10

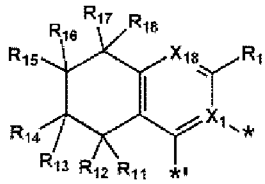
Formule CY1-11

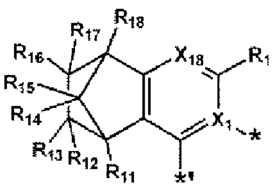
Formule CY1-12

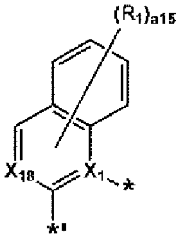
Formule CY1-13

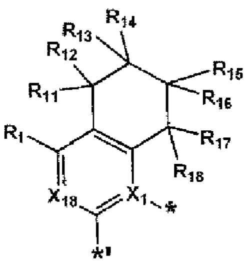
Formule CY1-14

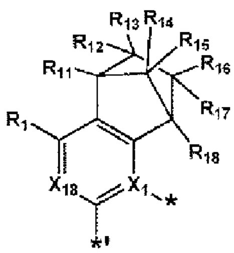
Formule CY1-15

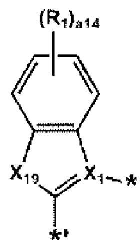
Formule CY1-16

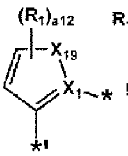
Formule CY1-17

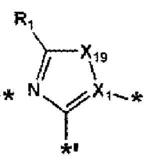
Formule CY1-18

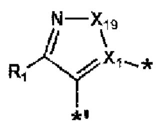
Formule CY1-19

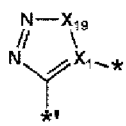
Formule CY1-20

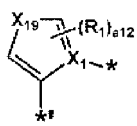
Formule CY1-21

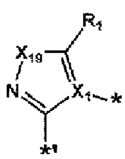
Formule CY1-22

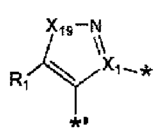
Formule CY1-23

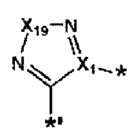
Formule CY1-24

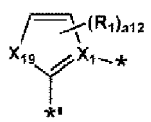
Formule CY1-25

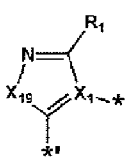
Formule CY1-26

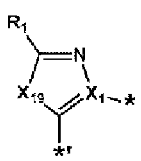
Formule CY1-27

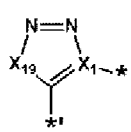
Formule CY1-28

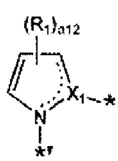
Formule CY1-29

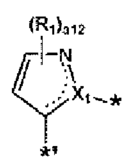
Formule CY1-30

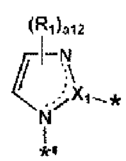
Formule CY1-31

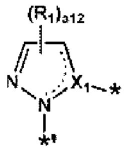
Formule CY1-32

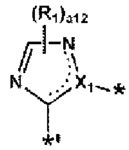
Formule CY1-33

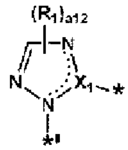
Formule CY1-34

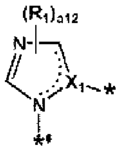
Formule CY1-35

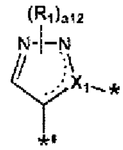
Formule CY1-36

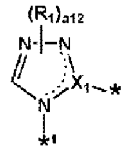
Formule CY1-37

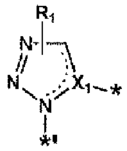
Formule CY1-38

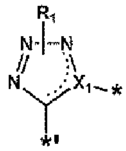
Formule CY1-39

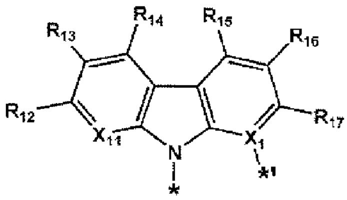
Formule CZ1-1

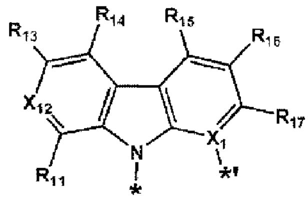
Formule CZ1-2

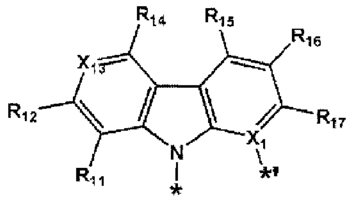
Formule CZ1-3

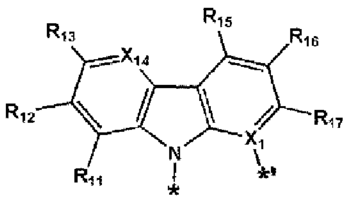
Formule CZ1-4

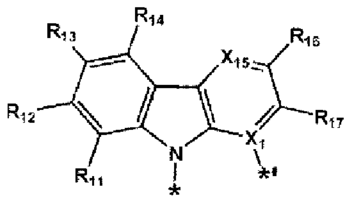
Formule CZ1-5

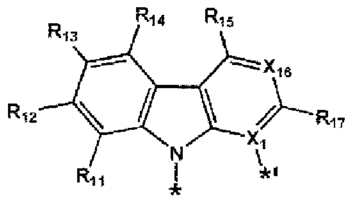
Formule CZ1-6

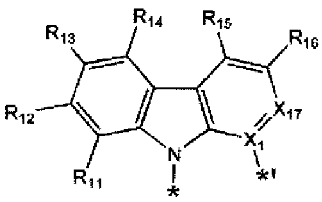
Formule CZ1-7

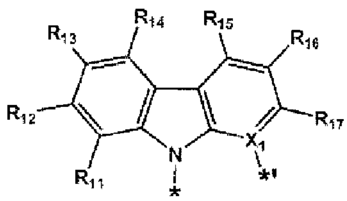
Formule CZ1-8

dans lesquelles, dans les formules CY1-1 à CY1-39 et CZ1-1 à CZ1-8,

$X_1$ et $R_1$ représentent chacun indépendamment la même chose que décrite dans la revendication 1,
$X_{18}$ représente un atome N ou un groupe $C(R_{18})$,
$X_{19}$ représente un atome O ou S, un groupe $N[(L_{19})_{b19}\text{-}(R_{19})]$ ou $C(R_{19a})(R_{19b})$,
$R_{11}$ à $R_{18}$ représentent chacun indépendamment la même chose que décrite en lien avec $R_1$ dans la revendication 1,
$L_{19}$ et $b_{19}$ représentent chacun indépendamment la même chose que décrite en lien avec $L_5$ et b5 dans la revendication 1,
$R_{19}$, $R_{19a}$ et $R_{19b}$ représentent chacun indépendamment la même chose que décrite en lien avec $R_5$ dans la revendication 1,
$X_{11}$ à $X_{17}$ représentent chacun indépendamment un atome N ou un groupe C(CN),
a15 représente un entier allant de 0 à 5,
a14 représente un entier allant de 0 à 4,
a13 représente un entier allant de 0 à 3,
a12 représente un entier allant de 0 à 2, et
* et *' indiquent chacun un site de liaison à un atome voisin ; et/ou

dans lesquelles
un groupement représenté par

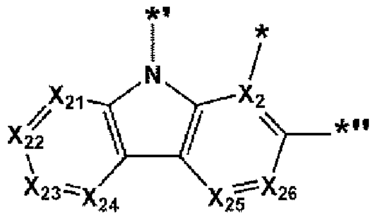

dans la formule 1 est choisi parmi les groupes représentés par les formules CZ2-1 à CZ2-7 :

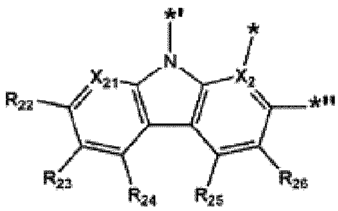
Formule **CZ2-1**

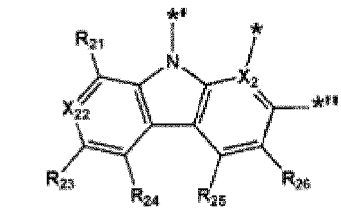
Formule **CZ2-2**

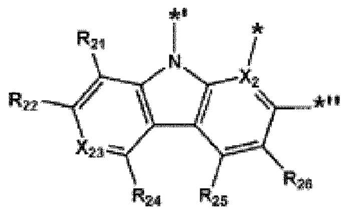
Formule **CZ2-3**

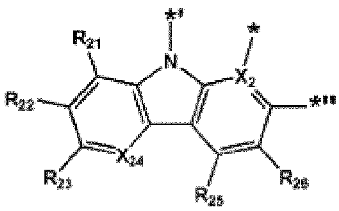
Formule **CZ2-4**

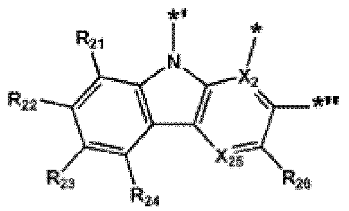
Formule **CY2-5**

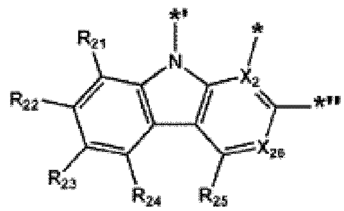
Formule **CZ2-6**

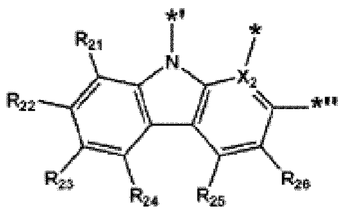
Formule **CZ2-7**

dans lesquelles, dans les formules CZ2-1 à CZ2-7,

$X_2$ et $R_{21}$ à $R_{26}$ représentent chacun indépendamment la même chose que décrite dans la revendication 1, $X_{21}$ à $X_{26}$ représentant chacun un atome N ou un groupe C(CN), et
*, *', et *" indiquent chacun un site de liaison un atome voisin.

**9.** Composé organométallique selon l'une quelconque des revendications 1 à 8, un groupement représenté par

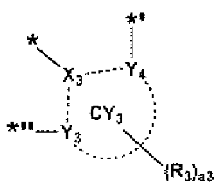

dans la formule 1 étant choisi parmi les groupes représentés par les formules CY3-1 à CY3-27 et CZ3-1 à CZ3-7 :

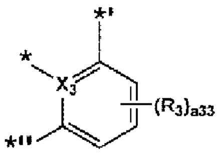
Formule CY3-1

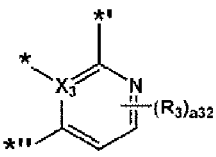
Formule CY3-2

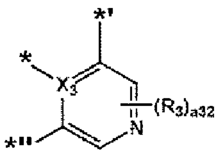
Formule CY3-3

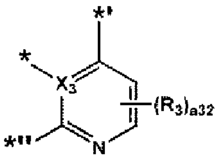
Formule CY3-4

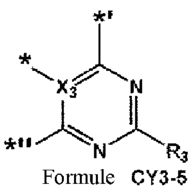
Formule CY3-5

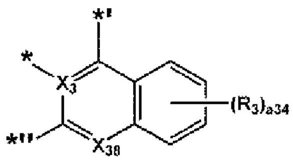
Formule CY3-6

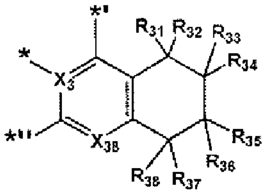
Formule CY3-7

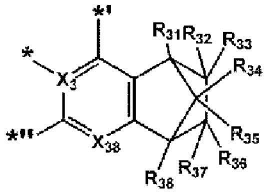
Formule CY3-8

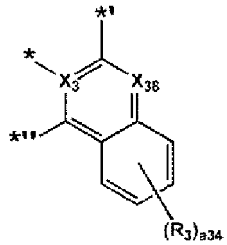
Formule CY3-9

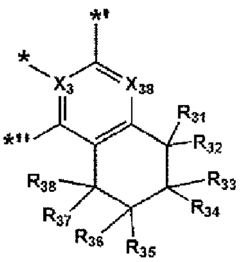
Formule CY3-10

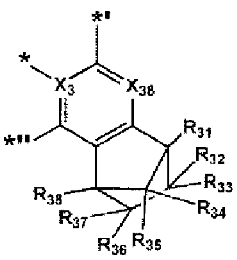
Formule CY3-11

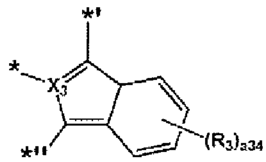
Formule CY3-12

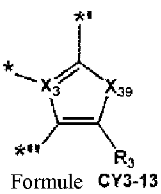
Formule CY3-13

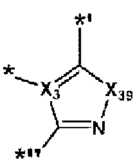
Formule CY3-14

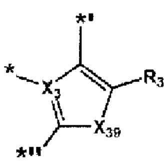
Formule CY3-15

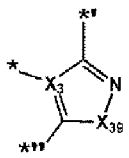
Formule CY3-16

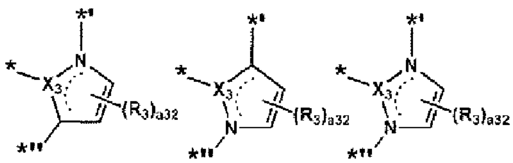
Formule CY3-17 Formule CY3-18 Formule CY3-19

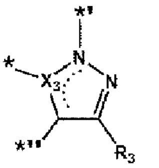
Formule CY3-20

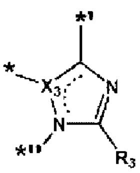
Formule CY3-21

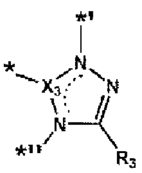
Formule CY3-22

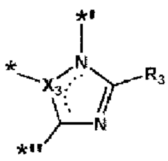
Formule CY3-23

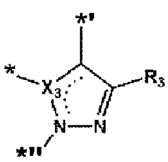
Formule CY3-24

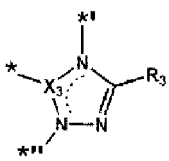
Formule CY3-25

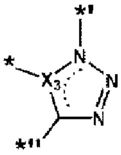
Formule CY3-26

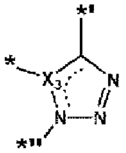
Formule CY3-27

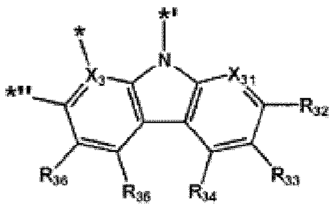
Formule CZ3-1

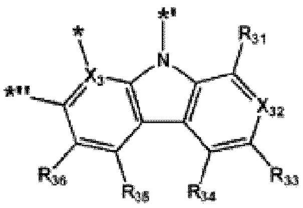
Formule CZ3-2

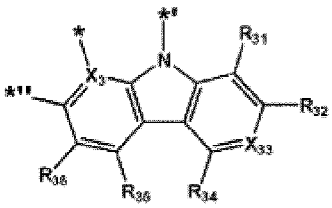
Formule CZ3-3

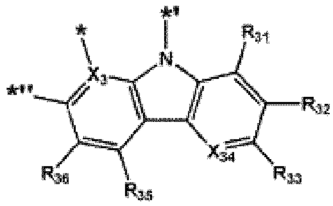
Formule CZ3-4

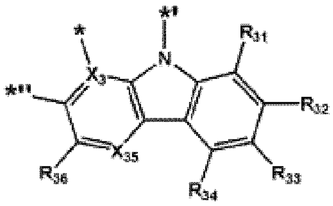
Formule CZ3-5

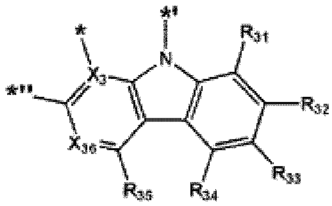
Formule CZ3-6

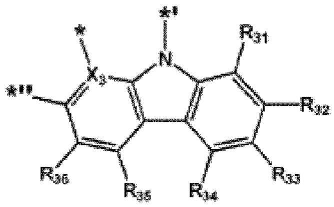
Formule CZ3-7

,

dans lesquelles, dans les formules CY3-1 à CY3-27 et CZ3-1 à CZ3-7,

$X_3$ et $R_3$ représentent chacun indépendamment la même chose que décrite dans la revendication 1,
$X_{38}$ représente un atome N ou un groupe $C(R_{38})$,
$X_{39}$ représente un atome O ou S, un groupe $N[(L_{39})b_{39}-(R_{39})]$ ou $C(R_{39a})(R_{39b})$,
$R_{31}$ à $R_{38}$ représentent chacun indépendamment la même chose que décrite en lien avec $R_1$ dans la revendication 1,
$L_{39}$ et b39 représentent chacun indépendamment la même chose que décrite en lien avec $L_5$ et b5 dans la revendication 1,
$R_{39}$, $R_{39a}$ et $R_{39b}$ représentent chacun indépendamment la même chose que décrite en lien avec $R_5$ dans la revendication 1,
$X_{31}$ à $X_{36}$ représentent chacun un atome N ou un groupe C(CN),
a34 représente un entier allant de 0 à 4,
a33 représente un entier allant de 0 à 3,
a32 représente un entier allant de 0 à 2, et
*, *', et *" indiquent chacun un site de liaison à un atome voisin.

**10.** Composé organométallique selon l'une quelconque des revendications 1 à 9, un groupement représenté par

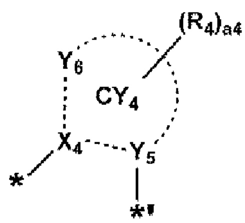

dans la formule 1 étant sélectionné parmi les groupes représentés par les formules CY4-1 à CY3-39 et CZ4-1 à CZ4-8 :

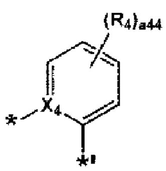
Formule CY4-1

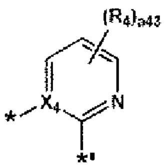
Formule CY4-2

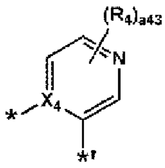
Formule CY4-3

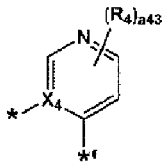
Formule CY4-4

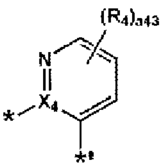
Formule CY4-5

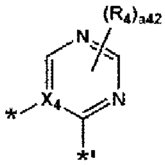
Formule CY4-6

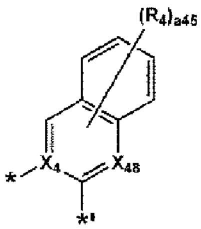
Formule CY4-7

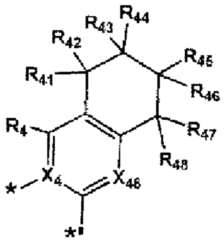
Formule CY4-8

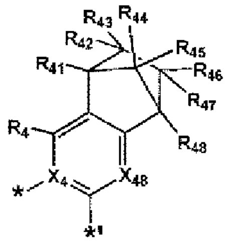
Formule CY4-9

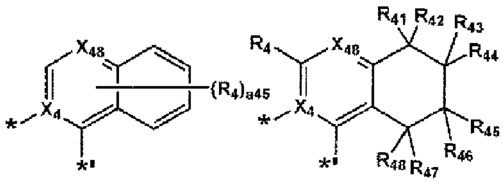
Formule CY4-10

Formule CY4-11

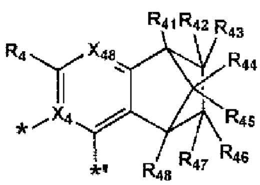
Formule CY4-12

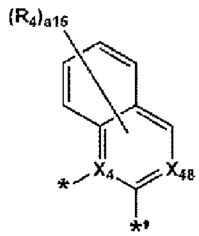
Formule CY4-13

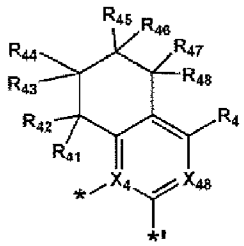
Formule CY4-14

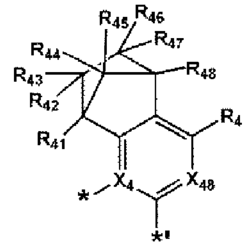
Formule CY4-15

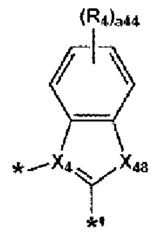
Formule CY4-16

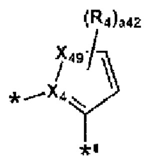
Formule CY4-17

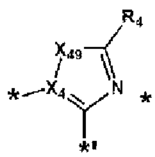
Formule CY4-18

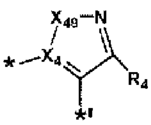
Formule CY4-19

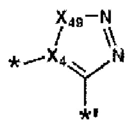
Formule CY4-20

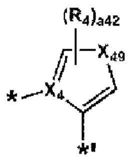
Formule CY4-21

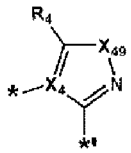
Formule CY4-22

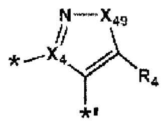
Formule CY4-23

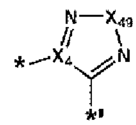
Formule CY4-24

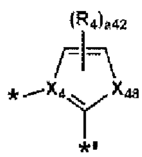
Formule CY4-25

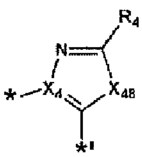
Formule CY4-26

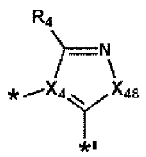
Formule CY4-27

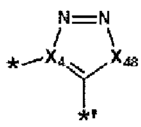
Formule CY4-28

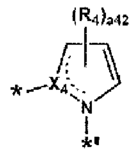
Formule CY4-29

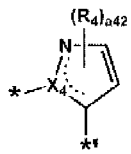
Formule CY4-30

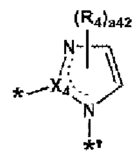
Formule CY4-31

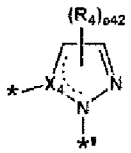
Formule CY4-32

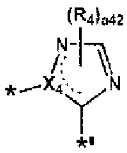
Formule CY4-33

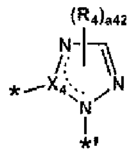
Formule CY4-34

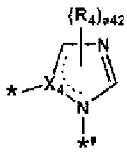
Formule CY4-35

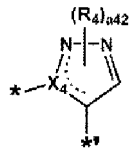
Formule CY4-36

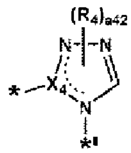
Formule CY4-37

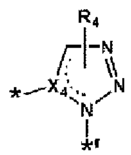
Formule CY4-38

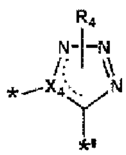
Formule CY4-39

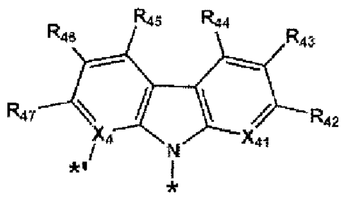

Formule CZ4-1

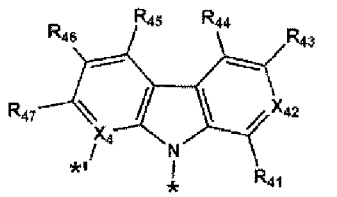

Formule CZ4-2

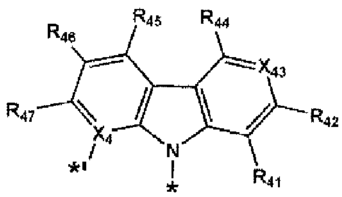

Formule CZ4-3

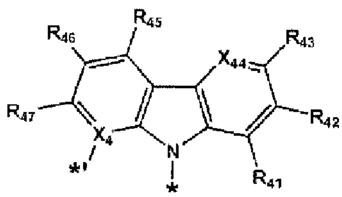

Formule CZ4-4

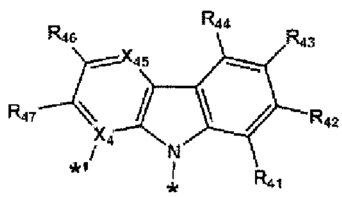

Formule CZ4-5

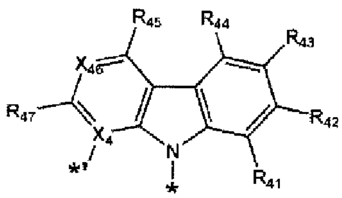

Formule CZ4-6

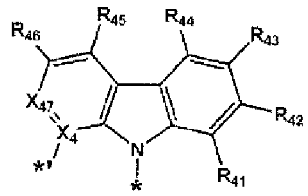

Formule CZ4-7

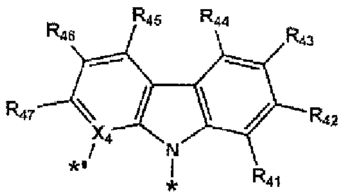

Formule CZ4-8

,

Dans lesquelles, dans les formules CY4-1 à CY4-39 et CZ4-1 à CZ4-8,

$X_4$ et $R_4$ représentent chacun indépendamment la même chose que décrite dans la revendication 1,
$X_{48}$ représente un atome N ou un groupe $C(R_{48})$,
$X_{49}$ représente un atome O ou S, un groupe $N[(L_{49})_{b49}\text{-}(R_{49})]$ ou $C(R_{49a})(R_{49b})$,
$R_{41}$ à $R_{48}$ représentent chacun indépendamment la même chose que décrite en lien avec $R_1$ dans la revendication 1,
$L_{49}$ et b49 représentent chacun indépendamment la même chose que décrite en lien avec $L_5$ et b5 dans la revendication 1,
$R_{49}$, $R_{49a}$ et $R_{49b}$ représentent chacun indépendamment la même chose que décrite en lien avec $R_5$ dans la revendication 1,
$X_{41}$ à $X_{47}$ représentent chacun un atome N ou un groupe C(CN),
a45 représente un entier allant de 0 à 5,
a44 représente un entier allant de 0 à 4,
a43 représente un entier allant de 0 à 3,
a42 représente un entier allant de 0 à 2, et
* et *' indiquent chacun un site de liaison à un atome voisin.

**11.** Composé organométallique selon l'une quelconque des revendications 1 à 10, ledit composé organométallique satisfaisant au moins l'une de la condition 1-1 à la condition 4-1 :

Condition 1-1
un groupement représenté par

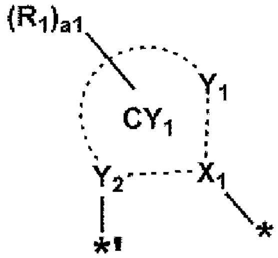

dans la formule 1 est choisi parmi les groupes représentés par les formules CZ1-1 à CZ1-7,
Condition 2-1
un groupement représenté par

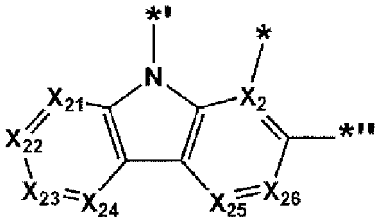

dans la formule 1 est choisi parmi les groupes représentés par les formules CZ2-1 à CZ2-6,
Condition 3-1
un groupement représenté par

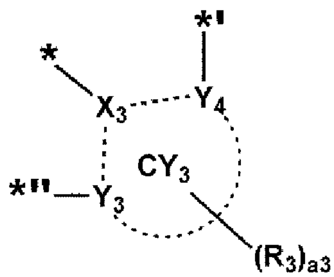

dans la formule 1 est choisi parmi les groupes représentés par les formules CZ3-1 à CZ3-6, et
Condition 4-1
un groupement représenté par

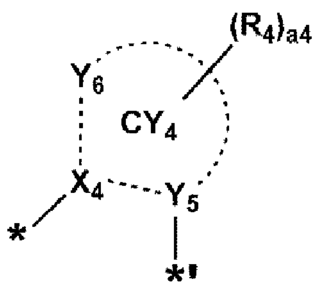

dans la formule 1 est choisi parmi les groupes représentés par les formules CZ4-1 à CZ4-7 :

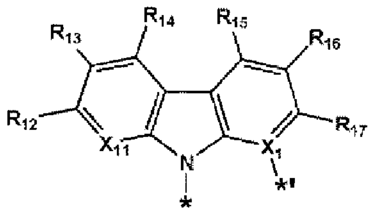

Formule CZ1-1

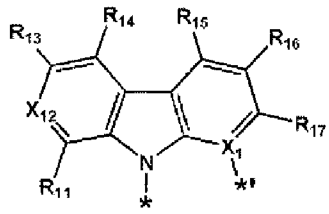

Formule CZ1-2

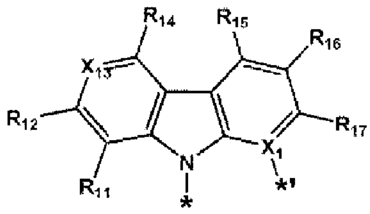

Formule CZ1-3

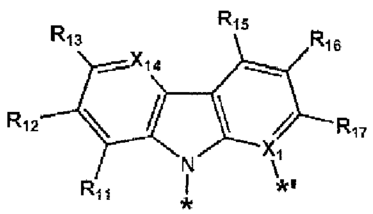

Formule CZ1-4

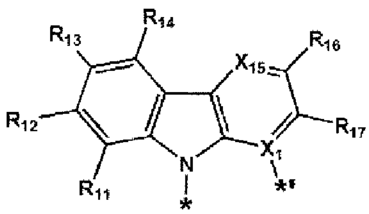

Formule CZ1-5

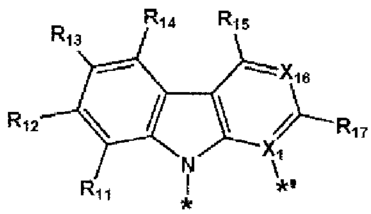

Formule CZ1-6

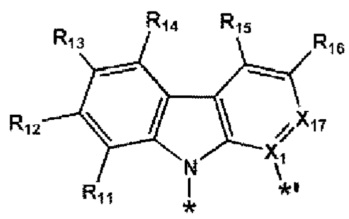

Formule CZ1-7

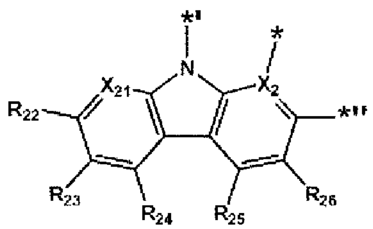

Formule CZ2-1

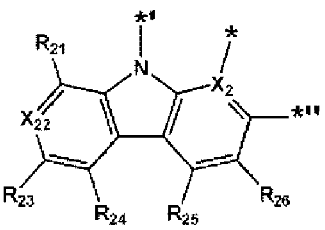

Formule CZ2-2

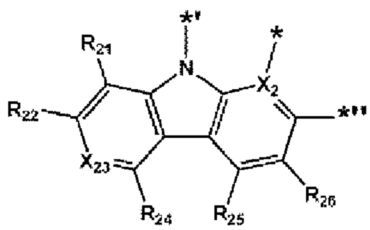

Formule CZ2-3

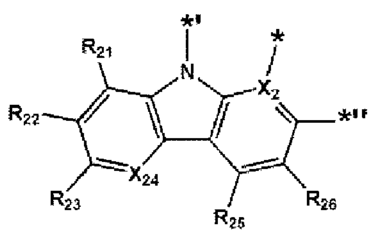

Formule CZ2-4

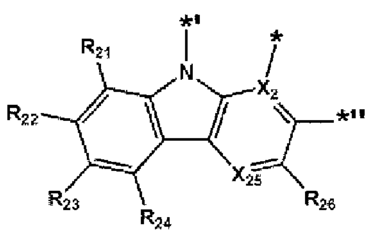

Formule CY2-5

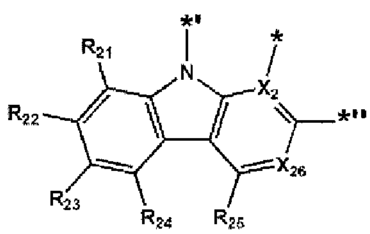

Formule CZ2-6

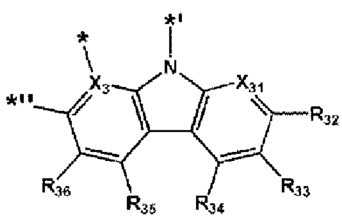

Formule CZ3-1

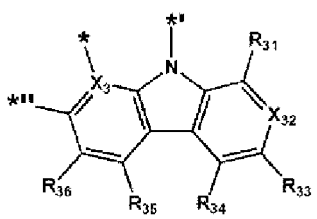

Formule CZ3-2

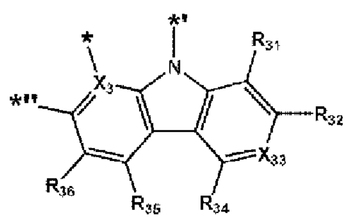

Formule CZ3-3

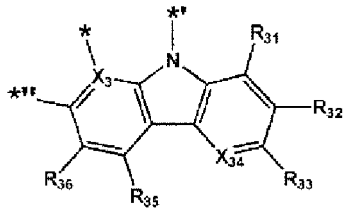

Formule CZ3-4

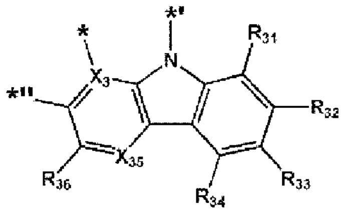

Formule CZ3-5

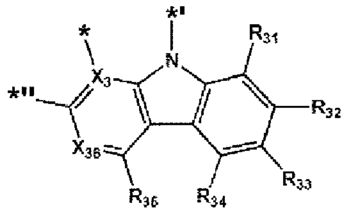

Formule CZ3-6

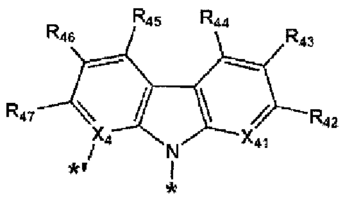

Formule CZ4-1

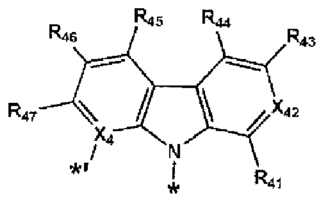

Formule CZ4-2

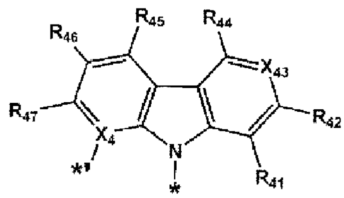

Formule CZ4-3

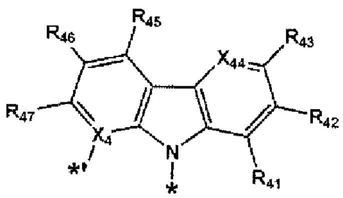

Formule CZ4-4

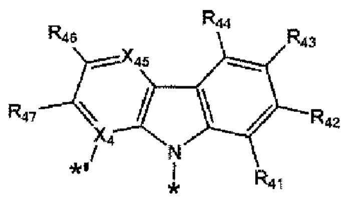

Formule CZ4-5

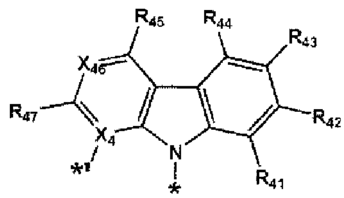

Formule CZ4-6

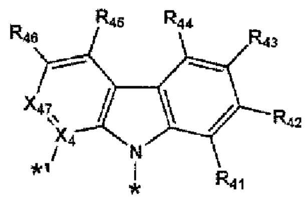

Formule CZ4-7

,

dans lesquelles, dans les formules CZ1-1 à CZ1-7, CZ2-1 à CZ2-6, CZ3-1 à CZ3-6, et CZ4-1 à CZ4-7,

$X_1$, $X_2$, $X_3$, $X_4$, $R_{11}$ à $R_{17}$, $R_{21}$ à $R_{26}$, $R_{31}$ à $R_{36}$, et $R_{41}$ à $R_{47}$ représentent chacun indépendamment la même chose que décrite dans la revendication 1,

$X_{11}$ à $X_{17}$, $X_{21}$ à $X_{26}$, $X_{31}$ à $X_{36}$, et $X_{41}$ à $X_{47}$ représentent chacun indépendamment un atome N ou un groupe C(CN), et

*, *', et *'' indiquent chacun un site de liaison à un atome voisin.

**12.** Composé organométallique selon l'une quelconque des revendications 1 à 11, ledit composé organométallique étant choisi parmi les composés 1 à 136 :

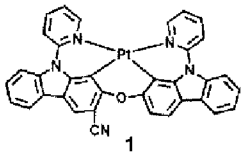

1

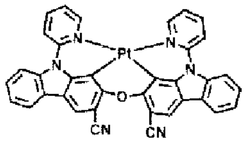

2

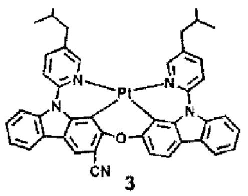

3

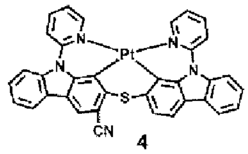

4

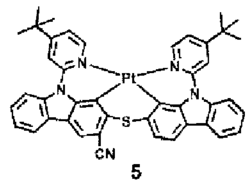
5

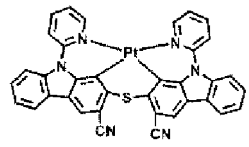
6

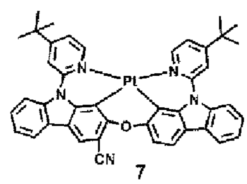
7

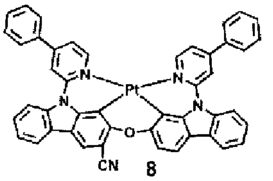
8

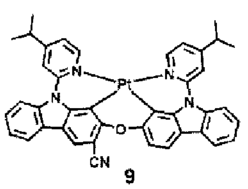
9

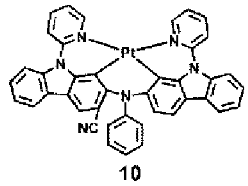
10

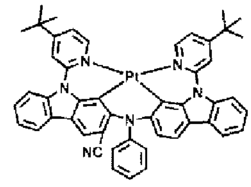
11

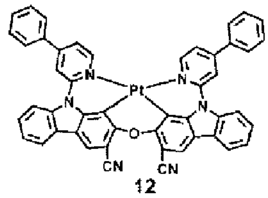
12

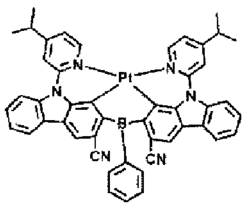
13

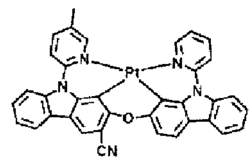
14

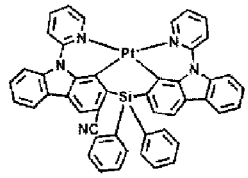
15

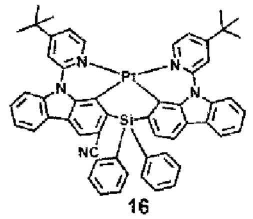
16

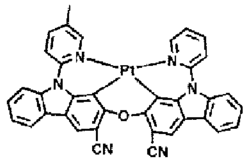
17

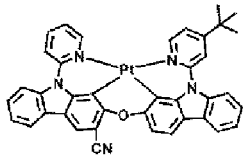
18

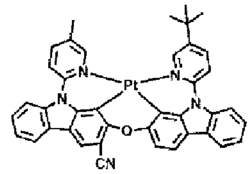
19

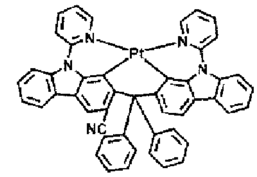
20

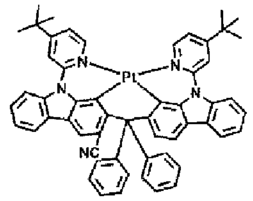
21

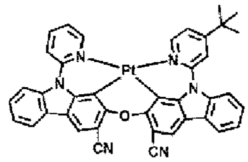
22

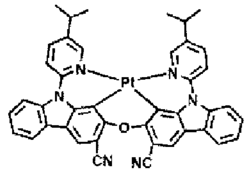
23

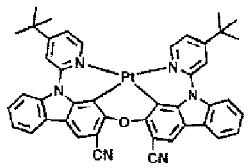
24

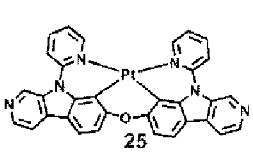
25

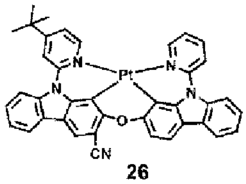
26

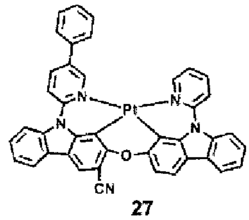
27

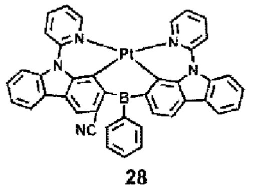
28

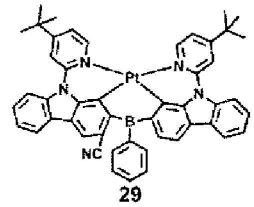
29

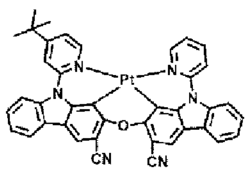
30

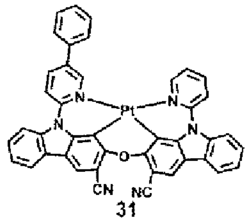
31

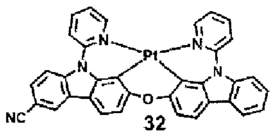
32

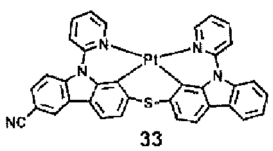
33

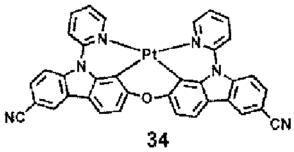
34

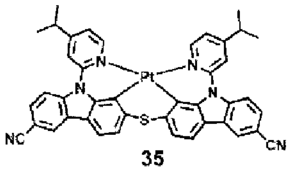
35

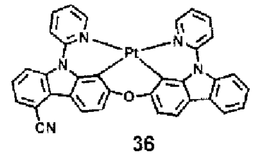
36

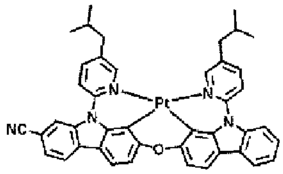
37

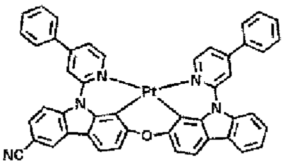
38

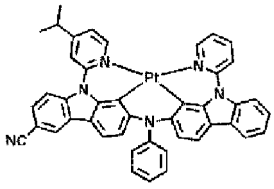
39

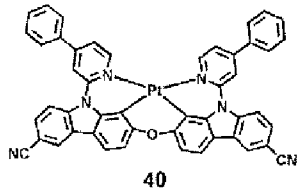
40

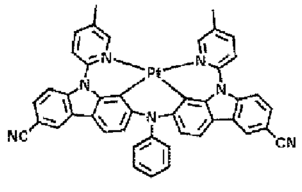
41

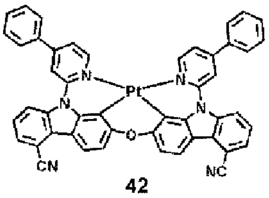
42

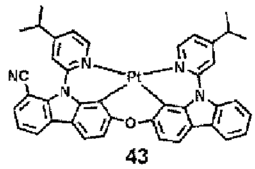
43

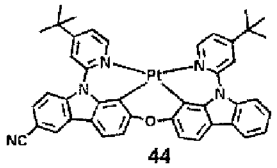
44

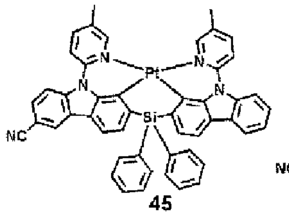
45

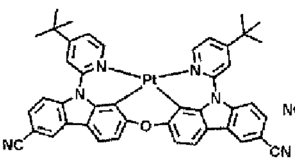
46

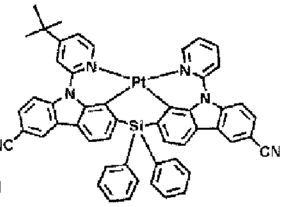
47

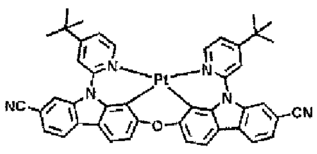
48

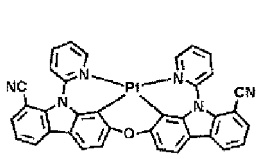
49

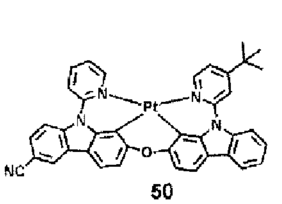
50

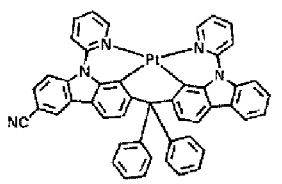
51

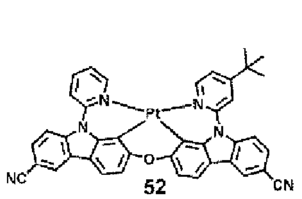
52

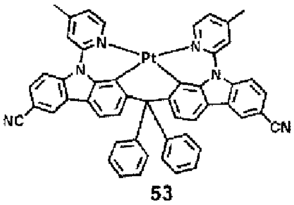
53

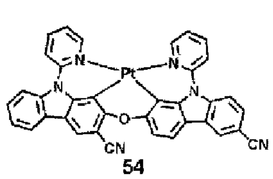
54

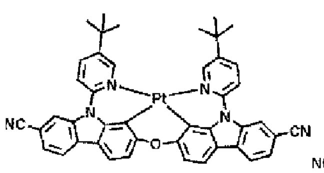
55

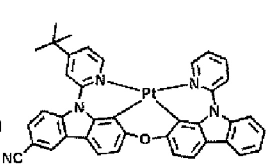
56

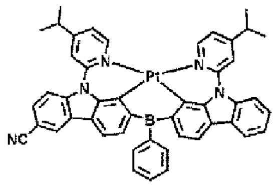
57

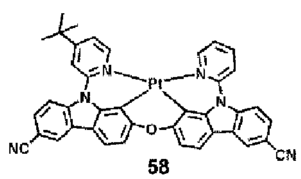
58

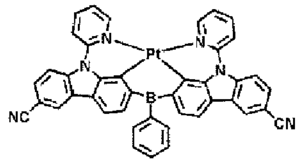
59

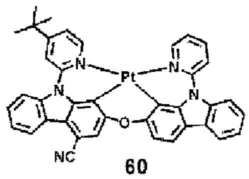
60

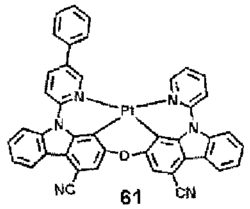
61

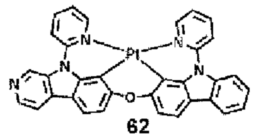
62

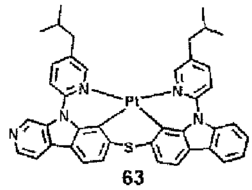
63

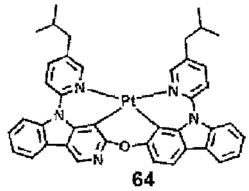
64

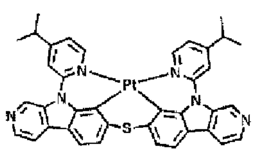
65

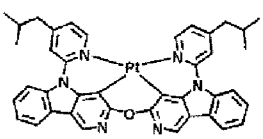
66

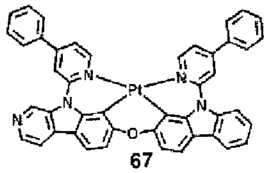
67

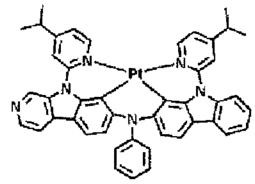
68

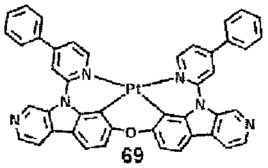
69

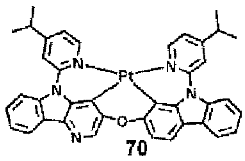
70

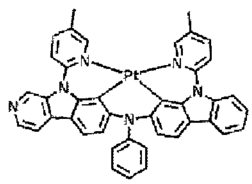
71

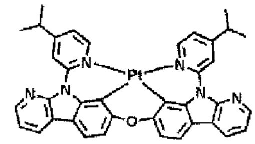
72

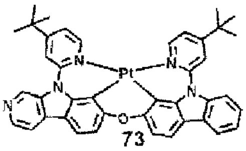
73

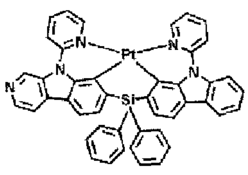
74

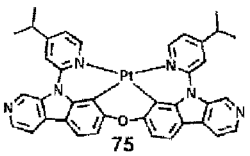
75

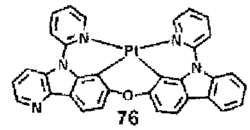
76

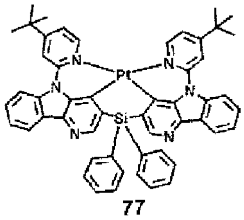
77

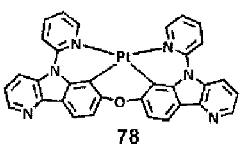
78

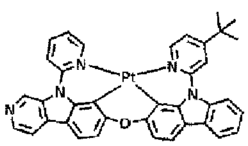
79

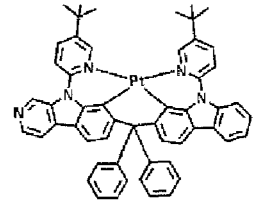
80

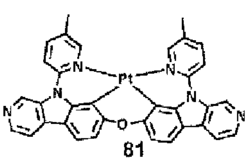
81

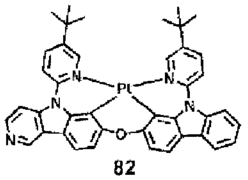
82

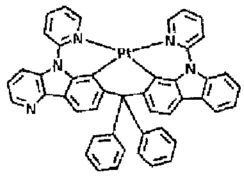
83

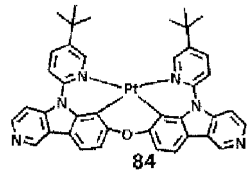
84

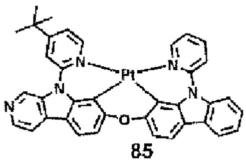
85

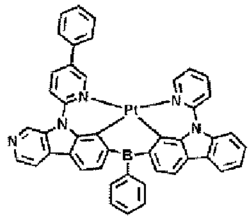
86

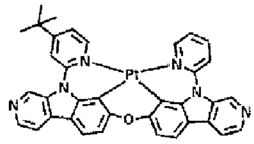
87

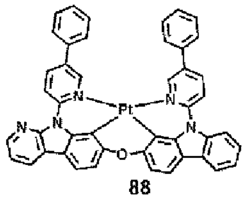
88

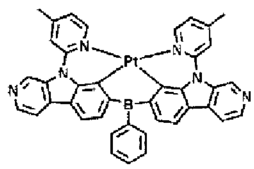
89

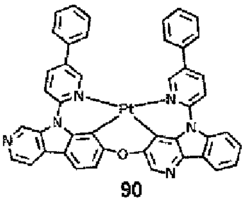
90

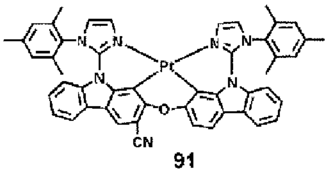
91

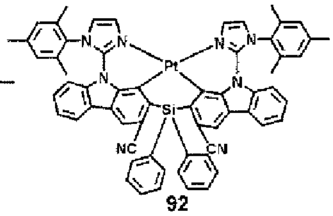
92

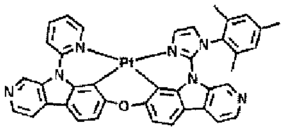
93

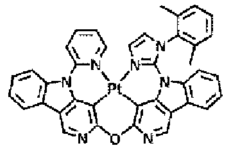
94

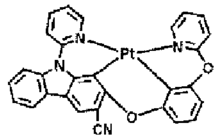
95

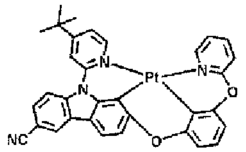
96

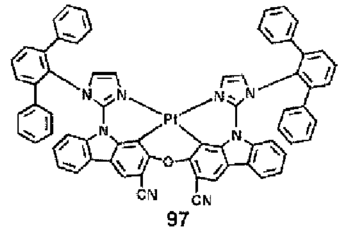
97

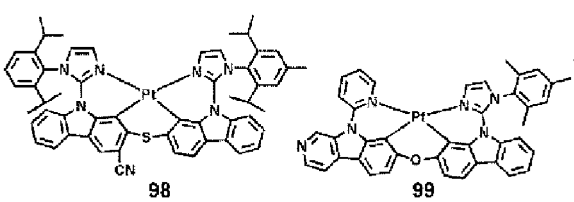
98

99

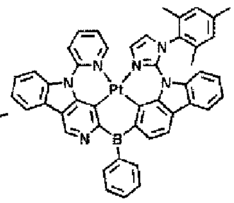
100

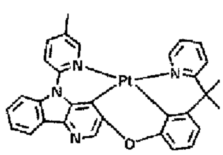
101

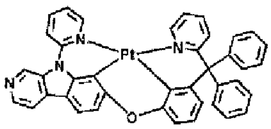
102

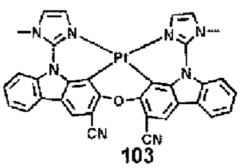
103

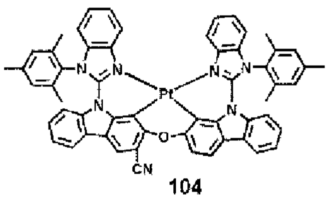
104

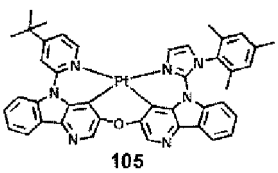
105

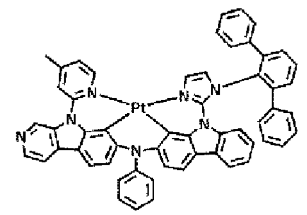
106

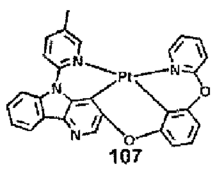
107

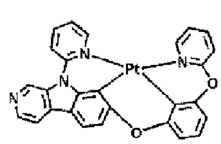
108

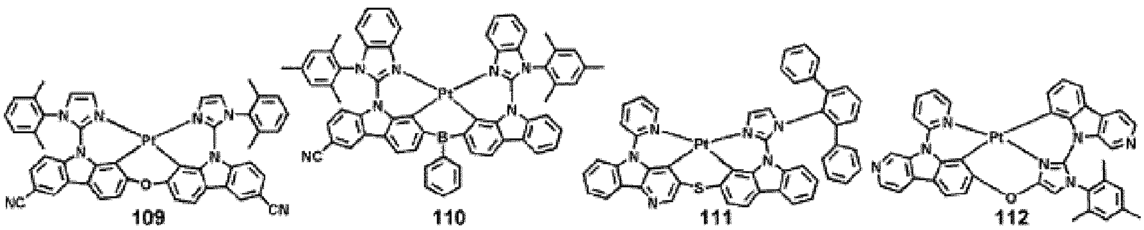
109

110

111

112

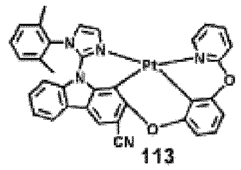
113

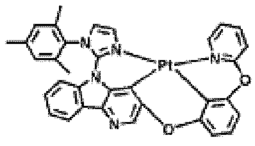
114

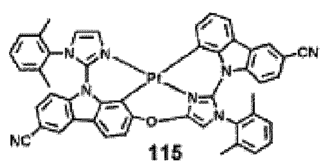
115

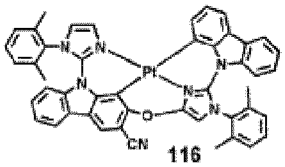
116

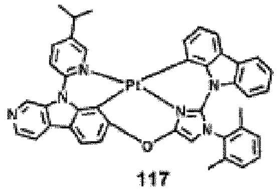
117

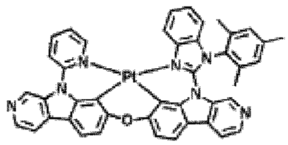
118

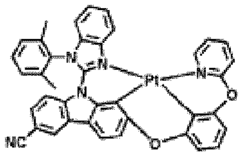
119

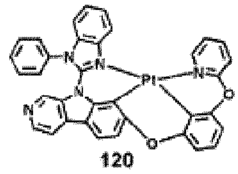
120

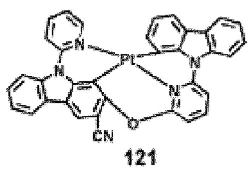
121

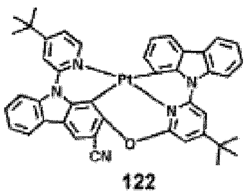
122

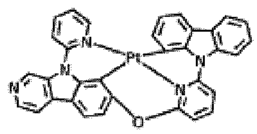
123

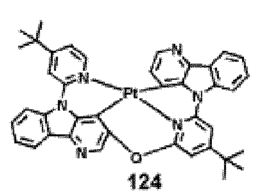
124

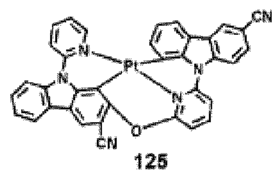
125

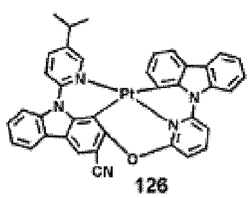
126

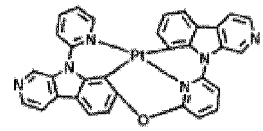
127

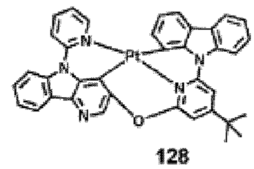
128

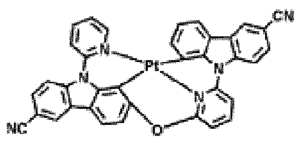
129

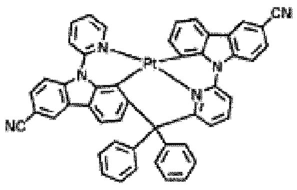
130

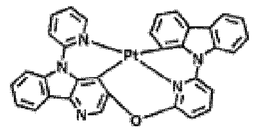
131

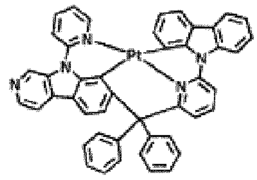
132

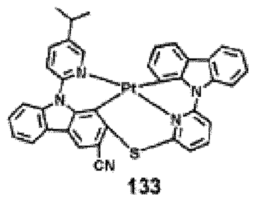
133

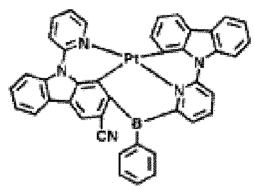
134

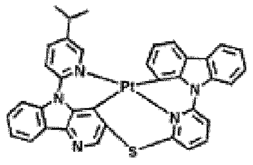
135

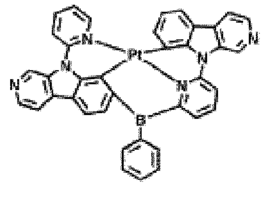
136

**13.** Dispositif électroluminescent organique comprenant :

une première électrode ;
une seconde électrode ; et
une couche organique disposée entre la première électrode et la seconde électrode,
ladite couche organique comprenant une couche d'émission et au moins un composé organométallique selon l'une quelconque des revendications 1 à 12 ;
de préférence
la première électrode étant une anode,
la seconde électrode étant une cathode,

la couche organique comprenant en outre une région de transport de trous disposée entre la première électrode et la couche d'émission et une région de transport d'électrons disposée entre la couche d'émission et la seconde électrode,
la région de transport de trous comprenant une couche d'injection de trous, une couche de transport de trous, une couche de blocage des électrons, ou toute combinaison de celles-ci, et
la région de transport d'électrons comprenant une couche de blocage de trous, une couche de transport d'électrons, une couche d'injection d'électrons, ou toute combinaison de celles-ci.

**14.** Dispositif électroluminescent organique selon la revendication 13, ladite couche d'émission comprenant le composé organométallique ;
de préférence
ladite couche d'émission comprenant un hôte, et
la quantité de l'hôte dans la couche d'émission étant plus grande que la quantité du composé organométallique dans la couche d'émission.

**15.** Composition de diagnostic comprenant au moins un composé organométallique selon l'une quelconque des revendications 1 à 12.

FIG. 1

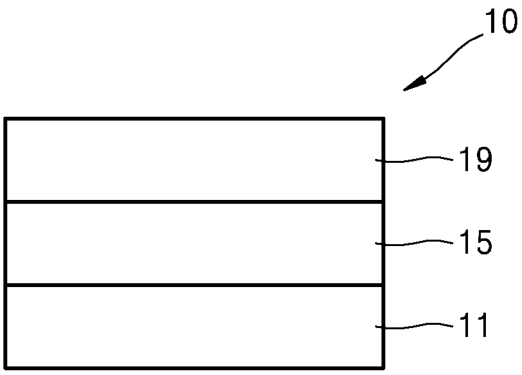
10
19
15
11

FIG. 2

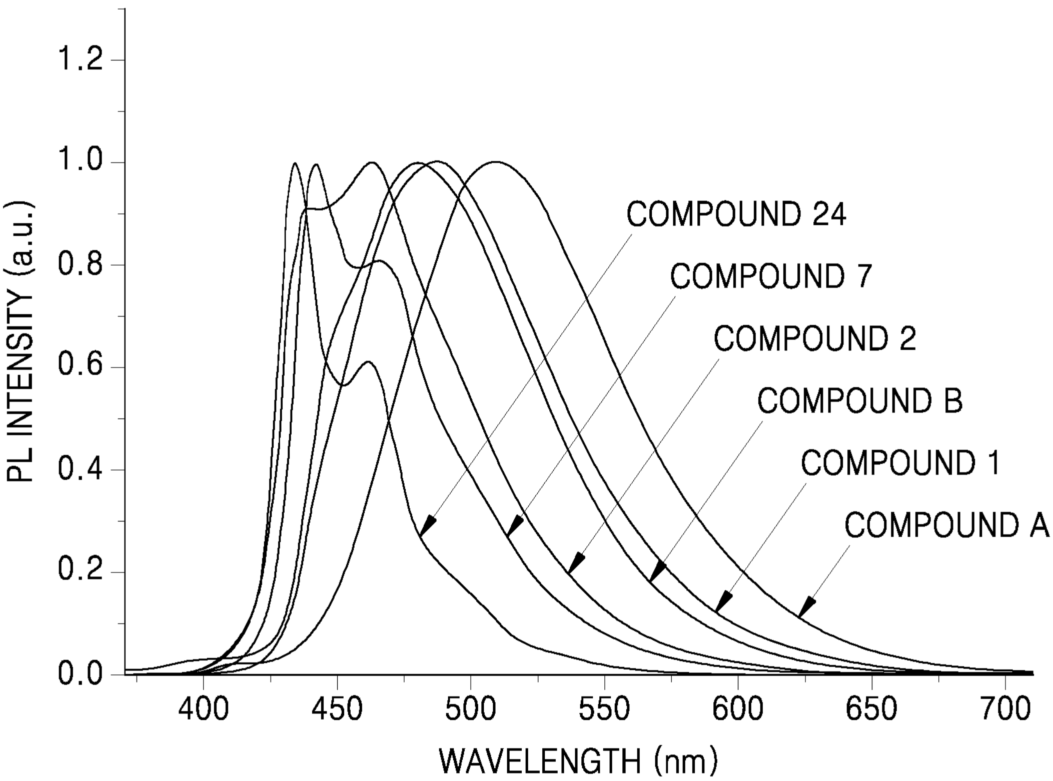
PL INTENSITY (a.u.)
1.2
1.0
0.8
0.6
0.4
0.2
0.0
400
450
500
550
600
650
700
WAVELENGTH (nm)
COMPOUND 24
COMPOUND 7
COMPOUND 2
COMPOUND B
COMPOUND 1
COMPOUND A

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2017040555 A